(19) Europäisches Patentamt
European Patent Office
Office européen des brevets

(11) EP 4 484 507 B1

(12) **EUROPEAN PATENT SPECIFICATION**

(45) Date of publication and mention of the grant of the patent:
**01.04.2026 Bulletin 2026/14**

(21) Application number: **23886305.4**

(22) Date of filing: **02.11.2023**

(51) International Patent Classification (IPC):
***C09D 11/03*** $^{(2014.01)}$ ***C09D 11/033*** $^{(2014.01)}$
***C09D 11/101*** $^{(2014.01)}$ ***C09D 11/107*** $^{(2014.01)}$
***C09D 11/38*** $^{(2014.01)}$ ***C09D 11/36*** $^{(2014.01)}$
***H10K 50/17*** $^{(2023.01)}$ ***H10K 85/60*** $^{(2023.01)}$
***H10K 50/00*** $^{(2023.01)}$ ***H10K 50/15*** $^{(2023.01)}$
***H10K 71/13*** $^{(2023.01)}$ ***H10K 71/15*** $^{(2023.01)}$
***H10K 85/30*** $^{(2023.01)}$

(52) Cooperative Patent Classification (CPC):
**C09D 11/03; C09D 11/033; C09D 11/101; C09D 11/107; C09D 11/36; C09D 11/38; H10K 71/15; H10K 85/30; H10K 85/633;**
H10K 50/17; H10K 71/135; H10K 85/322

(86) International application number:
**PCT/KR2023/017366**

(87) International publication number:
**WO 2024/096610 (10.05.2024 Gazette 2024/19)**

(54) **INK COMPOSITION, ORGANIC MATERIAL LAYER COMPRISING SAME, AND ORGANIC LIGHT-EMITTING DEVICE COMPRISING SAME**

TINTENZUSAMMENSETZUNG, ORGANISCHE MATERIALSCHICHT DAMIT UND ORGANISCHE LICHTEMITTIERENDE VORRICHTUNG DAMIT

COMPOSITION D’ENCRE, COUCHE DE MATÉRIAU ORGANIQUE LA COMPRENANT ET DISPOSITIF ÉLECTROLUMINESCENT ORGANIQUE LES COMPRENANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **04.11.2022 KR 20220146048**

(43) Date of publication of application:
**01.01.2025 Bulletin 2025/01**

(73) Proprietor: **LG Chem, Ltd.**
**Yeongdeungpo-gu**
**Seoul 07336 (KR)**

(72) Inventors:
- **KANG, Eunhye**
  **Daejeon 34122 (KR)**
- **KIM, Daeho**
  **Daejeon 34122 (KR)**
- **SHIN, Jiyeon**
  **Daejeon 34122 (KR)**
- **KIM, Byungjae**
  **Daejeon 34122 (KR)**
- **SEO, Minseob**
  **Daejeon 34122 (KR)**
- **LEE, Jiyoung**
  **Daejeon 34122 (KR)**
- **LEE, Ho Gyu**
  **Daejeon 34122 (KR)**

(74) Representative: **Hoffmann Eitle**
**Patent- und Rechtsanwälte PartmbB**
**Arabellastraße 30**
**81925 München (DE)**

(56) References cited:
**EP-A1- 3 954 677** **CN-A- 108 110 140**
**JP-A- 2009 059 846** **KR-A- 20200 036 610**
**KR-A- 20220 057 778** **US-A1- 2018 346 741**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 484 507 B1

## Description

[Technical Field]

This application claims priority to and the benefit of Korean Patent Application No. 10-2022-0146048 filed in the Korean Intellectual Property Office on November 4, 2022.

The present invention relates to an ink composition, an organic material layer including the same and an organic light emitting device including the same.

[Background Art]

An organic light emission phenomenon is one of the examples of converting an electric current into visible rays through an internal process of a specific organic molecule. The principle of the organic light emission phenomenon is as follows. When an organic material layer is disposed between an anode and a cathode and an electric current is applied between the two electrodes, electrons and holes are injected into the organic material layer from the cathode and the anode, respectively. The electrons and the holes which are injected into the organic material layer are recombined to form an exciton, and the exciton falls down again to the ground state to emit light. An organic light emitting device using the principle may be generally composed of a cathode, an anode, and an organic material layer disposed therebetween, for example, a hole injection layer, a hole transport layer, a light emitting layer, an electron injection layer, an electron transport layer, an electron blocking layer, a hole blocking layer, and the like.

In order to manufacture an organic light emitting device in the related art, a deposition process has been usually used. However, there are problems in that the loss of materials occurs frequently when an organic light emitting device is manufactured by a deposition process and in that it is difficult to manufacture a device having a large area, and to solve these problems, a device using a solution process has been developed.

Therefore, there is a need for the development of a material for a solution process.

Relavant background art represents documents EP3954677 A1,KR20200036610 and KR20220057778 A.

[Detailed Description of the Invention]

[Technical Problem]

The present invention relates to an ink composition, an organic material layer including the same and an organic light emitting device including the same.

[Technical Solution]

An exemplary embodiment of the present invention provides an ink composition including: a compound represented by the following Chemical Formula 1; a first solvent represented by the following Chemical Formula A; and a second solvent represented by the following Chemical Formula A and different from the first solvent.

[Chemical Formula 1]

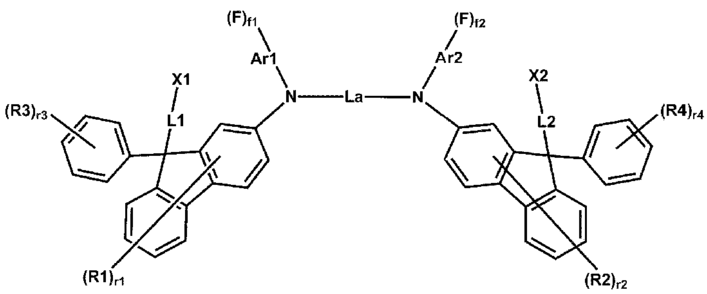

[Chemical Formula A]

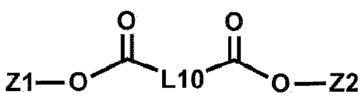

In Chemical Formulae 1 and A,

La is a substituted or unsubstituted divalent hydrocarbon ring group; or a substituted or unsubstituted divalent heterocyclic group,
L1 and L2 are the same as or different from each other, and are each independently a direct bond; or a substituted or unsubstituted arylene group,
R1 to R4 are the same as or different from each other, and are each independently hydrogen; deuterium; a halogen group; a substituted or unsubstituted alkyl group; a substituted or unsubstituted alkoxy group; a substituted or unsubstituted aryl group; or a substituted or unsubstituted heteroaryl group,
Ar1 and Ar2 are the same as or different from each other, and are each independently a substituted or unsubstituted aryl group; or a substituted or unsubstituted heteroaryl group,
X1 and X2 are the same as or different from each other, and are each independently a curable group,
L10 is a direct bond; or a substituted or unsubstituted alkylene group,
Z1 and Z2 are the same as or different from each other, and are each independently a substituted or unsubstituted alkyl group; or a substituted or unsubstituted aryl group,
r1 and r2 are each an integer from 1 to 7, r3 and r4 are each an integer from 1 to 5, and when r1 to r4 are each 2 or higher, two or more substituents in the parenthesis are the same as or different from each other,
f1 is 1 to the number of binding positions in which substituents can be bonded to Ar1, and
f2 is 1 to the number of binding positions in which substituents can be bonded to Ar2.

Another exemplary embodiment of the present invention provides a pixel including the above-described ink composition or a cured product thereof.
Still another exemplary embodiment of the present invention provides an organic material layer including the above-described pixel.
Yet another exemplary embodiment of the present invention provides an organic light emitting device including: a first electrode; a second electrode; and an organic material layer having one or more layers provided between the first electrode and the second electrode, in which one or more layers of the organic material layer are the above-described organic material layer.

[Advantageous Effects]

The ink composition according to an exemplary embodiment of the present invention has an advantage of forming a stable thin film that is not damaged by subsequent solution processes by forming thin films cured by a heat treatment or a light treatment.
Further, since the ink composition according to an exemplary embodiment of the present invention shows resistance to a specific solvent after curing, a solution process can be performed when a device is manufactured, and accordingly, the device can be made to have a large area.
In addition, the ink composition according to an exemplary embodiment of the present invention can be used as a material for an organic material layer of an organic light emitting device, and it is possible to obtain a device having low driving voltage, excellent efficiency characteristics, and/or excellent service life characteristics when the ink composition is applied to an organic light emitting device.
Furthermore, pixels formed using the ink composition according to an exemplary embodiment of the present invention have an effect of excellent flatness.

[Brief Description of Drawings]

FIG. 1 illustrates an organic light emitting device according to an exemplary embodiment of the present invention.
FIG. 2 is a view illustrating the NMR measurement results of Compound D-A.
FIG. 3 is a view illustrating the NMR measurement results of Compound D-B.
FIG. 4 is a view illustrating a plan view of an organic material layer in which banks are formed.
FIG. 5 is a view exemplifying a flatness measurement region.
FIG. 6 is a view illustrating a process in which an ink composition is applied to an organic material layer provided with pixels with a short-axis width of more than 50 μm.
FIG. 7 is a view illustrating a process in which an ink composition is applied to an organic material layer provided with pixels with a short-axis width of 50 μm or less.
FIG. 8 is a view illustrating the flatness measurement results when pixels are formed using Ink Composition 1.

FIG. 9 is a view illustrating the flatness measurement results when pixels are formed using Ink Composition 18.

- 1': Pixel
- 10: Printhead
- 20: Ink composition
- 30: Substrate on which pixels are formed
- 101: Substrate
- 201: First electrode
- 301: Hole injection layer
- 401: Hole transport layer
- 501: Light emitting layer
- 601: Electron injection and transport layer
- 701: Second electrode

[Best Mode]

Hereinafter, the present invention will be described in detail.

An exemplary embodiment of the present invention provides an ink composition including: a compound represented by the following Chemical Formula 1; a first solvent represented by the following Chemical Formula A; and a second solvent represented by the following Chemical Formula A and different from the first solvent.

[Chemical Formula 1]

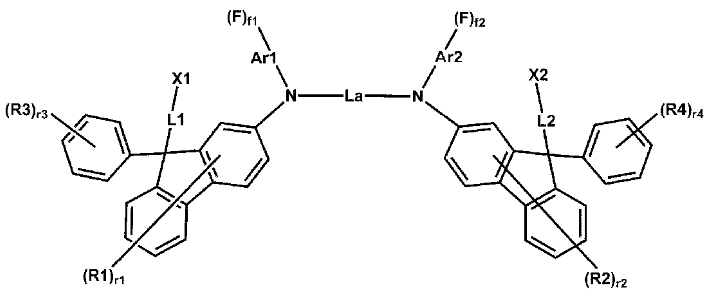

[Chemical Formula A]

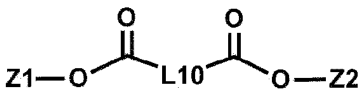

In Chemical Formulae 1 and A,

La is a substituted or unsubstituted divalent hydrocarbon ring group; or a substituted or unsubstituted divalent heterocyclic group,

L1 and L2 are the same as or different from each other, and are each independently a direct bond; or a substituted or unsubstituted arylene group,

R1 to R4 are the same as or different from each other, and are each independently hydrogen; deuterium; a halogen group; a substituted or unsubstituted alkyl group; a substituted or unsubstituted alkoxy group; a substituted or unsubstituted aryl group; or a substituted or unsubstituted heteroaryl group,

Ar1 and Ar2 are the same as or different from each other, and are each independently a substituted or unsubstituted aryl group; or a substituted or unsubstituted heteroaryl group,

X1 and X2 are the same as or different from each other, and are each independently a curable group,

L10 is a direct bond; or a substituted or unsubstituted alkylene group,

Z1 and Z2 are the same as or different from each other, and are each independently a substituted or unsubstituted alkyl group; or a substituted or unsubstituted aryl group,

r1 and r2 are each an integer from 1 to 7, r3 and r4 are each an integer from 1 to 5, and when r1 to r4 are each 2 or higher, two or more substituents in the parenthesis are the same as or different from each other,

f1 is 1 to the number of binding positions in which substituents can be bonded to Ar1, and

f2 is 1 to the number of binding positions in which substituents can be bonded to Ar2.

The compound represented by Chemical Formula 1 according to an exemplary embodiment of the present invention has high stability and a high highest occupied molecular orbital (HOMO) energy level value by including a halogen group (specifically, F) in each of the substituents Ar1 and Ar2 to suppress radical formation at the positions of Ar1 and Ar2. For this reason, when the compound of Chemical Formula 1 is included in the hole injection layer in the organic light emitting device, the compound facilitates the injection of holes from the hole injection layer to the hole transport layer, thereby greatly affecting the improving service life of the device.

The first solvent and second solvent represented by Chemical Formula A according to an exemplary embodiment of the present invention may dissolve the compound represented by Chemical Formula 1, and have the effect of forming a flat thin film after drying ink due to the low surface tension of the solvent and the difference in low surface tension between the solvents.

Generally, when the size of a unit pixel is reduced in order to increase the resolution of a display panel, it is difficult to form a flat thin film when vacuum drying is performed after inkjet printing. In particular, as the short-axis length of the pixel decreases, it becomes more difficult to form a flat thin film. When a flat thin film is not formed as described above, the factors that affect the interference conditions of emitted light increase depending on the thickness, thereby reducing the light emitting effect and/or coloring effect of the display panel.

An exemplary embodiment of the present invention includes the compound represented by Chemical Formula 1, the first solvent represented by Chemical Formula A, and the second solvent represented by Chemical Formula A and different from the first solvent, thereby showing an effect of forming a flat thin film even though the size of the pixel is reduced. Accordingly, the ink composition according to an exemplary embodiment of the present invention may exhibit excellent light emitting effect and/or coloring effect when applied to an organic material layer.

When one member (layer) is disposed "on" another member (layer) in the present invention, this includes not only a case where the one member (layer) is brought into contact with another member, but also a case where still another member (layer) is present between the two members (layers).

When one part "includes" one constituent element in the present invention, unless otherwise specifically described, this does not mean that another constituent element is excluded, but means that another constituent element may be further included.

In the present invention, the "layer" has a meaning compatible with a "film" usually used in the art, and means a coating covering a target region. The size of the "layer" is not limited, and the sizes of the respective "layers" may be the same as or different from one another. According to an exemplary embodiment, the size of the "layer" may be the same as that of the entire device, may correspond to the size of a specific functional region, and may also be as small as a single sub-pixel.

In the present invention, "energy level" means a size of energy. Therefore, the energy level is interpreted to mean the absolute value of the corresponding energy value. For example, a deep energy level means that the absolute value increases in the negative direction from the vacuum level.

Unless otherwise defined in the present invention, all technical and scientific terms used in the present invention have the same meaning as commonly understood by one with ordinary skill in the art to which the present invention pertains. Although methods and materials similar to or equivalent to those described in the present invention may be used in the practice or in the test of exemplary embodiments of the present invention, suitable methods and materials will be described below.

Further, the materials, methods, and examples are illustrative only and are not intended to be limiting.

In the present invention, "------" and "+" each mean a moiety bonded to another substituent or a bonding portion.

In the present invention, the term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more substituents are substituted, the two or more substituents may be the same as or different from each other.

In the present invention, the term "substituted or unsubstituted" means being substituted with one or more substituents selected from the group consisting of hydrogen; deuterium; a halogen group; an amine group; an alkyl group; an aryl group; and a heteroaryl group, being substituted with a substituent to which two or more substituents among the exemplified substituents are linked, or having no substituent.

In the present invention, the fact that two or more substituents are linked indicates that hydrogen of any one substituent is linked to another substituent. For example, an isopropyl group and a phenyl group may be linked to each other to become a substituent of

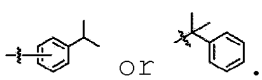

In the present invention, there is no limitation in the bonding direction of -COO-. For example, the -COO-means both

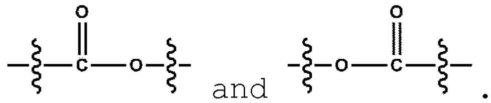

In the present invention, a halogen group is a fluoro group (-F), a chloro group (-Cl), a bromo group (-Br), or an iodo group (-I).

In the present invention, an alkyl group may be straight-chained or branched, and the number of carbon atoms thereof is not particularly limited, but is preferably 1 to 30, 1 to 20, 1 to 10, or 1 to 5. Specific examples thereof include methyl, ethyl, propyl, n-propyl, isopropyl, butyl, n-butyl, isobutyl, t-butyl, sec-butyl, 1-methylbutyl, 1-ethylbutyl, pentyl, n-pentyl, isopentyl, neopentyl, t-pentyl, hexyl, n-hexyl, 1-methylpentyl, 2-methylpentyl, 3,3-dimethylbutyl, 2-ethylbutyl, heptyl, n-heptyl, 1-methylhexyl, cyclopentylmethyl, cyclohexylmethyl, octyl, n-octyl, t-octyl, 1-methylheptyl, 2-ethylhexyl, 2-propylpentyl, n-nonyl, 2,2-dimethylheptyl, 1-ethylpropyl, 1,1-dimethylpropyl, isohexyl, 4-methylhexyl, 5-methylhexyl, and the like, but are not limited thereto.

In the present invention, the alkyl group may include a haloalkyl group, which is an alkyl group substituted with a halogen group. Specific examples thereof include a methyl group substituted with three fluoro groups, that is, a trifluoromethyl group, and the like, but are not limited thereto.

In the present invention, an alkylene group means a group having two bonding positions in an alkyl group, that is, a divalent group. The above-described description on the alkyl group may be applied to the alkylene group, except that it is a divalent group.

In the present invention, the number of carbon atoms of the cycloalkyl group is not particularly limited, but is preferably 3 to 60. According to an exemplary embodiment, the number of carbon atoms of the cycloalkyl group is 3 to 30. Specific examples of the cycloalkyl group include a cyclopropyl group, a cyclobutyl group, a cyclopentyl group, a cyclohexyl group, a cycloheptyl group, a cyclooctyl group, and the like, but are not limited thereto.

In the present invention, an aryl group means a monovalent aromatic hydrocarbon or a monovalent group of an aromatic hydrocarbon derivative. In the present invention, an aromatic hydrocarbon means a compound in which pi electrons are completely conjugated and which contains a planar ring, and a group derived from an aromatic hydrocarbon means a structure in which an aromatic hydrocarbon or a cyclic aliphatic hydrocarbon is fused with an aromatic hydrocarbon. Further, in the present invention, an aryl group intends to include a monovalent group in which two or more aromatic hydrocarbons or derivatives of an aromatic hydrocarbon are linked to each other. The aryl group is not particularly limited, but preferably has 6 to 60 carbon atoms, 6 to 50 carbon atoms, 6 to 30 carbon atoms, 6 to 25 carbon atoms, 6 to 20 carbon atoms, 6 to 18 carbon atoms, 6 to 15 carbon atoms, 6 to 13 carbon atoms, or 6 to 12 carbon atoms, and may be a monocyclic aryl group or a polycyclic aryl group.

The monocyclic aryl group is not particularly limited, but preferably has 6 to 60 carbon atoms, 6 to 54 carbon atoms, 6 to 48 carbon atoms, 6 to 42 carbon atoms, 6 to 36 carbon atoms, 6 to 30 carbon atoms, 6 to 24 carbon atoms, 6 to 18 carbon atoms, or 6 to 12 carbon atoms, and may be specifically a phenyl group, a biphenyl group, a terphenyl group, and the like, but is not limited thereto.

The polycyclic aryl group is not particularly limited, but preferably has 6 to 60 carbon atoms, 6 to 45 carbon atoms, 6 to 30 carbon atoms, 6 to 24 carbon atoms, 6 to 22 carbon atoms, 6 to 20 carbon atoms, 6 to 18 carbon atoms, 6 to 16 carbon atoms, 6 to 15 carbon atoms, 6 to 14 carbon atoms, 6 to 13 carbon atoms, 6 to 12 carbon atoms, or 6 to 10 carbon atoms, and may be a naphthyl group, an anthracenyl group, a phenanthrenyl group, a pyrenyl group, a perylenyl group, a triphenylenyl group, a chrysenyl group, a fluorenyl group, and the like, but is not limited thereto.

In the present invention, the aryl group may include a haloaryl group substituted with a halogen group. The haloaryl group means an aryl group substituted with one or more halogen groups, and the haloaryl group may be an aryl group substituted with one or more substituents selected from the group consisting of a fluoro group, a chloro group, a bromo group and an iodo group. In addition, the haloaryl group may have the same two halogen groups or more substituted, and may be, for example, not only an aryl group substituted with one fluoro group, but also an aryl group substituted with two or more fluoro groups.

In the present invention, the arylene group means an aryl group having two bonding sites, that is, a divalent group. The above-described description on the aryl group may be applied to the arylene group, except that it is a divalent group.

In the present invention, a heterocyclic group is an aromatic group, an aliphatic group, including one or more of N, O, P and S as a heteroatom, or a fused ring group of the aromatic group and the aliphatic group. The number of carbon atoms of the heterocyclic group is not particularly limited, but may be 2 to 60.

In the present invention, a heteroaryl group means a monovalent aromatic hetero ring. Here, the aromatic hetero ring is a monovalent group of an aromatic ring or a derivative of the aromatic ring, and means a group including one or more selected from the group consisting of N, O, P, S, Si and Se as a heteroatom. The derivative of the aromatic ring all includes a

structure in which an aromatic ring or an aliphatic ring is fused with an aromatic ring. Further, in the present specification, the heteroaryl group intends to include a monovalent group in which two or more aromatic rings including a heteroatom or two or more derivatives of an aromatic ring including a heteroatom are linked to each other. The number of carbon atoms of the heteroaryl group is preferably 2 to 60, 2 to 50, 2 to 30, 2 to 20, 2 to 18, or 2 to 13. Examples of the heteroaryl group include a thiophene group, a furanyl group, a pyrrole group, an imidazole group, a thiazole group, an oxazole group, a pyridine group, a pyrimidine group, a triazine group, a triazole group, an acridine group, a pyridazine group, a pyrazine group, a quinoline group, a quinazoline group, a quinoxaline group, an isoquinoline group, an indole group, a carbazole group, a benzoxazole group, a benzimidazole group, a benzothiazole group, a benzocarbazole group, a benzothiophene group, a dibenzothiophene group, a benzofuran group, a phenanthrolinyl group, a dibenzofuran group, and the like, but are not limited thereto.

In the present invention, a hydrocarbon ring may be an aromatic ring, an aliphatic ring, or a fused ring of the aromatic ring and the aliphatic ring. Examples of the fused ring of the aromatic ring and the aliphatic ring include a 1,2,3,4-tetrahydronaphthalene group, a 2,3-dihydro-1H-indene group, and the like, but are not limited thereto.

In the present invention, the above-described description on the aryl group may be applied to an aromatic ring.

In the present invention, the aliphatic ring is not an aromatic but a hydrocarbon ring, and examples thereof include examples of the above-described cycloalkyl group, an adamantyl group, and the like.

In the present invention, the above-described content on the aryl group may be applied to an aromatic ring.

In the present invention, a curable group may be subjected to a polymerization or cross-linking reaction, and through this, a reaction to increase the molecular weight may be performed, and examples of the curable group include a thermosetting group that is cured by heat, a photocurable group that is cured by light, or the like.

In an exemplary embodiment of the present invention, the curable group is any one of the following structures.

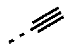 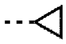 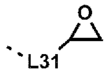 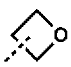 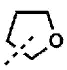 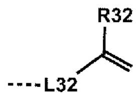 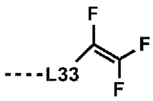

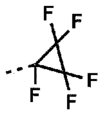 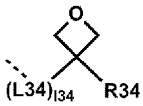 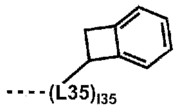 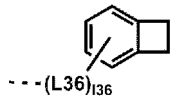 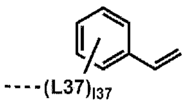

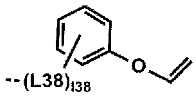 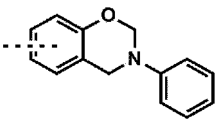 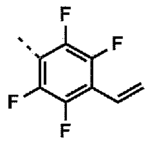 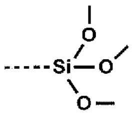

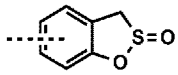 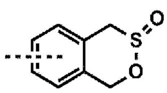

In the structures,

R32 and R34 are the same as or different from each other, and are each independently hydrogen; deuterium; or a substituted or unsubstituted alkyl group,

L31 to L38 are the same as or different from each other, and are each independently a direct bond; -O-; a substituted or unsubstituted alkylene group; or a substituted or unsubstituted arylene group,

l34 to l38 are an integer from 1 to 10, and when l34 to l38 are each 2 or higher, two or more substituents in the parenthesis are the same as or different from each other, and

------ is a moiety bonded to Chemical Formula 1.

In an exemplary embodiment of the present invention, the curable group is any one of the following structures.

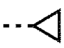 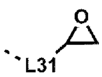 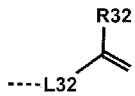 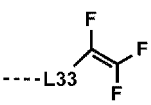 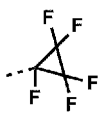 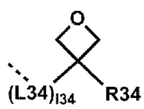

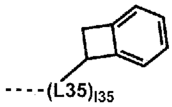 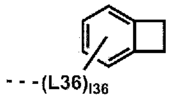 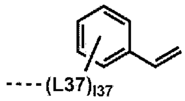 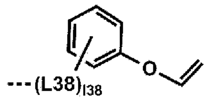

In the structures, L31 to L38, l34 to l38, R32, R34 and ------ are the same as those described above.

Hereinafter, the compound represented by Chemical Formula 1 will be specifically described.

The ink composition of the present invention includes the compound represented by Chemical Formula **1.**

In an exemplary embodiment of the present invention, L1 and L2 are the same as or different from each other, and are each independently a direct bond; or a substituted or unsubstituted arylene group having 6 to 30 carbon atoms.

In an exemplary embodiment of the present invention, L1 and L2 are the same as or different from each other, and are each independently a direct bond; or a substituted or unsubstituted phenylene group.

In an exemplary embodiment of the present invention, Chemical Formula 1 is represented by the following Chemical Formula 1-1.

[Chemical Formula 1-1]

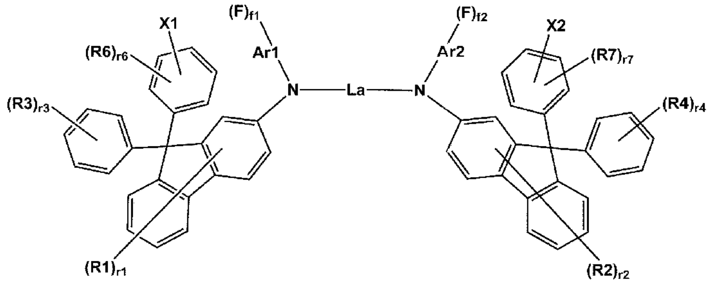

In Chemical Formula 1-1,

La, Ar1, Ar2, R1 to R4, X1, X2, r1 to r4, f1 and f2 are the same as those defined in Chemical Formula **1,**
R6 and R7 are the same as or different from each other, and are each independently hydrogen; deuterium; a substituted or unsubstituted alkyl group; a substituted or unsubstituted alkoxy group; a substituted or unsubstituted aryl group; or a substituted or unsubstituted heteroaryl group, and
r6 and r7 are each an integer from 1 to 4, and when r6 and r7 are each 2 or higher, two or more substituents in the parenthesis are the same as or different from each other.

In an exemplary embodiment of the present invention, La is a substituted or unsubstituted divalent hydrocarbon ring group having 6 to 30 carbon atoms; or a substituted or unsubstituted divalent heterocyclic group having 2 to 30 carbon atoms.

In an exemplary embodiment of the present invention, La is a divalent hydrocarbon ring group having 6 to 30 carbon atoms, which is unsubstituted or substituted with an alkyl group having 1 to 30 carbon atoms.

In an exemplary embodiment of the present invention, La is any one of the following structures.

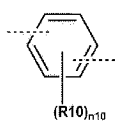 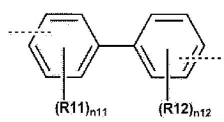 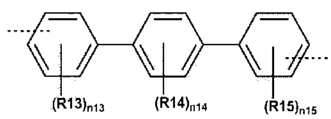

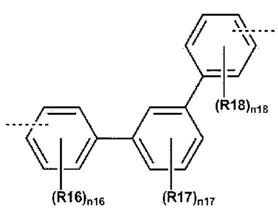 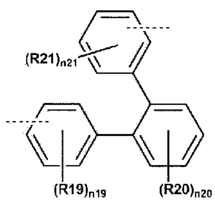 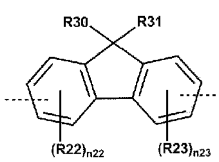

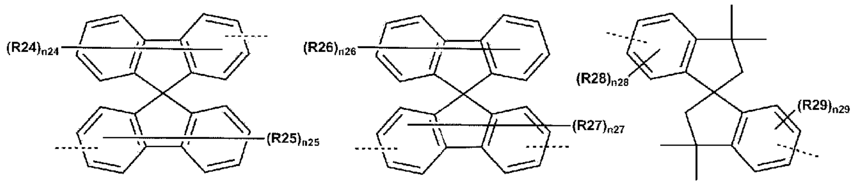

In the structures,

R10 to R31 are the same as or different from each other, and are each independently hydrogen; deuterium; a halogen group; a substituted or unsubstituted alkyl group; a substituted or unsubstituted alkoxy group; a substituted or unsubstituted aryl group; or a substituted or unsubstituted heteroaryl group,

n10 to n21 are each an integer from 1 to 4, n22, n23, n28 and n29 are each an integer from 1 to 3, n24 and n25 are each an integer from 1 to 7, n26 is an integer from 1 to 8, n27 is an integer from 1 to 6, and when n10 to n29 are each 2 or higher, two or more substituents in the parenthesis are the same as or different from each other, and

**------** is a moiety bonded to Chemical Formula 1.

In an exemplary embodiment of the present invention, R10 to R31 are the same as or different from each other, and are each independently hydrogen; deuterium; a halogen group; a substituted or unsubstituted alkyl group having 1 to 20 carbon atoms; a substituted or unsubstituted alkoxy group having 1 to 20 carbon atoms; a substituted or unsubstituted aryl group having 6 to 30 carbon atoms; or a substituted or unsubstituted heteroaryl group having 2 to 30 carbon atoms.

In an exemplary embodiment of the present invention, R10 to R31 are the same as or different from each other, and are each independently hydrogen; deuterium; or a substituted or unsubstituted alkyl group having 1 to 20 carbon atoms.

In an exemplary embodiment of the present invention, R10 to R31 are the same as or different from each other, and are each independently hydrogen; deuterium; or a substituted or unsubstituted alkyl group having 1 to 10 carbon atoms.

In an exemplary embodiment of the present invention, Ar1 and Ar2 are the same as or different from each other, and are each independently a substituted or unsubstituted aryl group having 6 to 30 carbon atoms; or a substituted or unsubstituted heteroaryl group having 2 to 30 carbon atoms.

In an exemplary embodiment of the present invention, Ar1 and Ar2 are the same as or different from each other, and are each independently an aryl group having 6 to 30 carbon atoms, which is unsubstituted or substituted with an alkyl group having 1 to 30 carbon atoms.

In an exemplary embodiment of the present invention, Ar1 and Ar2 are the same as or different from each other, and are each independently a substituted or unsubstituted phenyl group; a substituted or unsubstituted biphenyl group; or a substituted or unsubstituted terphenyl group.

According to an exemplary embodiment of the present invention, f1 is 1 to the number of binding positions in which substituents can be bonded to Ar1, and f2 is 1 to the number of binding positions in which substituents can be bonded to Ar2. As a specific example, the number of binding positions to which the substituent can be bonded means five in which hydrogens are bonded when Ar1 or Ar2 is a phenyl group, and means nine in which hydrogens are bonded when Ar1 or Ar2 is a biphenyl group.

In an exemplary embodiment of the present invention, f1 and f2 are each an integer from 1 to 5.

In an exemplary embodiment of the present invention, $-Ar1-(F)_{f1}$ and $-Ar2-(F)_{f2}$ are the same as or different from each other, and are each independently represented by the following Chemical Formula 1-A.

[Chemical Formula 1-A]

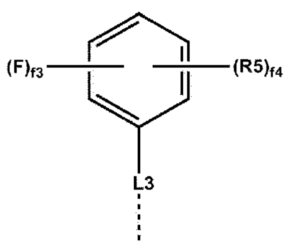

In Chemical Formula 1-A,

R5 is hydrogen; deuterium; or a substituted or unsubstituted alkyl group,
L3 is a direct bond; or a substituted or unsubstituted arylene group,
f3 is an integer from 1 to 5, f4 is an integer from 0 to 4, and f3+f4 is 5 or less, and
------ is a moiety bonded to Chemical Formula 1.

In an exemplary embodiment of the present invention, f3 is 1.
In an exemplary embodiment of the present invention, f3 is 2.
In an exemplary embodiment of the present invention, f3 is 3.
In an exemplary embodiment of the present invention, f3 is 4.
In an exemplary embodiment of the present invention, f3 is 5.
In an exemplary embodiment of the present invention, -Ar1-$(F)_{f1}$ and -Ar2-$(F)_{f2}$ are the same as or different from each other, and are each independently any one of the following structures.

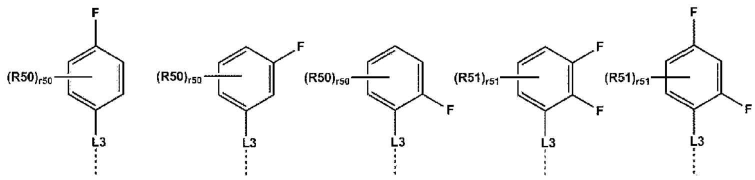

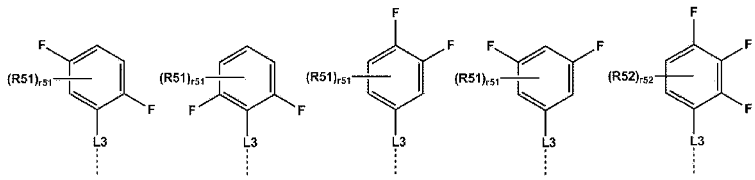

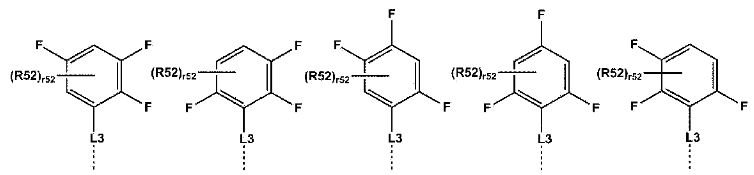

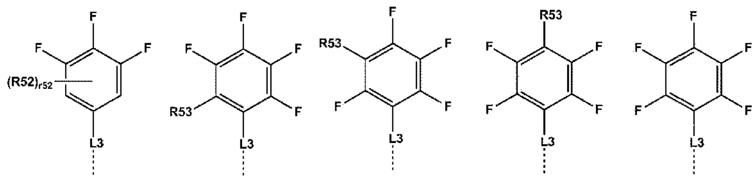

In the structures,

L3 is a direct bond; or a substituted or unsubstituted arylene group,
R50 to R53 are the same as or different from each other, and are each independently hydrogen; deuterium; or an alkyl group,
r50 is an integer from 1 to 4, r51 is an integer from 1 to 3, and r52 is 1 or 2, and
------ is a moiety bonded to Chemical Formula 1.

In an exemplary embodiment of the present invention, L3 is a direct bond; a substituted or unsubstituted phenylene group; or a substituted or unsubstituted biphenylene group.
In an exemplary embodiment of the present invention, L3 is a direct bond; or a substituted or unsubstituted phenylene group.
In an exemplary embodiment of the present invention, L3 is a direct bond; a phenylene group; a phenylene group substituted with an alkyl group; a phenylene group substituted with a halogen group; or a phenylene group substituted with an alkyl group and a halogen group.
In an exemplary embodiment of the present invention, R1 to R4 are the same as or different from each other, and are each independently hydrogen; deuterium; a halogen group; a substituted or unsubstituted alkyl group having 1 to 30

carbon atoms; a substituted or unsubstituted alkoxy group having 1 to 30 carbon atoms; a substituted or unsubstituted aryl group having 6 to 30 carbon atoms; or a substituted or unsubstituted heteroaryl group having 2 to 30 carbon atoms.

In an exemplary embodiment of the present invention, R1 and R2 are each hydrogen; or deuterium.

In an exemplary embodiment of the present invention, R3 and R4 are the same as or different from each other, and are each independently hydrogen; deuterium; or a halogen group.

In an exemplary embodiment of the present invention, R3 and R4 are the same as or different from each other, and are each independently hydrogen; deuterium; or F.

In an exemplary embodiment of the present invention, X1 and X2 are the same as or different from each other, and are each independently any one of the following structures.

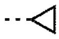
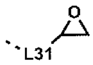
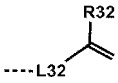
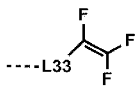
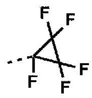
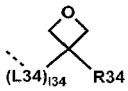

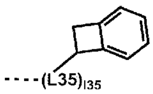
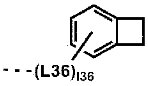
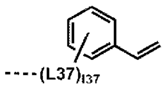
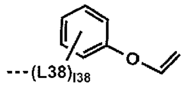

In the structures, L31 to L38, l34 to l38, R32, R34 and ------ are the same as those described above.

In an exemplary embodiment of the present invention, X1 and X2 are the same as or different from each other, and are each independently any one of the following structures.

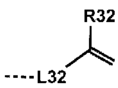
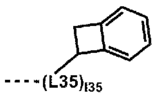
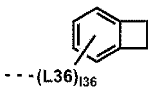
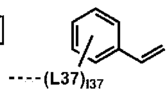
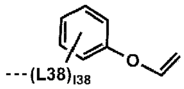

In the structures, R32, L32, L35 to L38, l35 to l38 and ------ are the same as those defined above.

In an exemplary embodiment of the present invention, X1 and X2 are the same as or different from each other, and are each independently

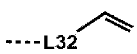 or 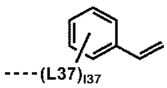 ,

L32 and L37 are the same as or different from each other, and are each independently a direct bond; -O-; or an alkylene group, l37 is an integer from 1 to 5, and ------ is a moiety bonded to Chemical Formula 1.

In an exemplary embodiment of the present invention, X1 and X2 are the same as or different from each other, and are each independently any one of the following structures.

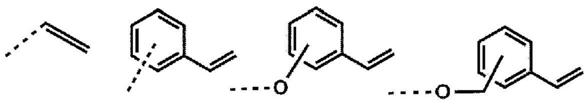

In an exemplary embodiment of the present invention, Chemical Formula 1 is any one of the following structures.

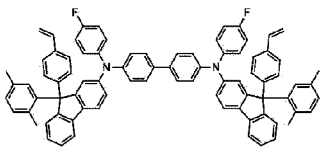
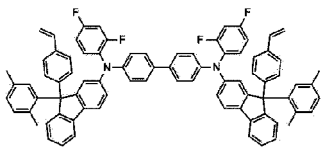
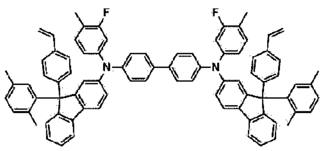

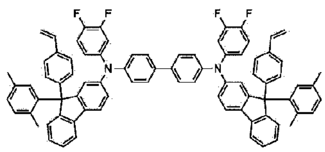
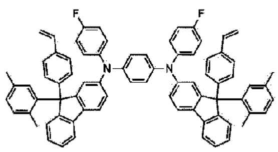
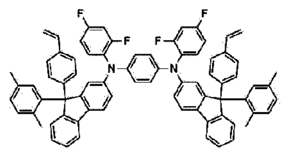

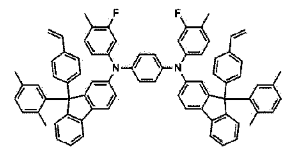
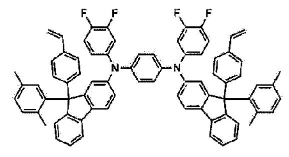
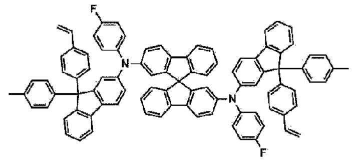

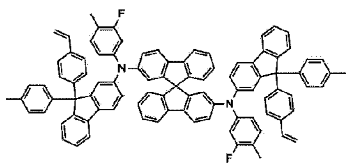
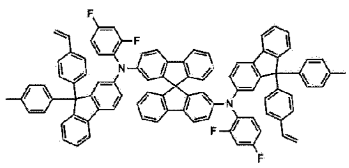
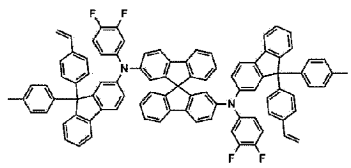

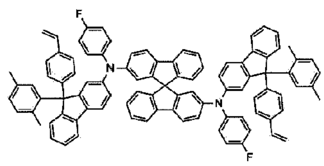
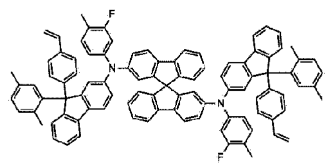
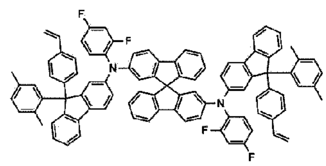

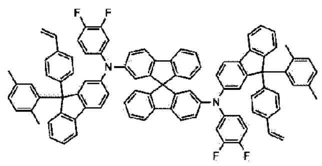
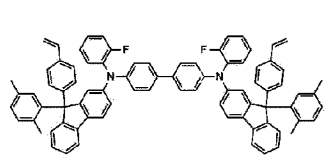
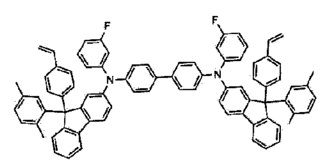

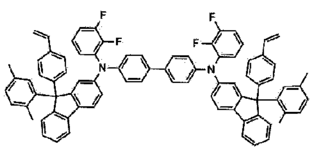
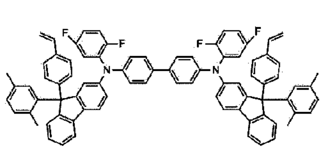
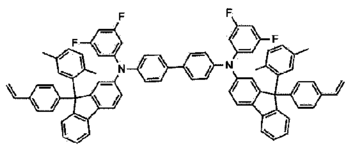

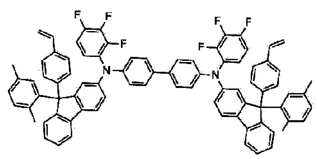
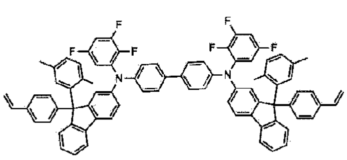
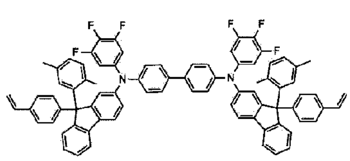

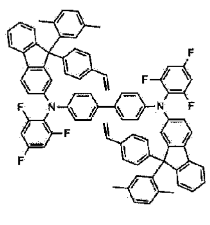
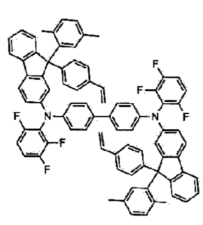
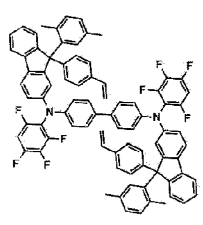
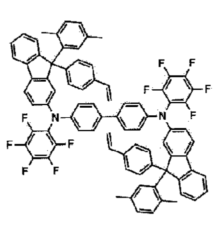

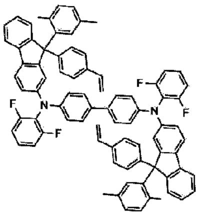

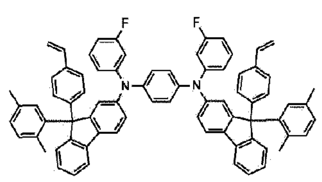
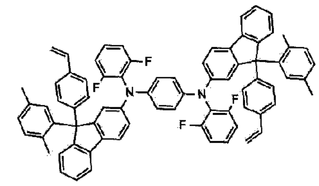
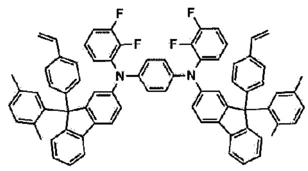

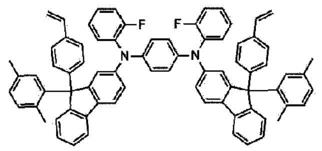
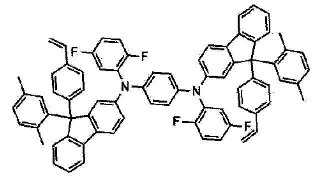
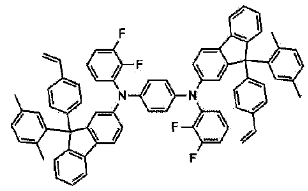

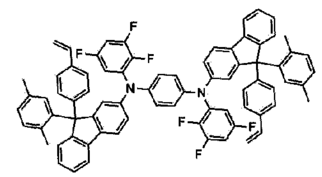
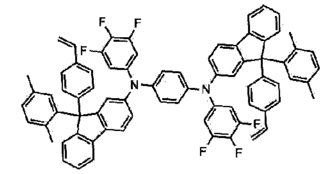
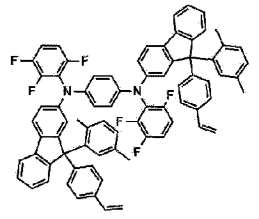

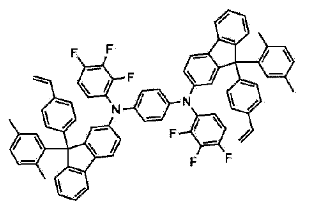
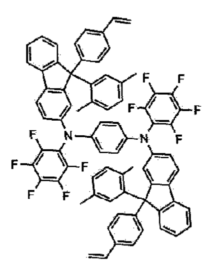
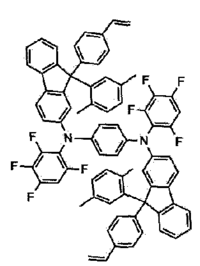
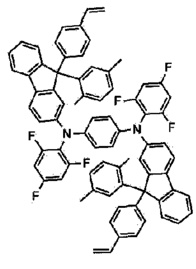

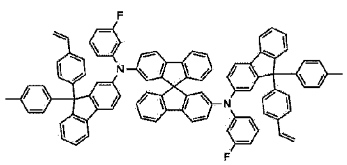
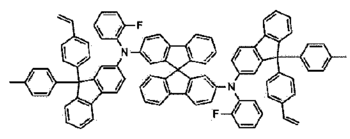
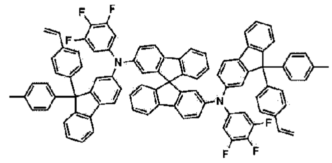

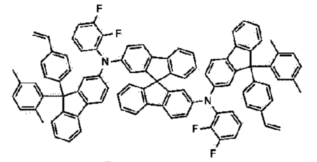
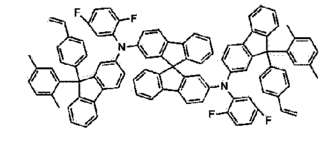
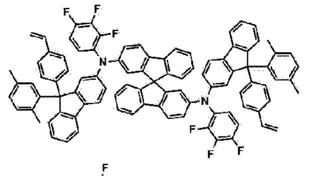

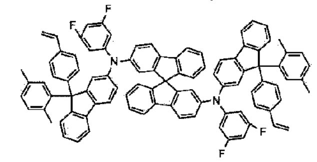
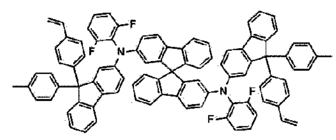
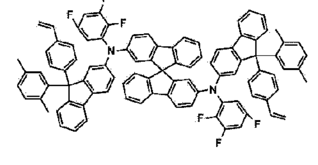

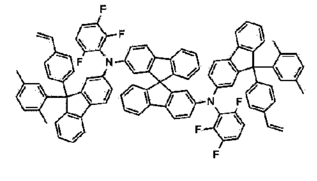
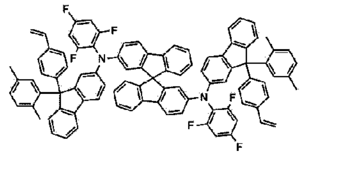
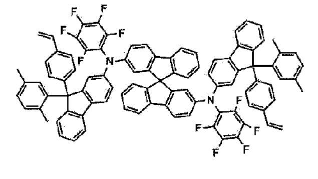

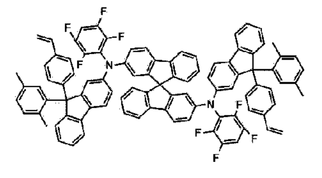
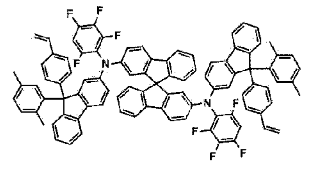
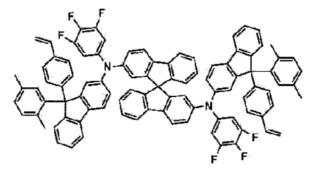

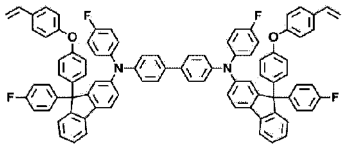
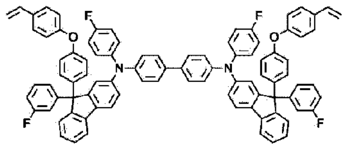
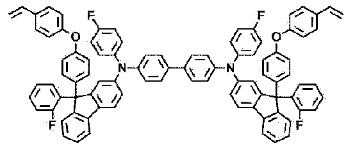

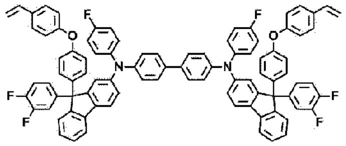
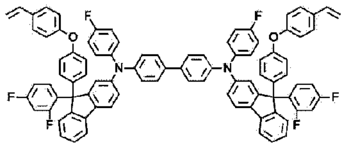
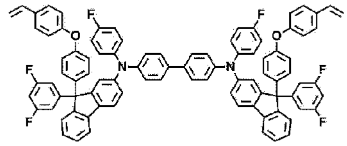

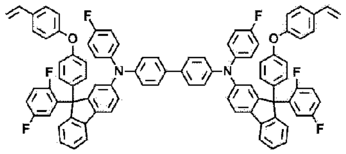
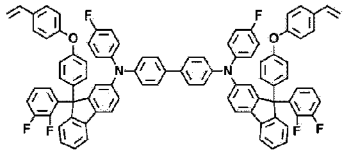
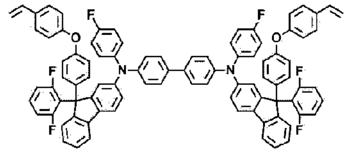

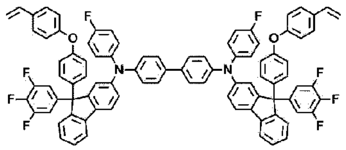
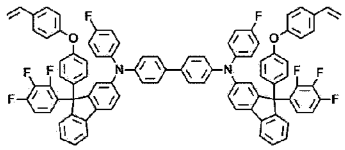
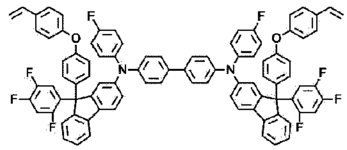

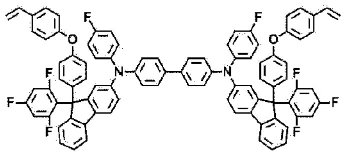
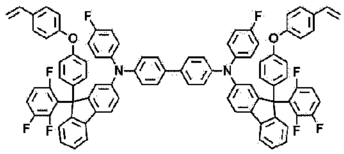
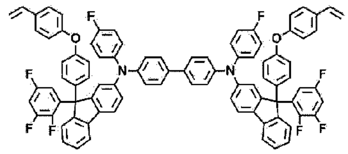

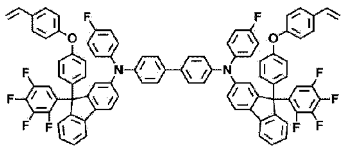
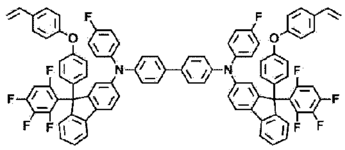
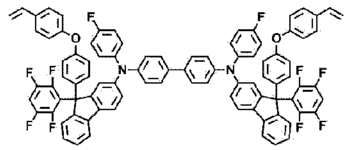

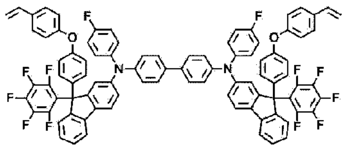

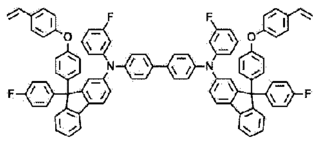
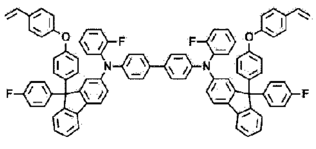
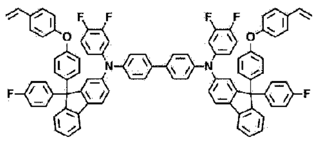

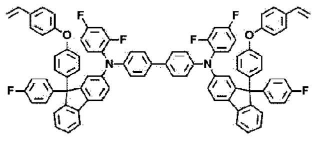 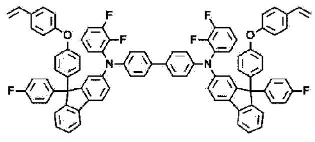 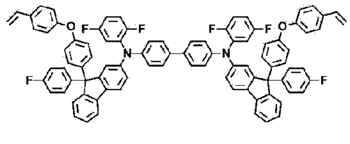

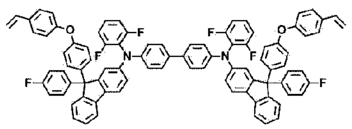 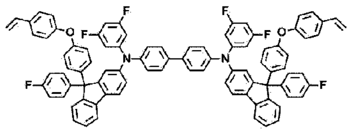 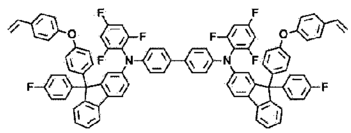

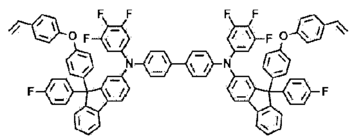 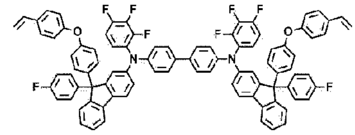 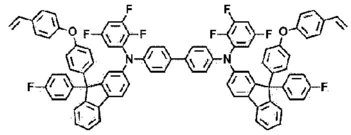

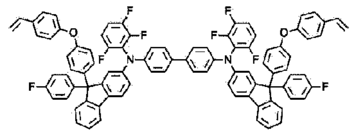 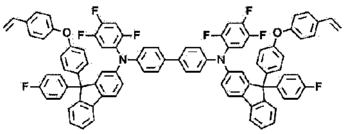 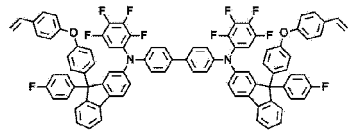

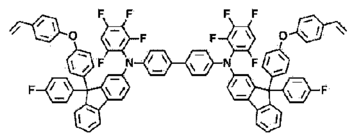 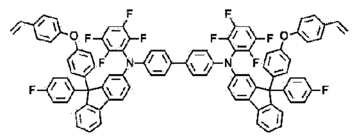 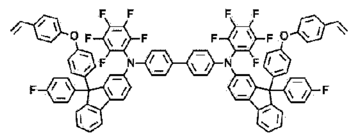

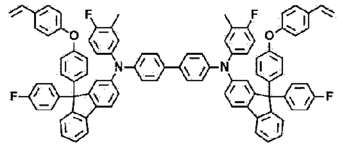 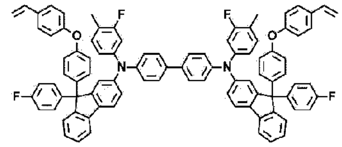 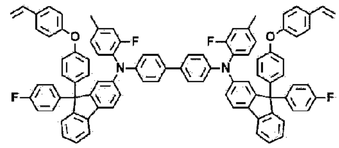

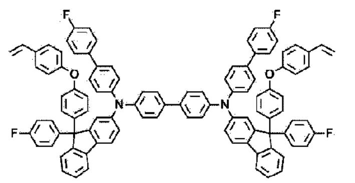 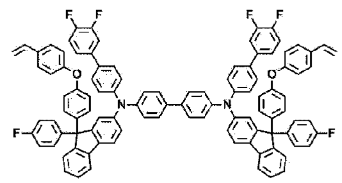 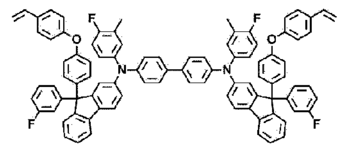

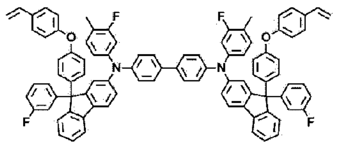 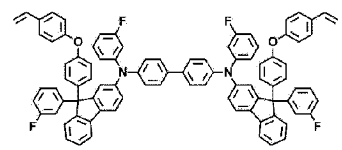 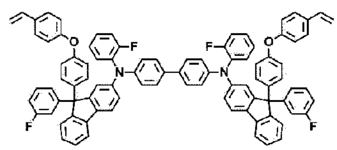

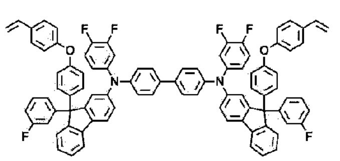 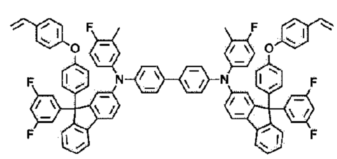 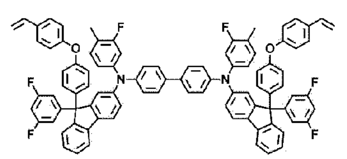

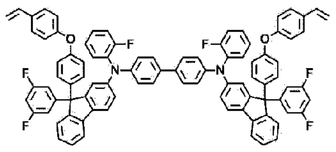 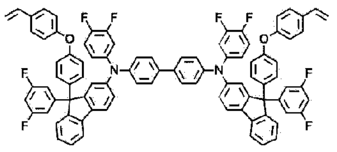 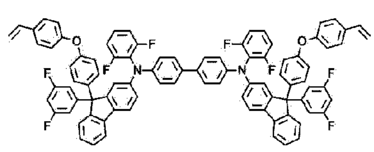

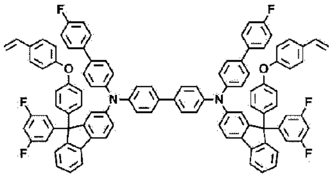 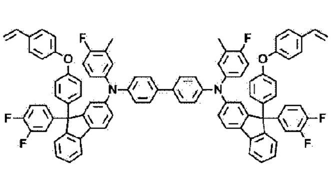 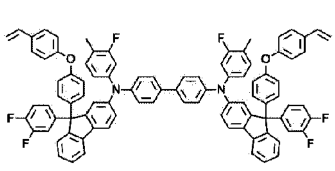

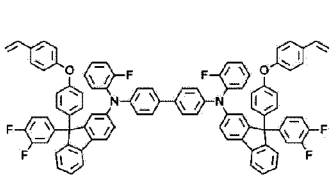 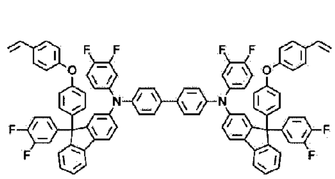 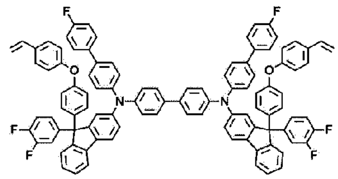

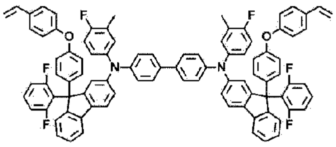 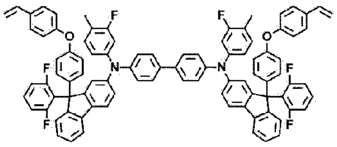 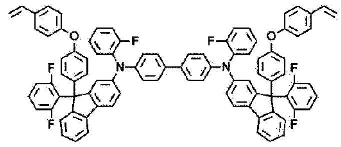

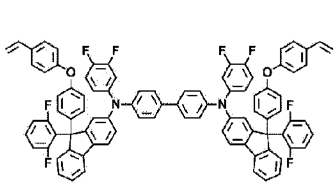 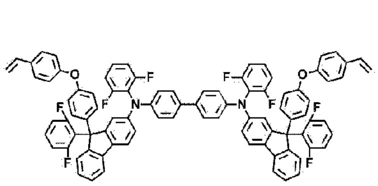 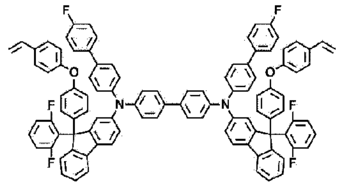

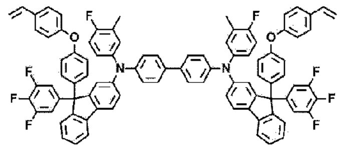 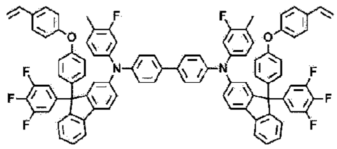 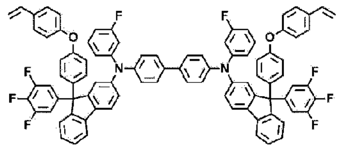

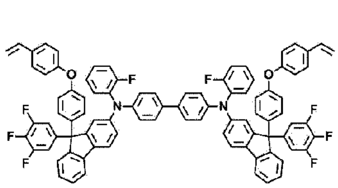 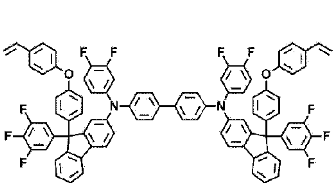 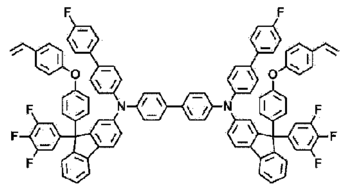

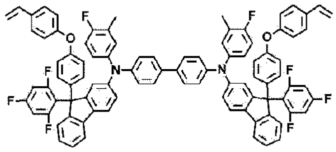 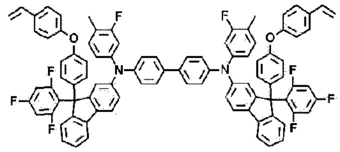 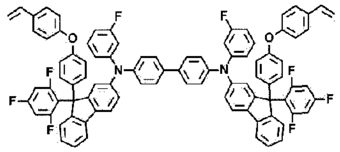

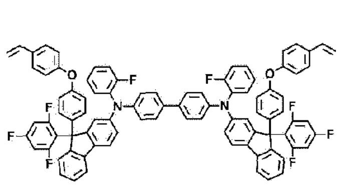
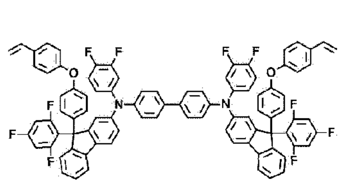
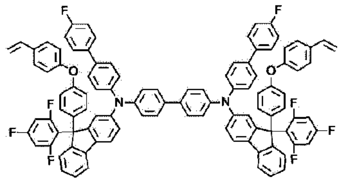

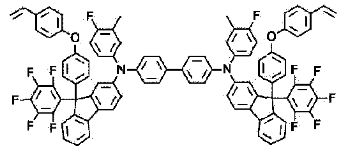
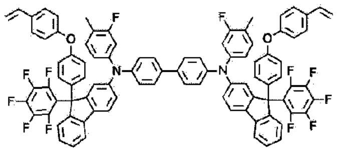
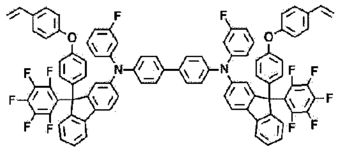

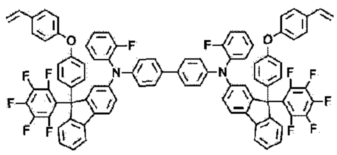
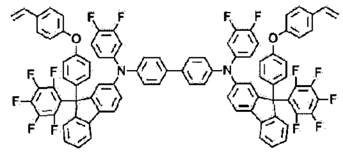
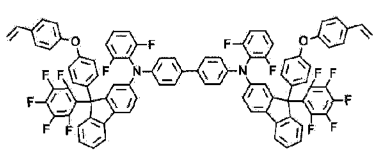

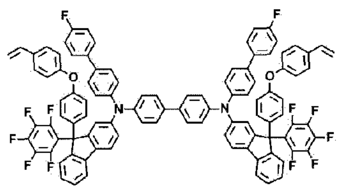

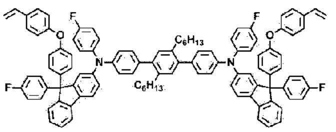
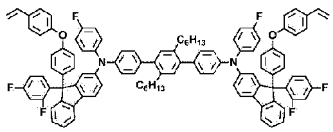
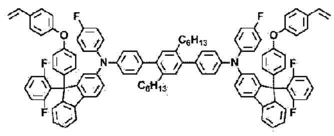

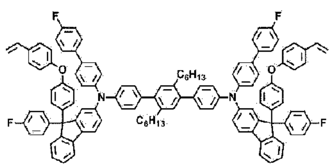
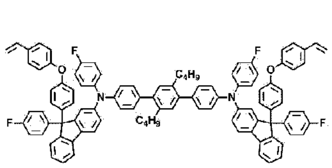
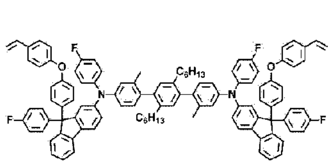

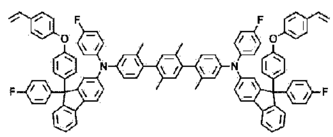
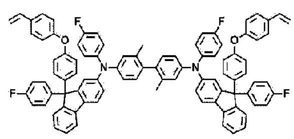
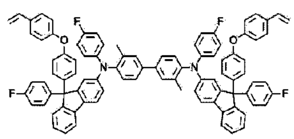

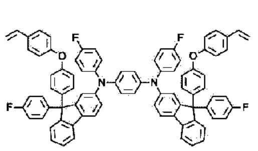
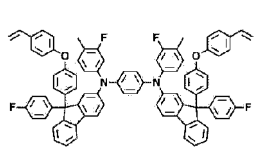
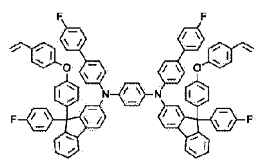

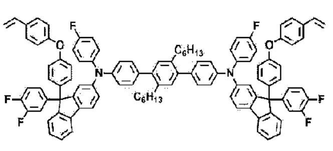
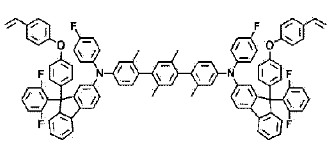

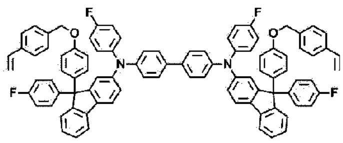
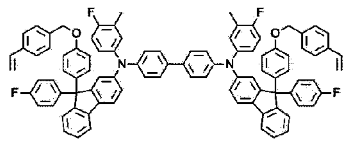
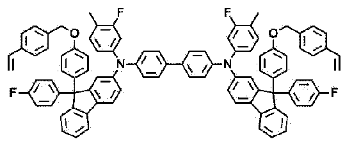
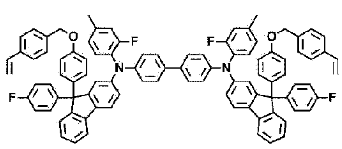
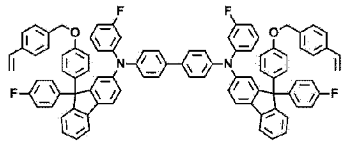
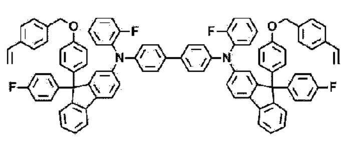
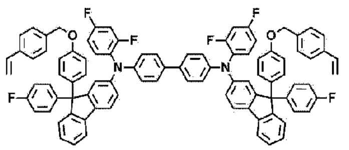
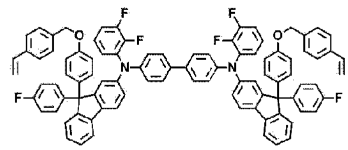
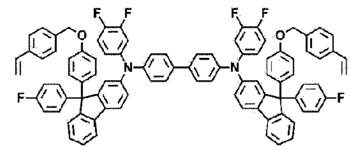
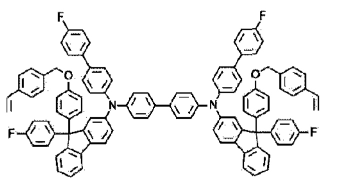
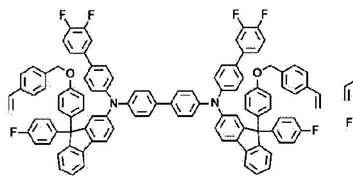
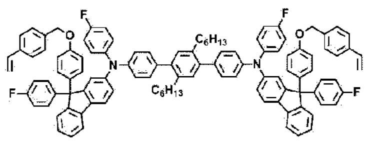
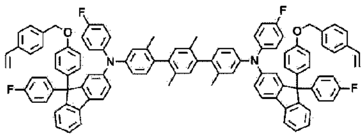
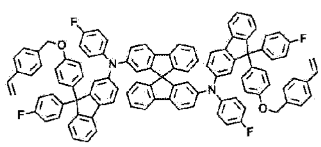
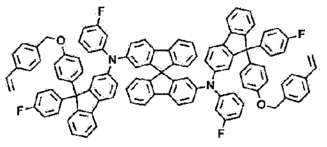
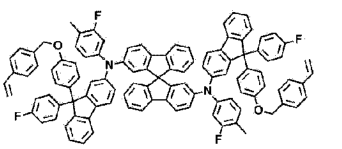
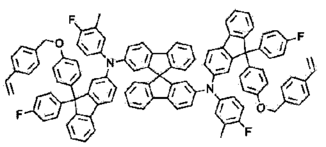
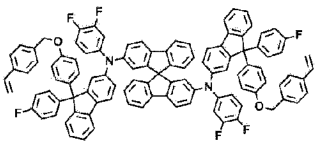
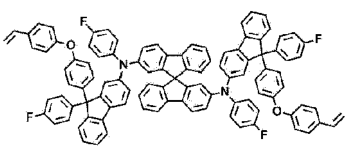
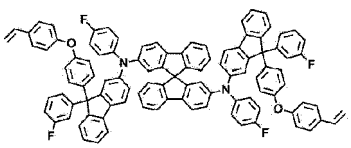
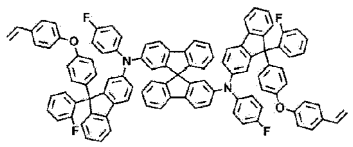
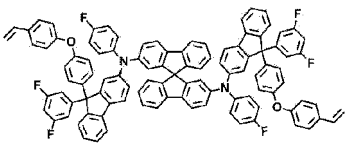
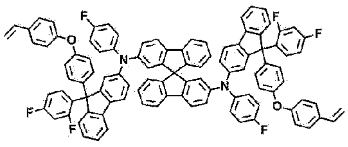
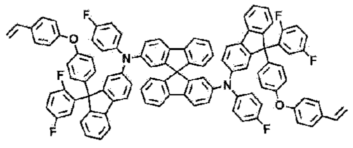
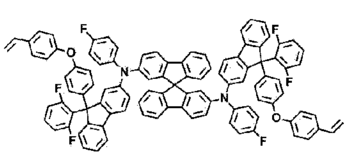
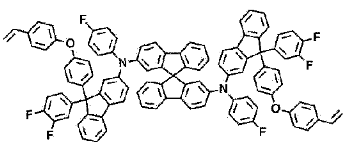
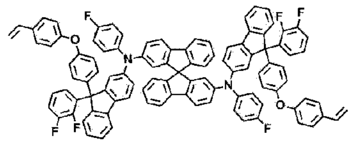

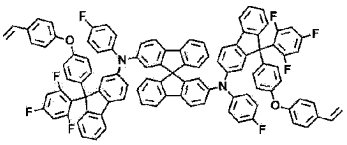
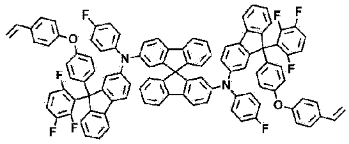
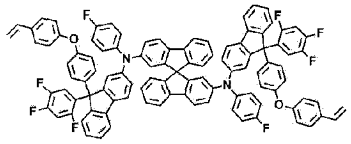
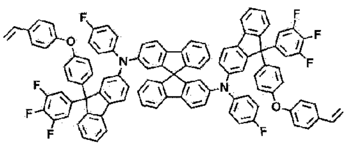
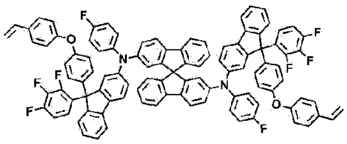
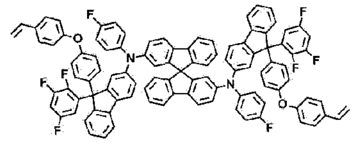
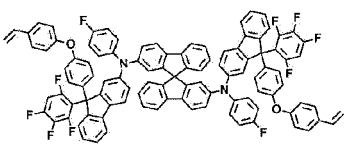
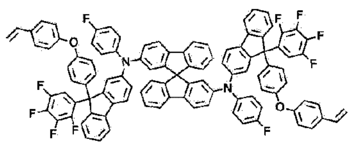
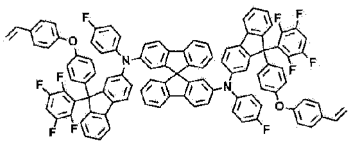
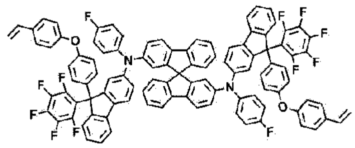
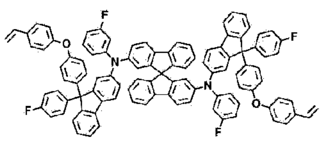
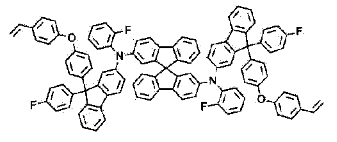
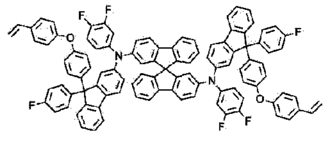
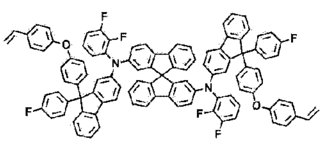
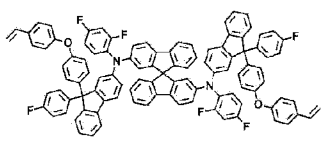
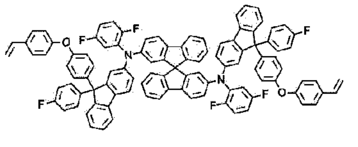
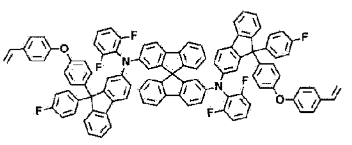
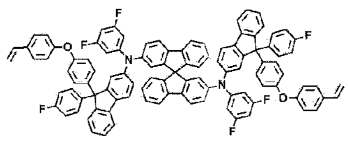
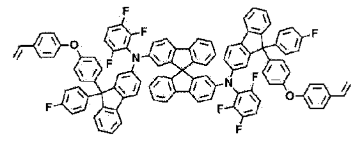
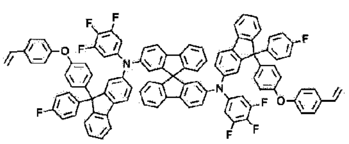
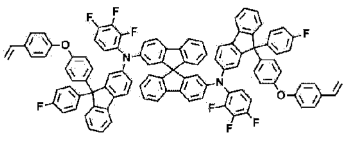
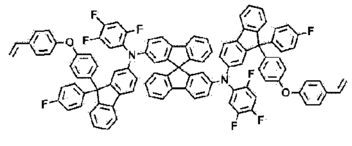
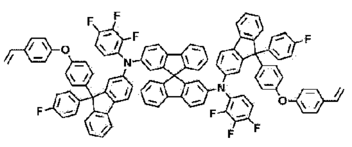
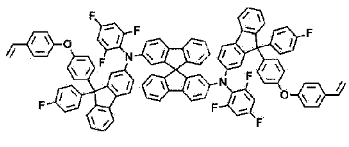
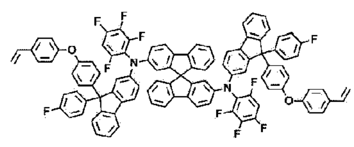

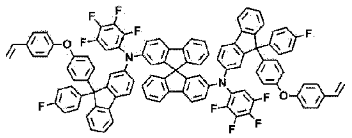 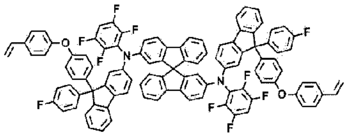 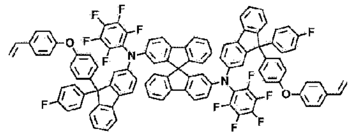

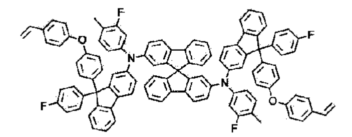 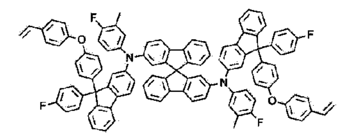 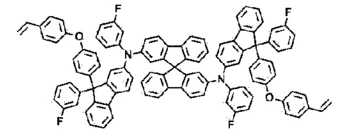

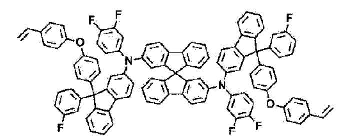 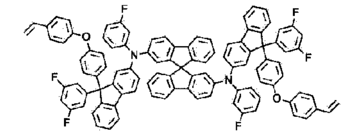 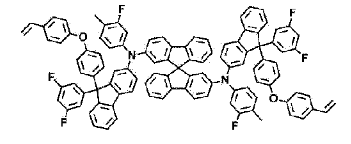

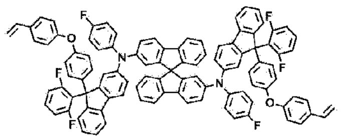 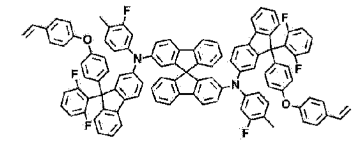 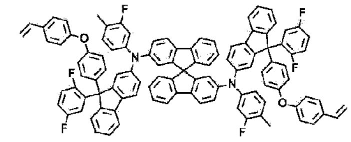

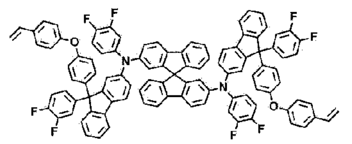 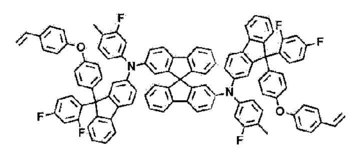 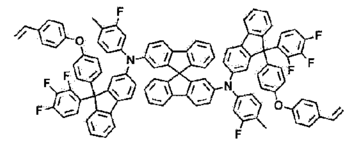

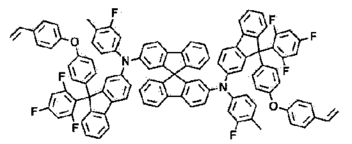 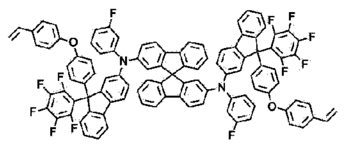 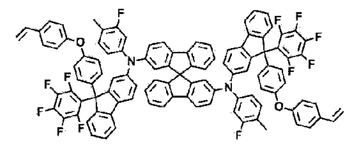

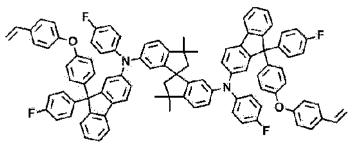 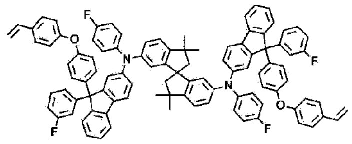 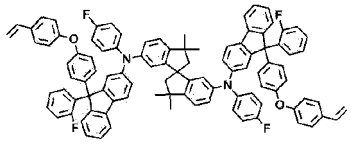

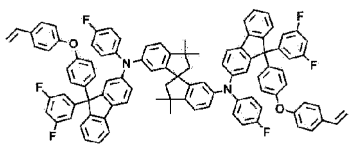 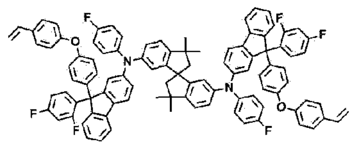 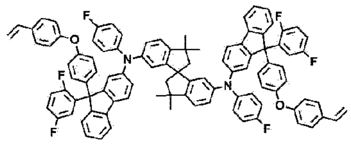

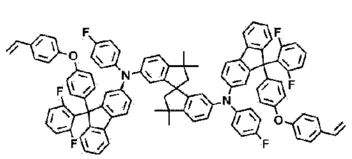 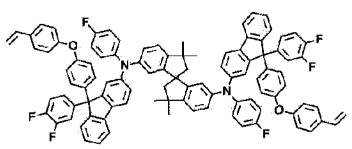 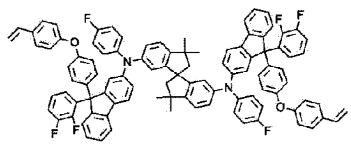

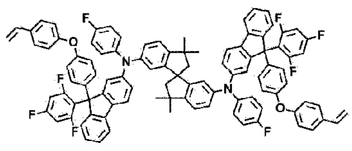
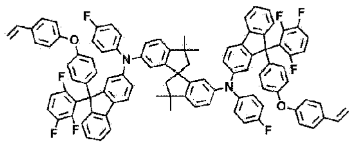
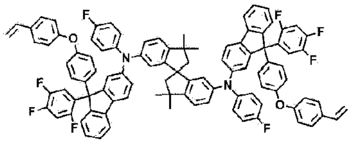
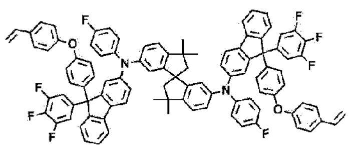
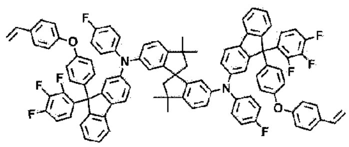
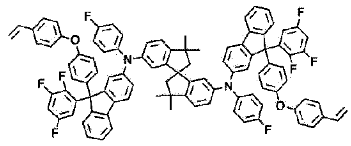
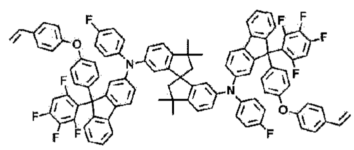
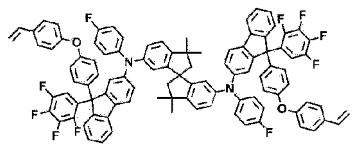
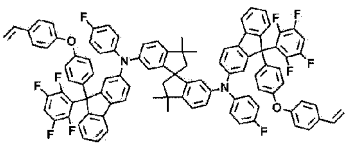
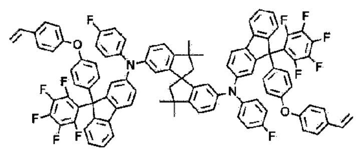
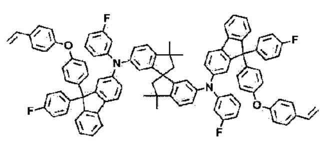
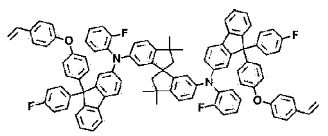
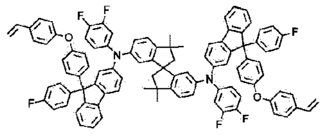
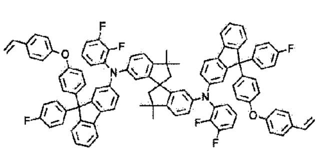
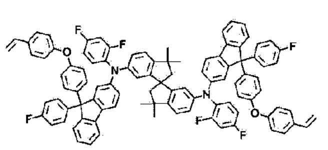
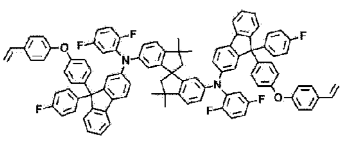
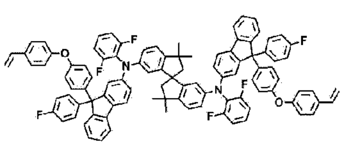
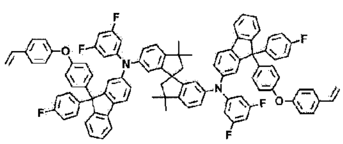
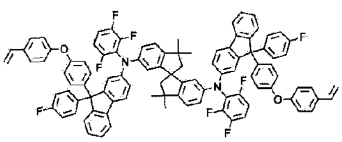
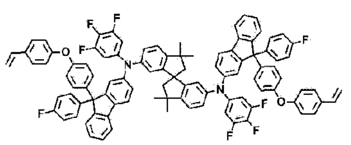
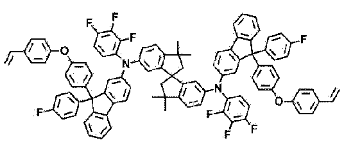
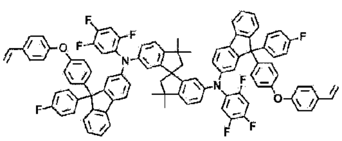
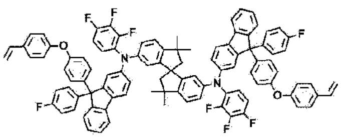
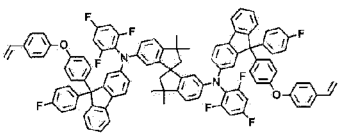
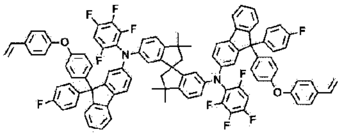

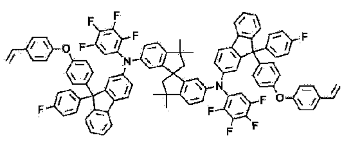
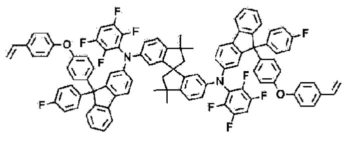
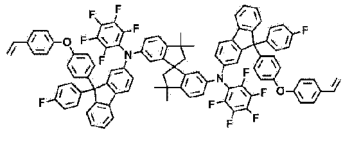

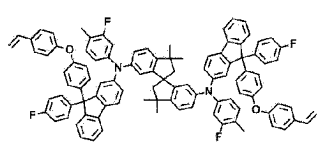
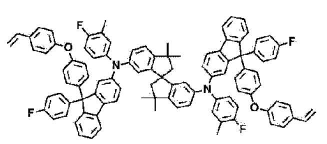
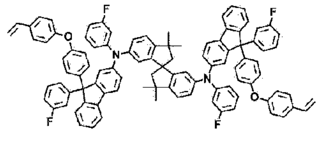

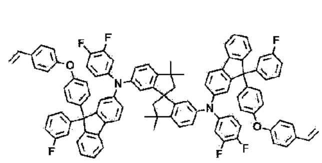
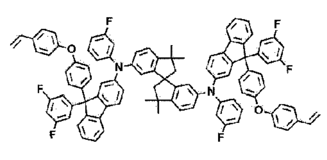
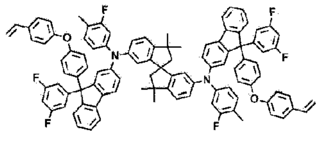

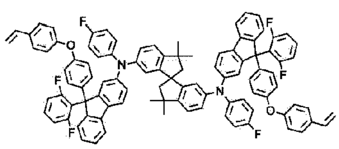
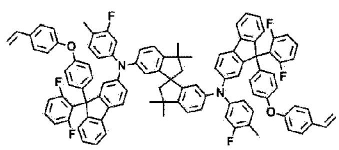
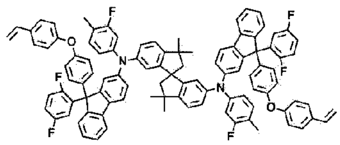

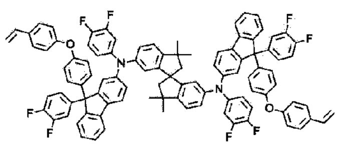
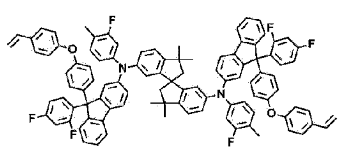
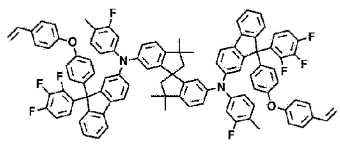

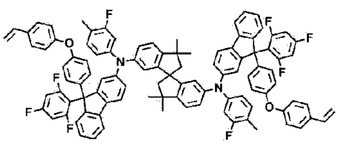
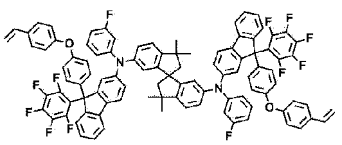
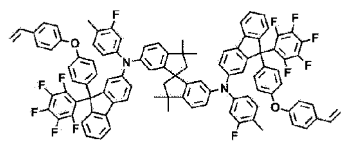

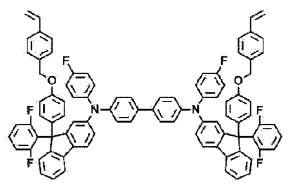

Hereinafter, a first solvent represented by Chemical Formula A and a second solvent represented by Chemical Formula A and different from the first solvent will be specifically described.

The ink composition of the present invention includes the first solvent represented by Chemical Formula A and the second solvent represented by Chemical Formula A and different from the first solvent.

[Chemical Formula A]

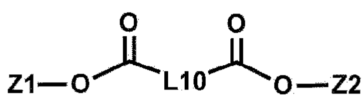

In Chemical Formula A,

L10 is a direct bond; or a substituted or unsubstituted alkylene group, and

Z1 and Z2 are the same as or different from each other, and are each independently a substituted or unsubstituted alkyl group; or a substituted or unsubstituted aryl group.

In an exemplary embodiment of the present invention, L10 is a direct bond; or a substituted or unsubstituted alkylene group having 1 to 30 carbon atoms.

In an exemplary embodiment of the present invention, L10 is a direct bond; or an alkylene group having 1 to 30 carbon atoms, which is unsubstituted or substituted with an alkyl group.

In an exemplary embodiment of the present invention, L10 is a direct bond; or an alkylene group having 1 to 20 carbon atoms, which is unsubstituted or substituted with an alkyl group.

In an exemplary embodiment of the present invention, L10 is a direct bond; or an alkylene group having 1 to 10 carbon atoms, which is unsubstituted or substituted with an alkyl group.

In an exemplary embodiment of the present invention, Z1 and Z2 are the same as or different from each other, and are each independently a substituted or unsubstituted alkyl group.

In an exemplary embodiment of the present invention, Z1 and Z2 are the same as or different from each other, and are each independently a substituted or unsubstituted alkyl group having 1 to 30 carbon atoms.

In an exemplary embodiment of the present invention, Z1 and Z2 are the same as or different from each other, and are each independently an alkyl group.

In an exemplary embodiment of the present invention, Z1 and Z2 are the same as or different from each other, and are each independently an alkyl group having 1 to 30 carbon atoms.

In an exemplary embodiment of the present invention, Z1 and Z2 are the same as or different from each other, and are each independently an alkyl group having 1 to 20 carbon atoms.

In an exemplary embodiment of the present invention, Z1 and Z2 are the same as or different from each other, and are each independently an alkyl group having 1 to 10 carbon atoms.

In an exemplary embodiment of the present invention, Z1 and Z2 are the same as or different from each other, and are each independently a straight-chained or branched alkyl group.

In an exemplary embodiment of the present invention, Z1 and Z2 are the same as or different from each other, and are each independently a straight-chained alkyl group having 1 to 30 carbon atoms; or a branched alkyl group having 3 to 30 carbon atoms.

In an exemplary embodiment of the present invention, Z1 and Z2 are the same as or different from each other, and are each independently a straight-chained alkyl group having 1 to 10 carbon atoms; or a branched alkyl group having 3 to 10 carbon atoms.

In an exemplary embodiment of the present invention, Chemical Formula A is any one of the following structures.

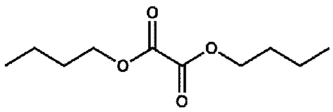
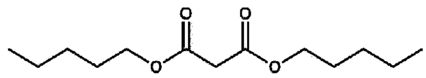
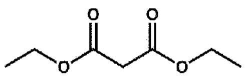
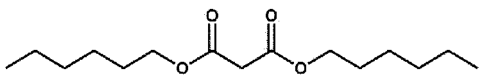
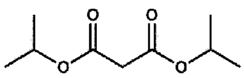
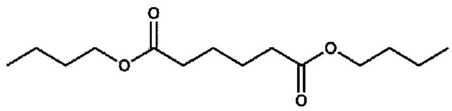
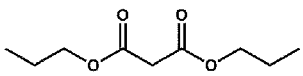
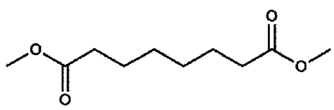
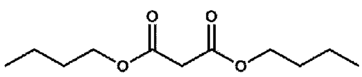
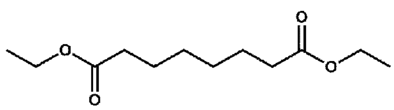

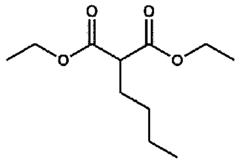
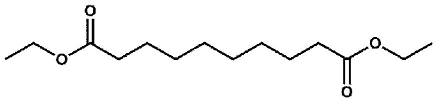
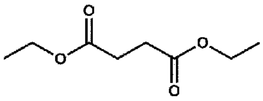
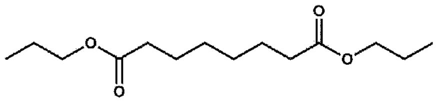
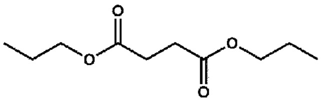
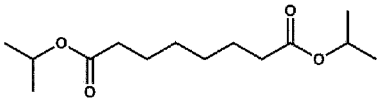
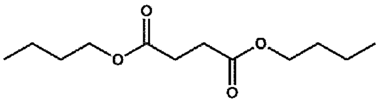
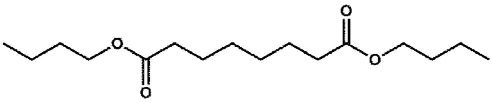
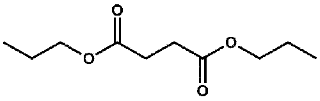
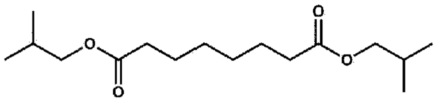
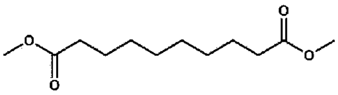
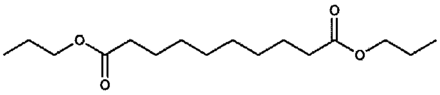
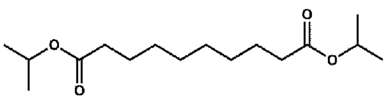
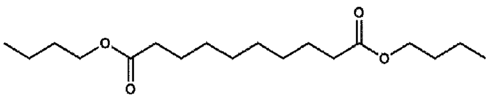
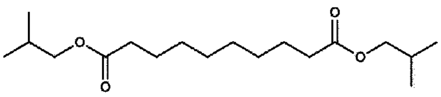

In an exemplary embodiment of the present invention, the first solvent is any one of the structures, and the second solvent is any one of the structures, but is different from the first solvent.

In an exemplary embodiment of the present invention, both the first solvent and the second solvent are represented by Chemical Formula A, and the boiling point of the first solvent is higher than the boiling point of the second solvent.

In an exemplary embodiment of the present invention, the first solvent has a boiling point of 250°C to 350°C, the second solvent has a boiling point of 180°C to 280°C, and the boiling point of the first solvent is higher than the boiling point of the second solvent.

In an exemplary embodiment of the present invention, since the first solvent has the lowest vapor pressure among the constituent solvents, and thus, is not removed in the initial drying step, there is an advantage in that it is possible to adjust the difference in surface tension between materials remaining even after the initial drying step.

In an exemplary embodiment of the present invention, the second solvent imparts a concentration suitable for inkjet printing, and has a high vapor pressure, so that the second solvent prevents the overloading of a vacuum drying device while being partially removed during the initial drying step. In addition, due to its structural similarity to the first solvent, the second solvent has an effect of preventing rapid changes in the flatness of the thin film before and after the initial drying step.

As a result, the ink composition includes the first solvent and the second solvent described above, and thus has an advantage in that the flatness of the manufactured organic material layer and/or the flatness of the pixel are excellent.

In an exemplary embodiment of the present invention, the first solvent has a boiling point of 250°C to 350°C,

260°C to 350°C, or 270°C to 350°C.

In an exemplary embodiment of the present invention, the second solvent has a boiling point of 180°C to 280°C, 180°C to 250°C, or 180°C to 245°C.

In an exemplary embodiment of the present invention, the first solvent has a surface tension of 28 mN/m to 38 mN/m. Specifically, the surface tension is 30 mN/m to 37 mN/m, or 30 mN/m to 36.5 mN/m.

In an exemplary embodiment of the present invention, the second solvent has a surface tension of 25 mN/m to 35 mN/m. Specifically, the surface tension is 27 mN/m to 35 mN/m.

As the surface tension of the first solvent is limited, the range of surface tension between materials other than the first solvent may be easily adjusted. Specifically, the materials included in the ink compositions used in the solution process (for example, the second solvent, an additional solvent, and the like) typically have surface tension values ranging from 25 mN/m to 45 mN/m. When small amounts of the first and second solvents remain after ink drying, it is preferred that the difference in surface tension between first and second solvents is small because there is a concern in that a thin film to be finally formed may become non-uniform when the difference in surface tension between the first and second solvents is large. A surface tension in a range of 28 mN/m to 38 mN/m is close to the median value of the surface tension range from 25 mN/m to 45 mN/m, which the surface tension values of the typical organic solvents, and accordingly, when the first solvent has a surface tension in a range of 28 mN/m to 38 mN/m, the difference in surface tension between materials other than the first solvent represented by Chemical Formula A may be adjusted so as to be small.

In an exemplary embodiment of the present invention, the ink composition further includes a third solvent different from the first solvent and the second solvent.

In an exemplary embodiment of the present invention, the third solvent is different from the first solvent and the second solvent, and includes one or more of the solvent represented by Chemical Formula A; a solvent represented by the following Chemical Formula B; tetralin; 4-methoxytoluene; tripropylene glycol monobutyl ether; and cyclohexylbenzene.

[Chemical Formula B]

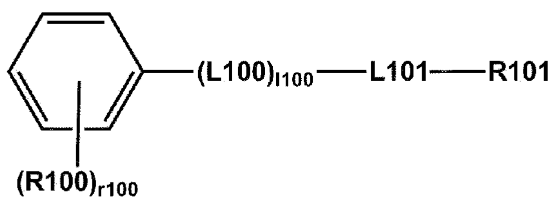

In Chemical Formula B,

L100 is an alkylene group,
L101 is -COO-,
R100 is hydrogen; or a substituted or unsubstituted alkyl group,
R101 is a substituted or unsubstituted alkyl group,
l100 is 0 or 1, and
r100 is an integer from 1 to 5, and when r100 is 2 or higher, substituents in the parenthesis are the same as or different from each other.

In an exemplary embodiment of the present invention, l100 is 0.

In an exemplary embodiment of the present invention, R100 is hydrogen; or an alkyl group having 1 to 10 carbon atoms.

In an exemplary embodiment of the present invention, R101 is an alkyl group having 1 to 30 carbon atoms.

In an exemplary embodiment of the present invention, the third solvent is different from the first solvent and the second solvent, and includes one or more of the solvent represented by Chemical Formula A; butylbenzoate; isobutylbenzoate; ethyl 4-methylbenzoate; amyl benzoate; isoamyl benzoate; tetralin; 4-methoxytoluene; tripropylene glycol monobutyl ether; and cyclohexylbenzene.

In an exemplary embodiment of the present invention, the third solvent is a mixture of one to five of the above-described solvents, a mixture of one to three of the above-described solvents, or one solvent.

In an exemplary embodiment of the present invention, the third solvent has a boiling point of 180°C to 250°C.

In an exemplary embodiment of the present invention, the third solvent has a surface tension of 30 mN/m to 37 mN/m.

In an exemplary embodiment of the present invention, the ink composition includes a first solvent, a second solvent, and a third solvent, which are different from one another. In this case, the first solvent has the highest boiling point, the second solvent has an intermediate boiling point, and the third solvent has the lowest boiling point.

Hereinafter, an ionic compound including an anionic group represented by Chemical Formula 2 will be specifically described.

In an exemplary embodiment of the present invention, the ink composition further includes an ionic compound including an anionic group represented by the following Chemical Formula 2.

[Chemical Formula 2]

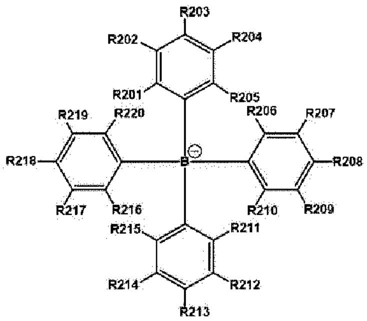

In Chemical Formula 2,

at least one of R201 to R220 is **F;** a cyano group; or a substituted or unsubstituted fluoroalkyl group,
at least one of the other R201 to R220 is a curable group,
the other R201 to R220 are the same as or different from each other, and are each independently hydrogen; deuterium; a halogen group; a nitro group; a cyano group; an amino group; -OR221; -SR222; -$SO_3$R223; -COOR224; -OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group, and
R221 to R228 are the same as or different from each other, and are each independently hydrogen; deuterium; or a substituted or unsubstituted alkyl group.

A curable group is introduced into the ionic compound including an anionic group, which is represented by Chemical Formula 2 (hereinafter referred to as an anionic group compound) according to an exemplary embodiment of the present invention. In contrast, when a curable group is not introduced, the ionic compound is not cured, so that the characteristics of a device are reduced due to the migration of the ionic compound between electrodes or layers. Meanwhile, when the number of curable groups increases, the curing rate of the ionic compound or the composition including the same increases, and the film retention rate is improved.

In an exemplary embodiment of the present invention, the number of curable groups of the anionic group compound is 1.

In an exemplary embodiment of the present invention, the number of curable groups of the anionic group compound is 2.

In an exemplary embodiment of the present invention, the number of curable groups of the anionic group compound is 4.

In an exemplary embodiment of the present invention, the number of F's, cyano groups, or substituted or unsubstituted fluoroalkyl groups of the anionic group compound is 16 to 19.

In an exemplary embodiment of the present invention, based on 100 parts by weight of the anionic group compound, the part by weight of F in the anionic group compound is 15 parts by weight to 50 parts by weight.

In an exemplary embodiment of the present invention, based on 100 parts by weight of the anionic group compound, the part by weight of F in the anionic group compound is 10 parts by weight to 45 parts by weight.

In an exemplary embodiment of the present invention, based on 100 parts by weight of the anionic group compound, the number of F's in the anionic group compound is 8 to 20.

As described above, when the ratio of F, the cyano group, or the fluoroalkyl group in the molecule is increased, the film retention rate during heat treatment is improved.

According to an exemplary embodiment of the present invention, the ionic compound may be used in the hole injection layer of the organic light emitting device. Specifically, the ionic compound may be used as the dopant of a hole injection layer. In this case, when the content of F of the ionic compound is increased, the force of attracting electrons from another compound (host compound) is increased, and holes are more proficiently produced in the host, so that the performance in the hole injection layer is improved.

In an exemplary embodiment of the present invention, the content of F may be analyzed using COSA AQF-100 combustion furnace coupled to a Dionex ICS 2000 ion-chromatograph, or may be confirmed through 19F NMR which is a method generally used in the F analysis.

In an exemplary embodiment of the present invention, at least one benzene ring of a benzene ring including R201 to R205, a benzene ring including R206 to R210, a benzene ring including R211 to R215, and a benzene ring including R216 to R220 in Chemical Formula 2 is selected from the following structural formulae.

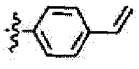
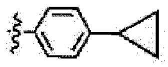
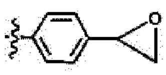
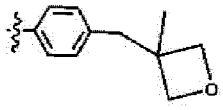
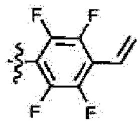
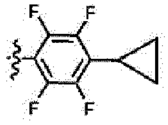
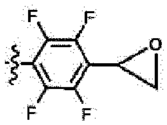
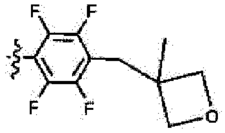
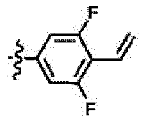
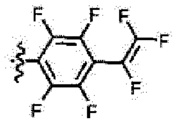
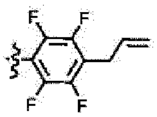
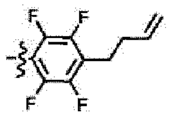
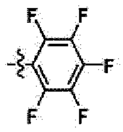
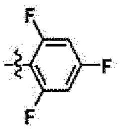
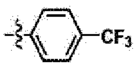
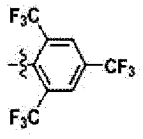
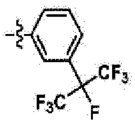
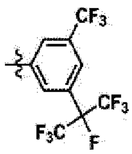
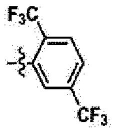
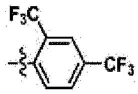
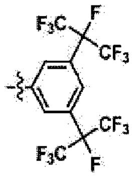
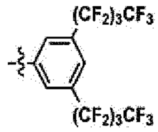

In an exemplary embodiment of the present invention, Chemical Formula 2 is any one of the following structures.

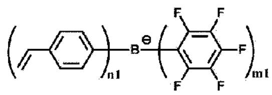
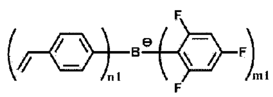
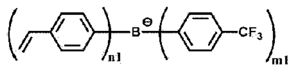
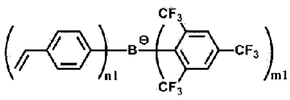
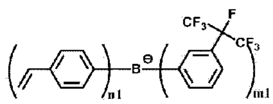
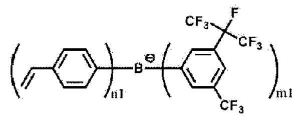
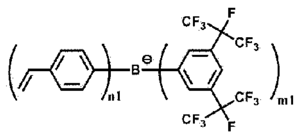
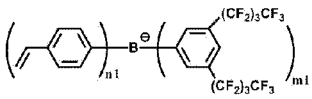
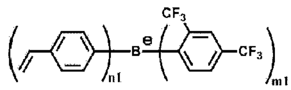
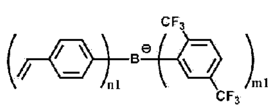
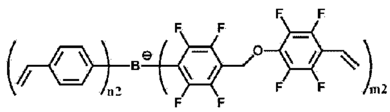

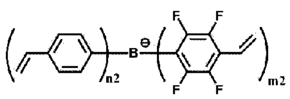
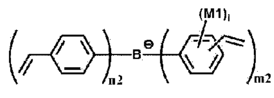
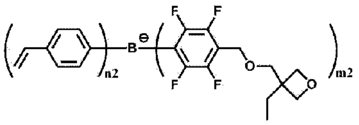

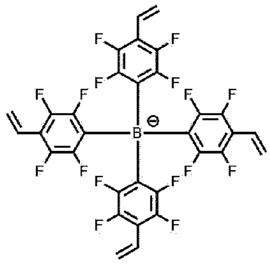
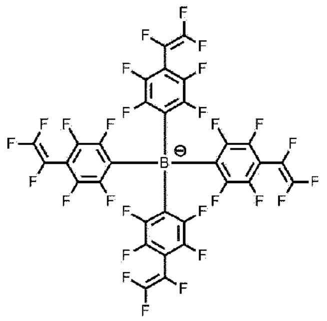
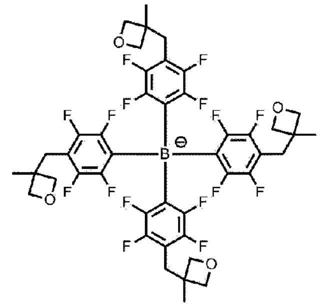

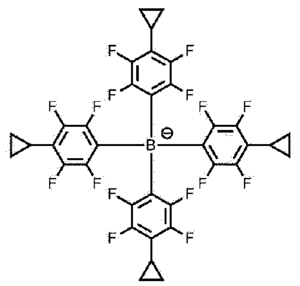
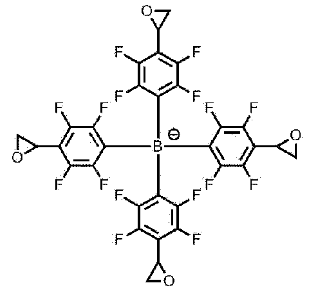

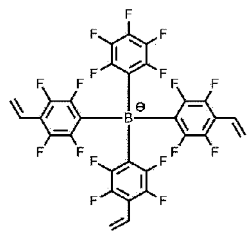
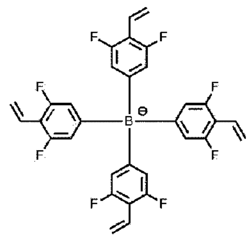
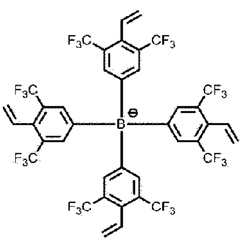

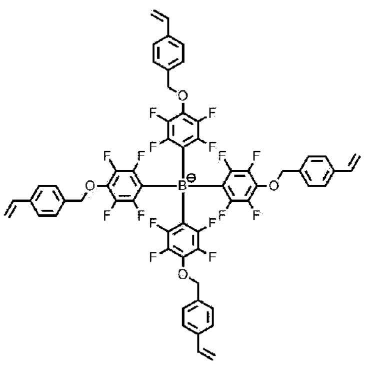
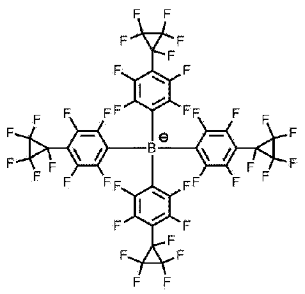
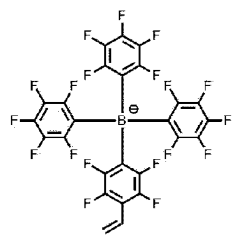

In the structures,

n1 is an integer from 1 to 3, m1 is an integer from 1 to 3, and n1+m1=4,
n2 is an integer from 0 to 3, m2 is an integer from 1 to 4, and n2+m2=4,
M1 is deuterium; a halogen group; a nitro group; a cyano group; an amino group; -OR221; -SR222; -$SO_3$R223; -COOR224; -OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group,

R221 to R228 are the same as or different from each other, and are each independently hydrogen; deuterium; or a substituted or unsubstituted alkyl group, and

i is an integer from 1 to 4, and when i is 2 or higher, two or more M1's are the same as or different from each other.

In an exemplary embodiment of the present invention, the ionic compound further includes a cationic group. Specifically, the above-described ink composition further includes an ionic compound including the anionic group represented by the above-described Chemical Formula 2 and the cationic group.

In an exemplary embodiment of the present invention, the ionic compound further includes a cationic group, and the cationic group is a monovalent cationic group, an onium compound or any one of the following structures.

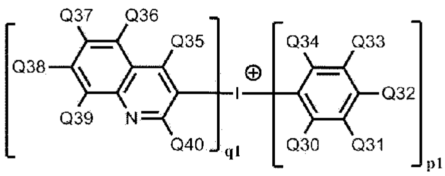

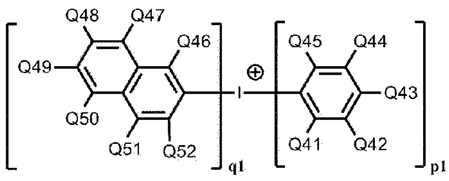

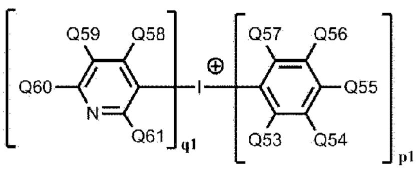

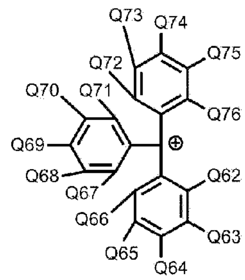

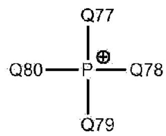

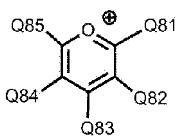

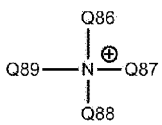

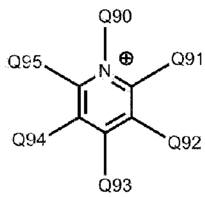

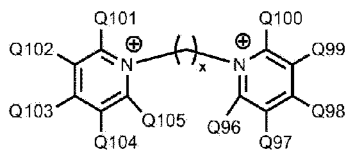

In the structures,

Q30 to Q105 are the same as or different from each other, and are each independently hydrogen; deuterium; a cyano group; a nitro group; a halogen group; a hydroxyl group; -COOR250; a substituted or unsubstituted alkyl group; a substituted or unsubstituted alkoxy group; a substituted or unsubstituted aryloxy group; a substituted or unsubstituted cycloalkyl group; a substituted or unsubstituted aryl group; or a curable group,

R250 is hydrogen; deuterium; or a substituted or unsubstituted alkyl group,

x is an integer from 0 to 10, and

p1 is 1 or 2, q1 is 0 or 1 and p1+q1=2.

In an exemplary embodiment of the present invention, the monovalent cationic group may be an alkali metal cation, and examples of the alkali metal cation include $Na^+$, $Li^+$, $K^+$, and the like, but are not limited thereto.

In an exemplary embodiment of the present invention, the cationic group is an onium compound, or any one selected from the above-described structural formulae.

In an exemplary embodiment of the present invention, the cationic group is any one of the following structures.

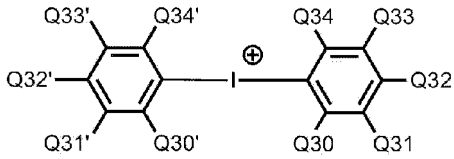
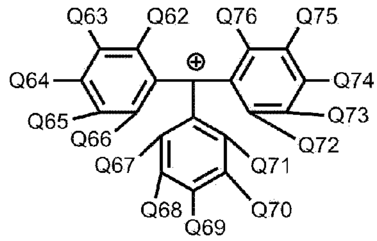

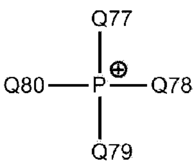
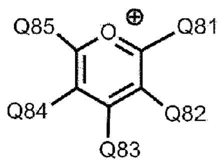
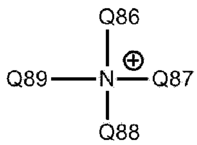
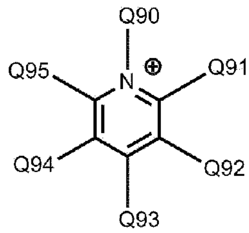

In the structures,

Q30 to Q34, Q30' to Q34' and Q62 to Q95 are the same as or different from each other, and are each hydrogen; deuterium; a cyano group; a nitro group; a halogen group; a hydroxyl group; -COOR250; a substituted or unsubstituted alkyl group; a substituted or unsubstituted alkoxy group; a substituted or unsubstituted aryloxy group; a substituted or unsubstituted cycloalkyl group; a substituted or unsubstituted aryl group; or a curable group, and
R250 is hydrogen; deuterium; or a substituted or unsubstituted alkyl group.

In an exemplary embodiment of the present invention, the cationic group is any one of the following structures.

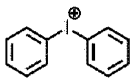
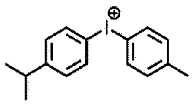
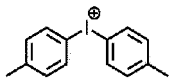
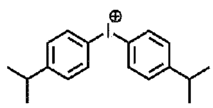

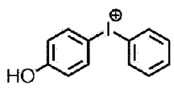
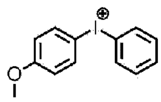
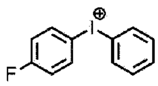
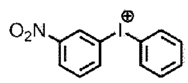

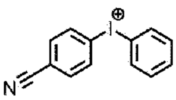
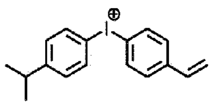
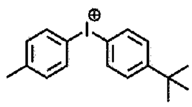
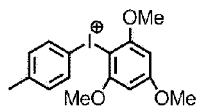

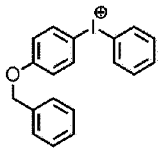
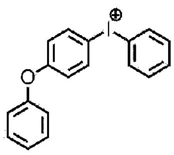
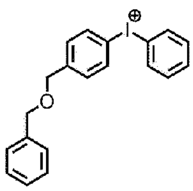
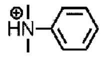
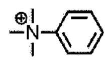

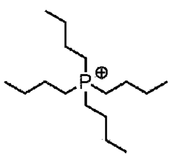
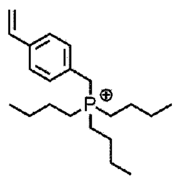
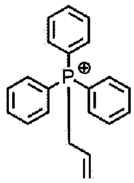
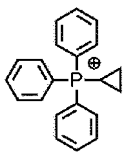
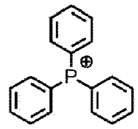

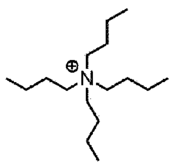

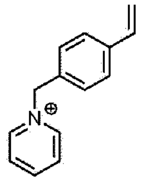

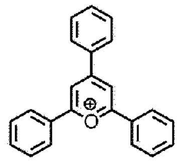

In an exemplary embodiment of the present invention, the ionic compound is any one of the following Chemical Formulae D-1 to D-37.

[Chemical Formula D-1]

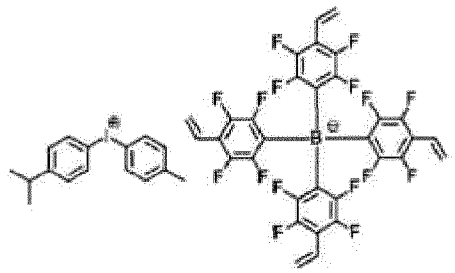

[Chemical Formula D-2]

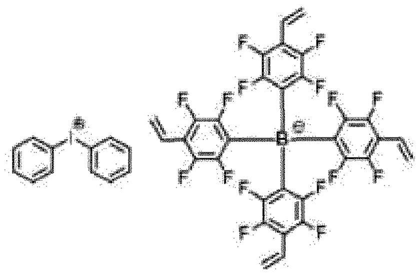

[Chemical Formula D-3]

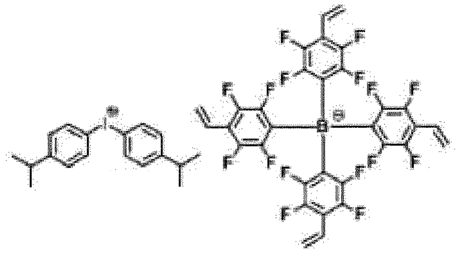

[Chemical Formula D-4]

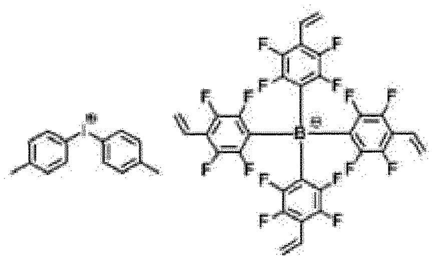

[Chemical Formula D-5]

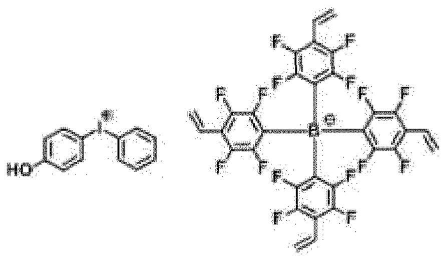

[Chemical Formula D-6]

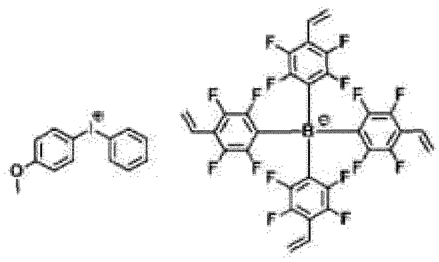

[Chemical Formula D-7]

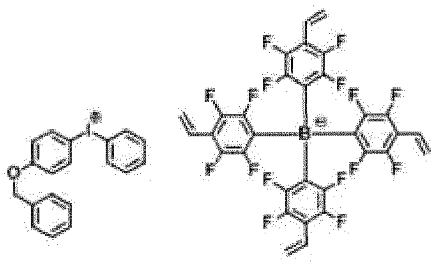

[Chemical Formula D-8]

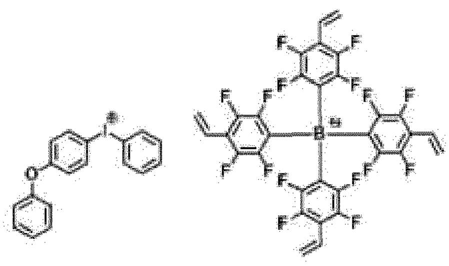

[Chemical Formula D-9]

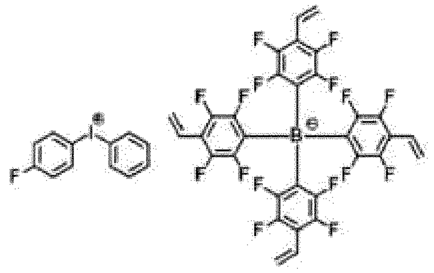

[Chemical Formula D-10]

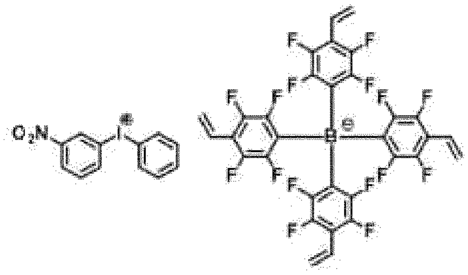

[Chemical Formula D-11]

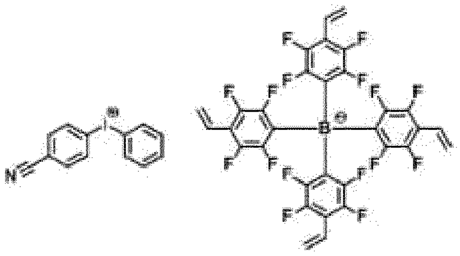

[Chemical Formula D-12]

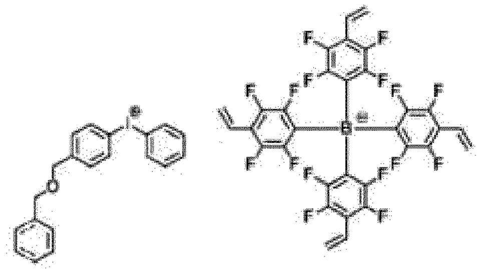

[Chemical Formula D-13]

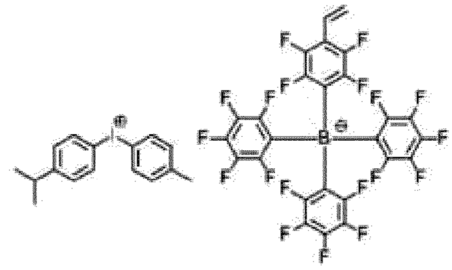

[Chemical Formula D-14]

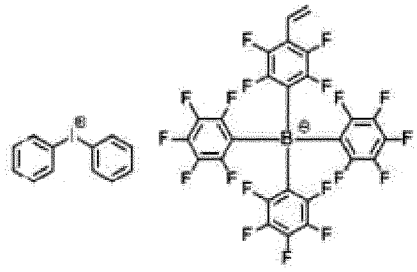

[Chemical Formula D-15]

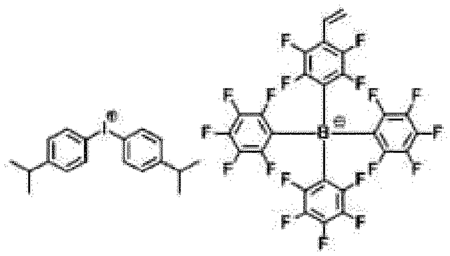

[Chemical Formula D-16]

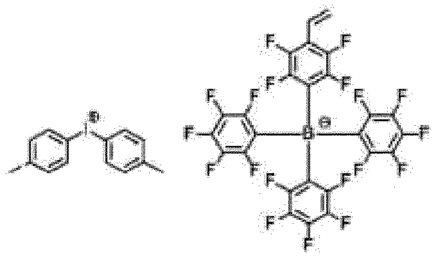

[Chemical Formula D-17]

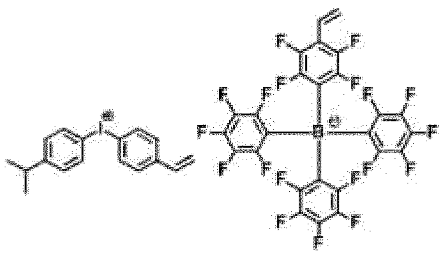

[Chemical Formula D-18]

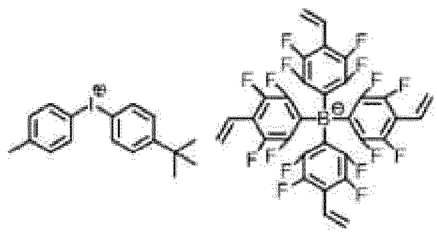

[Chemical Formula D-19]

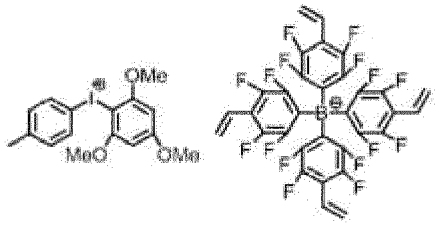

[Chemical Formula D-20]

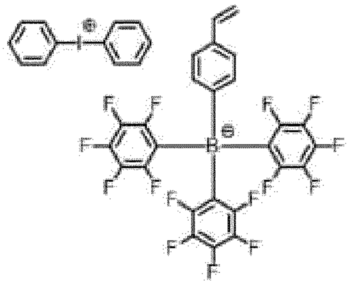

[Chemical Formula D-21]

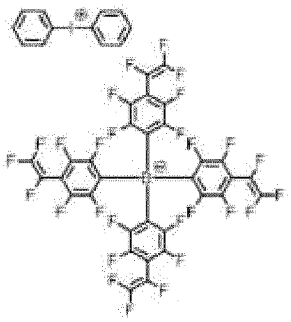

[Chemical Formula D-22]

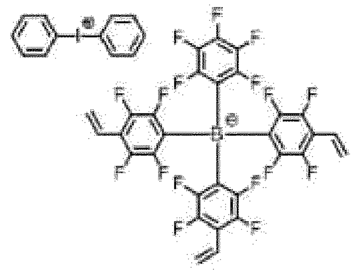

[Chemical Formula D-23]

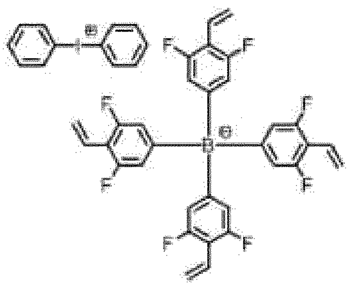

[Chemical Formula D-24]

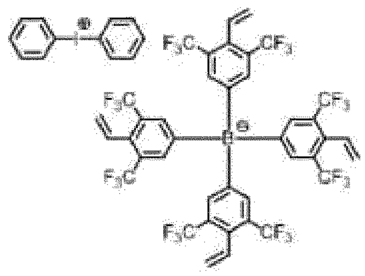

[Chemical Formula D-25]

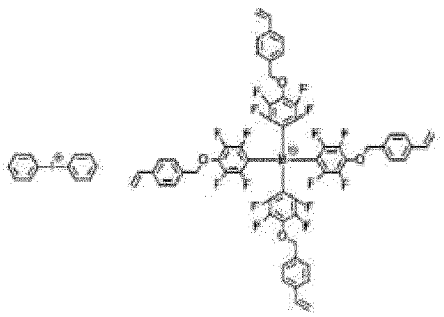

[Chemical Formula D-26]

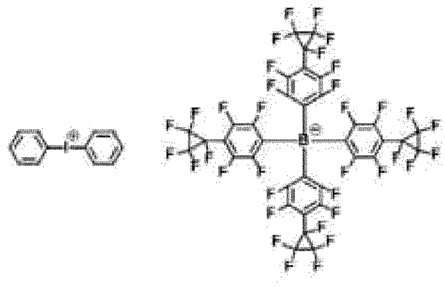

[Chemical Formula D-27]

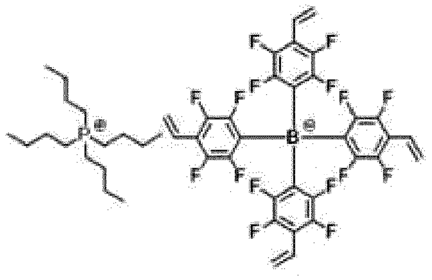

[Chemical Formula D-28]

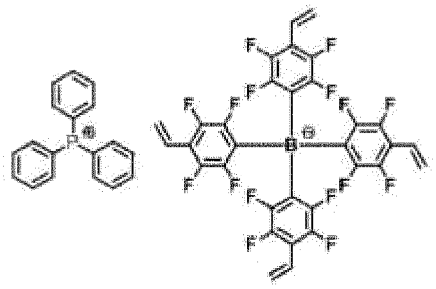

[Chemical Formula D-29]

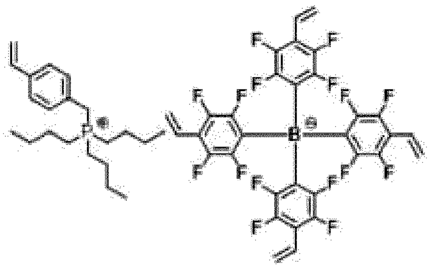

[Chemical Formula D-30]

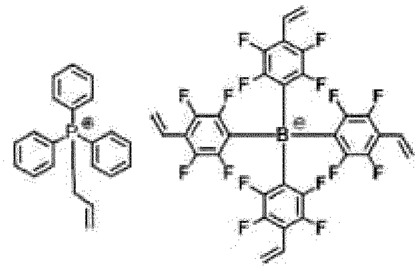

[Chemical Formula D-31]

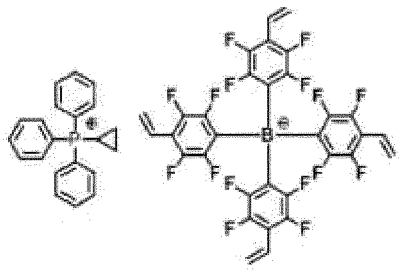

[Chemical Formula D-32]

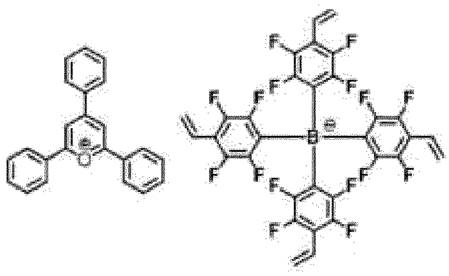

[Chemical Formula D-33]

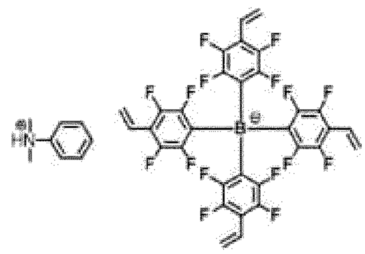

[Chemical Formula D-34]

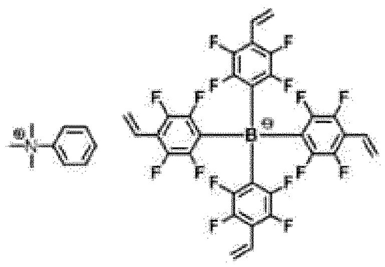

[Chemical Formula D-35]

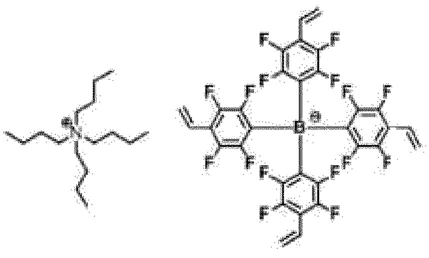

[Chemical Formula D-36]

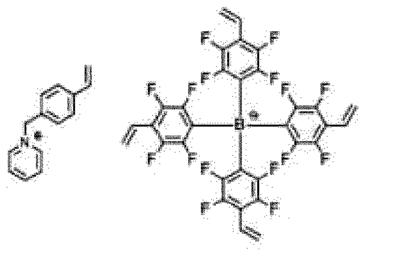

[Chemical Formula D-37]

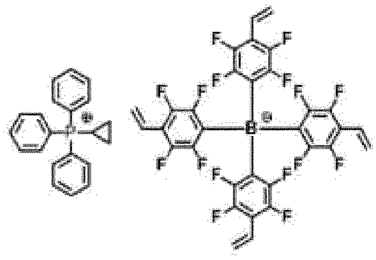

In an exemplary embodiment of the present invention, in the ionic compound, the anionic group represented by Chemical Formula 2 and the cationic group are included at an equivalent ratio of 1 : 5 to 5 : 1. Specifically, the anionic group represented by Chemical Formula 2 and the cationic group are included at an equivalent ratio of 1 : 1.

Hereinafter, an ink composition will be specifically described.

The present invention provides an ink composition including: the compound represented by Chemical Formula 1; the first solvent represented by Chemical Formula A; and the second solvent represented by Chemical Formula A and different from the first solvent.

According to an exemplary embodiment of the present invention, the ink composition further includes an ionic compound including the anionic group represented by the above-described Chemical Formula 2.

According to an exemplary embodiment of the present invention, the ionic compound further includes the above-described cationic group.

According to an exemplary embodiment of the present invention, the ink composition further comprises an additional solvent in addition to the above-described first, second, and third solvents. The additional solvent further includes one or more additional solvents selected from the group consisting of a chlorine-based solvent such as chloroform, methylene chloride, 1,2-dichloroethane, 1,1,2-trichloroethane, chlorobenzene, and o-dichlorobenzene; an ether-based solvent such as tetrahydrofuran, dioxane, and dipropylene glycol monomethyl ether; an aromatic hydrocarbon-based solvent such as toluene, xylene, trimethylbenzene, and mesitylene; an aliphatic hydrocarbon-based solvent such as cyclohexane, methylcyclohexane, n-pentane, n-hexane, n-heptane, n-octane, n-nonane, and n-decane; a ketone-based solvent such as acetone, methyl ethyl ketone, cyclohexanone, isophorone, tetralone, decalone, and acetylacetone; an ester-based solvent such as ethyl acetate, butyl acetate, ethyl cellosolve acetate, and benzyl butyrate; a polyhydric alcohol such as ethylene glycol, ethylene glycol monobutyl ether, ethylene glycol monoethyl ether, ethylene glycol monomethyl ether, dimethoxy ethane, propylene glycol, diethoxymethane, triethylene glycol monoethyl ether, glycerin, and 1,2-hexanediol, and derivatives thereof; an alcohol-based solvent such as methanol, ethanol, propanol, isopropanol, and cyclohexanol; a sulfoxide-based solvent such as dimethyl sulfoxide; an amide-based solvent such as N-methyl-2-pyrrolidone and N,N-dimethylformamide; and tetralin. However, the additional solvent is not limited to the above example, and is sufficient as long as the additional solvent can dissolve or disperse the compound represented by the above-described Chemical Formula 1.

An exemplary embodiment of the present invention provides an ink composition including: the compound represented by the above-described Chemical Formula 1; the first solvent represented by the above-described Chemical Formula A; the second solvent represented by the above-described Chemical Formula A and different from the first solvent; the third solvent different from the first solvent and the second solvent; and the ionic compound including the anionic group represented by the above-described Chemical Formula 2.

In an exemplary embodiment of the present invention, based on 100 wt% of the ink composition, the compound represented by Chemical Formula 1 is included in an amount of 0.1 wt% to 10 wt%, or 0.1 wt% to 5 wt%.

In an exemplary embodiment of the present invention, based on 100 wt% of the ink composition, the first solvent is included in an amount of 0.1 wt% to 70 wt%; 3 wt% to 60 wt%, or 5 wt% to 50 wt%.

In an exemplary embodiment of the present invention, based on 100 wt% of the ink composition, the second solvent is included in an amount of 3 wt% to 90 wt%, or 5 wt% to 80 wt%.

In an exemplary embodiment of the present invention, based on 100 wt% of the ink composition, the third solvent is included in an amount of 3 wt% to 90 wt%, or 5 wt% to 80 wt%.

In an exemplary embodiment of the present invention, based on 100 wt% of the ink composition, the ionic compound including the anionic group represented by Chemical Formula 2 is included in an amount of 0.1 wt% to 10 wt%, or 0.1 wt% to 5 wt%.

In an exemplary embodiment of the present invention, based on 100 wt% of the ink composition, the additional solvent is included in an amount of 0 wt% to 80 wt%, or 0 wt% to 50 wt%.

In an exemplary embodiment of the present invention, the ink composition has an intrinsic viscosity of 2 cP to 15 cP at room temperature. When the above viscosity is satisfied, a device is easily manufactured. Specifically, a uniform film

may be formed when an organic material layer in an organic light emitting device is formed.

The above intrinsic viscosity is a value measured at room temperature using a viscometer manufactured by Brookfield Engineering Labs Inc., after dissolving a compound represented by Chemical Formula 1 to be measured at any one concentration of 1 wt% to 3 wt% in solvents, which are mixed at an arbitrary ratio.

In an exemplary embodiment of the present invention, the solvent measured at the above intrinsic viscosity is a mixed solvent of the first solvent and the second solvent, or a mixed solvent of the first to third solvents.

In an exemplary embodiment of the present invention, the ink composition is in a liquid phase.

In an exemplary embodiment of the present invention, the ink composition can be cured by a heat treatment or a light treatment. When the ink composition is cured, this may be expressed as a cured product of the ink composition.

In an exemplary embodiment of the present invention, the ink composition further includes: a single molecule including a photocurable group and/or a thermosetting group; or a single molecule including an end group capable of forming a polymer by heat. As described above, the single molecule including a photocurable group and/or a thermosetting group; or the single molecule including an end group capable of forming a polymer by heat may be a compound having a molecular weight of 3,000 g/mol or less, but the molecular weight is not limited to the exemplified molecular weight.

The single molecule including a photocurable group and/or a thermosetting group; or the single molecule including an end group capable of forming a polymer by heat may mean aryl such as phenyl, biphenyl, fluorene, and naphthalene; arylamine; or a single molecule in which fluorene substituted with a photocurable group, a thermosetting group and/or an end group capable of forming a polymer by heat.

In an exemplary embodiment of the present invention, the ink composition is a composition for forming one or more layers selected from the group consisting of a hole injection layer, a hole transport layer, a hole injection and transport layer, and an electron blocking layer.

Hereinafter, a pixel and an organic material layer, which include the above-described ink composition, will be specifically described.

An exemplary embodiment of the present invention provides a pixel including the above-described ink composition or a cured product thereof. Further, an exemplary embodiment of the present invention provides an organic material layer including the above-described pixel.

In an exemplary embodiment of the present invention, the pixel may be included in an organic material layer, an organic light emitting diode, or an organic light emitting display device. In addition, the organic material layer may be included in an organic light emitting diode, or an organic light emitting display device.

In an exemplary embodiment of the present invention, the organic light emitting display device includes a plurality of pixels composed of red (R), green (G), and blue (B) sub-pixels, and an organic light emitting diode and a pixel circuit are located for each sub-pixel. An organic light emitting diode includes two electrodes (anode and cathode) and an organic light emitting layer located therebetween, and a pixel circuit includes at least two thin film transistors and at least one capacitor.

In an exemplary embodiment of the present invention, the organic material layer, the organic light emitting diode or the organic light emitting display device includes a bank which may be separated from each sub-pixel to apply ink or a bank in which ink droplets are connected in two or more sub-pixels.

In an exemplary embodiment of the present invention, the form of the bank is not limited. As an example, the organic material layer, the organic light emitting diode, or the organic light emitting display device may include a line-shaped bank. The line-shaped bank may define a line-shaped pixel region and/or a sub-pixel region. As another example, the organic material layer, the organic light emitting diode, or the organic light emitting display device may include separated banks instead of a line-shaped shape. In a normal case, the light emitting layer among the organic material layers is composed of a red light emitting layer, a green light emitting layer and a blue light emitting layer located in a red sub-pixel, a green sub-pixel and a blue sub-pixel, respectively. In this case, the above-described pixel may correspond to the pixel or sub-pixel. As a preferred exemplary embodiment, the pixel corresponds to the sub-pixel.

Generally, when the size of a unit pixel is reduced in order to increase the resolution of a display panel, it is difficult to form a flat thin film when vacuum drying is performed after inkjet printing. In particular, as the short-axis length of the pixel decreases, it becomes more difficult to form a flat thin film. However, the pixel according to an exemplary embodiment of the present invention enables a flat thin film to be formed even though the size of the pixel is reduced.

In an exemplary embodiment of the present invention, the flatness is a value obtained by measuring the thickness and profile of the cured thin film included in the pixel using an optical profiler manufactured by Bruker (model name: Contour GT-I), which is an optical thickness measuring device, and calculating the ratio of a region having a thickness within 5% from the pixel center thickness in a range of 95% of the width with respect to the short-axis of the pixel.

In an exemplary embodiment of the present invention, the flatness is calculated by the following Equation 1.

$$\text{Flatness} = [\text{number of i's in which } \{(H_c-H_i)/(\text{average of } H_i \text{ from i=1 to n}) < 0.05\}]/n \qquad \text{[Equation 1]}$$

In Equation 1,

n is an integer from 2 to 1,000,
i is the thickness measurement position between 1 and n in the flatness measurement section,
$H_i$ is the thickness of the thin film at the i-th measurement point, and
$H_c$ is the thickness of the thin film at the center of the pixel.

The flatness measurement regions (Hi, Hc) are specifically illustrated in FIG. 5.
When a flatness is calculated using Equation 1 above, the flatness has a value between 0 and 1.
In an exemplary embodiment of the present invention, n is the number of parts into which the flatness measurement section is divided into arbitrary unit lengths, and is an integer from 2 to 1,000.
In an exemplary embodiment of the present invention, the pixel has a flatness of 0.4 or more when the pixel has a short-axis width of 50 μm or less. Specifically, the pixel has a flatness of 0.4 or more for a pixel with a short-axis width of 20 μm to 25 μm, and a flatness of 0.6 or more for a pixel with a short-axis width of 40 μm to 45 μm.
FIG. 6 illustrates a process in which an ink composition is applied to an organic material layer in the related art, which is provided with pixels with a short-axis width of more than 50 μm.
FIG. 7 illustrates a process in which an ink composition is applied to an organic material layer in the related art, which is provided with pixels with a short-axis width of 50 μm or less.
In the present invention, the short-axis width means the shortest width part in the horizontal plane of a pixel. In FIGS. 6 and 7, the part corresponding to the short-axis width is indicated by an arrow (↔).
In FIGS. 6 and 7, 10 is a printhead, 20 is an ink composition to be applied, and 30 is a substrate on which pixels are formed.
An exemplary embodiment of the invention forms a flat thin film in pixels having a short-axis width of 50 μm or less.
An ink composition according to an exemplary embodiment of the present invention exhibits excellent flatness not only for pixels with a short-axis width of 50 μm or less, but also for pixels with a short-axis width of more than 50 μm.
In an exemplary embodiment of the present invention, a high flatness value means that the pixel is formed flat. That is, it means that the higher the flatness value, the more uniformly the pixels are formed.
An exemplary embodiment of the present invention provides an organic material layer including the above-described pixel. Since the pixel includes the above-described ink composition or a cured product thereof, an exemplary embodiment of the present invention can be said to provide an organic material layer including the above-described ink composition or a cured product thereof.
In an exemplary embodiment of the present invention, the organic material layer includes a plurality of the pixels. For example, the organic material layer includes an x-axis on which na pixels are aligned and a y-axis that is perpendicular to the x-axis and on which nb pixels are aligned, and na and nb are each an integer from 2 to $10^4$.
In an exemplary embodiment of the present invention, the form in which pixels are provided in the organic material layer is not limited, but for example, as shown in FIG. 4, a plurality of pixels 1' may be formed in a separated form.
In an exemplary embodiment of the present invention, na and nb are each 2 or higher, 5 or higher, 10 or higher, 20 or higher, 40 or higher, or 60 or higher, $10^4$ or lower, $10^3$ or lower, or $10^2$ or lower.
In an exemplary embodiment of the present invention, the organic material layer includes 2 or more, 4 or more, 10 or more, 20 or more, 40 or more, 80 or more, or 100 or more and $10^8$ or less, $10^6$ or less, $10^4$ or less, or $10^3$ or less pixels.
In an exemplary embodiment of the present invention, the organic material layer includes na x nb pixels.
In an exemplary embodiment of the present invention, a plurality of pixels included in the organic material layer have a uniform thickness.
In an exemplary embodiment of the present invention, the organic material layer is included in an organic light emitting device.
In an exemplary embodiment of the present invention, the organic material layer is formed by a solution process.
In an exemplary embodiment of the present invention, the organic material layer is one or more layers selected from the group consisting of a hole injection layer, a hole transport layer, a hole injection and transport layer, an electron blocking layer, a light emitting layer, a hole blocking layer, an electron injection layer, an electron transport layer, and an electron injection and transport layer.
In an exemplary embodiment of the present invention, the organic material layer is one or more layers selected from the group consisting of a hole injection layer, a hole transport layer, a hole injection and transport layer, an electron blocking layer, and a light emitting layer.
In an exemplary embodiment of the present invention, the organic material layer is one or more layers selected from the group consisting of a hole injection layer, a hole transport layer, a hole injection and transport layer, and an electron blocking layer.
In a preferred exemplary embodiment of the present invention, the organic material layer is a hole transport layer or a hole injection layer.

Hereinafter, an organic light emitting device will be specifically described.

An exemplary embodiment of the present invention provides an organic light emitting device including: a first electrode; a second electrode; and an organic material layer having one or more layers provided between the first electrode and the second electrode, in which one or more layers of the organic material layer are the above-described organic material layer.

That is, an exemplary embodiment of the present specification provides an organic light emitting device including: a first electrode; a second electrode; and an organic material layer having one or more layers provided between the first electrode and the second electrode, in which one or more layers of the organic material layer include the above-described ink composition or a cured product thereof.

In an exemplary embodiment of the present invention, the organic material layer includes one or more layers selected from the group consisting of a hole injection layer, a hole transport layer, a hole injection and transport layer, an electron blocking layer, a light emitting layer, a hole blocking layer, an electron injection layer, an electron transport layer, and an electron injection and transport layer, and the one or more layers selected from the group consisting of the hole injection layer, the hole transport layer, the hole injection and transport layer, the electron blocking layer, the light emitting layer, the hole blocking layer, the electron injection layer, the electron transport layer, and the electron injection and transport layer include the above-described ink composition or a cured product thereof.

In an exemplary embodiment of the present invention, the organic material layer includes one or more layers selected from the group consisting of a hole injection layer, a hole transport layer, a hole injection and transport layer, and an electron blocking layer, and the one or more layers selected from the group consisting of the hole injection layer, the hole transport layer, the hole injection and transport layer, and the electron blocking layer include the above-described ink composition or a cured product thereof.

In an exemplary embodiment of the present invention, the organic material layer includes a hole injection layer, a hole transport layer, or an electron blocking layer, and the hole injection layer, the hole transport layer, or the electron blocking layer includes the above-described ink composition or a cured product thereof.

In an exemplary embodiment of the present invention, the organic material layer includes the na x nb pixels described above, and the na x nb pixels satisfy Equation 1.

Hereinafter, a method for manufacturing an organic light emitting device will be specifically described.

An exemplary embodiment of the present invention provides a method for manufacturing an organic light emitting device, the method including:

preparing a first electrode;
forming an organic material layer having one or more layers on the first electrode; and
forming a second electrode on the organic material layer having one or more layers,
in which the forming of the organic material layer includes forming an organic material layer using the above-described ink composition.

In an exemplary embodiment of the present invention, the forming of the organic material layer using the ink composition uses a spin coating method.

In an exemplary embodiment of the present invention, the forming of the organic material layer using the ink composition uses a printing method.

In an exemplary embodiment of the present invention, examples of the printing method include inkjet printing, nozzle printing, offset printing, transfer printing, screen printing, or the like, but are not limited to the printing methods listed above.

In an exemplary embodiment of the present invention, the forming of the organic material layer using the ink composition uses an inkjet printing method.

In an exemplary embodiment of the present invention, the forming of the one or more organic material layers using the ink composition may be performed by applying the ink composition on a substrate or an organic material layer including banks, and then drying or heat-treating the ink composition.

A solution process is suitable for the ink composition according to an exemplary embodiment of the present invention due to the structural characteristics thereof, so that the organic material layer may be formed by a printing method, and as a result, there is an economic effect in terms of time and costs when a device is manufactured.

In an exemplary embodiment of the present invention, the forming of the organic material layer on the first electrode may further include drying after one or more steps of pressure reduction. As an example, the forming of the organic material layer having one or more layers on the first electrode further includes drying after two steps of pressure reduction. In this case, the drying after the first pressure reduction is performed under normal pressure to $2x10^{-2}$ torr, and the pressure reduction time under normal pressure to $2x10^{-2}$ torr may be 30 seconds to 600 seconds. Further, the drying after the second pressure reduction is performed under $2x10^{-2}$ torr to $2x10^{-6}$ torr, and the pressure reduction time under $2x10^{-2}$ torr to $2x10^{-6}$ torr may also be 30 seconds to 600 seconds.

In an exemplary embodiment of the present invention, the forming of the organic material layer using the ink composition includes: coating the ink composition; and heat-treating or light-treating the coated ink composition.

In an exemplary embodiment of the present invention, the forming of the organic material layer having one or more layers using the ink composition includes: coating the first electrode or the organic material layer having one or more layers with the coating composition; and heat-treating or light-treating the coated coating composition.

In an exemplary embodiment of the present invention, the heat-treating of the coating composition may be performed through a heat treatment, and the heat treatment temperature in the heat-treating of the coating composition may be 85°C to 250°C, may be 100°C to 250°C in an exemplary embodiment, and may be 150°C to 250°C in another exemplary embodiment.

In an exemplary embodiment of the present invention, the heat treatment time in the heat treatment step may be 10 minutes to 2 hours, may be 10 minutes to 1 hour in an exemplary embodiment, and may be 20 minutes to 1 hour in another exemplary embodiment.

When the forming of the organic material layer using the ink composition includes the heat-treating or light-treating of the ink composition, a plurality of the compounds included in the ink composition may form a crosslinkage, thereby providing an organic material layer including a thin-filmed structure. In this case, it is possible to prevent the organic material layer from being dissolved, morphologically affected or decomposed by a solvent when another layer is stacked on the surface of the organic material layer formed using the ink composition.

Therefore, when the organic material layer is formed by heat-treating or light-treating the ink composition, the resistance to solvents increases. Accordingly, the solution deposition and crosslinking methods may be repeatedly performed to form multiple layers, and the stability may be increased to increase the service life characteristics of the device.

Hereinafter, the types of organic material layers included in the above-described organic light emitting device will be specifically described.

In an exemplary embodiment of the present invention, the organic light emitting device includes an organic material layer having one layer, and one layer of the organic material layer include the ink composition or a cured product thereof.

In an exemplary embodiment of the present invention, the organic light emitting device includes an organic material layer having two or more layers, and one or more layers of the organic material layer having two or more layers include the ink composition or a cured product thereof. For example, among organic material layers having two or more layers, the organic material layer having any one layer includes the ink composition or a cured product thereof, and further includes another organic material layer. Another organic material layer according to an exemplary embodiment does not include the ink composition or a cured product thereof. Another organic material layer according to another exemplary embodiment further includes the ink composition or a cured product thereof. However, the organic light emitting device is not limited to the example.

The organic material layer having two or more layers includes two or more layers selected from the group consisting of, for example, a hole injection layer, a hole transport layer, a hole injection and transport layer, an electron blocking layer, a light emitting layer, a hole blocking layer, an electron transport layer, an electron injection layer, an electron injection and transport layer, and the like. In this case, the hole injection and transport layer means a layer which simultaneously injects and transports holes, and the electron injection and transport layer means a layer which simultaneously injects and transports electrons. However, the organic material layers forming the group are merely an example, and are not limited to the above example. Further, the organic material layer having two or more layers may include two or more layers that play the same role, if necessary. The organic light emitting device according to an exemplary embodiment includes a first hole injection layer and a second hole injection layer. However, the organic material layer having two or more layers is not limited to the examples.

In an exemplary embodiment of the present invention, the organic material layer includes a light emitting layer. As an example, the light emitting layer includes the ink composition or a cured product thereof. As a specific example, the light emitting layer includes the ink composition or a cured product thereof as a host of the light emitting layer. As another specific example, the light emitting layer includes the ink composition or a cured product thereof as a dopant of the light emitting layer.

In an exemplary embodiment of the present invention, the organic material layer includes a hole injection and transport layer, a hole injection layer, a hole transport layer and an electron blocking layer. As an example, the hole injection and transport layer, the hole injection layer, the hole transport layer or the electron blocking layer includes an ink composition or a cured product thereof.

In an exemplary embodiment of the present invention, the organic material layer including the ink composition or the cured product thereof is a hole injection layer.

In an exemplary embodiment of the present invention, the organic material layer is a hole injection layer, a hole transport layer and/or an electron blocking layer. As an example, the hole injection layer, the hole transport layer and/or the electron blocking layer includes the ink composition or a cured product thereof.

In an exemplary embodiment of the present invention, the organic material layer further includes one or more layers selected from the group consisting of a hole blocking layer, an electron transport layer, an electron injection layer, and an electron injection and transport layer. As an example, one or more layers selected from the group consisting of the hole blocking layer, the electron transport layer, the electron injection layer, and the electron injection and transport layer include the ink composition or a cured product thereof. As another example, one or more layers selected from the group consisting of the hole blocking layer, the electron transport layer, the electron injection layer, and the electron injection and transport layer do not include the ink composition or a cured product thereof.

In an exemplary embodiment of the present invention, the organic light emitting device includes: a first electrode; a second electrode; and an organic material layer having one or more layers provided between the first electrode and the second electrode, the organic material layer includes a light emitting layer, a hole injection layer and an electron blocking layer, and the hole injection layer or the electron blocking layer include the ink composition or a cured product thereof.

Hereinafter, the stacking structure of the organic material layer and the organic light emitting device including the organic material layer will be specifically described.

In an exemplary embodiment of the present invention, the organic material layer of the organic light emitting device has a single-layered structure. For example, the organic material layer having the single-layered structure is provided between the first electrode and the second electrode of the organic light emitting device, and the organic material layer includes the ink composition or a cured product thereof. In a specific exemplary embodiment, the organic material layer having the single-layered structure is a light emitting layer, and in this case, the light emitting layer includes the ink composition or a cured product thereof.

In an exemplary embodiment of the present invention, the organic material layer of the organic light emitting device has a multi-layered structure in which an organic material layer having two or more layers is stacked. For example, the organic material layer having the multi-layered structure is provided between the first electrode and the second electrode of the organic light emitting device.

In an exemplary embodiment of the present invention, the organic material layer having the multi-layered structure includes a light emitting layer and an organic material layer other than the light emitting layer. As an example, the light emitting layer is provided between the first electrode and the second electrode, and the organic material layer other than the light emitting layer is provided between the first electrode and the light emitting layer. As another example, the light emitting layer is provided between the first electrode and the second electrode, and the organic material layer other than the light emitting layer is provided between the light emitting layer and the second electrode. As still another example, the light emitting layer is provided between the first electrode and the second electrode, any one organic material layer other than the light emitting layer is provided between the first electrode and the light emitting layer, and any other organic material layer other than the light emitting layer is provided between the light emitting layer and the second electrode. However, the above structure is merely an example, and the structure is not limited to the above structure. Further, the organic material layer other than the light emitting layer may be one or more layers selected from the group consisting of, for example, a hole injection and transport layer, a hole injection layer, a hole transport layer, an electron blocking layer, a hole blocking layer, an electron transport layer, an electron injection layer, an electron injection and transport layer, and the like, but is not limited thereto.

In general, a hole injection layer, a hole transport layer or an electron blocking layer in an organic light emitting device is provided between an anode and a light emitting layer. As a specific example, the hole injection layer is provided on the anode, the hole transport layer is provided on the hole injection layer, and the electron blocking layer is provided on the hole injection layer, but the present invention is not limited to the above examples.

Further, in general, an electron injection layer, an electron transport layer or a hole blocking layer in an organic light emitting device is provided between a cathode and a light emitting layer. As a specific example, the hole blocking layer is provided on the light emitting layer, the electron transport layer is provided on the hole blocking layer, and the electron injection layer is provided on the electron transport layer, but the present invention is not limited to the above examples.

In an exemplary embodiment of the present invention, the organic material layer having a multi-layered structure included in the organic light emitting device includes: one or more layers selected from the group consisting of a hole injection and transport layer, a hole injection layer, a hole transport layer, an electron blocking layer, a hole blocking layer, an electron transport layer, an electron injection layer, and an electron injection and transport layer; and a light emitting layer, the light emitting layer is provided between a first electrode and a second electrode, the one or more layers are provided between the first electrode and the light emitting layer, and the one or more layers include the compound represented by Chemical Formula 1 and/or the first solvent represented by Chemical Formula A.

The structure of the organic light emitting device according to an exemplary embodiment of the present invention is illustrated in FIG. 1. FIG. 1 exemplifies a structure of an organic light emitting device in which a first electrode 201, a hole injection layer 301, a hole transport layer 401, a light emitting layer 501, an electron injection and transport layer 601, and a second electrode 701 are sequentially stacked on a substrate 101. The hole injection layer 301 and/or the hole transport layer 401 of FIG. 1 includes the above-described ink composition or a cured product thereof, or may be formed using the ink composition.

FIG. 1 exemplifies an organic light emitting device according to an exemplary embodiment of the present specification, and the structure of the organic light emitting device of the present invention is not limited thereto.
As described above, an organic light emitting device having an organic material layer having a single-layered or multi-layered structure may have, for example, the following stacking structure, but the stacking structure is not limited thereto.

(1) Anode/Hole transport layer/Light emitting layer/Cathode
(2) Anode/Hole injection layer/Hole transport layer/Light emitting layer/Cathode
(3) Anode/Hole injection layer/Hole buffer layer/Hole transport layer/Light emitting layer/Cathode
(4) Anode/Hole transport layer/Light emitting layer/Electron transport layer/Cathode
(5) Anode/Hole transport layer/Light emitting layer/Electron transport layer/Electron injection layer/Cathode
(6) Anode/Hole injection layer/Hole transport layer/Light emitting layer/Electron transport layer/Cathode
(7) Anode/Hole injection layer/Hole transport layer/Light emitting layer/Electron transport layer/Electron injection layer/Cathode
(8) Anode/Hole injection layer/Hole buffer layer/Hole transport layer/Light emitting layer/Electron transport layer/-Cathode
(9) Anode/Hole injection layer/Hole buffer layer/Hole transport layer/Light emitting layer/Electron transport layer/-Electron injection layer/Cathode
(10) Anode/Hole transport layer/Electron blocking layer/Light emitting layer/Electron transport layer/Cathode
(11) Anode/Hole transport layer/Electron blocking layer/Light emitting layer/Electron transport layer/Electron injection layer/Cathode
(12) Anode/Hole injection layer/Hole transport layer/Electron blocking layer/Light emitting layer/Electron transport layer/Cathode
(13) Anode/Hole injection layer/Hole transport layer/Electron blocking layer/Light emitting layer/Electron transport layer/Electron injection layer/Cathode
(14) Anode/Hole transport layer/Light emitting layer/Hole blocking layer/Electron transport layer/Cathode
(15) Anode/Hole transport layer/Light emitting layer/Hole blocking layer/Electron transport layer/Electron injection layer/Cathode
(16) Anode/Hole injection layer/Hole transport layer/Light emitting layer/Hole blocking layer/Electron transport layer/Cathode
(17) Anode/Hole injection layer/Hole transport layer/Light emitting layer/Hole blocking layer/Electron transport layer/Electron injection layer/Cathode
(18) Anode/Hole injection layer/Hole transport layer/Light emitting layer/Hole blocking layer/Electron transport layer/Electron injection layer/Cathode/Capsule
(19) Anode/Hole injection layer/First hole transport layer/Second hole transport layer/Light emitting layer/Hole blocking layer/Electron transport layer/Electron injection layer/Cathode/Capsule

In the structures, the ’Electron transport layer/Electron injection layer’ may be replaced with an ’electron injection and transport layer’ or a ’layer that simultaneously injects and transports electrons’.
Further, in the structures, the ’Hole injection layer/Hole transport layer’ may be replaced with the ’hole injection and transport layer’ or the "layer which simultaneously injects and transports holes".
In an exemplary embodiment of the present invention, the first electrode is an anode, and the second electrode is a cathode.
In an exemplary embodiment of the present invention, the first electrode is a cathode, and the second electrode is an anode.
In an exemplary embodiment of the present invention, the organic light emitting device may be a normal type organic light emitting device in which an anode, an organic material layer having one or more layers, and a cathode are sequentially stacked on a substrate.
In an exemplary embodiment of the present invention, the organic light emitting device may be an inverted type organic light emitting device in which a cathode, an organic material layer having one or more layers, and an anode are sequentially stacked on a substrate.
In an exemplary embodiment of the present invention, in an organic light emitting device, one or more layers of the organic material layer are formed using the above-described ink composition. Except for this, the organic light emitting device may be manufactured by materials and methods known in the art.
For example, the organic light emitting device of the present invention may be manufactured by sequentially stacking an anode, an organic material layer, and a cathode on a substrate. In this case, the organic light emitting device may be manufactured by depositing a metal or a metal oxide having conductivity, or an alloy thereof on a substrate to form an anode, forming an organic material layer including one or more layers of a hole injection layer, a hole transport layer, a

light emitting layer, an electron injection layer, an electron transport layer, a hole transport and injection layer, and an electron transport and injection layer thereon through a solution process, a deposition process, the like, and then depositing a material, which may be used as a cathode, thereon, by using a physical vapor deposition (PVD) method such as sputtering or e-beam evaporation. In addition to such a method, the organic light emitting device may also be manufactured by consecutively depositing a cathode material, an organic material layer and an anode material on a substrate.

As the anode material, materials having a high work function are usually preferred so as to facilitate the injection of holes into an organic material layer. Examples thereof include: a metal, such as vanadium, chromium, copper, zinc, and gold, or an alloy thereof; a metal oxide, such as zinc oxide, indium oxide, indium tin oxide (ITO), and indium zinc oxide (IZO); a combination of a metal and an oxide, such as ZnO:Al or $SnO_2$:Sb; a conductive polymer, such as poly(3-methylthiophene), poly[3,4-(ethylene-1,2-dioxy)thiophene] (PEDOT), polypyrrole, and polyaniline; and the like, but are not limited thereto.

As the cathode material, materials having a low work function are usually preferred so as to facilitate the injection of electrons into an organic material layer. Examples thereof include: a metal, such as magnesium, calcium, sodium, potassium, titanium, indium, yttrium, lithium, gadolinium, aluminum, silver, tin, and lead, or an alloy thereof; a multi-layer structured material, such as LiF/Al or $LiO_2$/Al; and the like, but are not limited thereto.

The light emitting layer may include a host material and/or a dopant material.

Examples of the host material include a fused aromatic ring derivative, a hetero ring-containing compound, or the like. Specific examples of the fused aromatic ring derivative include anthracene derivatives, pyrene derivatives, naphthalene derivatives, pentacene derivatives, phenanthrene compounds, fluoranthene compounds, and the like, and specific examples of the hetero ring-containing compound include dibenzofuran derivatives, ladder-type furan compounds, pyrimidine derivatives, and the like, but the examples are not limited thereto.

Examples of the dopant material include an aromatic amine derivative, a styrylamine compound, a boron complex, a fluoranthene compound, a metal complex, and the like. Specifically, the aromatic amine derivative is a fused aromatic ring derivative having a substituted or unsubstituted arylamine group, and examples thereof include pyrene, anthracene, chrysene, periflanthene, and the like having an arylamine group. Further, the styrylamine compound is a compound in which a substituted or unsubstituted arylamine is substituted with at least one arylvinyl group, and one or two or more substituents selected from the group consisting of an aryl group, a silyl group, an alkyl group, a cycloalkyl group, and an arylamine group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

The hole injection layer is a layer which accepts holes from an electrode. It is preferred that hole injection material has an ability to transport holes, and has an effect of accepting holes from an anode and an excellent hole injection effect for a light emitting layer or a light emitting material. Further, the hole injection material is preferably a material which is excellent in ability to prevent excitons produced from a light emitting layer from moving to an electron injection layer or an electron injection material. In addition, the hole injection material is preferably a material which is excellent in ability to form a thin film. In addition, the HOMO of the hole injection material is preferably a value between the work function of the anode material and the HOMO of the neighboring organic material layer. Specific examples of the hole injection material include: metal porphyrin, oligothiophene, and arylamine-based organic materials; hexanitrile hexaazatriphenylene-based organic materials; quinacridone-based organic materials; perylene-based organic materials; polythiophene-based conductive polymers such as anthraquinone and polyaniline; the compound of the above-described Chemical Formula 1, and the like, but are not limited thereto.

In an exemplary embodiment of the present invention, the hole injection layer is formed from the above-described ink composition or a cured product thereof.

In an exemplary embodiment of the present invention, the compound of Chemical Formula 1 is included as a host of a hole injection layer.

In an exemplary embodiment of the present invention, the ionic compound is included as a dopant of a hole injection layer.

The hole transport layer is a layer which accepts holes from a hole injection layer and transports the holes to a light emitting layer, and may have a single-layered structure or a multi-layered structure having two or more layers. A hole transport material is preferably a material having high hole mobility which may accept holes from an anode or a hole injection layer and transfer the holes to a light emitting layer. Specific examples of the hole transport material include arylamine-based organic materials, carbazole-based compounds, conductive polymers, block copolymers having both conjugated portions and nonconjugated portions, and the like, but are not limited thereto.

The electron transport layer is a layer which accepts electrons from an electron injection layer and transports the electrons to a light emitting layer. An electron transport material is preferably a material having high electron mobility which may proficiently accept electrons from a cathode and transfer the electrons to a light emitting layer. Specific examples thereof include: Al complexes of 8-hydroxyquinoline; complexes including $Alq_3$; organic radical compounds; hydroxy-

flavone-metal complexes; and the like, but are not limited thereto. The electron transport layer may be used with any desired cathode material, as used according to the related art. In particular, an appropriate cathode material is a typical material which has a low work function, followed by an aluminum layer or a silver layer. Specific examples thereof include cesium, barium, calcium, ytterbium, and samarium, in each case followed by an aluminum layer or a silver layer.

The electron injection layer is a layer which accepts electrons from an electrode. It is preferred that an electron injection material is excellent in ability to transport electrons and has an effect of accepting electrons from the cathode and an excellent electron injection effect for a light emitting layer or a light emitting material. Further, the electron injection material is preferably a material which prevents excitons produced from a light emitting layer from moving to a hole injection layer and is excellent in ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, metal complex compounds, nitrogen-containing 5-membered ring derivatives, and the like, but are not limited thereto. Examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, bis(2-methyl-8-quinolinato) (2-naphtholato) gallium, and the like, but are not limited thereto.

The electron blocking layer is a layer which may improve the service life and efficiency of a device by preventing electrons injected from an electron injection layer from passing through a light emitting layer and entering a hole injection layer. The electron blocking layer may be formed between the light emitting layer and the hole injection layer, or between the light emitting layer and the layer which simultaneously injects and transports holes using the compound of the above-described Chemical Formula 2.

The hole blocking layer is a layer which blocks holes from reaching a cathode, and may be generally formed under the same conditions as those of the electron injection layer. Specific examples of the hole blocking layer material include oxadiazole derivatives or triazole derivatives, phenanthroline derivatives, aluminum complexes, and the like, but are not limited thereto.

The hole injection and transport layer may include materials for the above-described hole injection layer and hole transport layer.

The electron injection and transport layer may include materials for the above-described electron injection layer and electron transport layer.

When the organic light emitting device includes a plurality of organic material layers, the organic material layers may be formed of the same material or different materials.

The organic light emitting device according to the present invention may be a top emission type, a bottom emission type, or a dual emission type according to the material to be used.

An exemplary embodiment of the present invention provides an electronic device including an organic light emitting device including the above-described ink composition or a cured product thereof, or including an organic material layer formed using the ink composition.

The electronic device may include all of the interlayer insulation film of a semiconductor device, a color filter, a black matrix, an overcoat, a column spacer, a passivation film, a buffer coating film, a multilayer printed board insulation film, a cover coat of a flexible copper-clad board, a solder resist film, an insulation film of OLED, a protection film of a thin-film transistor of a liquid crystal display device, an electrode protection film and a semiconductor protection film of an organic EL device, an OLED insulation film, an LCD insulation film, a semiconductor insulation film, a solar light module, a touch panel, a display device such as a display panel, and the like, but is not limited thereto.

[Mode for Invention]

Hereinafter, the present invention will be described in detail with reference to Examples for specifically describing the present invention. However, the Examples according to the present invention may be modified into various different forms, and it should not be interpreted that the scope of the present invention is limited to the Examples to be described below. The Examples of the present invention are provided for more completely explaining the present invention to the person with ordinary skill in the art.

**<Synthesis Example A. Preparation of Compound of Chemical Formula 1>**

**Synthesis Example A-1. Preparation of Compound H-1**

(a) Preparation of Compound 1-1

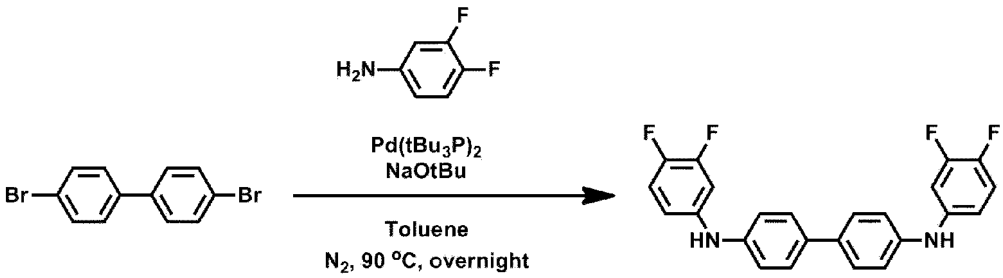


1-1

4,4'-Dibromobiphenyl (2 g, 6.4 mmol), bis(tri-tert-butylphosphine)palladium(0) ($Pd(tBu_3P)_2$) (163.5 mg), and sodium tert-butoxide (NaOtBu) (2.46 g, 25.6 mmol) were put into a reactor, and nitrogen ($N_2$) substitution was performed. Toluene (32 mL) and 3,4-difluoroaniline (1.4 mL, 14.1 mmol) were added thereto, and the resulting mixture was stirred at 90°C overnight. After work-up was performed by adding ethyl acetate and brine thereto, the resulting product was purified by column chromatography to prepare Compound 1-1.

(b) Preparation of Compound H-1

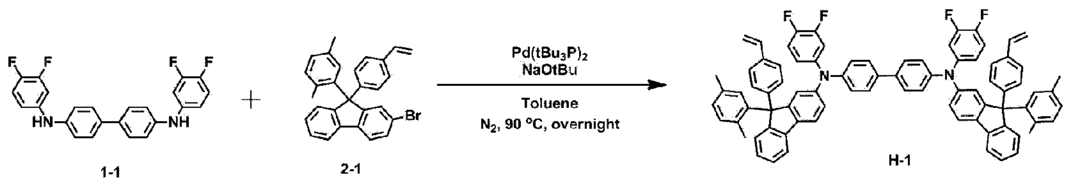


1-1 2-1 H-1

Compound 1-1 (1 g, 2.45 mmol), $Pd(tBu_3P)_2$ (87.6 mg, 0.17 mmol), and NaOtBu (0.706 g, 7.35 mmol) were put into a reactor, and the reactor was substituted with $N_2$. Toluene (12 mL) and Compound 2-1 (2.27 g, 5 mmol) were added thereto, and the resulting mixture was stirred at 90°C overnight. After work-up was performed by adding ethyl acetate and water thereto, the resulting product was purified with medium pressure liquid chromatography (MPLC), and then recrystallized with dichloromethane (DCM) to prepare Compound H-1. MS: $[M+H]^+ = 1149$

**Synthesis Example A-2. Synthesis of Compound H-2**

(a) Preparation of Compound 1-2

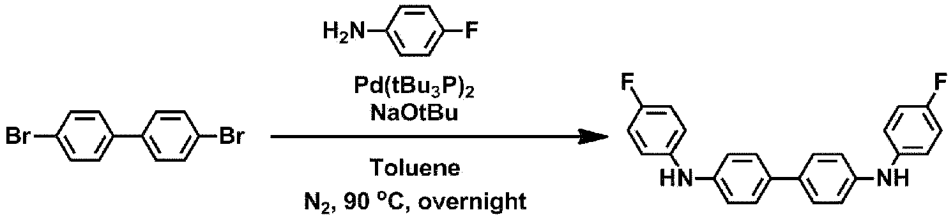


1-2

4,4'-Dibromobiphenyl (0.5 g, 1.6 mmol), $Pd(tBu_3P)_2$ (40.9 mg), and NaOtBu (615 mg) were put into a reactor, and nitrogen substitution was performed. Toluene (8 mL) and 4-fluoroaniline (0.337 mL, 3.52 mmol) were added thereto, and the resulting mixture was stirred at 90°C overnight. After work-up was performed by adding ethyl acetate and brine thereto, the resulting product was purified by column chromatography to prepare Compound 1-2.

(b) Preparation of Compound H-2

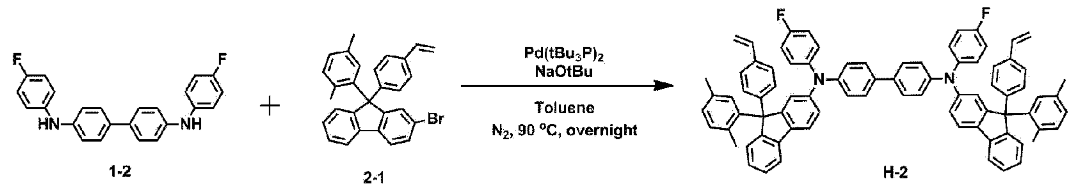

1-2 2-1 H-2

Compound 1-2 (0.32 g, 0.86 mmol), $Pd(tBu_3P)_2$ (31 mg), and NaOtBu (0.248 g, 2.58 mmol) were put into a reactor, and nitrogen substitution was performed. Toluene (6 mL) and Compound 2-1 (900 mg, 1.76 mmol) were added thereto, and the resulting mixture was stirred at 90°C overnight. After work-up was performed by adding ethyl acetate and water thereto, the resulting product was purified by column chromatography to prepare Compound H-2. MS: $[M+H]^+$ = 1113

**Synthesis Example A-3. Preparation of Compound H-3**

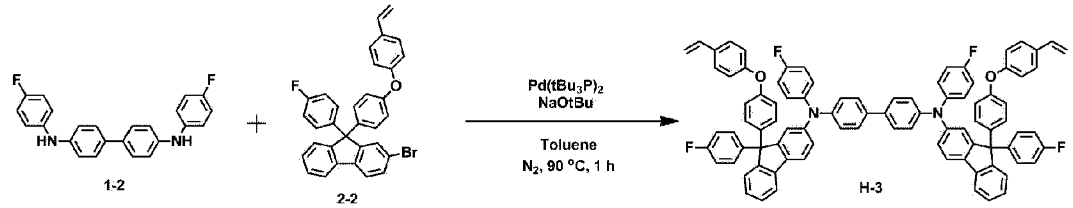

1-2 2-2 H-3

Compound 1-2 (944 mg, 2.5 mmol), Compound 2-2 (2.73 g, 5.13 mmol), $Pd(tBu_3P)_2$ (64 mg, 0.125 mmol), and NaOtBu (961 mg, 10 mmol) were put into a round bottom flask (RBF). After substitution with nitrogen, toluene (12.5 mL) was added thereto, and the resulting mixture was stirred at 90°C for 1 hour. Extraction was performed with ethyl acetate and water, an organic layer was collected, and then the organic layer was dried using $MgSO_4$ and then filtered. The filtrate was dried using a vacuum rotary concentrator to remove the organic solvent. After column purification, crystallization was performed under DCM/EtOH conditions to secure 2.7 g of Compound H-3. MS: $[M+H]^+$ = 1277

**Synthesis Example A-4. Preparation of Compound H-4**

(a) Preparation of Compound 1-3

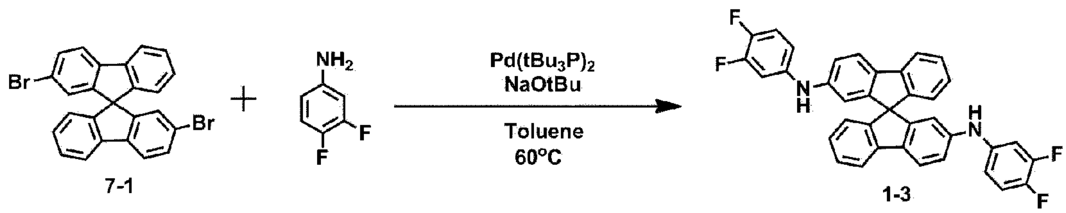

7-1 1-3

After Compound 7-1 (1.0 eq.), NaOtBu (7.10 g, 6.0 eq.), toluene (200 ml), and 3,4-difluoroaniline (2.02 eq.) were put into a round bottom flask, $N_2$ gassing was performed, and the flask was warmed to 60°C. After $Pd(tBu_3P)_2$ (0.250 g, 4 mol%) was added thereto, the resulting mixture was stirred at 60°C for 1 hour. After work-up was performed by adding ethyl acetate and brine thereto, the resulting product was purified by column chromatography to prepare Compound 1-3.

(b) Preparation of Compound H-4

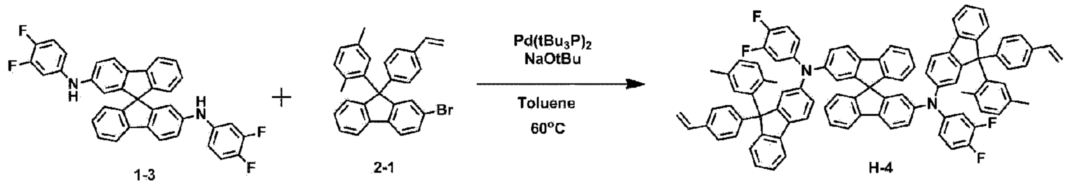

1-3 2-1 H-4

Compound 1-3 (1.0 eq.) and Compound 2-1 (11.4 g, 2.05 eq.) were put into a round bottom flask, NaOtBu (7.10 g, 6.0 eq.), toluene (200 mL), and Pd(tBu$_3$P)$_2$ (0.25 g, 4 mol%) were added thereto, and then the resulting mixture was stirred at 60°C for 1 hour. Subsequently, the resulting product was purified with column chromatography to prepare Compound H-4. MS: [M+H]$^+$ = 1312

**Synthesis Example A-5. Preparation of Compound H-5**

(a) Preparation of Compound 1-5

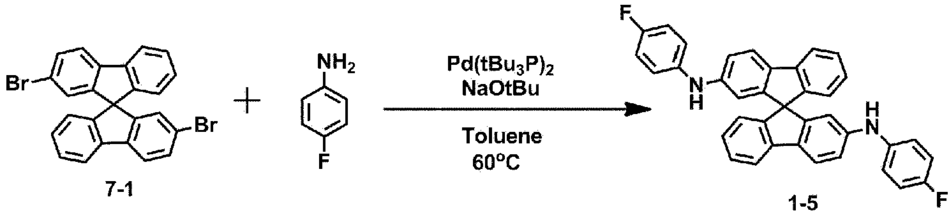

7-1 1-5

After Compound 7-1 (1.0 eq.), NaOtBu (7.10 g, 6.0 eq.), toluene (200 mL), and 4-fluoroaniline (2.40 mL, 2.02 eq.) were put into a round bottom flask, $N_2$ gassing was performed, and the flask was warmed to 60°C. After Pd(tBu$_3$P)$_2$ (0.250 g, 4 mol%) was added thereto, the resulting mixture was stirred at 60°C for 1 hour. After work-up was performed by adding ethyl acetate and brine thereto, the resulting product was purified by column chromatography to prepare Compound 1-5.

(b) Preparation of Compound H-5

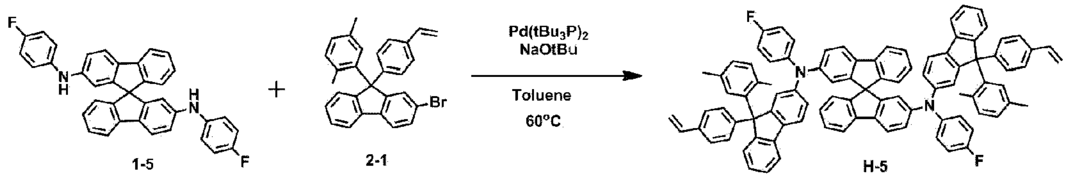

1-5 2-1 H-5

Compound 1-5 (1.0 eq.) and Compound 2-1 (11.4 g, 2.05 eq.) were put into a round bottom flask, NaOtBu (7.10 g, 6.0 eq.), toluene (200 mL), and Pd(tBu$_3$P)$_2$ (0.25 g, 4 mol%) were added thereto, and then the resulting mixture was stirred at 60°C for 1 hour. Subsequently, the resulting product was purified with column chromatography to prepare Compound H-5. MS: [M+H]$^+$ = 1276

**Synthesis Example A-6. Preparation of Compound H-6**

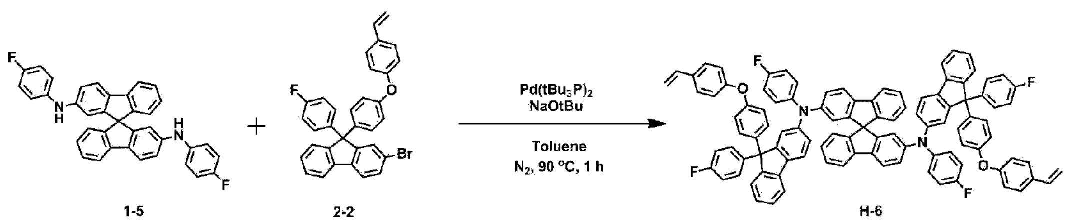

1-5 2-2 H-6

Compound 1-5 (1.34 g, 2.5 mmol), Compound 2-2 (2.73 g, 5.13 mmol), $Pd(tBu_3P)_2$ (64 mg, 0.125 mmol), and NaOtBu (961 mg, 10 mmol) were put into a RBF. After substitution with nitrogen, toluene (12.5 mL) was added thereto, and the resulting mixture was stirred at 90°C for 1 hour. Extraction was performed with ethyl acetate and water, an organic layer was collected, and then the organic layer was dried using $MgSO_4$ and then filtered. The filtrate was dried using a vacuum rotary concentrator to remove the organic solvent. After column purification, crystallization was performed under DCM/EtOH conditions to secure 2.9 g of Compound H-6. MS: $[M+H]^+$ = 1440

**<Synthesis Example B. Preparation of Ionic Compound>**

**Synthesis Example B-1. Preparation of Compound D-A**

(1) Preparation of Compound F-1

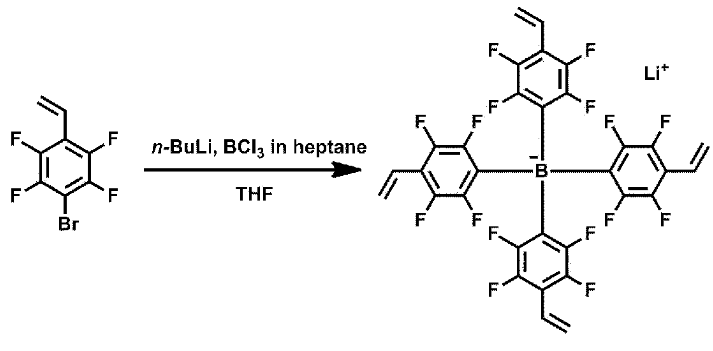


**F-1**

1-Bromo-2,3,5,6-tetrafluoro-4-vinylbenzene (2 g, 7.8428 mmol) was put into 20 mL of tetrahydrofuran (THF) in a 50-mL round bottom flask, and the resulting solution was stirred under a condition of -78°C for 30 minutes. n-BuLi (3.45 mL, 8.6271 mmol, 2.5 M in a hexane solution) was slowly added to the solution, and the resulting mixture was stirred at -78°C for 30 minutes. $BCl_3$ (2.6 mL, 2.6142 mmol, 1 M in a heptane solution) was added to the reaction solution at -78°C over 15 minutes. The resulting solution was slowly warmed to room temperature, the reaction solution was stirred overnight, and then 30 mL of water was added thereto. The synthesized material was extracted with ethyl acetate (EA) (10 mL, three times), and then the solvent was completely removed. Water was completely removed by means of a Dean-stock using benzene, and the solid was filtered to prepare 800 mg of Compound F-1. (Yield: 43 %).

(2) Preparation of Compound D-A

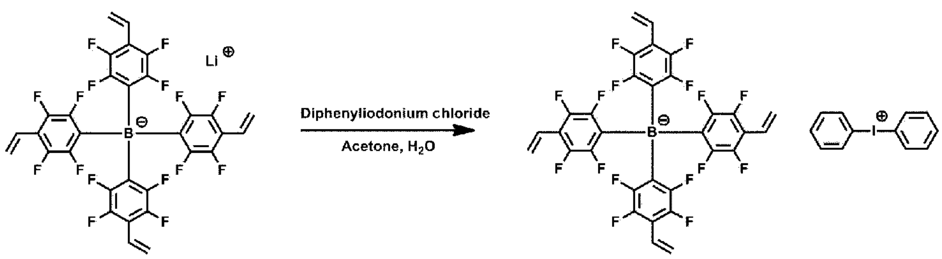


**F-1** **D-A**

Compound F-1 (400 mg, 0.5569 mmol), diphenyliodonium chloride (176 mg, 0.5569 mmol), 10 mL of $H_2O$, and 10 mL of acetone were put into a 25-mL round bottom flask and stirred for 30 minutes. Extraction was performed using dichloromethane to remove and dry the solvent. After the solvent was thoroughly removed, water was completely removed by means of a Dean-stock using benzene, and the solid was filtered to prepare 340 mg of the target compound D-A. (Yield: 28%) The synthesis of the compound was confirmed through LC-MS and NMR.

MS: [M-H]- = 711 (negative mode)
MS: [M+H]+ = 281 (positive mode)

FIG. 2 shows the NMR measurement results of Compound D-A.

**Synthesis Example B-2. Preparation of Compound D-B**

(1) Preparation of Compound F-2

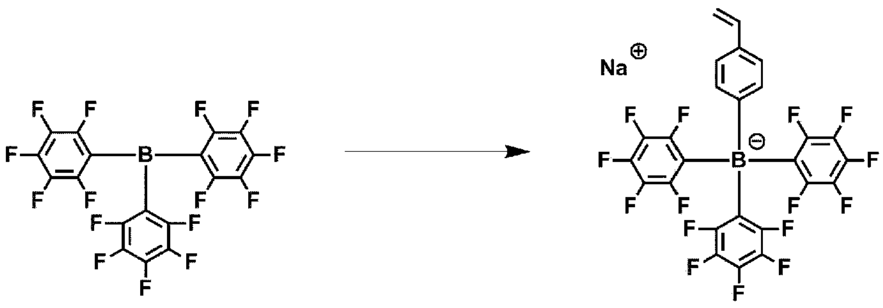

F-2

Mg (193 mg, 7.9208 mmol), $I_2$ (4 mg), and THF (10 mL) were put into a 100-ml round bottom flask under a nitrogen atmosphere, and the resulting mixture was stirred for 30 minutes. 4-Bromostyrene (1.04 mL, 7.9208 mmol) was put thereinto, a water bath at 30°C was placed under the round bottom flask, and the resulting mixture was stirred overnight. It was confirmed that the reaction solution had become black and Mg had been dissolved therein. The reaction solution was diluted by adding 5 mL of ether thereto. Tris(pentafluorophenyl)borane (1 g, 3.9604 mmol) was dissolved in 5 mL of ether, and the resulting solution was slowly added to the reaction solution for 30 minutes. The solution was stirred overnight. $Na_2CO_3$ (0.1 M, 80 mL, 8.0 mmol) was slowly added to the reaction solution. The organic solvent was extracted using EA, and the remaining water was removed over $MgSO_4$. Additionally, distillation was conducted with benzene by using a Dean-stock in order to remove the remaining water and impurities. When about 10 mL of the solvent remained, the solution was cooled and filtered to prepare 1.6 g of Compound F-2. (Yield: 64 %).

(2) Preparation of Compound D-B

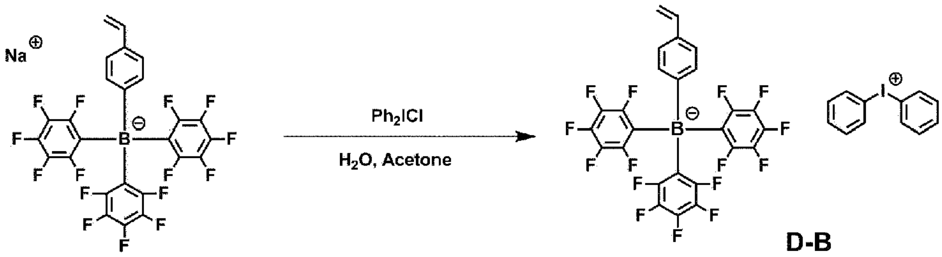


D-B

F-2

Compound F-2 (100 mg, 0.1567 mmol), 10 mL of distilled water and $Ph_2ICl$ (60 mg, 0.1881 mmol) were put into a 25-mL round bottom flask and stirred for 1 hour. When 15 mL of acetone was added to the reaction solution, a precipitate was produced, and the precipitate was filtered and dried to prepare 140 mg of Compound D-B. (Yield: 100 %) The synthesis of the compound was confirmed through LC-MS and NMR.

MS: [M-H]- = 615 (negative mode)
MS: [M+H]+ = 281 (positive mode)

FIG. 3 shows the NMR measurement results of Compound D-B.

**<Preparation of Ink Composition>**

**Preparation Example 1. Preparation of Ink Composition 1**

Mixture 1 was prepared by mixing Compound H-2 and Compound D-B at a weight ratio of 8:2. Thereafter, Mixture 1 was added at a concentration of 2 wt% to a mixed solvent in which a first solvent dibutyl succinate and a second solvent dibutyl oxalate were included at 25 wt% and 75 wt%, respectively. The mixed and prepared solution was stirred for 24 hours and completely dissolved to prepare Ink Composition 1.

**Preparation Examples 2 to 29. Preparation of Ink Compositions 2 to 29.**

An ink composition was prepared in the same manner as in Preparation Example 1, except that the materials shown in Table 1 were used instead of Compound H-2, Compound D-B, the first solvent, and the second solvent, respectively.

In the following Table 1, when a third solvent is further used in addition to the first solvent and the second solvent, a solvent in which the first solvent, the second solvent, and the third solvent were mixed at 15 wt%, 45 wt%, and 40 wt%, respectively, was used as a mixed solvent.

**<Experimental Example A>**

**Example 1-1.**

After Ink Composition 1 was printed on an ITO substrate having banks patterned thereon by an inkjet method, the printed substrate was put into a vacuum chamber, and the pressure was reduced from normal pressure to $2\times10^{-2}$ torr for 60 seconds and from $2\times10^{-2}$ torr to $2x10^{-6}$ torr for 180 seconds, and drying was performed at room temperature. After drying, a cured thin film was formed by performing a heat treatment under the conditions of $N_2$ atmosphere and hot plate 230°C for 30 minutes.

The thickness and profile of the cured thin film included in the pixel were measured using an optical profiler manufactured by Bruker (model name: Contour GT-I), which is an optical thickness measuring device, and the ratio of a region having a thickness within 5% from the pixel center thickness in a range of 95% of the width with respect to the short-axis of the pixel was calculated. Thereafter, the flatness was derived using the following Equation 1.

Flatness = [number of i's in which $\{(H_c-H_i)/(\text{average of } H_i \text{ from } i=1 \text{ to } n) < 0.05\}]/n$ [Equation 1]

n = an integer from 2 to 1000
i = the thickness measurement position between 1 and n in the flatness measurement section,
$H_i$ = the thickness of the thin film at the i-th measurement point
Hc = the thickness of the thin film at the center of the pixel

**Examples 1-2 to 1-16.**

A thin film was prepared in the same manner as in Example 1-1, except that the ink composition shown in the following Table 1 was used instead of Ink Composition 1 in Example 1-1, and then flatness was measured.

**Comparative Examples 1-1 to 1-13.**

A thin film was prepared in the same manner as in Example 1-1, except that the ink composition shown in the following Table 1 was used instead of Ink Composition 1 in Example 1-1, and then flatness was measured.

The following Table 1 shows the results of measuring the flatness of thin films with a thin film thickness of 50 nm in a unit pixel with a short-axis width of 40 μm to 45 μm.

[Table 1]

| | Ink Composition | HIL host | HIL dopant | First solvent | Second solvent | Third solvent | Flatness |
|---|---|---|---|---|---|---|---|
| Example 1-1 | 1 | H-2 | D-B | Dibutyl succinate | Dibutyl oxalate | - | O |
| Example 1-2 | 2 | H-4 | D-A | Dibutyl adipate | Dibutyl succinate | - | O |
| Example 1-3 | 3 | H-5 | D-A | Diethyl sebacate | Dibutyl succinate | - | O |
| Example 1-4 | 4 | H-6 | D-A | Dibutyl adipate | Dibutyl oxalate | - | O |
| Example 1-5 | 5 | H-1 | D-B | Dibutyl succinate | Diethyl butylmalonate | - | O |
| Example 1-6 | 6 | H-3 | D-B | Dibutyl adipate | Dibutyl oxalate | Diethyl malonate | O |
| Example 1-7 | 7 | H-6 | D-A | Dibutyl succinate | Diethyl butylmalonate | Diethyl malonate | O |
| Example 1-8 | 8 | H-6 | D-A | Dibutyl succinate | Dibutyl oxalate | Diisopropyl malonate | O |
| Example 1-9 | 9 | H-2 | D-A | Dibutyl adipate | Dibutyl oxalate | Diisopropyl malonate | O |
| Example 1-10 | 10 | H-1 | D-A | Diethyl sebacate | Dibutyl oxalate | Diisopropyl malonate | O |
| Example 1-11 | 11 | H-2 | D-B | Dibutyl succinate | Diethyl butylmalonate | Diisopropyl malonate | O |
| Example 1-12 | 12 | H-2 | D-A | Dibutyl adipate | Dibutyl succinate | Diisopropyl malonate | O |
| Example 1-13 | 13 | H-5 | D-B | Diethyl sebacate | Dibutyl oxalate | Diethyl succinate | O |
| Example 1-14 | 14 | H-6 | D-A | Dibutyl succinate | Dibutyl oxalate | Diethyl succinate | O |
| Example 1-15 | 15 | H-4 | D-A | Diethyl adipate | Diethyl butylmalonate | Diethyl succinate | O |
| Example 1-16 | 16 | H-3 | D-B | Diethyl sebacate | Diethyl butylmalonate | Diethyl succinate | O |
| Comparative Example 1-1 | 17 | H-3 | D-B | Dimethyl phthalate | Diethylene glycol | - | X |
| Comparative Example 1-2 | 18 | H-4 | D-A | Ethyl 4-ethoxybezoate | Dibutyl oxalate | - | X |
| Comparative Example 1-3 | 19 | H-1 | D-A | Ethyl 4-ethoxybezoate | Benzyl butyrate | - | X |
| Comparative Example 1-4 | 20 | H-2 | D-B | 1-Methoxynaphthalene | Benzyl butyrate | - | X |
| Comparative Example 1-5 | 21 | H-6 | D-A | Ethyl 4-ethoxybezoate | Benzyl butyrate | Acetophenone | X |
| Comparative Example 1-6 | 22 | H-5 | D-B | Ethyl 4-ethoxybezoate | Diethylene glycol dibutylether | Diethyl malonate | X |

(continued)

| | Ink Composition | HIL host | HIL dopant | First solvent | Second solvent | Third solvent | Flatness |
|---|---|---|---|---|---|---|---|
| Comparative Example 1-7 | 23 | H-2 | D-B | 1-Methoxynaphthalene | Diethylene glycol | Diisopropyl malonate | X |
| Comparative Example 1-8 | 24 | H-1 | D-A | 1-Methoxynaphthalene | Diethylene glycol dibutylether | Methyl salicylate | X |
| Comparative Example 1-9 | 25 | H-6 | D-A | Dimethyl phthalate | Benzyl butyrate | Diethyl succinate | X |
| Comparative Example 1-10 | 26 | H-2 | D-A | Dimethyl phthalate | Dibutyl oxalate | Acetophenone | X |
| Comparative Example 1-11 | 27 | H-5 | D-A | Dimethyl phthalate | Diethylene glycol dibutylether | Diethyl malonate | X |
| Comparative Example 1-12 | 28 | H-4 | D-A | Benzyl benzoate | Dibutyl succinate | Ethyl benzoate | X |
| Comparative Example 1-13 | 29 | H-2 | D-B | Diethyl sebacate | Diphenyl ether | Ethyl benzoate | Δ |
| Comparative Example 1-14 | 30 | H-5 | D-A | Diethyl malonate | - | - | X |
| Comparative Example 1-15 | 31 | H-5 | D-A | Dibutyl oxalate | - | - | X |
| Comparative Example 1-16 | 32 | H-6 | D-B | Dibutyl succinate | - | - | Δ |

- ○: Flatness 0.6 or more
- △: Flatness 0.4 or more and less than 0.6
- X: Flatness less than 0.4

FIG. 8 illustrates the flatness measurement results when pixels are formed using Ink Composition 1. In FIG. 8, (a) shows the pixel flatness measurement results when pixels with a short-axis width of 20 μm to 25 μm were manufactured, and (b) shows the pixel flatness measurement results when pixels with a short-axis width of 40 μm to 45 μm were manufactured. In FIGS. 8(a) and 8 (b), the dotted lines are banks, s1 is a thin film with a thickness in a range of 50 nm to 70 nm, and s2 is a thin film with a thickness in a range of 100 nm to 120 nm. Further, in FIGS. 8(a) and 8(b), flat portions are indicated by arrows (↔).

FIG. 9 illustrates the flatness measurement results when pixels are formed using Ink Composition 18. In FIG. 9, (a) shows the pixel flatness measurement results when pixels with a short-axis width of 20 μm to 25 μm were manufactured, and (b) shows the pixel flatness measurement results when pixels with a short-axis width of 40 μm to 45 μm were manufactured. In FIGS. 9(a) and 9(b), the dotted lines are banks, s1 is a thin film with a thickness in a range of 50 nm to 70 nm, and s2 is a thin film with a thickness in a range of 100 nm to 120 nm.

From Table 1, FIG. 8, and FIG. 9, it can be confirmed that the example using the ink composition according to an exemplary embodiment of the present invention has excellent flatness. In contrast, it can be confirmed that the flatnesses of the Comparative Examples using an ink composition that does not correspond to the present invention decrease.

Specifically, from Table 1, it can be confirmed that pixels are uniformly formed because Examples 1-1 to 1-16 using the ink composition according to an exemplary embodiment of the present invention all have a flatness value of 0.6 or more. Accordingly, it is possible to expect excellent light emitting and/or coloring effects by reducing factors that affect the

interference condition of light emitted from the light emitting device according to the thickness because the ink composition is used in the organic material layer and the like in the organic light emitting device. In contrast, it can be confirmed that pixels with a non-uniform thickness are formed because the flatnesses of the pixels of Comparative Examples 1-1 to 1-13 using a solvent other than Chemical Formula A as the first or second solvent and Comparative Examples 1-14 to 1-16 using only one solvent all exhibit a value of less than 0.6.

In addition, from FIGS. 8 and 9, it can be confirmed that the ink composition according to an exemplary embodiment of the present invention exhibit excellent flatness. Specifically, it can be confirmed that when comparing FIG. 8(a) and FIG. 9(a), in which experiments are performed on the short-axis with the same width, with each other and comparing FIG. 8(b) and FIG. 9(b) with each other, FIGS. 8(a) and 8(b) using the ink composition according to an exemplary embodiment of the present invention exhibit flat portions, whereas no flat portion appears in FIGS. 9(a) and 9(b) using an ink composition that does not correspond to the present invention. Furthermore, from (a) and (b) of FIG. 9, it can be confirmed that when an ink composition that does not correspond to the present invention is used, a flat section is not secured even though the short-axis width increases.

**<Experimental Example B>**

**Example 2-1.**

A glass substrate which was thin-film coated to have a thickness of 700 Å of indium tin oxide (ITO) and patterned with hydrophobic banks was washed with distilled water for 30 minutes and then dried on a hot plate at 230°C for 10 minutes. Ink Composition 1 in Table 1 was inkjet printed on a washed substrate patterned with banks, and heat-treated at 230°C for 30 minutes, thereby forming a hole injection layer having a thickness of 30 nm. A hole transport layer having a thickness of 40 nm was formed on the hole injection layer by inkjet printing an ink prepared by dissolving the following α-NPD compound in cyclohexyl benzene at a concentration of 2 wt %. Thereafter, the glass substrate was transferred to a vacuum deposition machine, and then the following ADN compound and the following DPAVBi compound were vacuum-deposited on the hole transport layer at a weight ratio of 20:1 (ADN:DPAVBi) to have a thickness of 20 nm, thereby forming a light emitting layer. The following BCP compound was vacuum-deposited to have a thickness of 35 nm on the light emitting layer, thereby forming an electron injection and transport layer. A cathode was formed by sequentially depositing LiF and aluminum to have a thickness of 1 nm and 100 nm, respectively, on the electron injection and transport layer, thereby manufacturing an organic light emitting device.

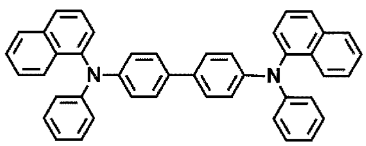

a-NPD

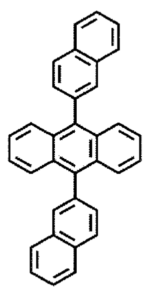

ADN

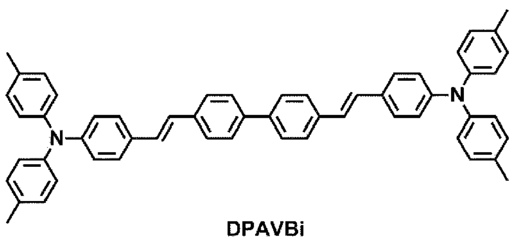

DPAVBi

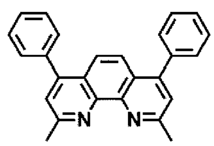

BCP

**Examples 2-2 to 2-16.**

Organic light emitting devices were manufactured in the same manner as in Example 2-1, except that the ink compositions in the following Table 2 were used instead of Ink Composition 1 in Example 2-1.

[Table 2]

| | Ink Composition |
|---|---|
| Example 2-1 | 1 |
| Example 2-2 | 2 |
| Example 2-3 | 3 |
| Example 2-4 | 4 |
| Example 2-5 | 5 |
| Example 2-6 | 6 |
| Example 2-7 | 7 |
| Example 2-8 | 8 |
| Example 2-9 | 9 |
| Example 2-10 | 10 |
| Example 2-11 | 11 |
| Example 2-12 | 12 |
| Example 2-13 | 13 |
| Example 2-14 | 14 |
| Example 2-15 | 15 |
| Example 2-16 | 16 |

It was confirmed that the organic light emitting devices manufactured in Examples 2-1 to 2-16 were driven. Through this, it was confirmed that the ink compositions according to the exemplary embodiments of the present invention can be applied to an organic light emitting device.

## Claims

**1.** An ink composition comprising:

a compound represented by the following Chemical Formula 1;
a first solvent represented by the following Chemical Formula A; and
a second solvent represented by the following Chemical Formula A and different from the first solvent:

[Chemical Formula 1]

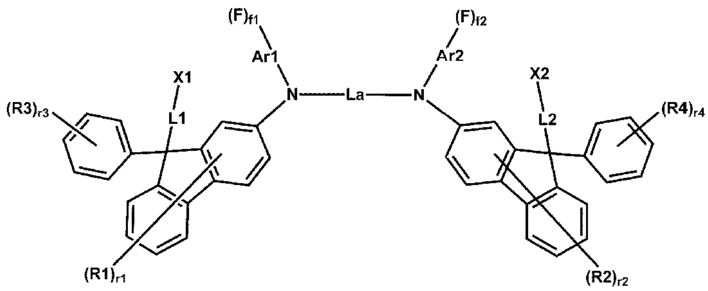

[Chemical Formula A]

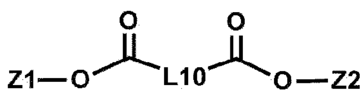

wherein, in Chemical Formulae 1 and A,

La is a substituted or unsubstituted divalent hydrocarbon ring group; or a substituted or unsubstituted divalent heterocyclic group,

L1 and L2 are the same as or different from each other, and are each independently a direct bond; or a substituted or unsubstituted arylene group,

R1 to R4 are the same as or different from each other, and are each independently hydrogen; deuterium; a halogen group; a substituted or unsubstituted alkyl group; a substituted or unsubstituted alkoxy group; a substituted or unsubstituted aryl group; or a substituted or unsubstituted heteroaryl group,

Ar1 and Ar2 are the same as or different from each other, and are each independently a substituted or unsubstituted aryl group; or a substituted or unsubstituted heteroaryl group,

X1 and X2 are the same as or different from each other, and are each independently a curable group,

L10 is a direct bond; or a substituted or unsubstituted alkylene group,

Z1 and Z2 are the same as or different from each other, and are each independently a substituted or unsubstituted alkyl group; or a substituted or unsubstituted aryl group,

r1 and r2 are each an integer from 1 to 7, r3 and r4 are each an integer from 1 to 5, and when r1 to r4 are each 2 or higher, two or more substituents in the parenthesis are the same as or different from each other,

f1 is 1 to the number of binding positions in which substituents can be bonded to Ar1, and

f2 is 1 to the number of binding positions in which substituents can be bonded to Ar2.

**2.** The ink composition of claim 1, wherein Chemical Formula 1 is any one of the following structures:

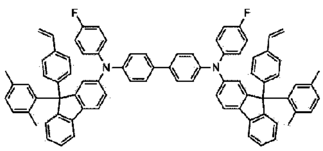
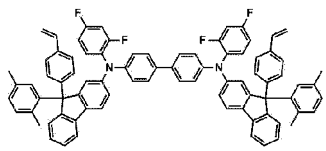
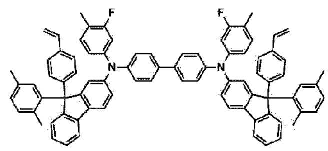
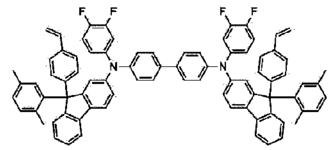
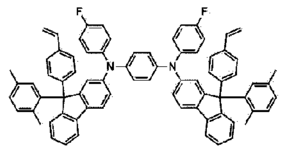
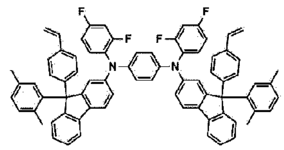
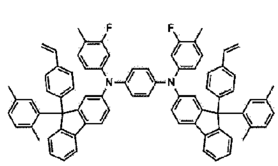
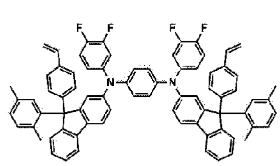
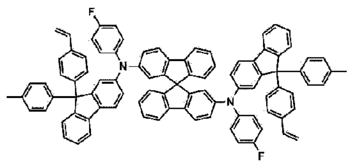
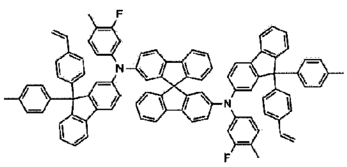
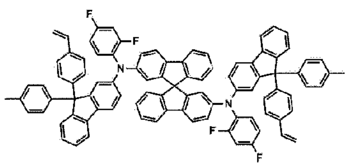
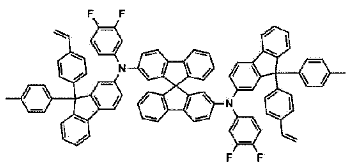
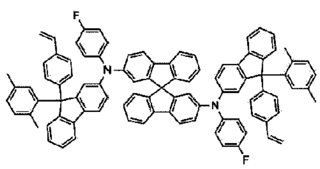
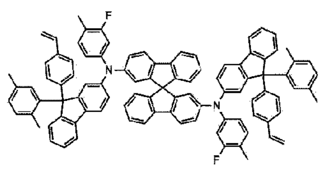
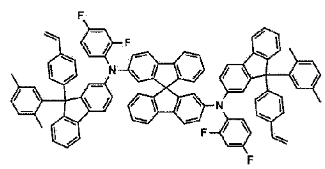

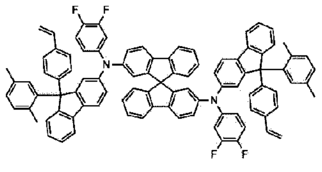
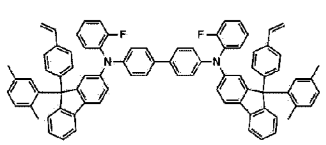
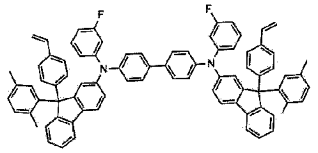

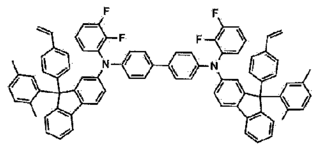
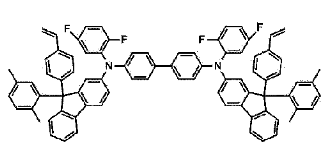
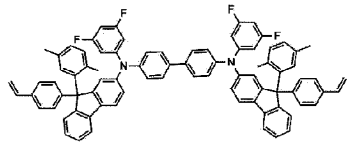

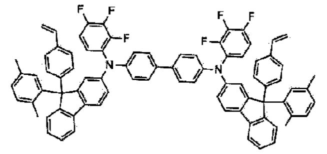
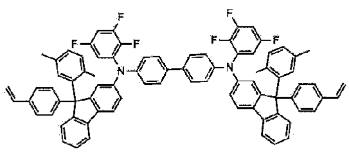
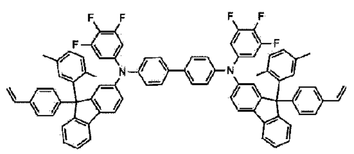

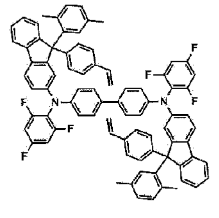
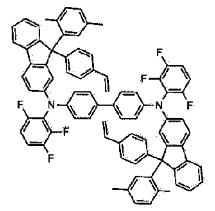
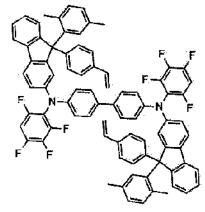
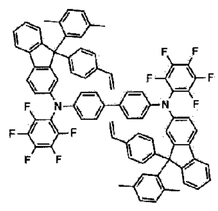

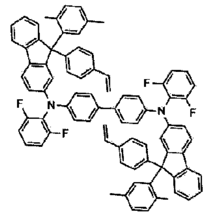

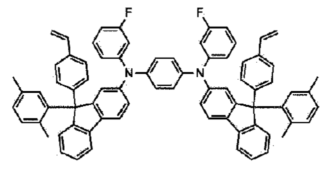
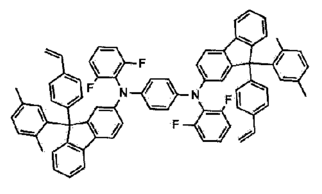
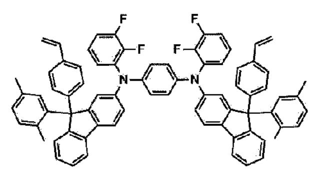

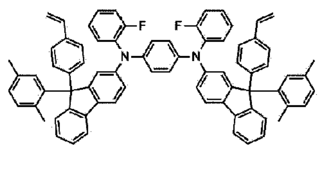
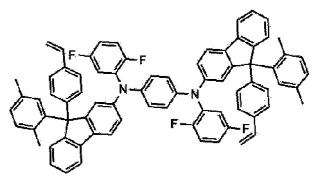
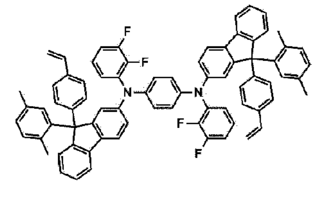

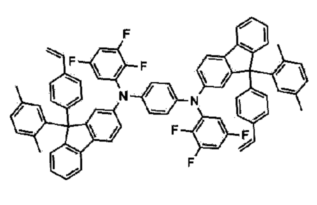
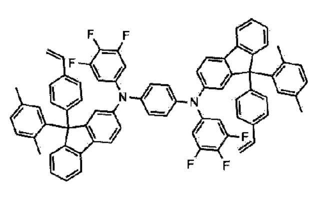
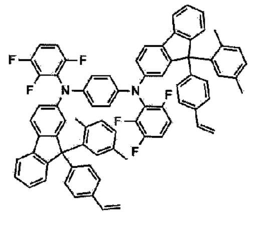

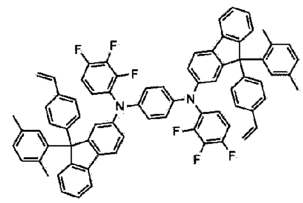
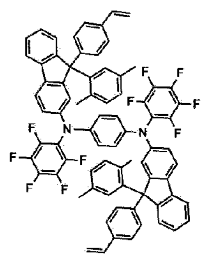
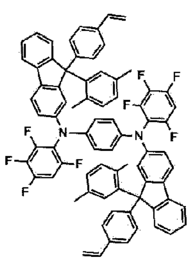
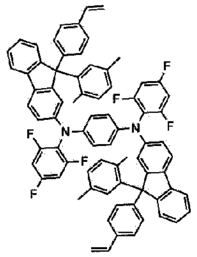

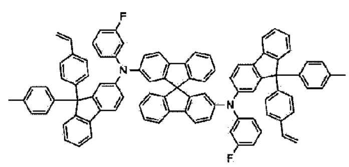
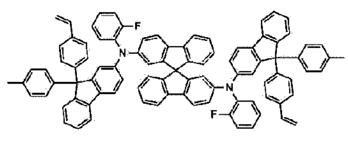
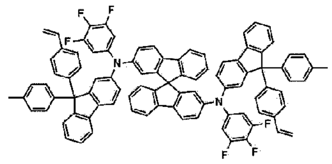

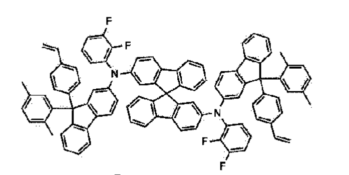
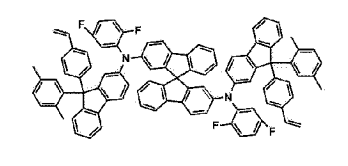
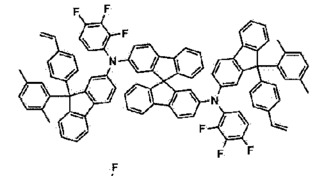

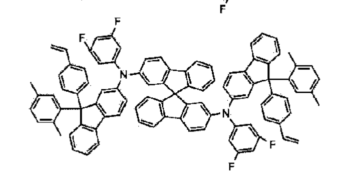
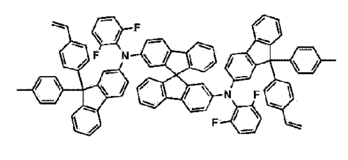
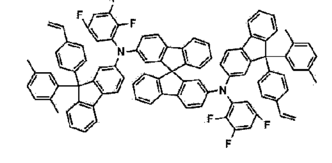

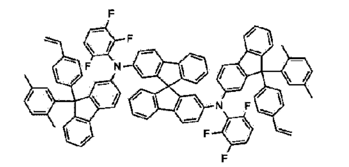
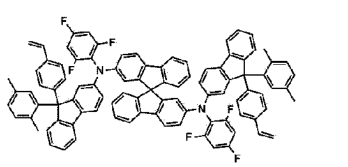
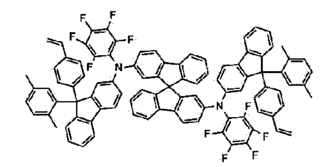

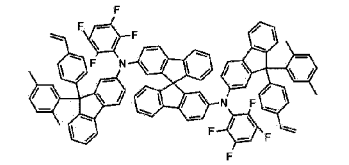
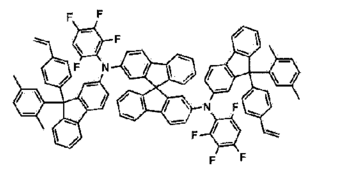
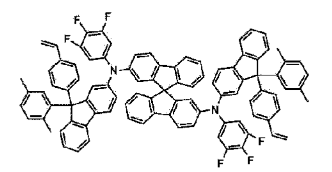

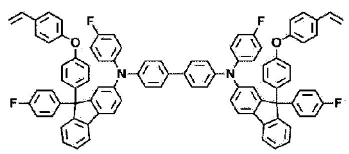
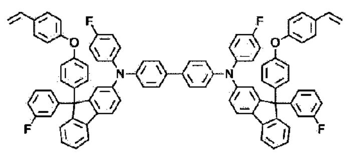
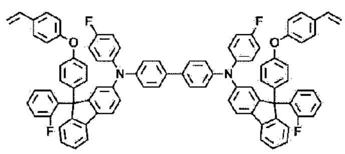

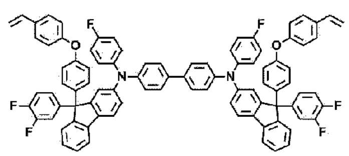
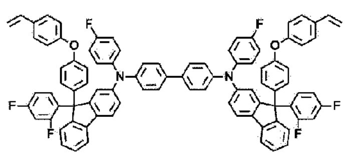
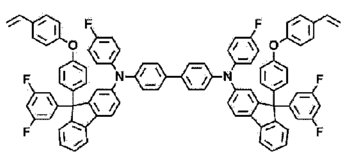

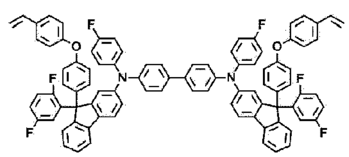
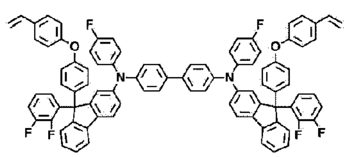
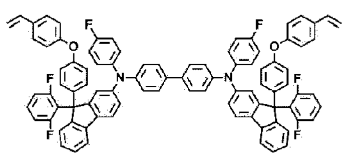

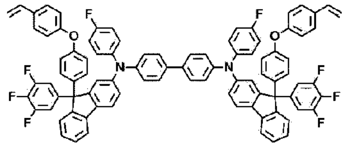
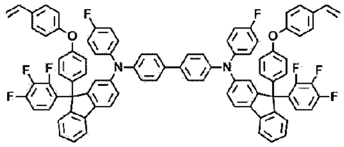
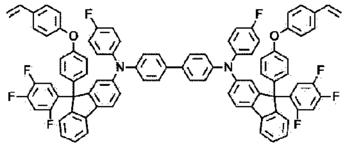

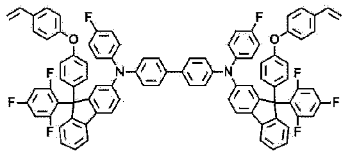
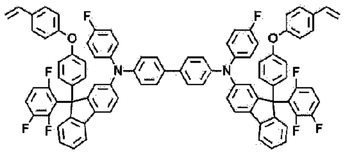
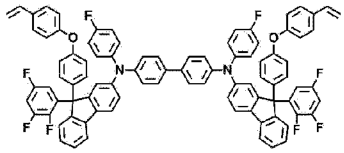

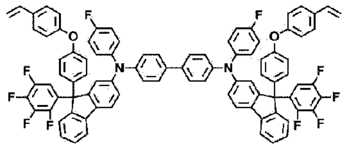
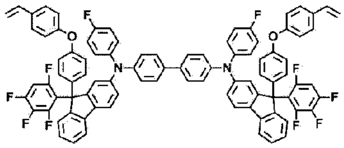
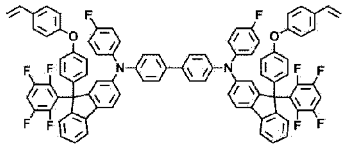

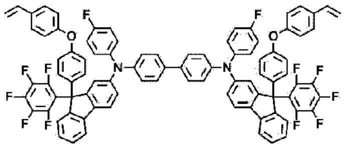

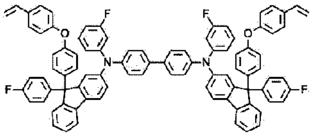
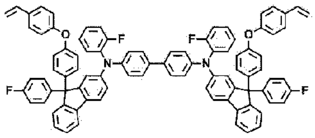
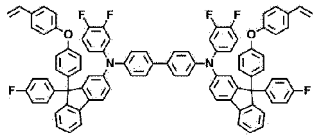

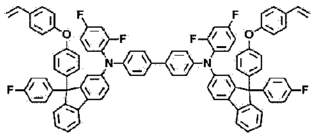
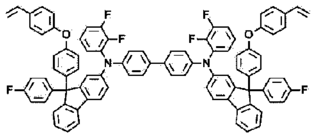
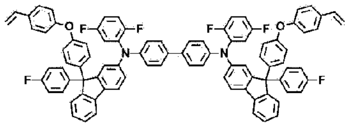

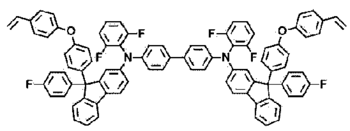
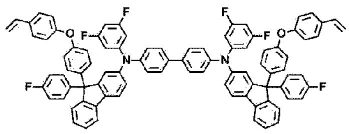
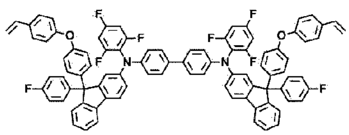

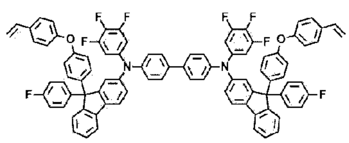
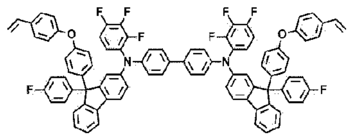
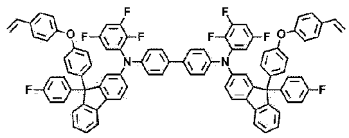

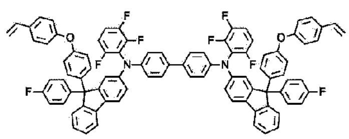
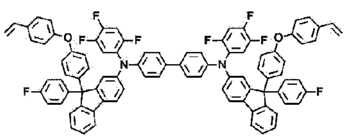
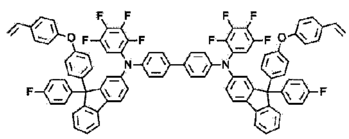

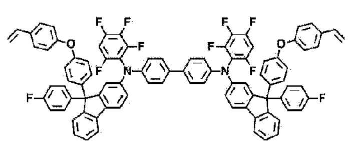
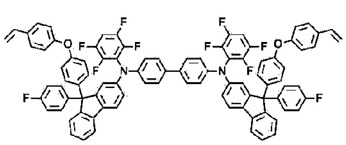
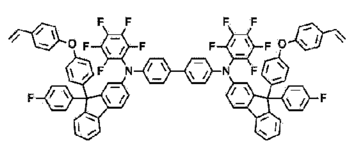

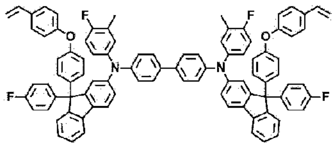 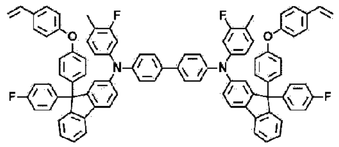 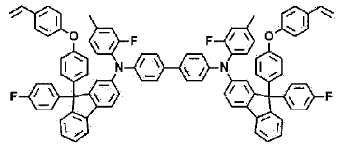

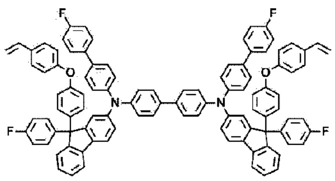 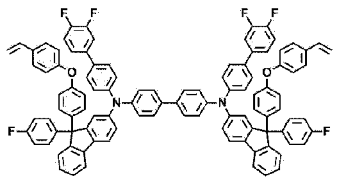 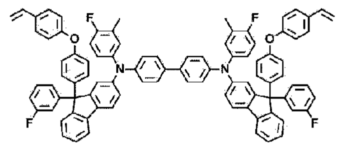

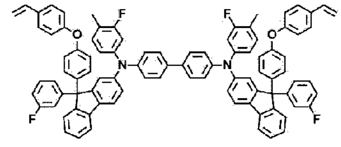 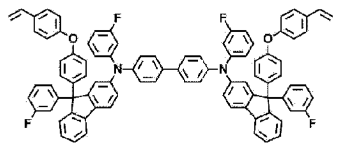 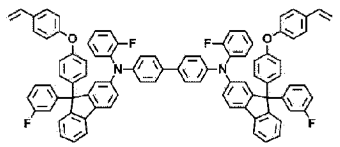

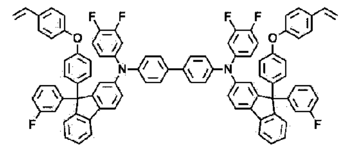 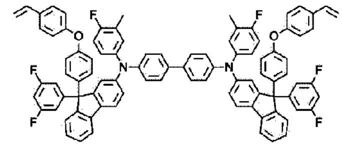 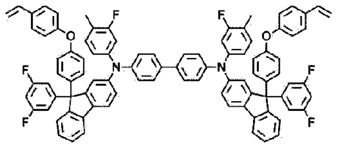

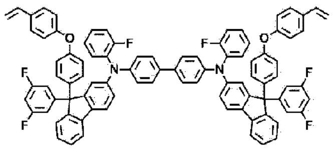 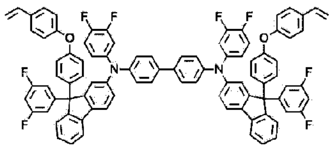 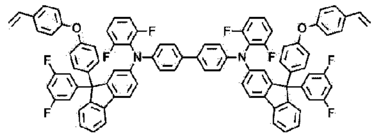

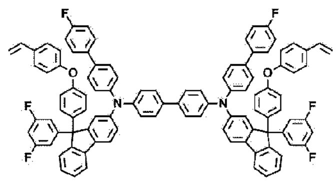 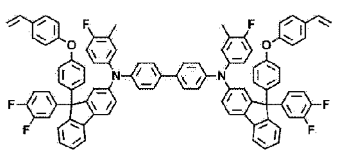 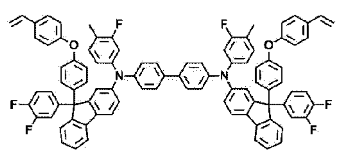

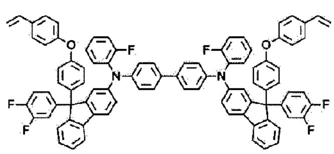 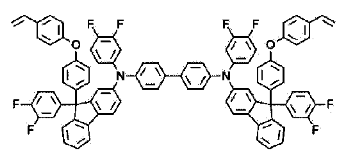 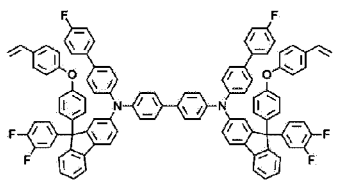

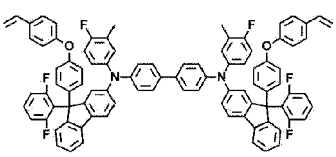 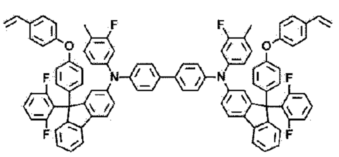 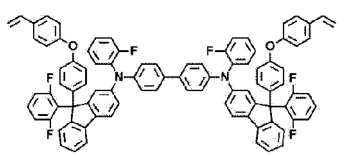

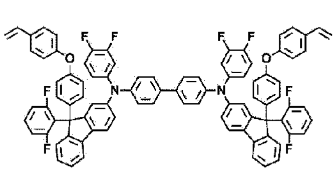 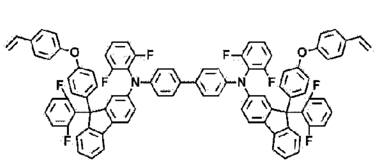 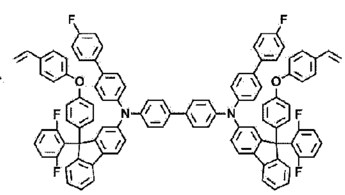

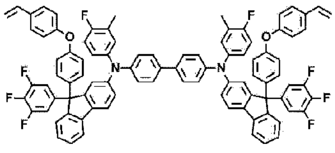 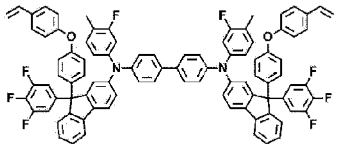 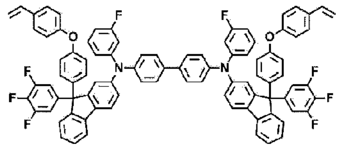

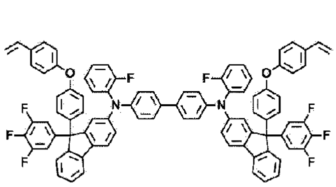 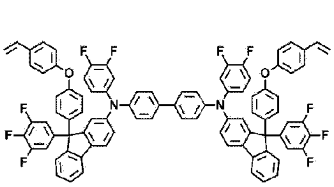 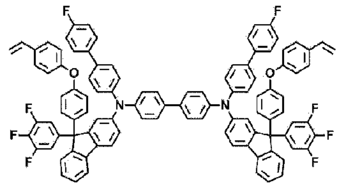

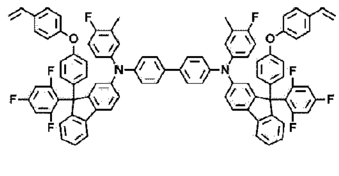 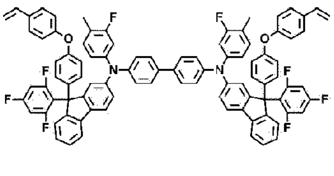 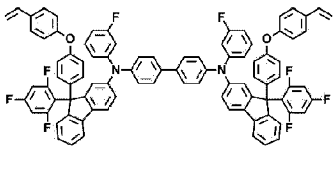

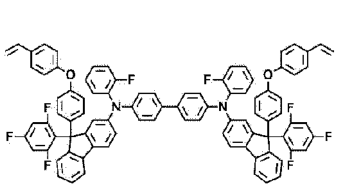 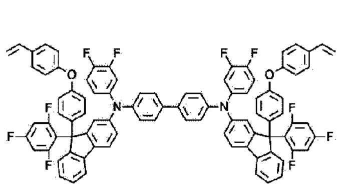 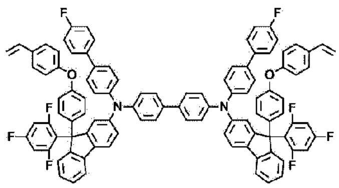

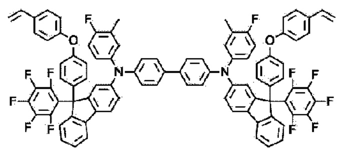 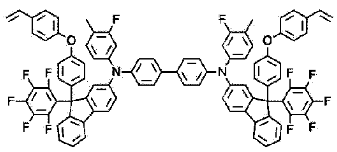 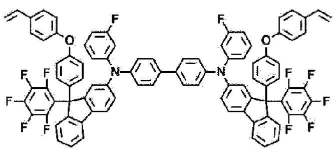

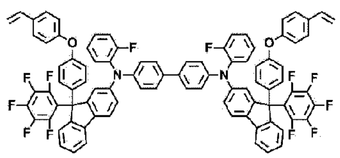 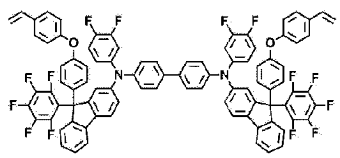 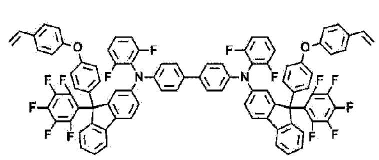

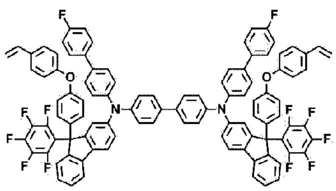

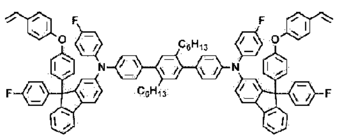 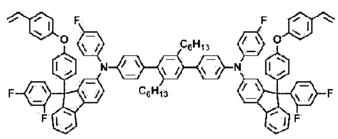 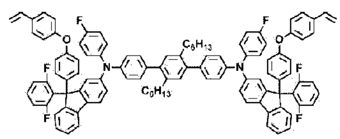

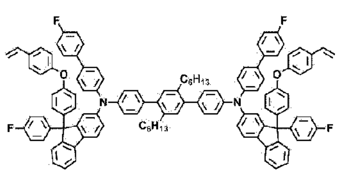 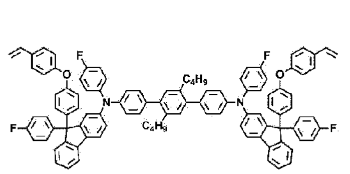 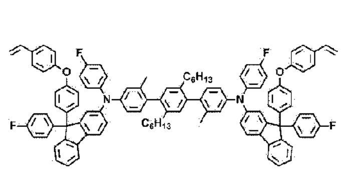

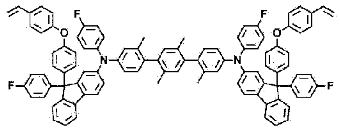 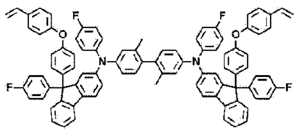 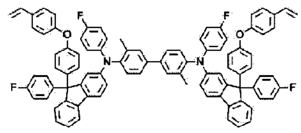

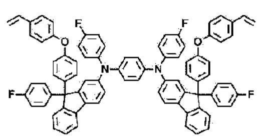 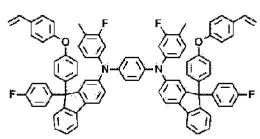 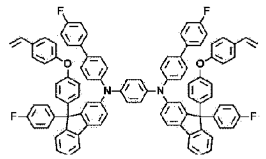

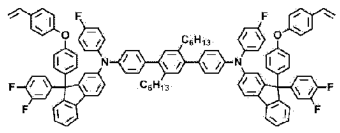 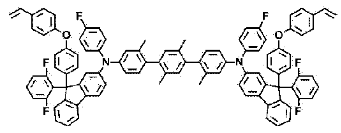

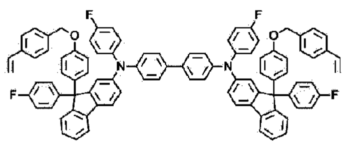 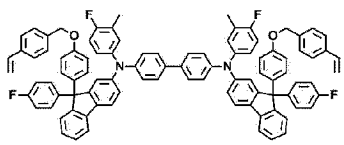 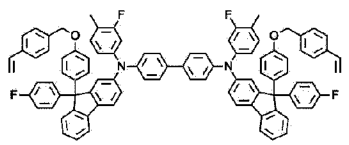

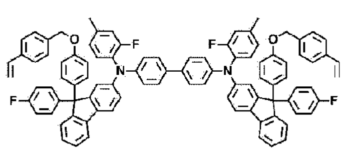 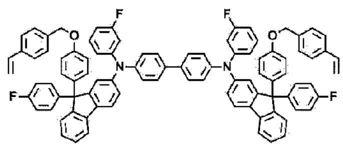 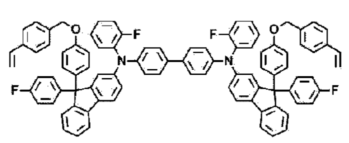

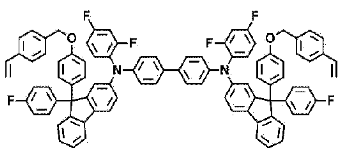 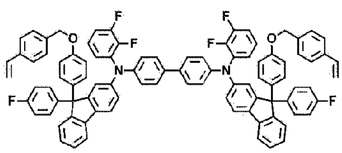 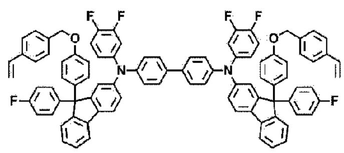

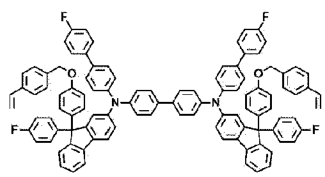 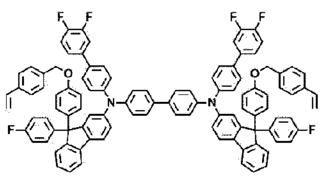 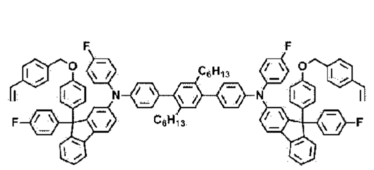

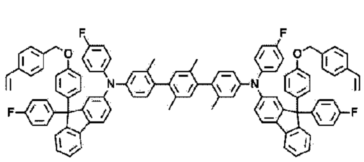 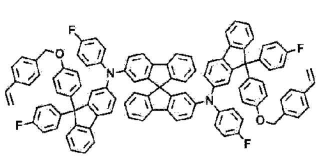 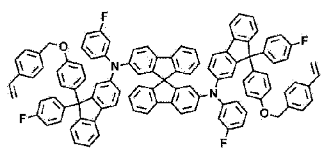

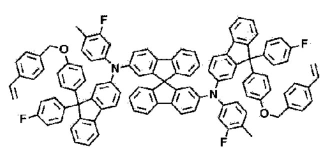 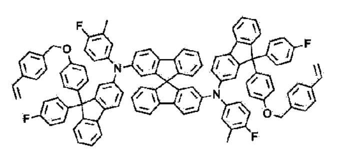 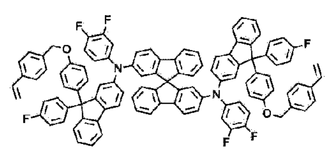

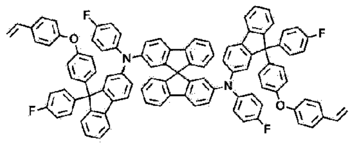
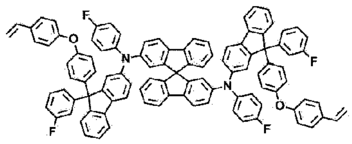
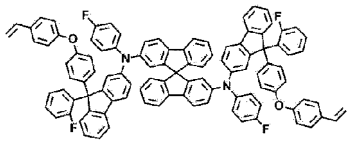

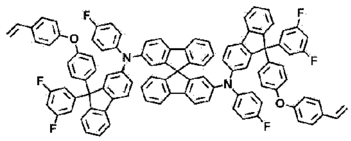
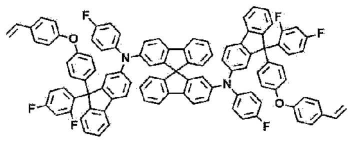
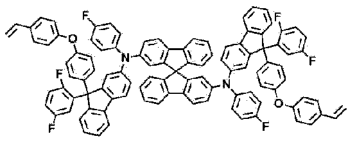

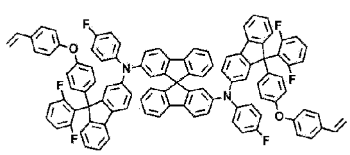
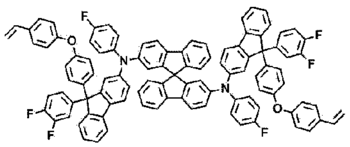
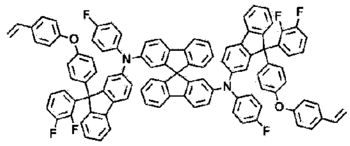

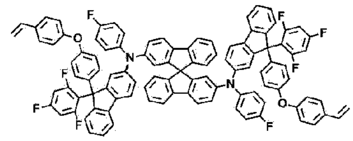
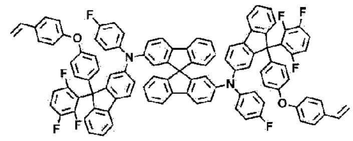
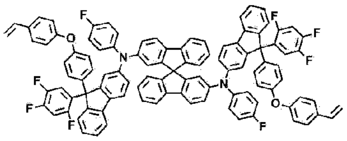

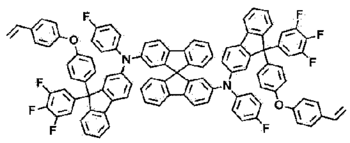
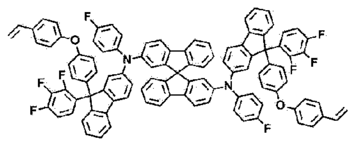
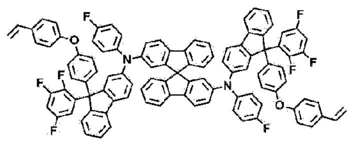

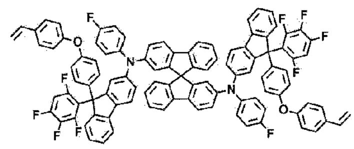
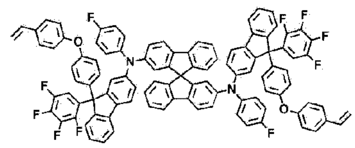
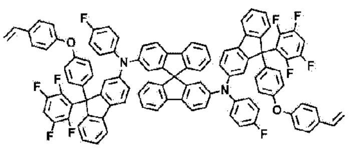

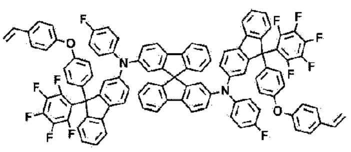

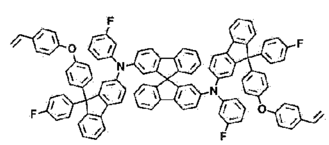
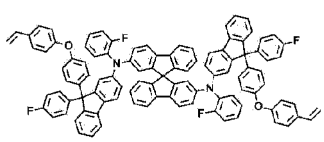
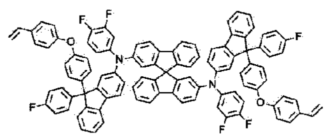

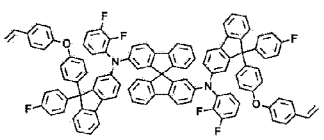
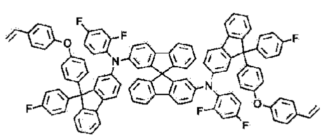
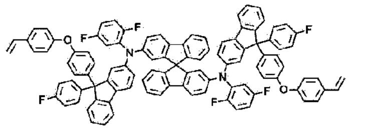

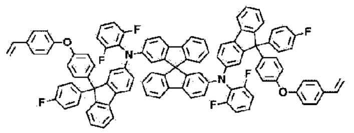
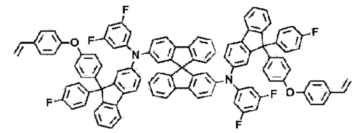
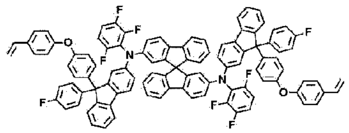

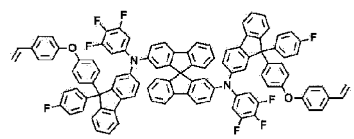
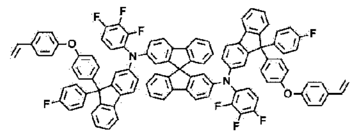
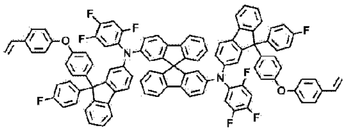

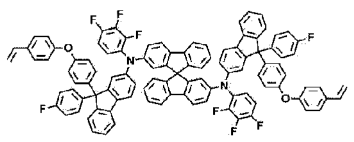
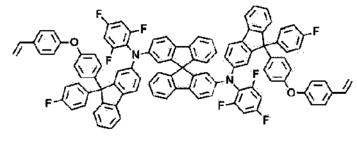
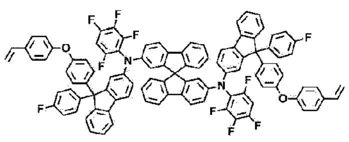

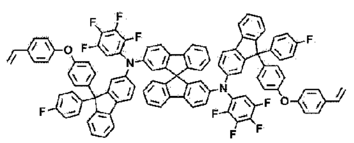
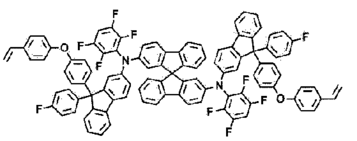
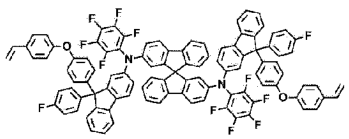

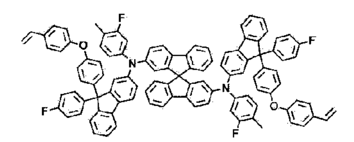
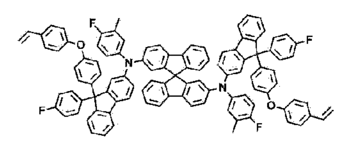
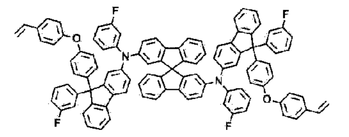

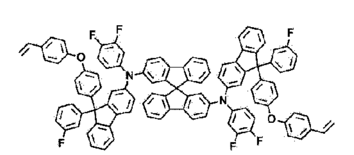
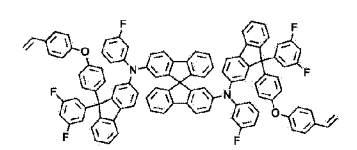
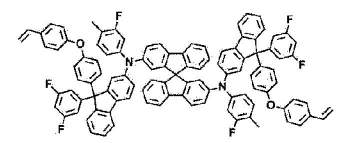

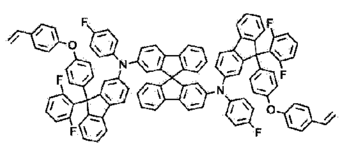
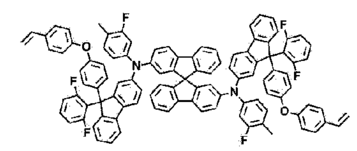
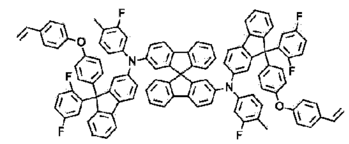

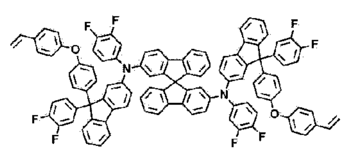
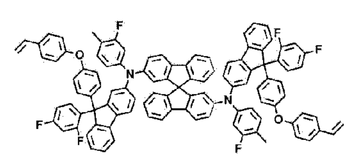
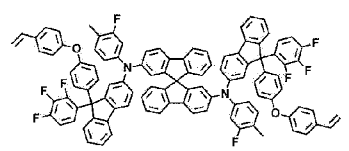

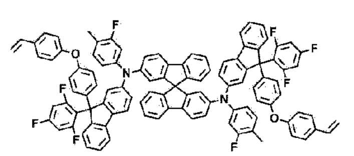
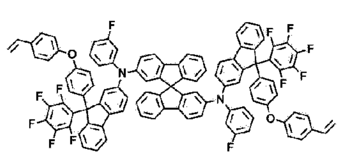
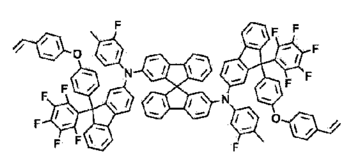

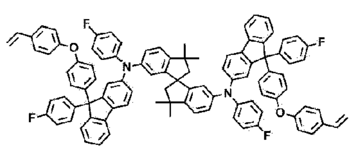
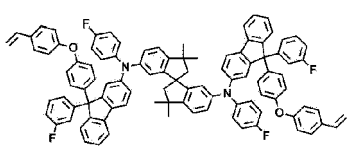
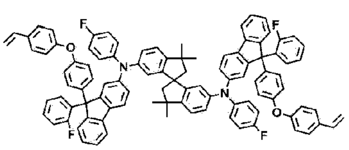

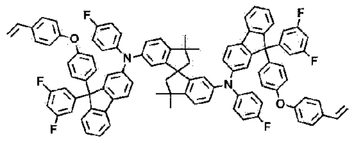
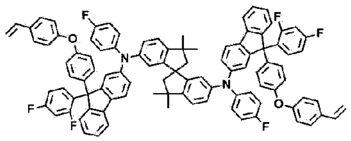
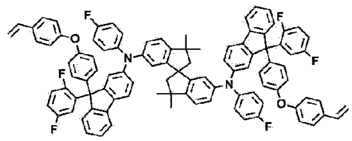

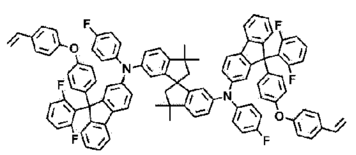
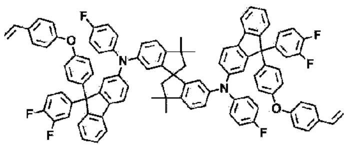
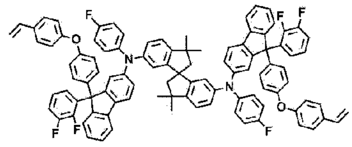

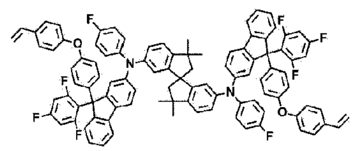
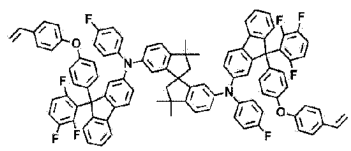
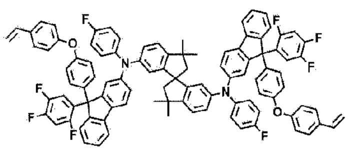

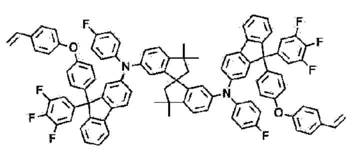
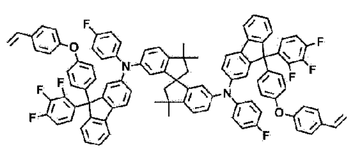
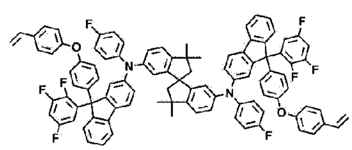

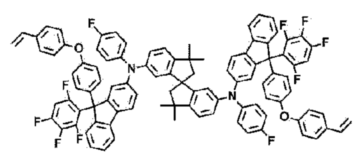
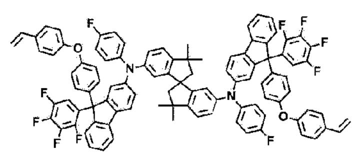
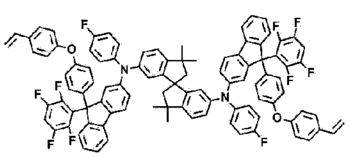

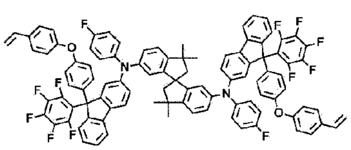

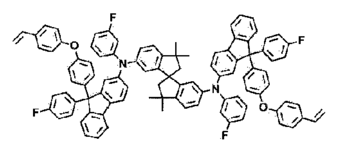
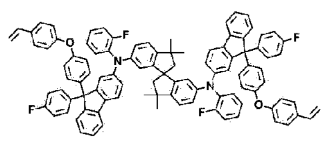
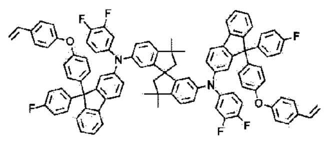

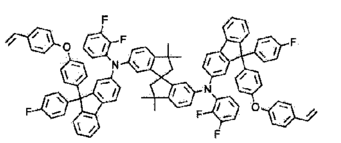
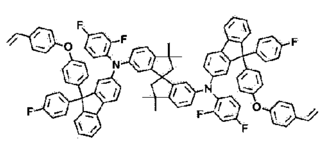
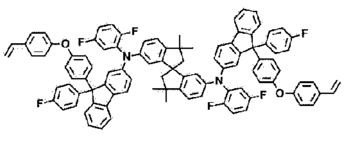

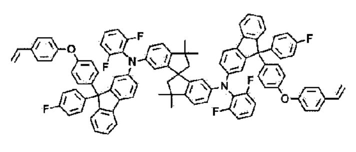
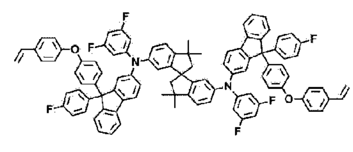
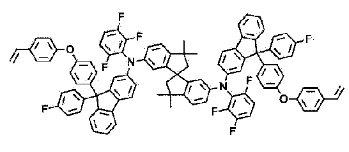

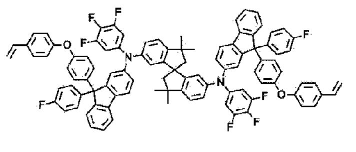
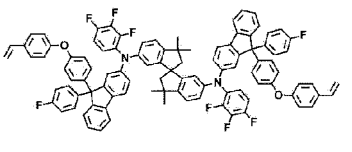
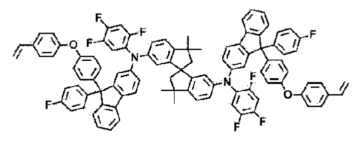

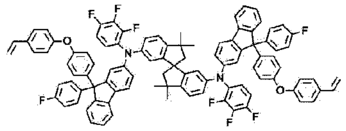
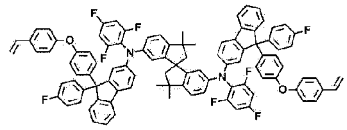
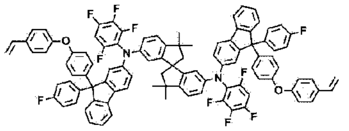
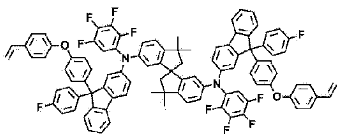
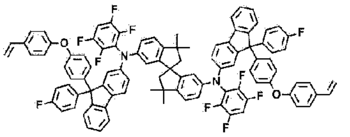
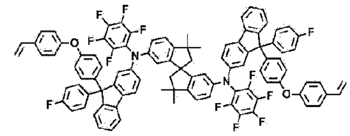
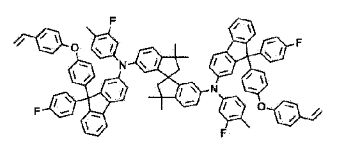
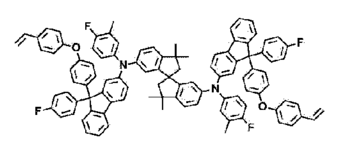
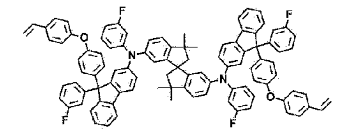
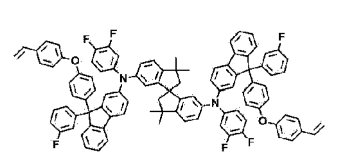
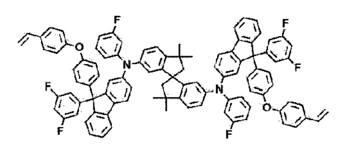
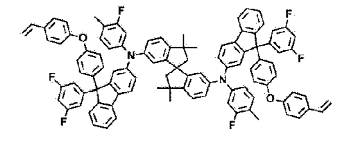
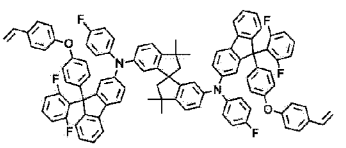
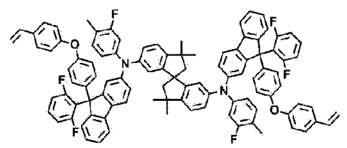
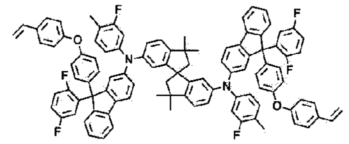
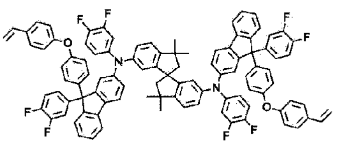
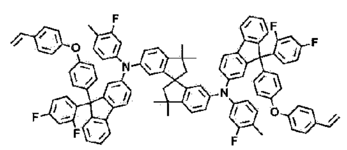
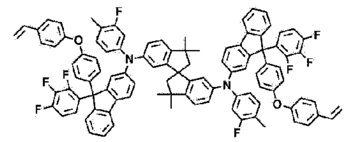
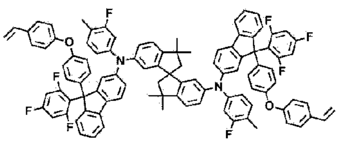
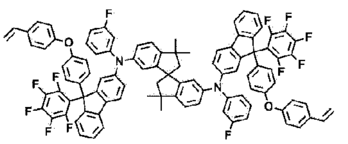
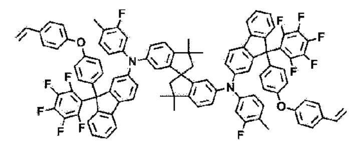
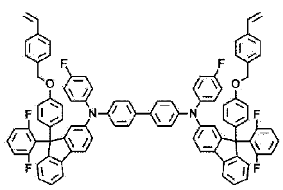
.

**3.** The ink composition of claim 1, wherein Chemical Formula A is any one of the following structures:

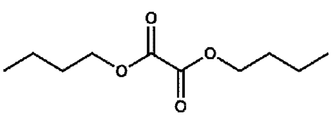
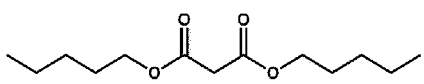

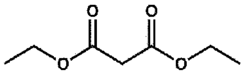

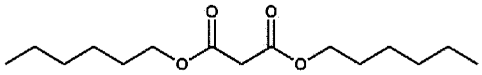

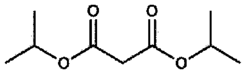

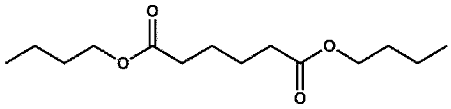

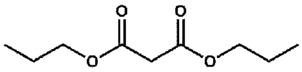

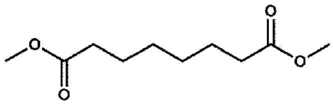

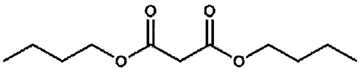

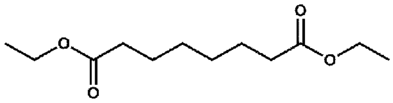

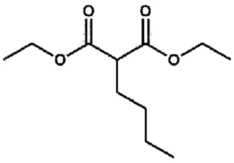

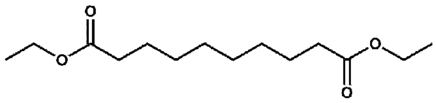

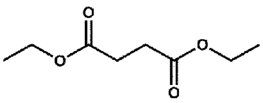

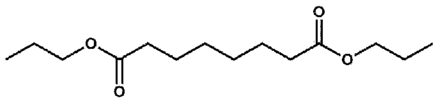

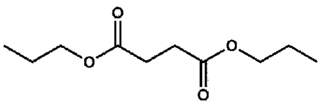

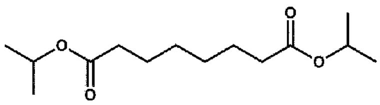

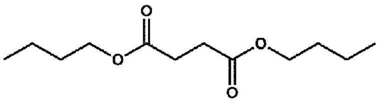

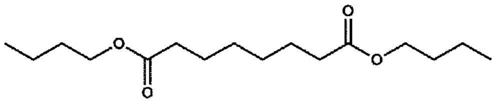

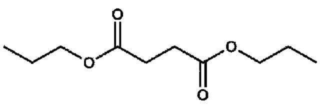

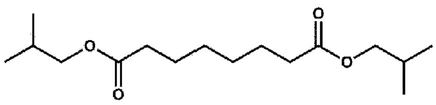

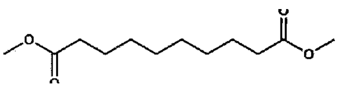

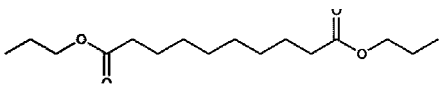

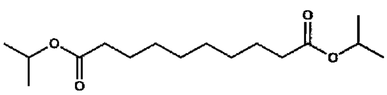

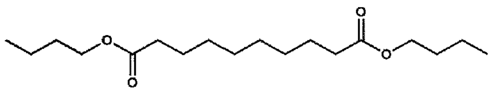

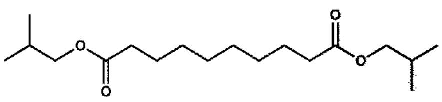

**4.** The ink composition of claim 1, wherein the first solvent has a boiling point of 250°C to 350°C,

the second solvent has a boiling point of 180°C to 280°C, and
the boiling point of the first solvent is higher than the boiling point of the second solvent.

**5.** The ink composition of claim 1, further comprising a third solvent different from the first solvent and the second solvent.

**6.** The ink composition of claim 5, wherein the third solvent is different from the first solvent and the second solvent, and comprises one or more of the solvent represented by Chemical Formula A; a solvent represented by the following Chemical Formula B; tetralin; 4-methoxytoluene; tripropylene glycol monobutyl ether; and cyclohexylbenzene:

[Chemical Formula B]

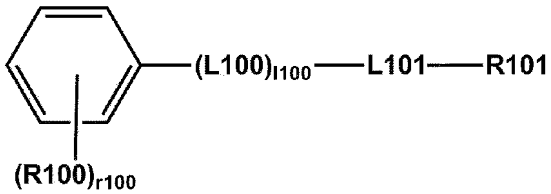

in Chemical Formula B,

L100 is an alkylene group,
L101 is -COO-,
R100 is hydrogen; or a substituted or unsubstituted alkyl group,
R101 is a substituted or unsubstituted alkyl group,
l100 is 0 or 1, and
r100 is an integer from 1 to 5, and when r100 is 2 or higher, substituents in the parenthesis are the same as or different from each other.

**7.** The ink composition of claim 1, further comprising an ionic compound comprising an anionic group represented by the following Chemical Formula 2:

[Chemical Formula 2]

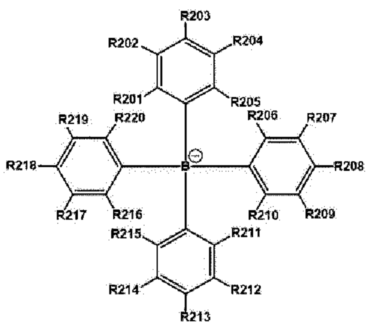

in Chemical Formula 2,

at least one of R201 to R220 is F; a cyano group; or a substituted or unsubstituted fluoroalkyl group,
at least one of the other R201 to R220 is a curable group,
the other R201 to R220 are the same as or different from each other, and are each independently hydrogen; deuterium; a halogen group; a nitro group; a cyano group; an amino group; -OR221; -SR222; $-SO_3R223$; -COOR224; - OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group, and
R221 to R228 are the same as or different from each other, and are each independently hydrogen; deuterium; or a

substituted or unsubstituted alkyl group.

**8.** The ink composition of claim 7, wherein Chemical Formula 2 is any one of the following structures:

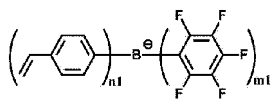
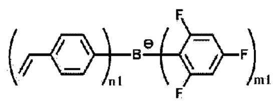
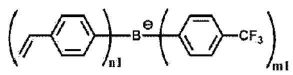

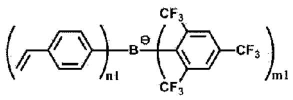
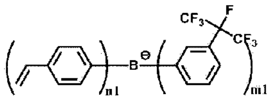
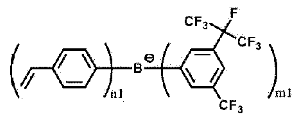

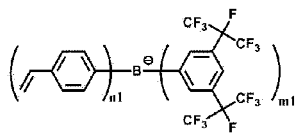
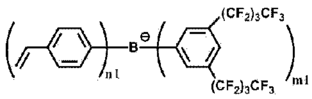
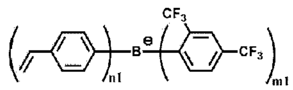

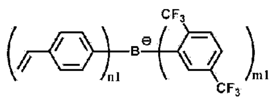
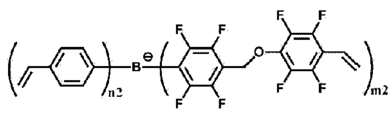

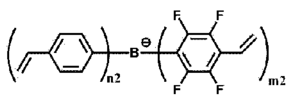
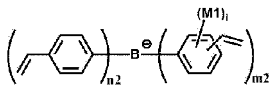
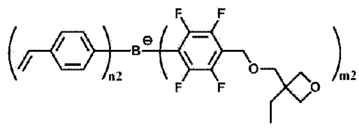

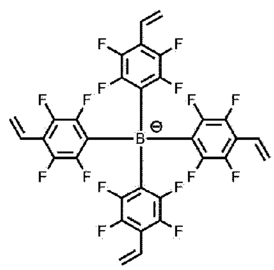
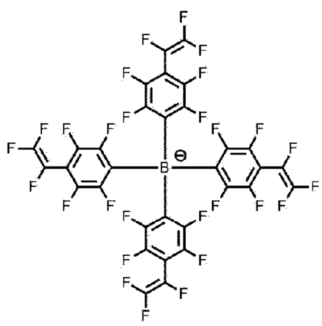
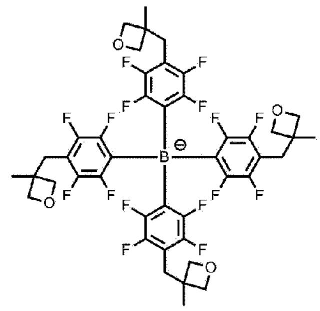

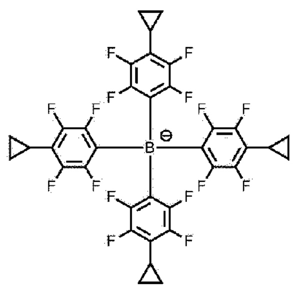
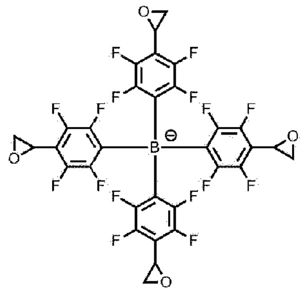

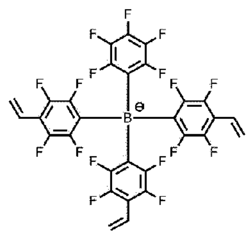

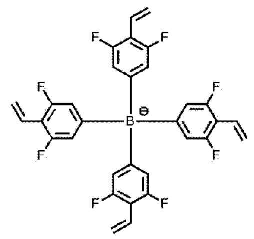

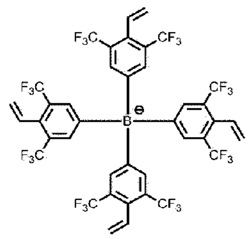

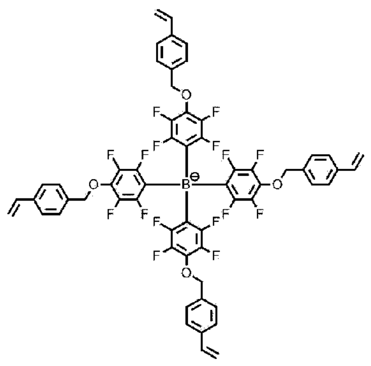

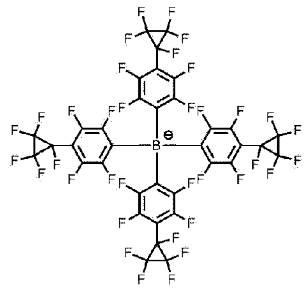

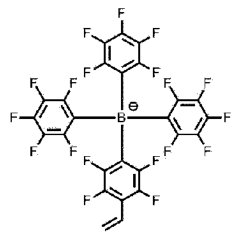

in the structures,

n1 is an integer from 1 to 3, m1 is an integer from 1 to 3, and n1+m1=4,
n2 is an integer from 0 to 3, m2 is an integer from 1 to 4, and n2+m2=4,
M1 is deuterium; a halogen group; a nitro group; a cyano group; an amino group; -OR221; -SR222; -$SO_3$R223; -COOR224; -OC(O)R225; -C(O)NR226R227; -C(O)R228; a substituted or unsubstituted alkyl group; a substituted or unsubstituted alkenyl group; a substituted or unsubstituted alkynyl group; a substituted or unsubstituted amine group; a substituted or unsubstituted aryl group; or a substituted or unsubstituted heterocyclic group,
R221 to R228 are the same as or different from each other, and are each independently hydrogen; deuterium; or a substituted or unsubstituted alkyl group, and
i is an integer from 1 to 4, and when i is 2 or higher, two or more M1's are the same as or different from each other.

**9.** The ink composition of claim 7, wherein the ionic compound further comprises a cationic group, and the cationic group is a monovalent cationic group, an onium compound or any one of the following structures:

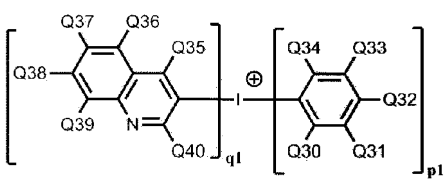

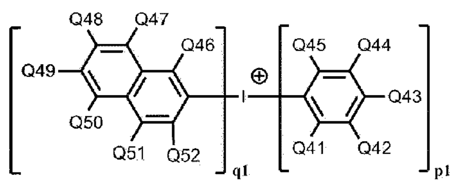

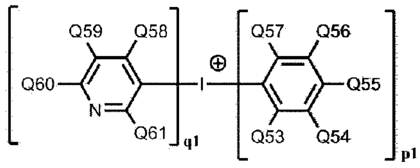

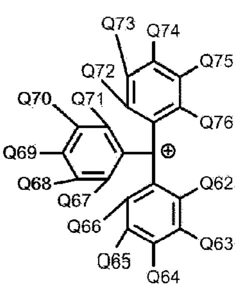

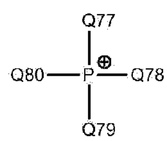

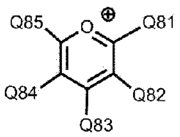
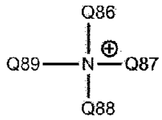
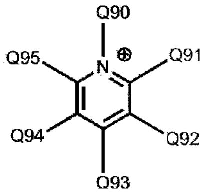
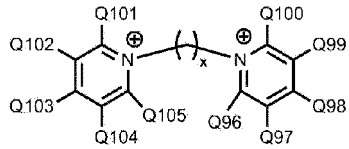

in the structures,

Q30 to Q105 are the same as or different from each other, and are each independently hydrogen; deuterium; a cyano group; a nitro group; a halogen group; a hydroxyl group; -COOR250; a substituted or unsubstituted alkyl group; a substituted or unsubstituted alkoxy group; a substituted or unsubstituted aryloxy group; a substituted or unsubstituted cycloalkyl group; a substituted or unsubstituted aryl group; or a curable group,
R250 is hydrogen; deuterium; or a substituted or unsubstituted alkyl group,
x is an integer from 0 to 10, and
p1 is 1 or 2, q1 is 0 or 1 and p1+q1=2.

**10.** The ink composition of claim 7, wherein the ionic compound is any one of the following Chemical Formulae D-1 to D-37:

[Chemical Formula D-1]

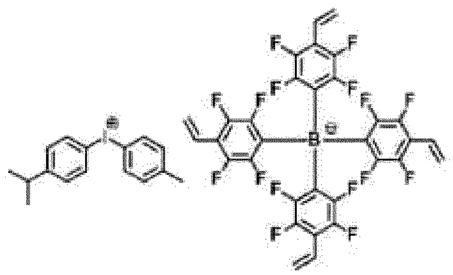

[Chemical Formula D-2]

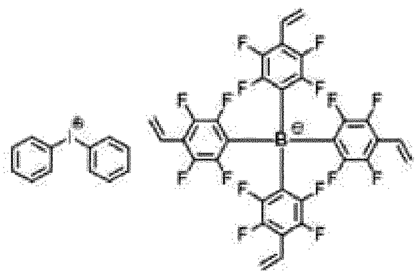

[Chemical Formula D-3]

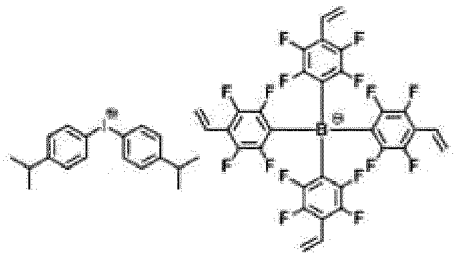

[Chemical Formula D-4]

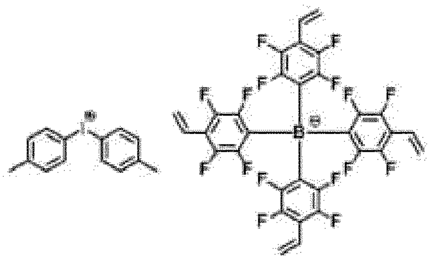

[Chemical Formula D-5]

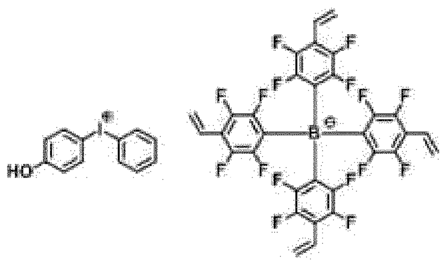

[Chemical Formula D-6]

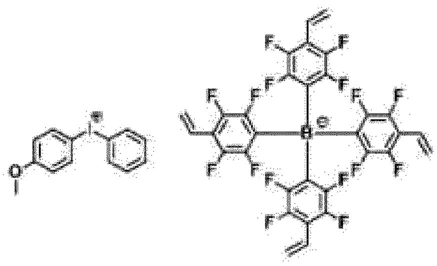

[Chemical Formula D-7]

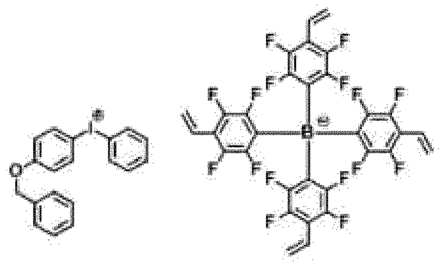

[Chemical Formula D-8]

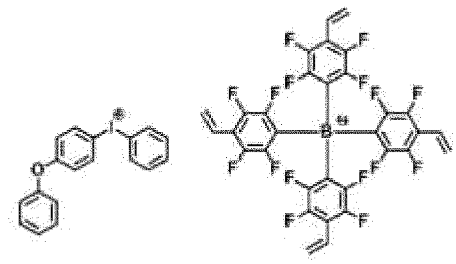

[Chemical Formula D-9]

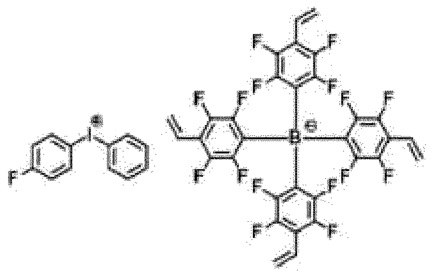

[Chemical Formula D-10]

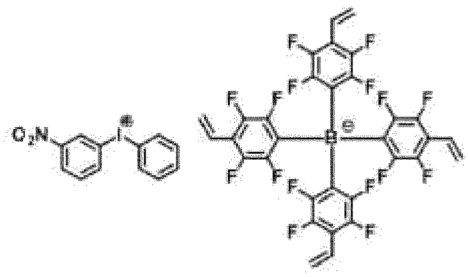

[Chemical Formula D-11]

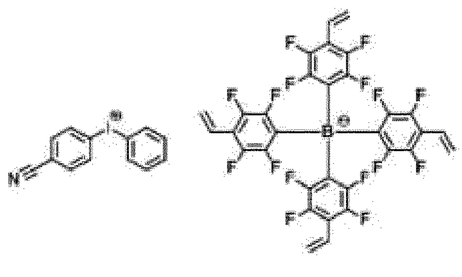

[Chemical Formula D-12]

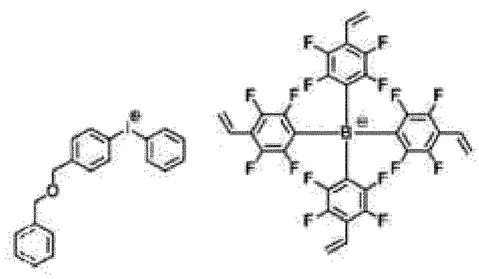

[Chemical Formula D-13]

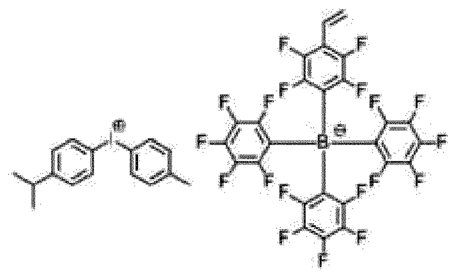

[Chemical Formula D-14]

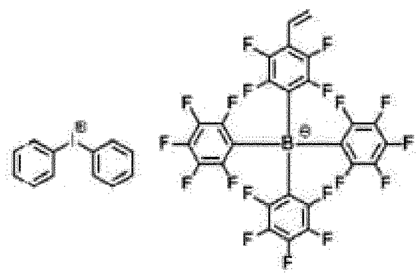

[Chemical Formula D-15]

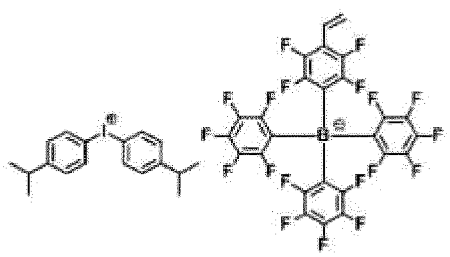

[Chemical Formula D-16]

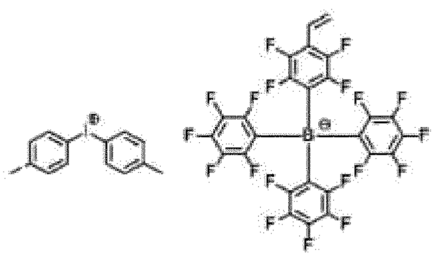

[Chemical Formula D-17]

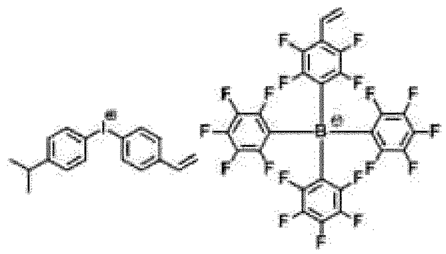

[Chemical Formula D-18]

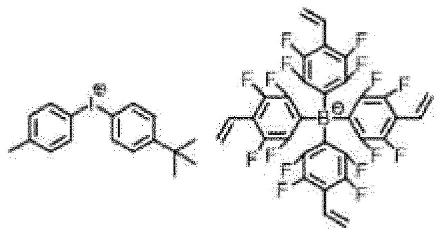

[Chemical Formula D-19]

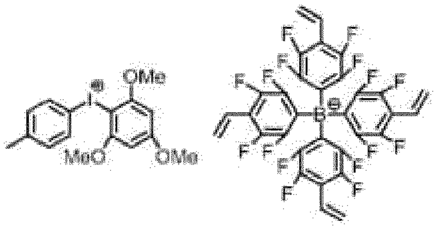

[Chemical Formula D-20]

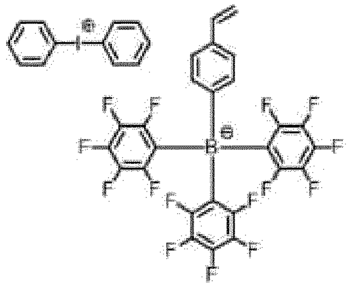

[Chemical Formula D-21]

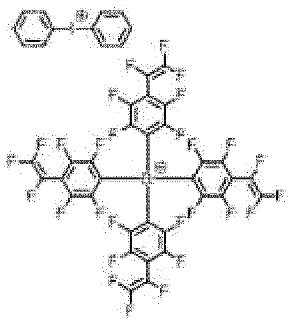

[Chemical Formula D-22]

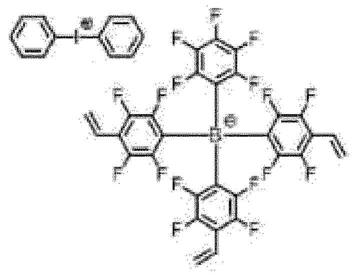

[Chemical Formula D-23]

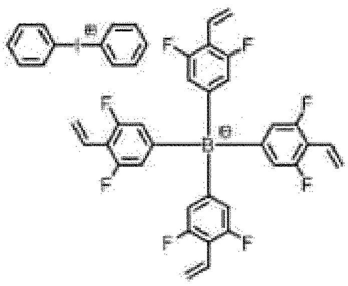

[Chemical Formula D-24]

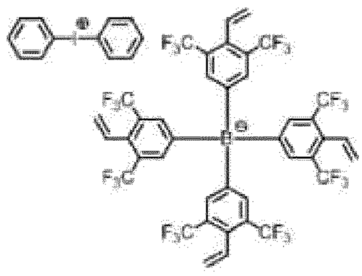

[Chemical Formula D-25]

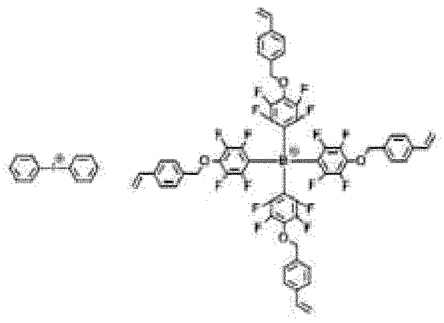

[Chemical Formula D-26]

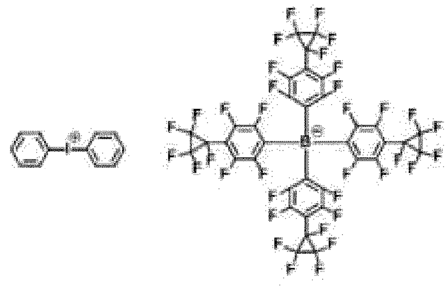

[Chemical Formula D-27]

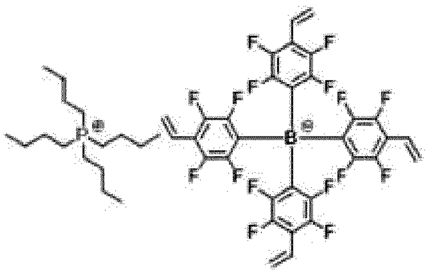

[Chemical Formula D-28]

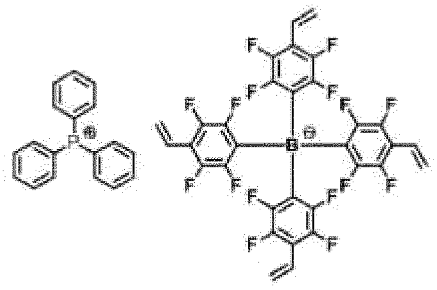

[Chemical Formula D-29]

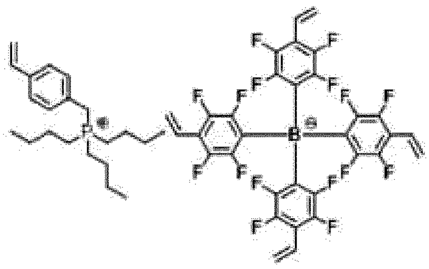

[Chemical Formula D-30]

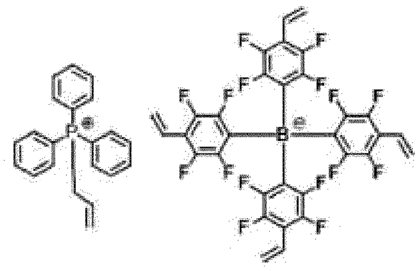

[Chemical Formula D-31]

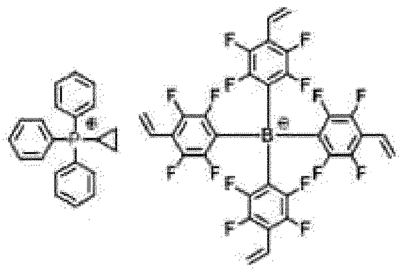

[Chemical Formula D-32]

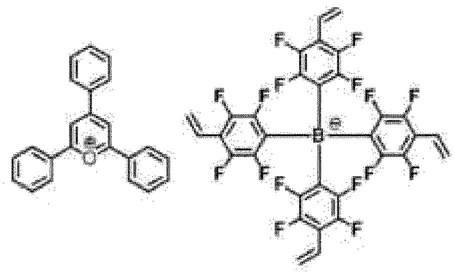

[Chemical Formula D-33] [Chemical Formula D-34]

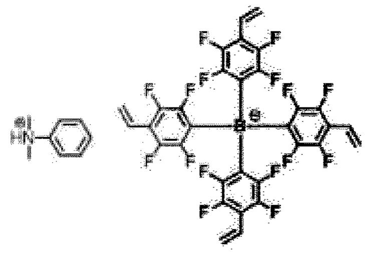

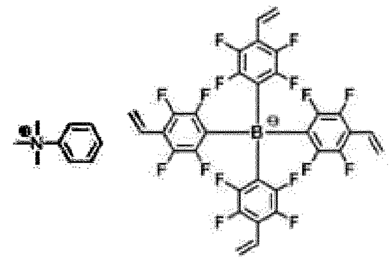

[Chemical Formula D-35] [Chemical Formula D-36]

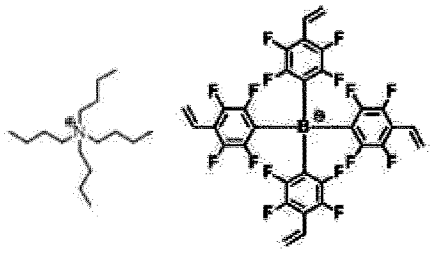

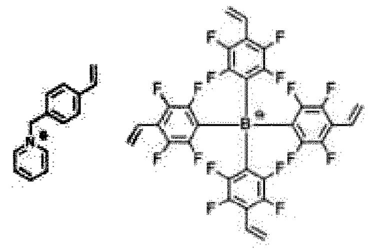

[Chemical Formula D-37]

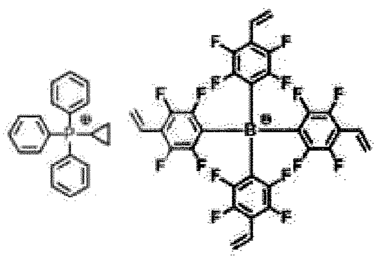

**11.** A pixel comprising the ink composition of any one of claims 1 to 10 or a cured product thereof.

**12.** The pixel of claim 11, wherein the pixel has a flatness of 0.4 or more when the pixel has a short-axis width of 50 μm or less.

**13.** An organic material layer comprising the pixel of claim 11

**14.** An organic light emitting device comprising:

a first electrode;
a second electrode; and
an organic material layer having one or more layers provided between the first electrode and the second electrode,
wherein one or more layers of the organic material layer are the organic material layer of claim 13.

**15.** The organic light emitting device of claim 14, wherein the organic material layer comprises one or more layers selected from the group consisting of a hole injection layer, a hole transport layer, a hole injection and transport layer, and an electron blocking layer, and
the one or more layers selected from the group consisting of the hole injection layer, the hole transport layer, the hole injection and transport layer, and the electron blocking layer comprise the ink composition or a cured product thereof.

**Patentansprüche**

**1.** Tintenzusammensetzung, umfassend:

eine durch die folgende chemische Formel 1 dargestellte Verbindung;
ein erstes, durch die folgende chemische Formel A dargestelltes Lösungsmittel; und
ein zweites, durch die folgende chemische Formel A dargestelltes und sich von dem ersten Lösungsmittel unterscheidendes Lösungsmittel:

[Chemische Formel 1]

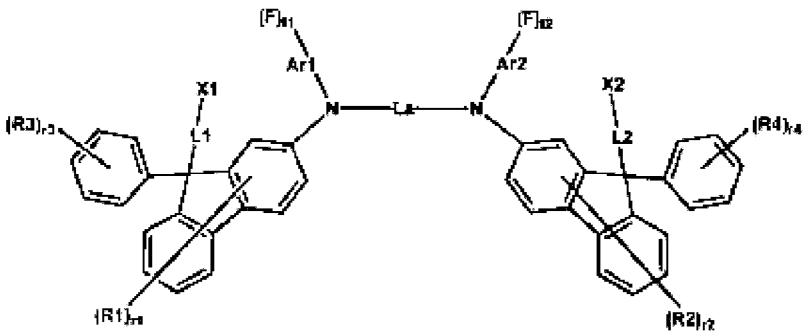

[Chemische Formel A]

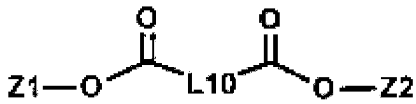

worin in den chemischen Formeln 1 und A
La eine substituierte oder unsubstituierte divalente Kohlenwasserstoff-Ringgruppe; oder eine substituierte oder unsubstituierte divalente heterocyclische Gruppe ist,
L1 und L2 gleich oder voneinander verschieden sind und jeweils unabhängig eine direkte Bindung; oder eine substituierte oder unsubstituierte Arylengruppe sind,
R1 bis R4 gleich oder voneinander verschieden sind und jeweils unabhängig Wasserstoff; Deuterium; eine Halogengruppe; eine substituierte oder unsubstituierte Alkylgruppe; eine substituierte oder unsubstituierte Alkoxygruppe; eine substituierte oder unsubstituierte Arylgruppe; oder eine substituierte oder unsubstituierte Heteroarylgruppe sind,
Ar1 und Ar2 gleich oder voneinander verschieden sind und jeweils unabhängig eine substituierte oder unsubstituierte Arylgruppe; oder eine substituierte oder unsubstituierte Heteroarylgruppe sind,
X1 und X2 gleich oder voneinander verschieden sind und jeweils unabhängig eine härtbare Gruppe sind,
L10 eine direkte Bindung; oder eine substituierte oder unsubstituierte Alkylengruppe ist,
Z1 und Z2 gleich oder voneinander verschieden sind und jeweils unabhängig eine substituierte oder unsubstituierte Alkylgruppe; oder eine substituierte oder unsubstituierte Arylgruppe sind,
r1 und r2 jeweils eine ganze Zahl von 1 bis 7 sind, r3 und r4 jeweils eine ganze Zahl von 1 bis 5 sind, und wenn r1 bis r4 jeweils 2 oder größer sind, zwei oder mehr Substituenten in den Klammern gleich oder voneinander verschieden sind,
f1 von 1 bis zur Anzahl der Bindungspositionen ist, an denen Substituenten an Ar1 gebunden sein können, und
f2 1 bis zur Anzahl von Bindungspositionen ist, an denen Substituenten an Ar2 gebunden sein können.

**2.** Tintenzusammensetzung gemäß Anspruch 1 worin die chemische Formel 1 irgendeine der folgenden Strukturen ist:

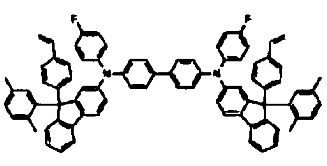

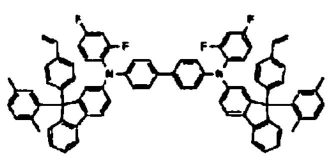

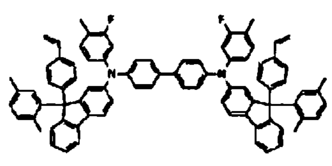

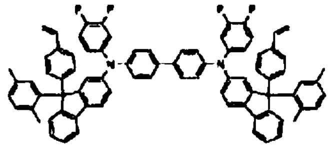
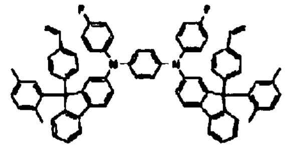
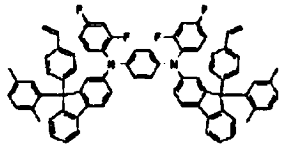
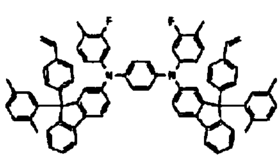
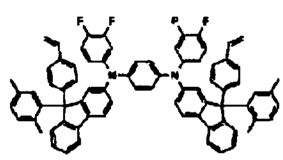
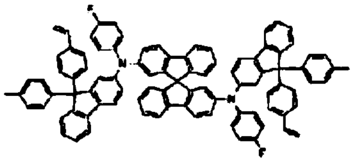
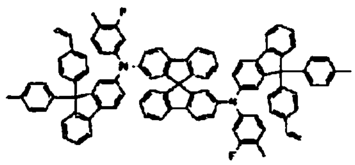
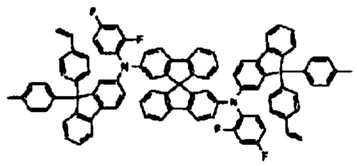
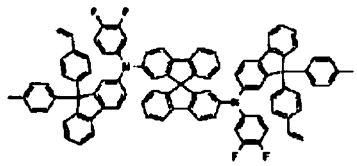
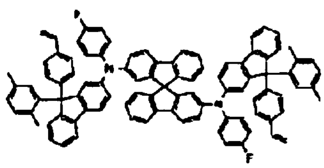
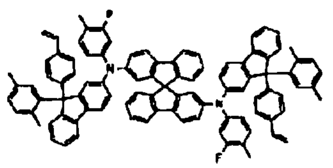
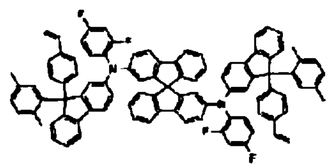
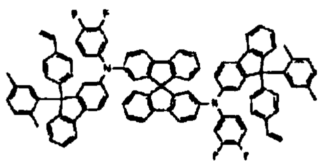
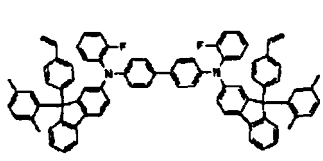
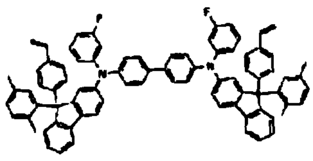
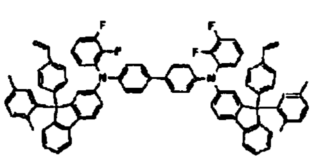
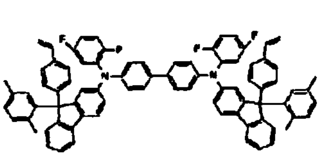
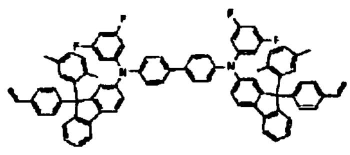
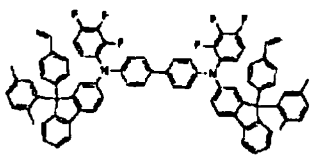
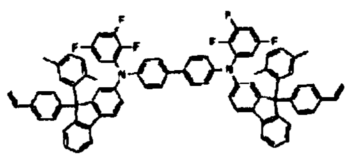
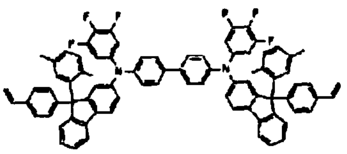
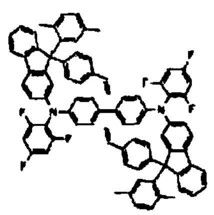
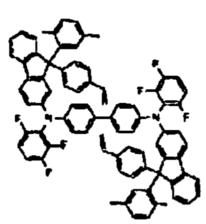
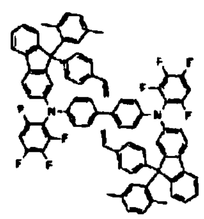
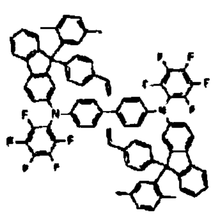

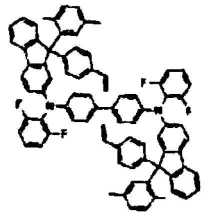

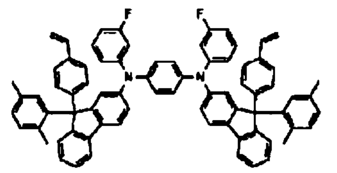
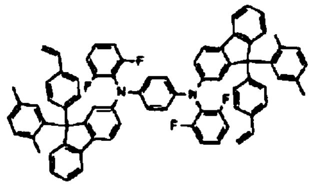
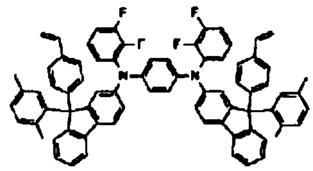

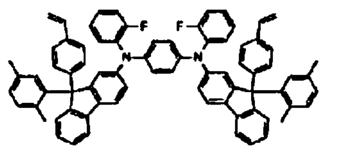
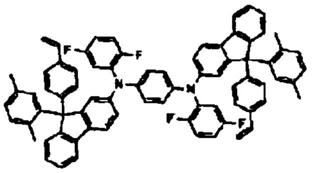
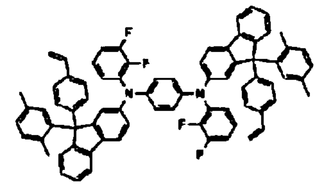

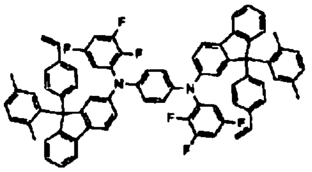
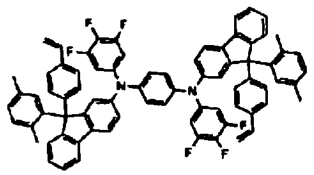
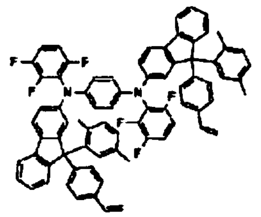

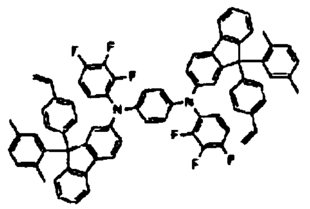
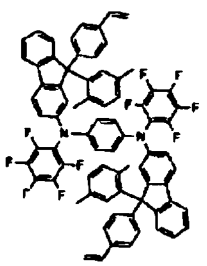
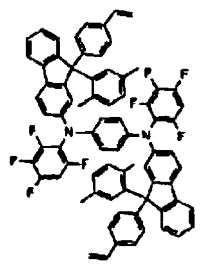
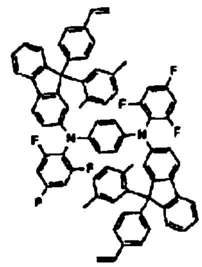

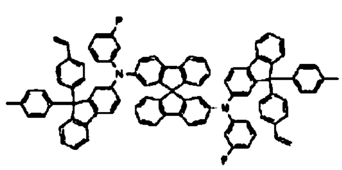
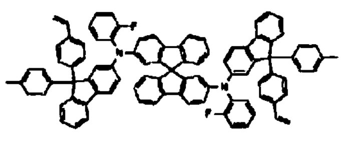
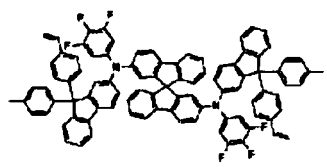

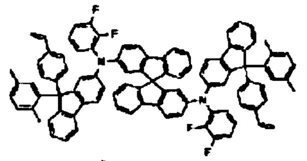
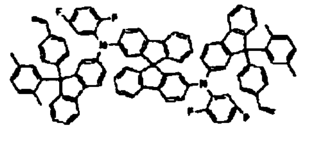
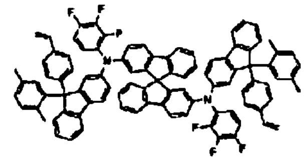

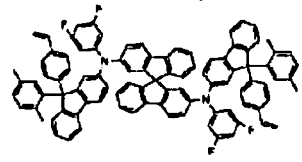
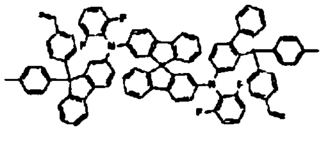
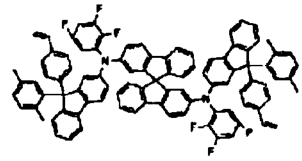

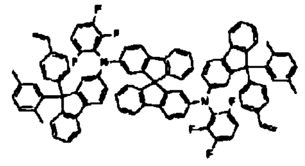
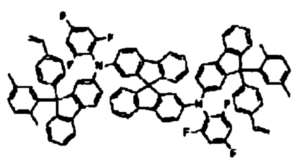
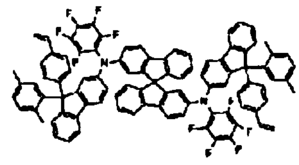
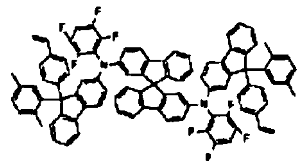
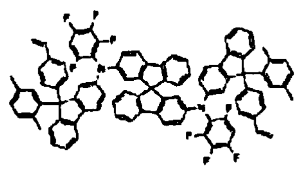
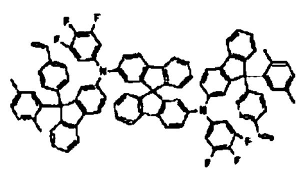
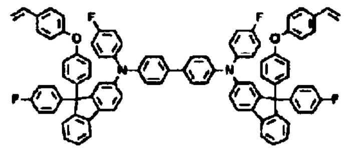
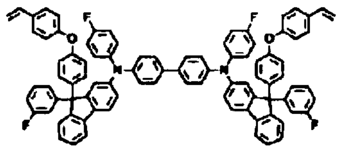
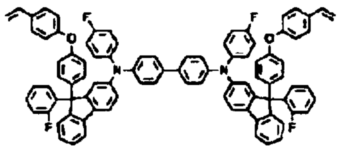
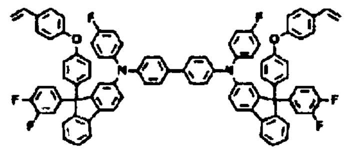
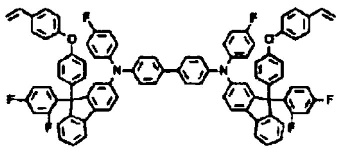
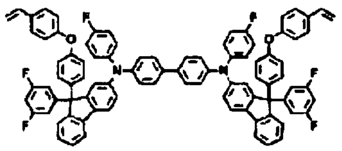
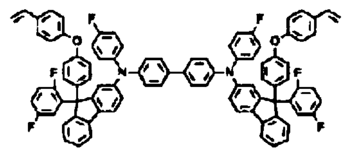
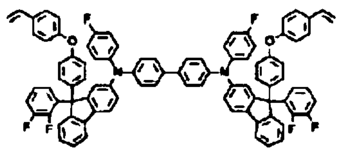
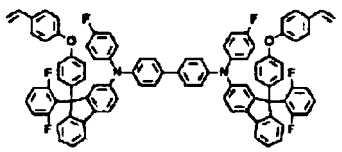
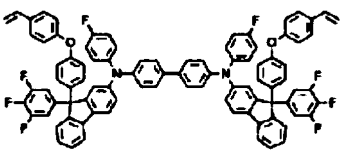
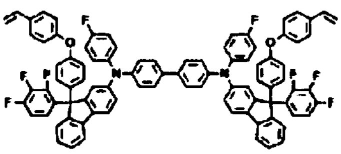
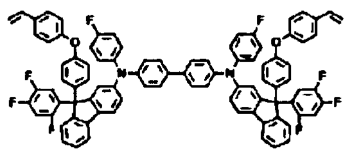
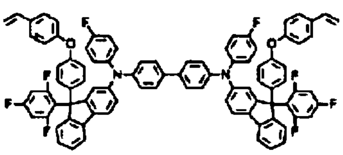
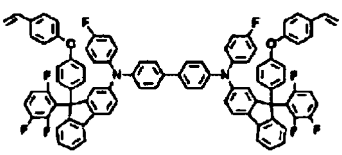
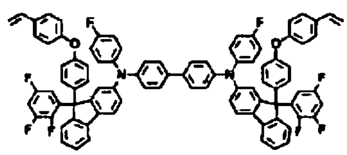
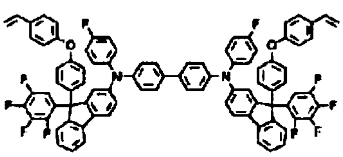
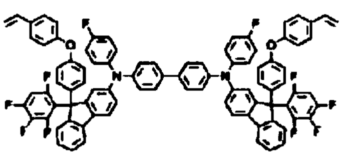
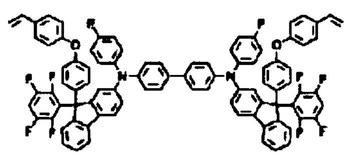
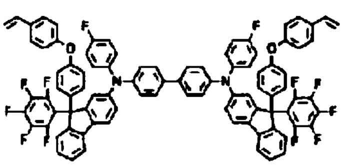

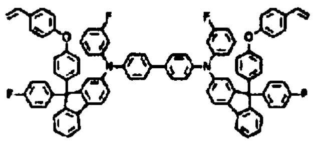
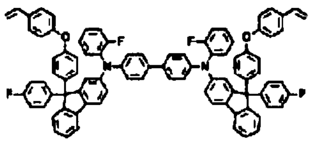
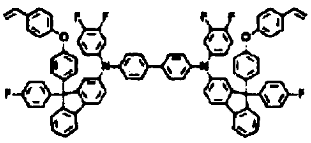
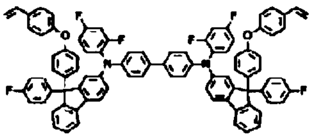
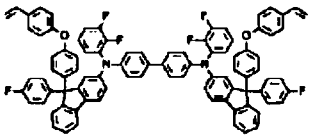
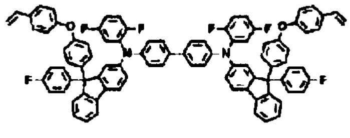
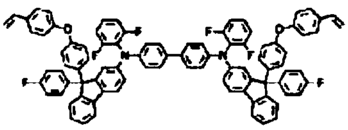
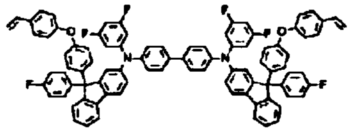
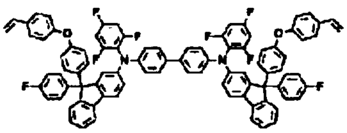
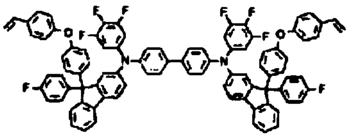
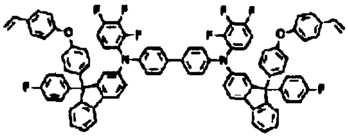
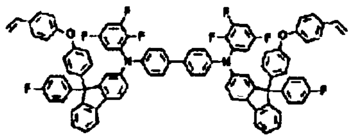
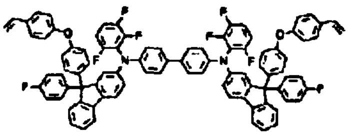
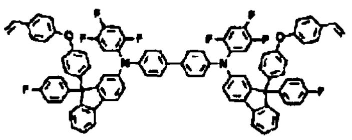
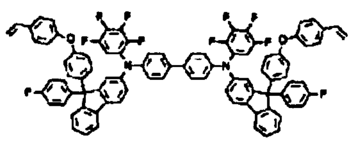
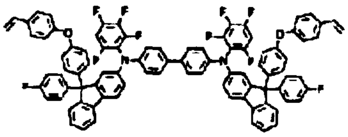
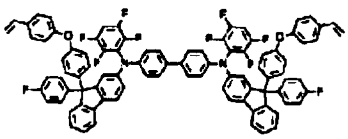
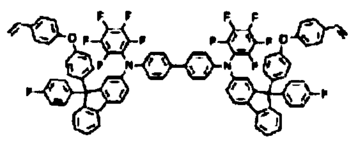
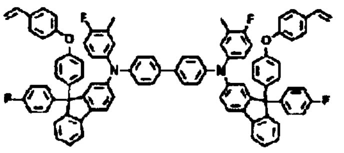
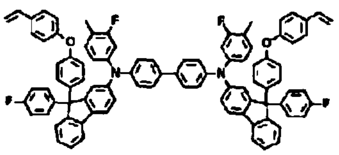
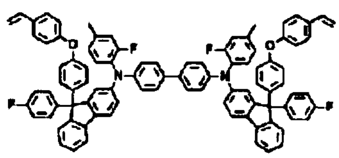
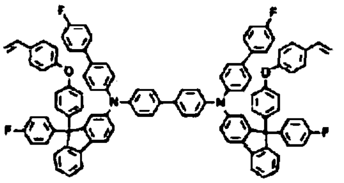
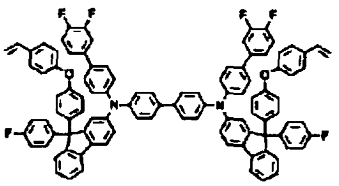
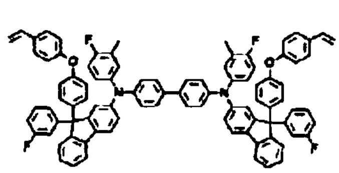
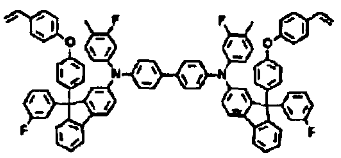
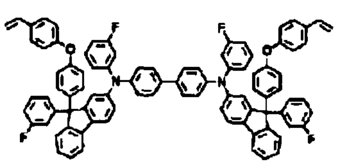
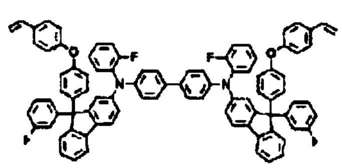

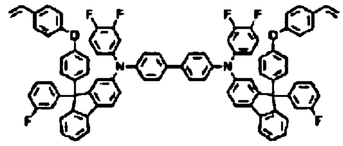 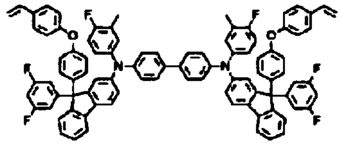 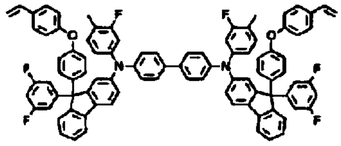

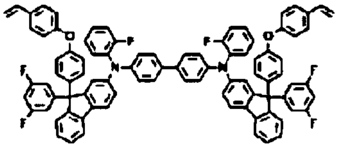 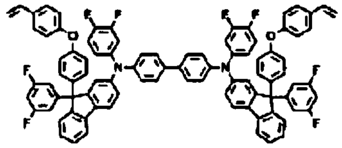 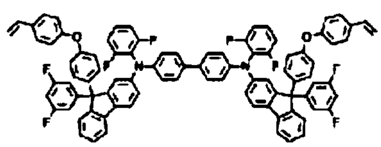

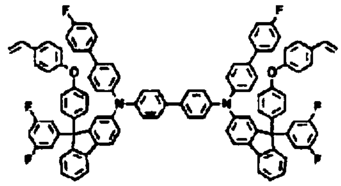 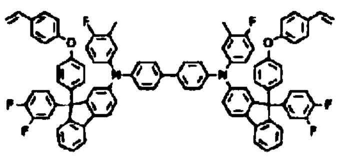 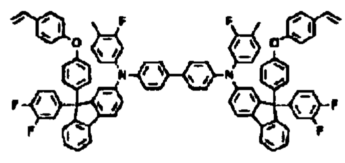

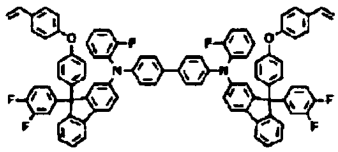 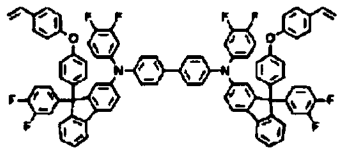 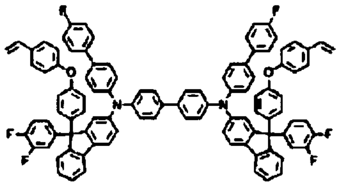

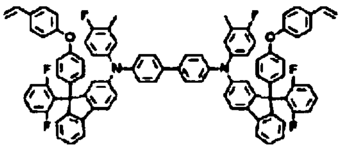 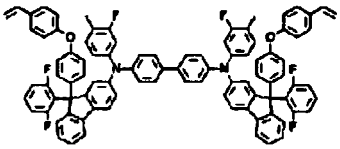 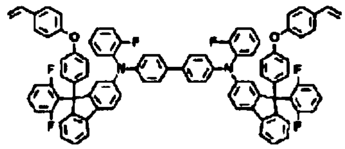

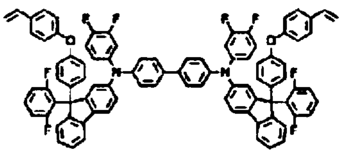 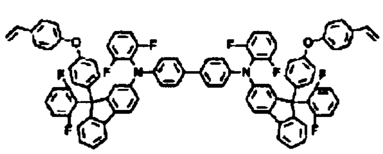 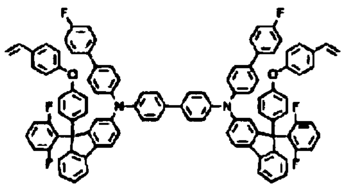

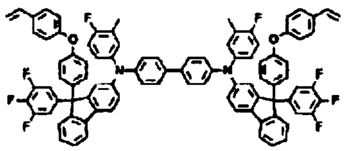 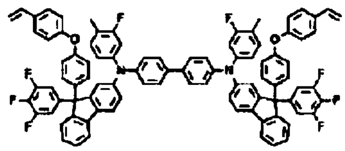 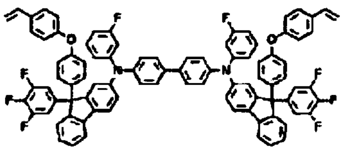

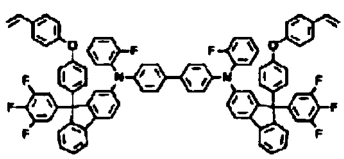 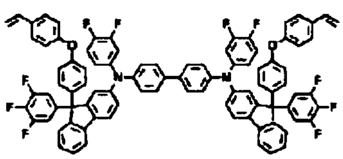 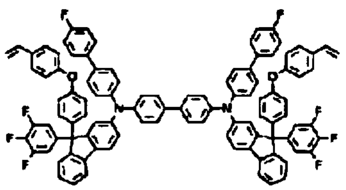

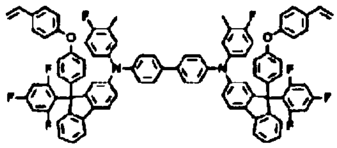
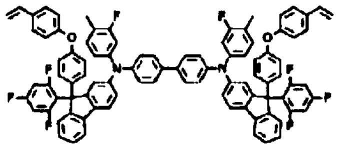
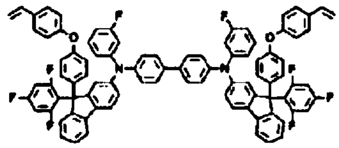

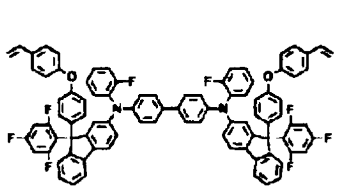
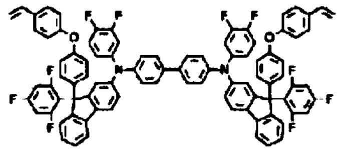
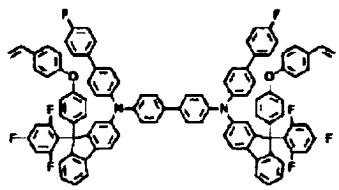

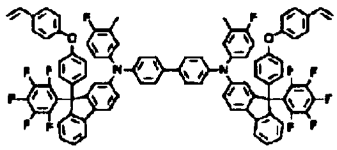
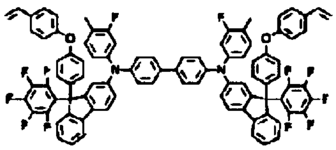
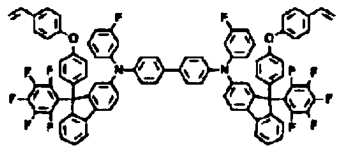

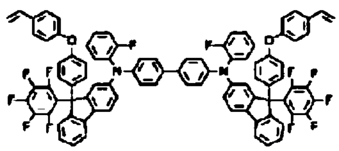
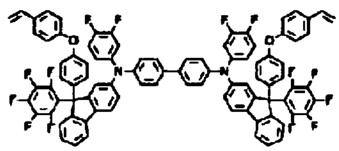
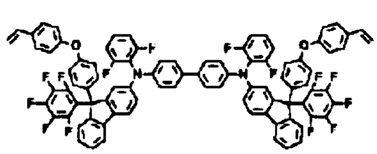

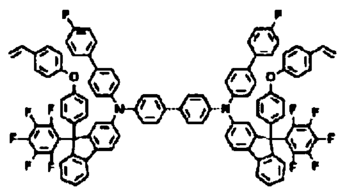

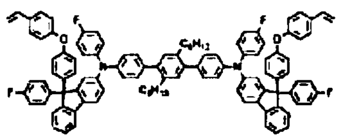
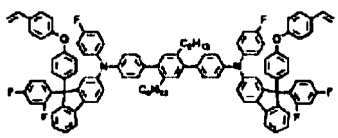
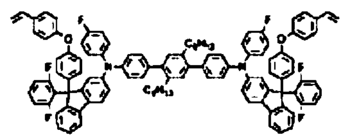

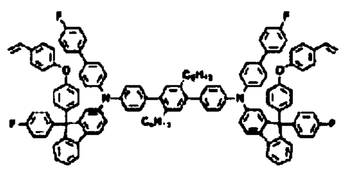
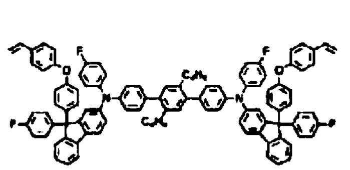
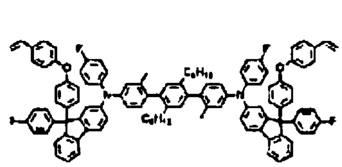

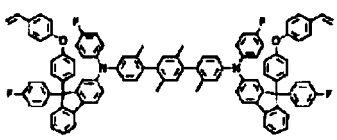
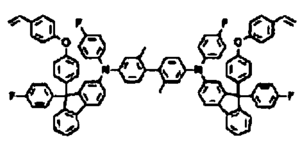
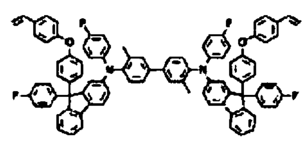

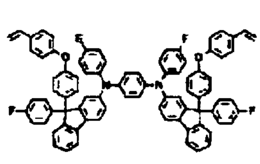
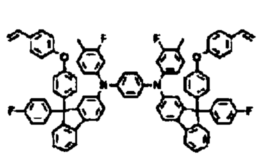
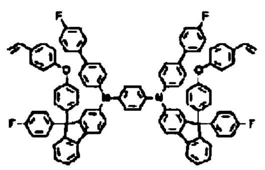

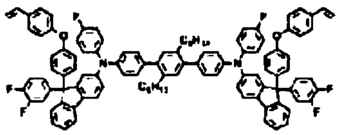
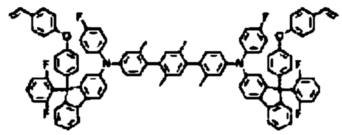

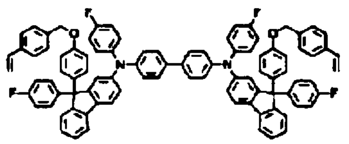
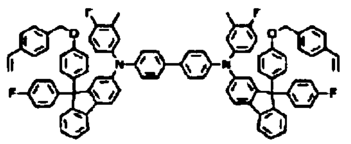
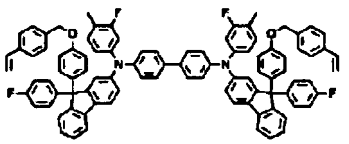

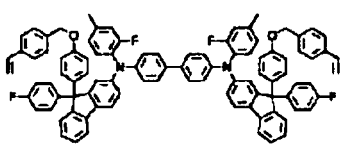
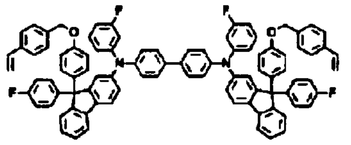
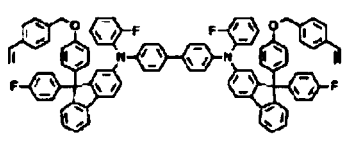

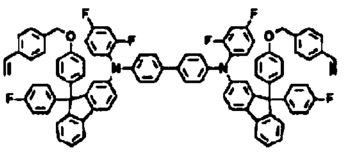
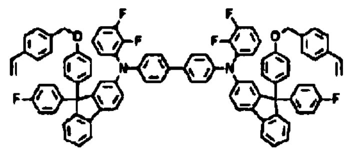
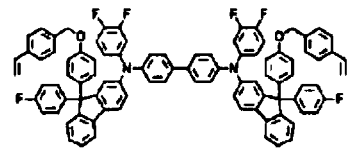

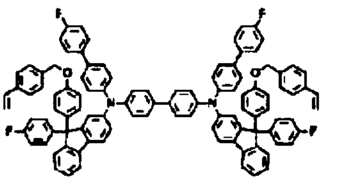
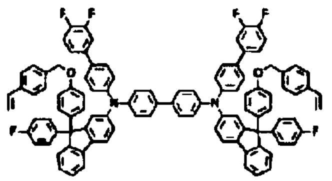
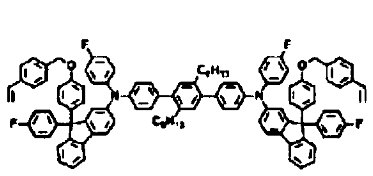

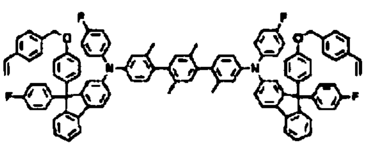
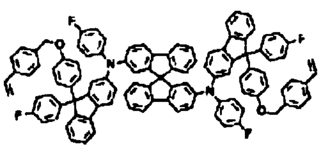
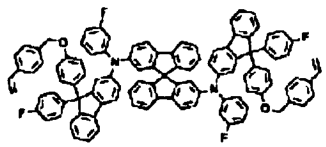

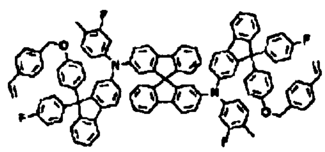
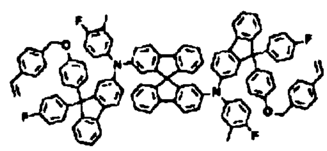
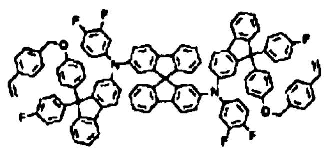

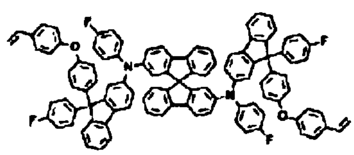
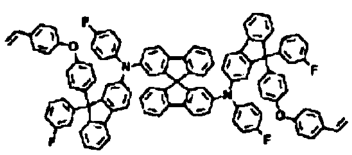
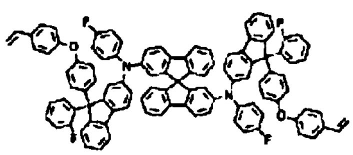

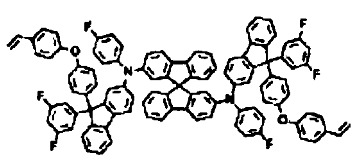
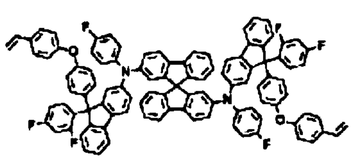
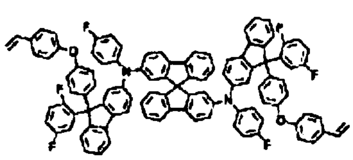

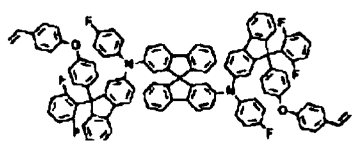
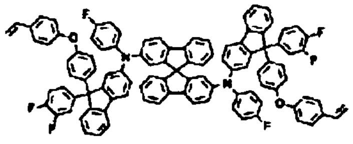
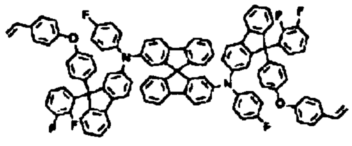

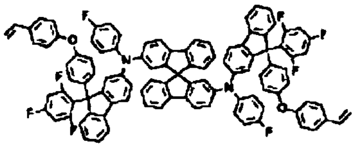
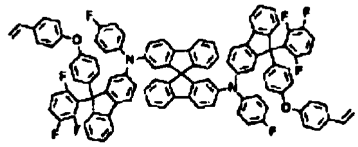
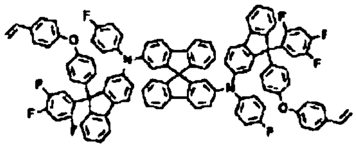

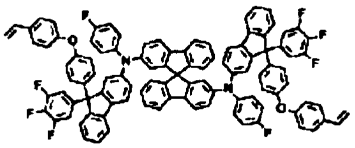
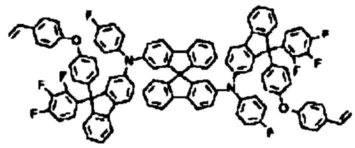
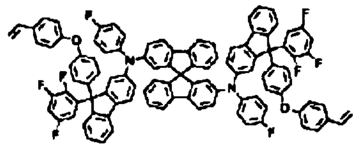

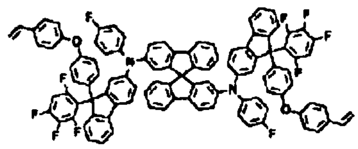
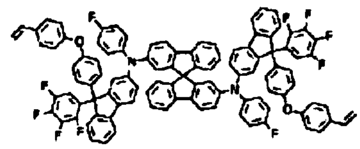
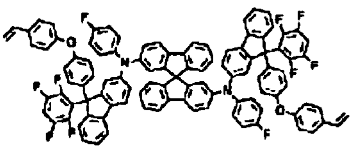

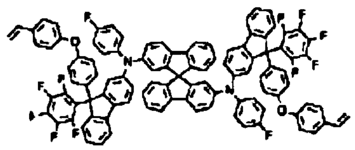

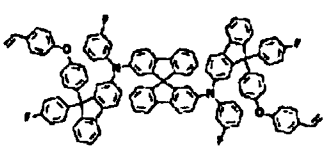
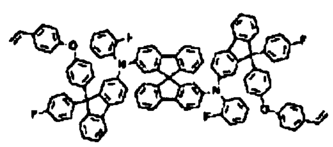
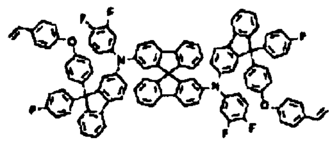

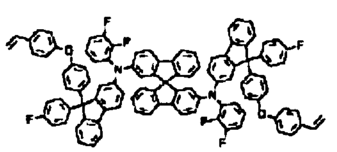
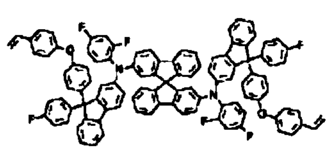
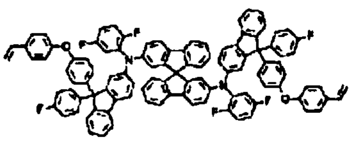

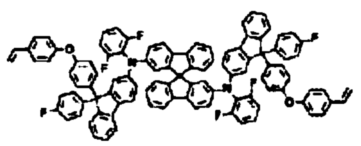
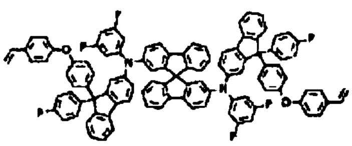
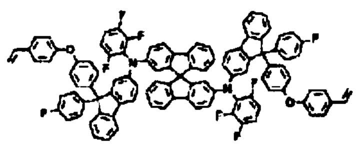

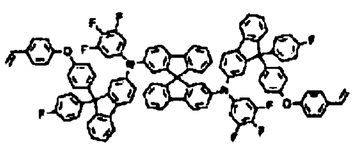
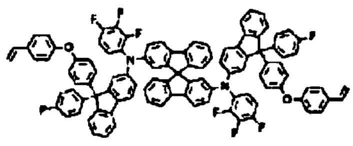
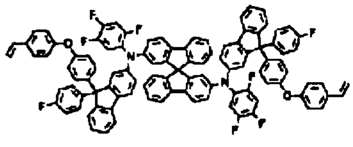

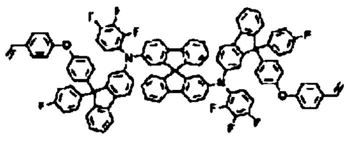
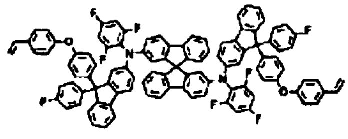
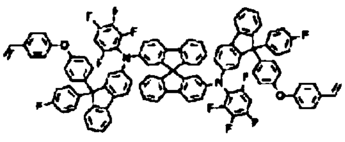

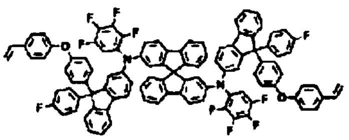
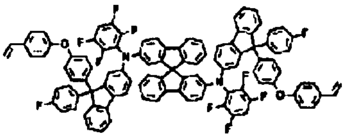
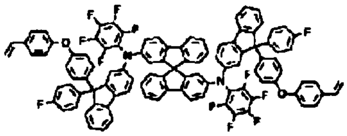

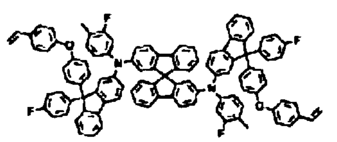
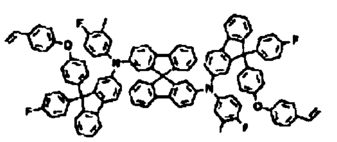
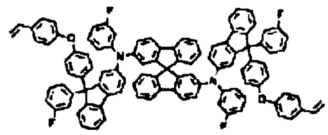

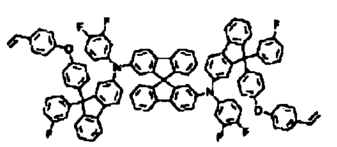
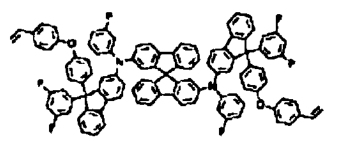
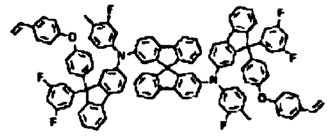

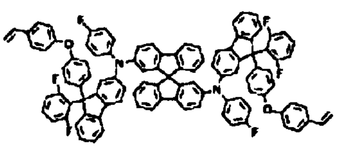
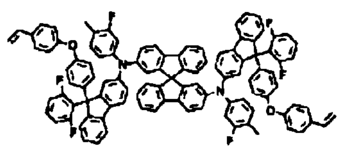
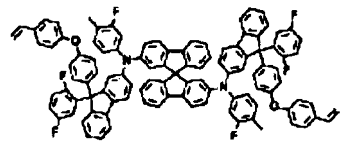

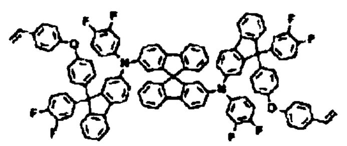
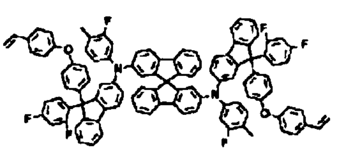
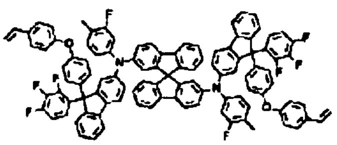

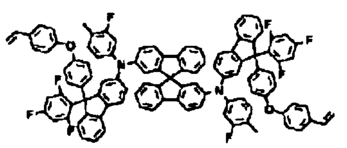
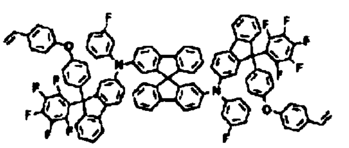
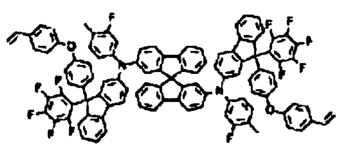

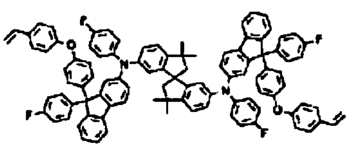
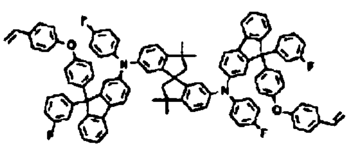
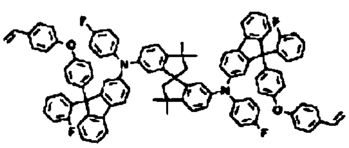

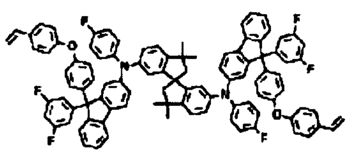
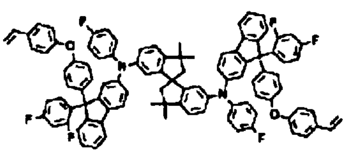
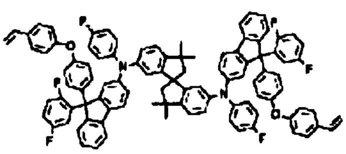

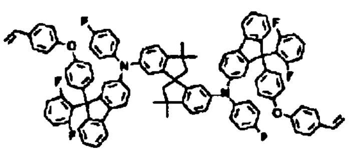 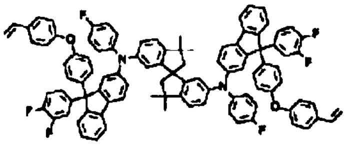 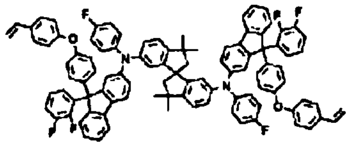

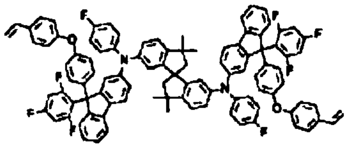 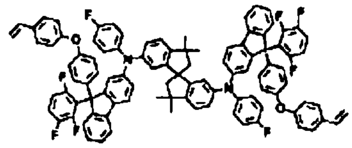 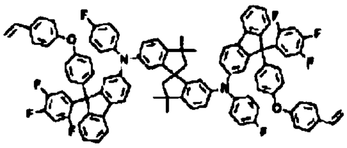

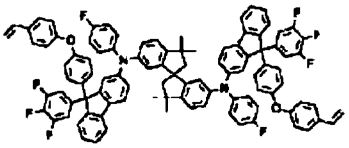 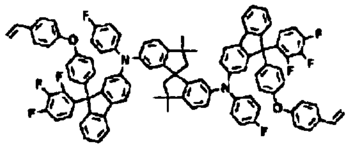 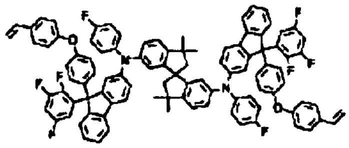

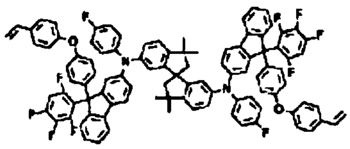 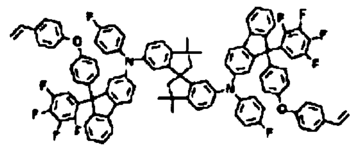 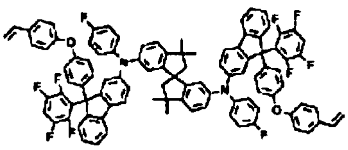

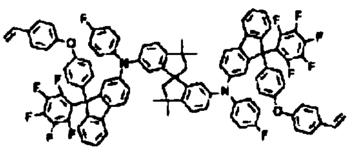

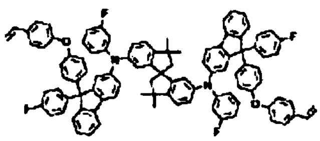 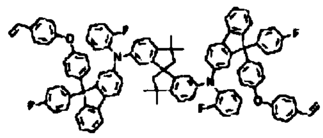 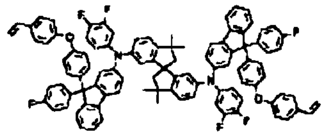

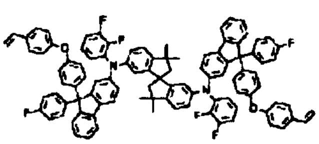 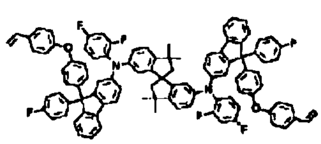 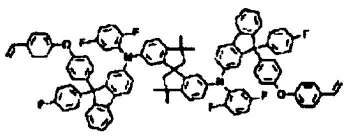

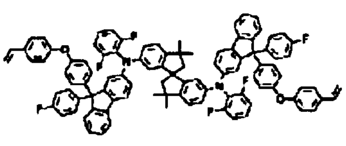 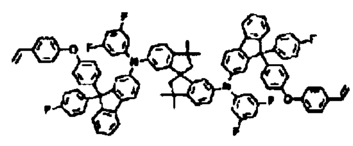 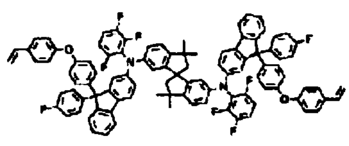

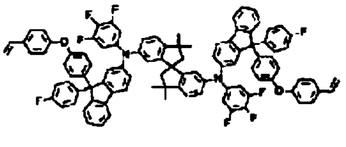 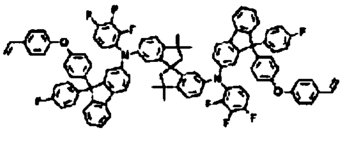 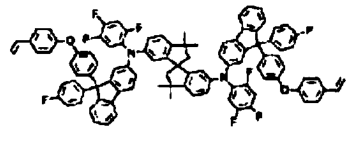

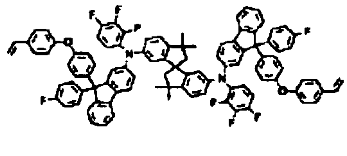 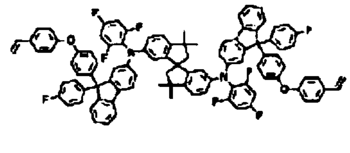 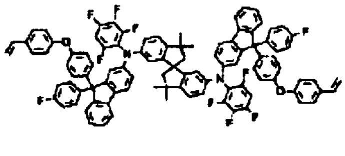

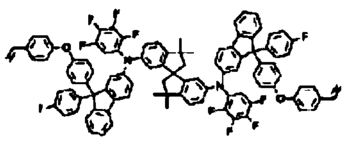 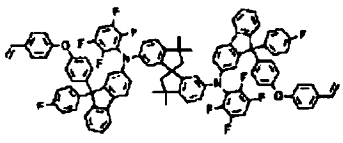 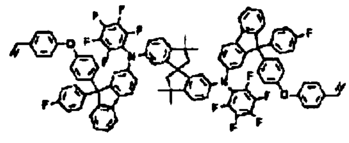

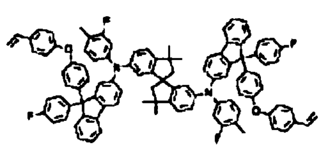 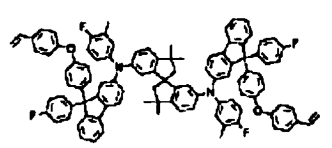 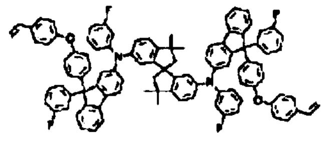

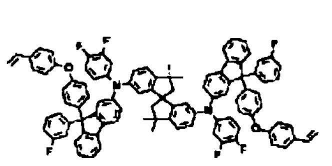 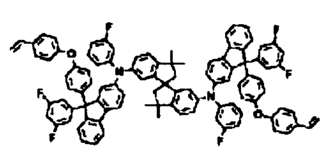 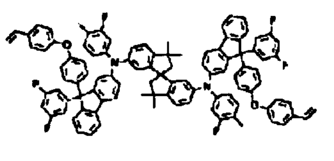

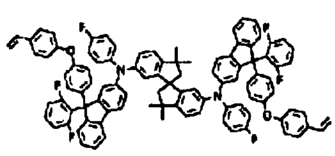 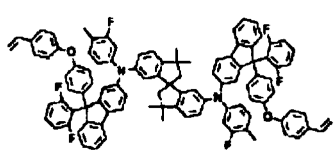 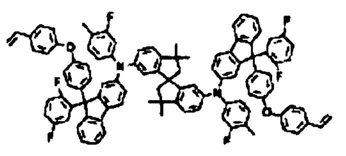

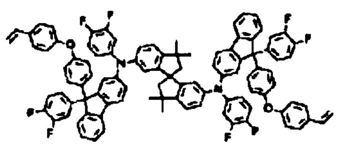 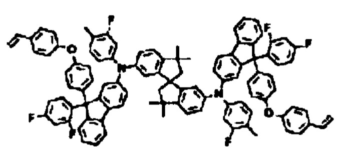 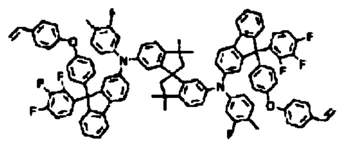

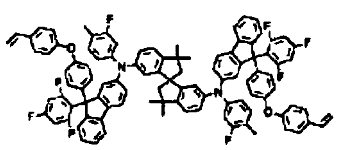 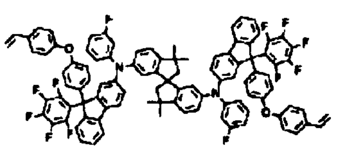 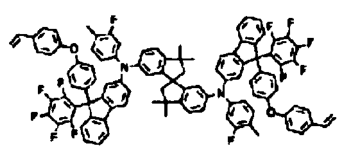

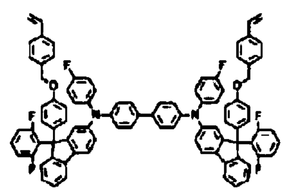

.

**3.** Tintenzusammensetzung gemäß Anspruch 1, worin die chemische Formel A irgendeine der folgenden Strukturen ist:

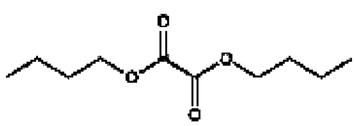 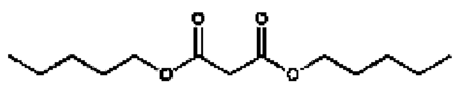

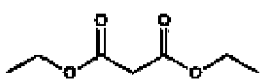 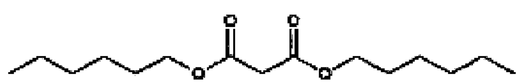

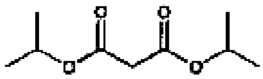
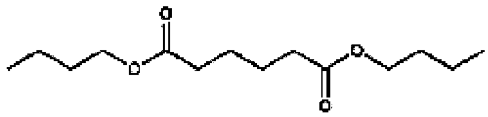
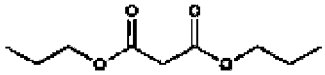
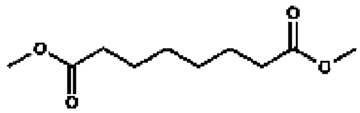
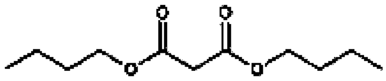
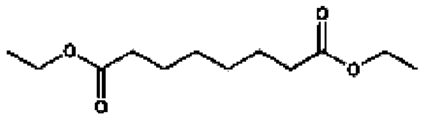
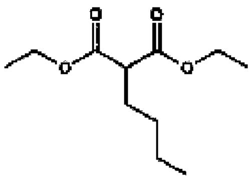
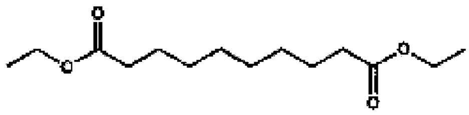
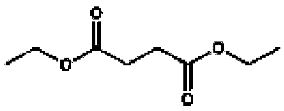
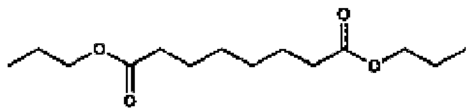
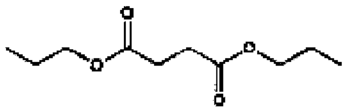
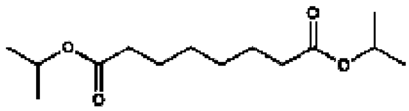
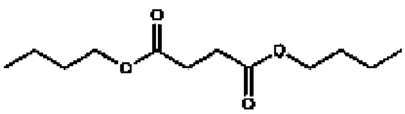
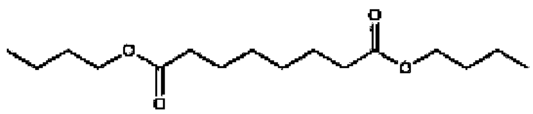
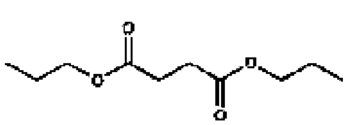
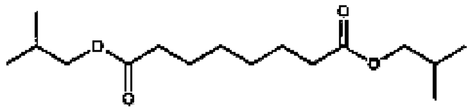
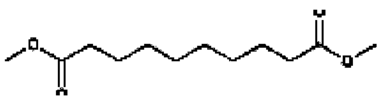
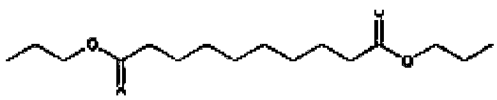
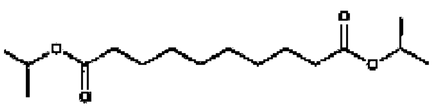
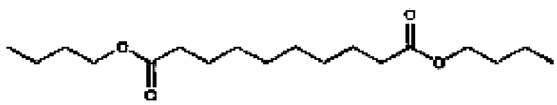
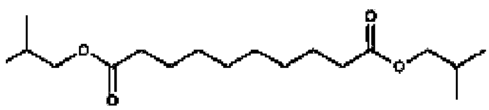

**4.** Tintenzusammensetzung gemäß Anspruch 1, worin das erste Lösungsmittel einen Siedepunkt von 250°C bis 350°C

aufweist,

das zweite Lösungsmittel einen Siedepunkt von 180°C bis 280°C aufweist, und
der Siedepunkt des ersten Lösungsmittels höher ist als der Siedepunkt des zweiten Lösungsmittels.

**5.** Tintenzusammensetzung gemäß Anspruch 1, ferner umfassend ein drittes Lösungsmittel, das sich von dem ersten Lösungsmittel und dem zweiten Lösungsmittel unterscheidet.

**6.** Tintenzusammensetzung gemäß Anspruch 5, worin das dritte Lösungsmittel sich von dem ersten Lösungsmittel und dem zweiten Lösungsmittel unterscheidet und eines oder mehrere umfasst von durch die chemische Formel A dargestelltes Lösungsmittel; durch die chemische Formel B dargestelltes Lösungsmittel; Tetralin; 4-Methoxytoluol; Tripropylenglykolmonobutylether; und Cyclohexylbenzol:

[Chemische Formel B]

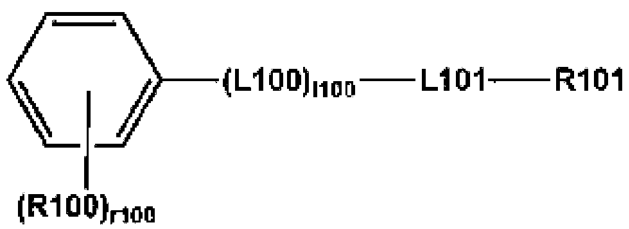

worin in der chemischen Formel B

L100 eine Alkylengruppe ist,
L101 -COO- ist,
R100 Wasserstoff; oder eine substituierte oder unsubstituierte Alkylgruppe ist,
R101 eine substituierte oder unsubstituierte Alkylgruppe ist,
l100 0 oder 1 ist und
r100 eine ganze Zahl von 1 bis 5 ist, und wenn r100 2 oder größer ist, die Substituenten in den Klammern gleich oder voneinander verschieden sind.

**7.** Tintenzusammensetzung gemäß Anspruch 1, ferner umfassend eine ionische Verbindung, umfassend eine durch die folgende chemische Formel 2 dargestellte anionische Gruppe:

[Chemische Formel 2]

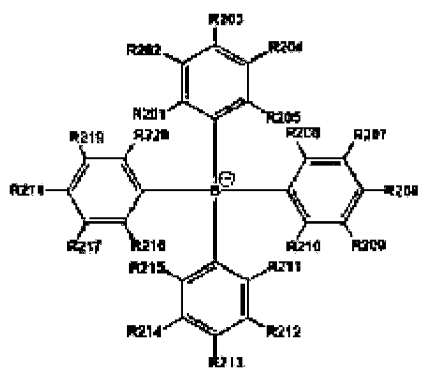

worin in der chemischen Formel 2

zumindest eines von R201 bis R220 F; eine Cyanogruppe; oder eine substituierte oder unsubstituierte Fluoralkylgruppe ist,

zumindest eines der anderen R201 bis R220 eine härtbare Gruppe ist,
die anderen R201 bis R220 gleich oder voneinander verschieden sind und jeweils unabhängig Wasserstoff, Deuterium; eine Halogengruppe; eine Nitrogruppe, eine Cyanogruppe; eine Aminogruppe; -OR221; -SR222; -$SO_3$R223; -COOR224; -OC(O)R225; -C(O)NR226R227; -C(O)R228; eine substituierte oder unsubstituierte Alkylgruppe; eine substituierte oder unsubstituierte Alkenylgrupp; eine substituierte oder unsubstituierte Alkinylgruppe; eine substituierte oder unsubstituierte Amingruppe; eine substituierte oder unsubstituierte Arylgruppe; oder eine substituierte oder unsubstituierte heterocyclische Gruppe sind, und
R221 bis R228 gleich oder voneinander verschieden sind und jeweils unabhängig Wasserstoff; Deuterium; oder eine substituierte oder unsubstituierte Alkylgruppe sind.

**8.** Tintenzusammensetzung gemäß Anspruch 7, worin die chemische Formel 2 irgendeine der folgenden Strukturen ist:

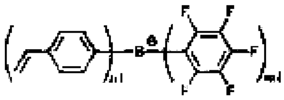
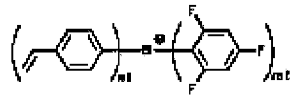
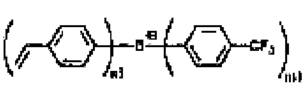
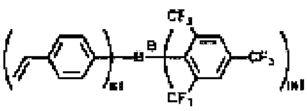
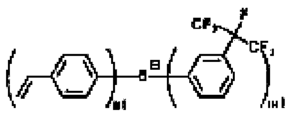
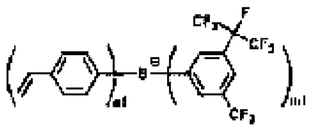
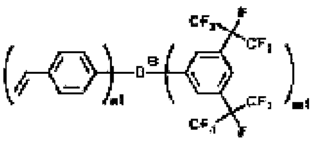
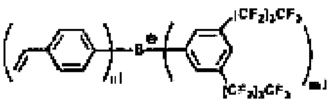
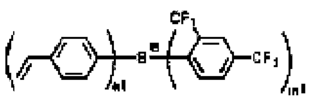
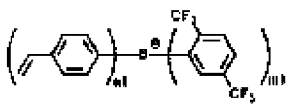
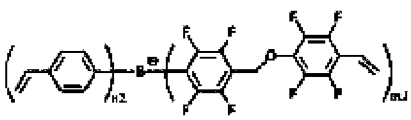
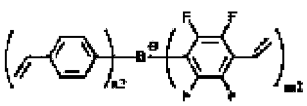
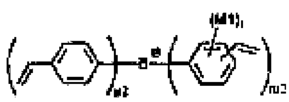
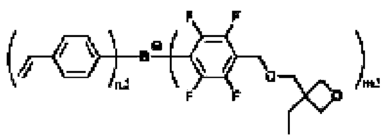
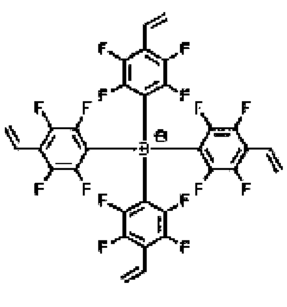
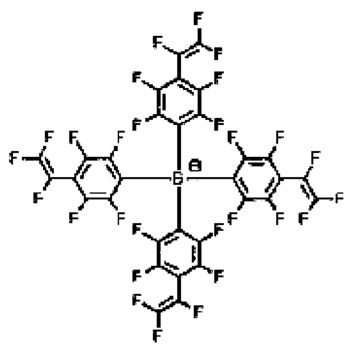
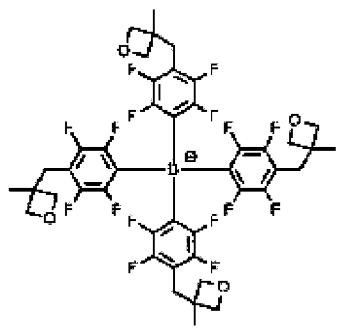

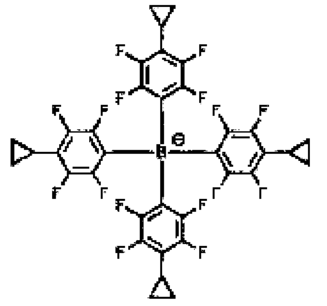
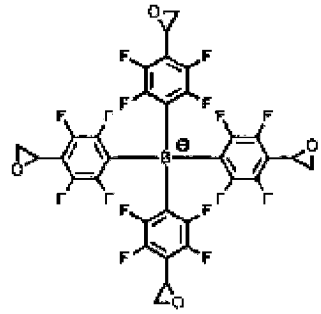

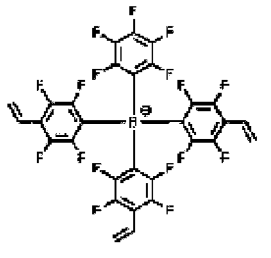
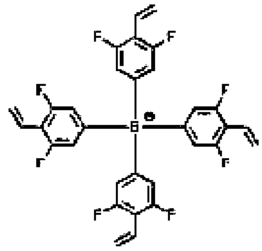
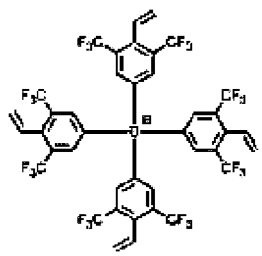

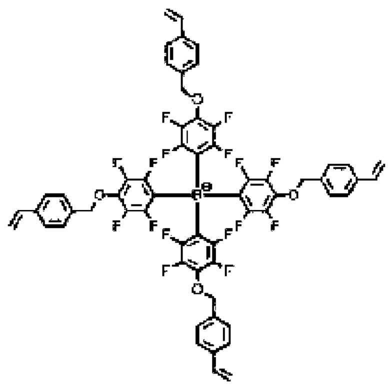
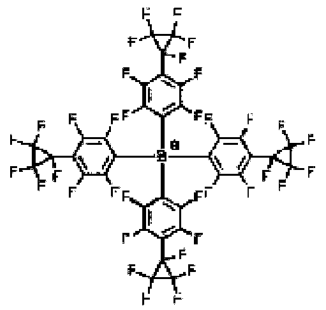
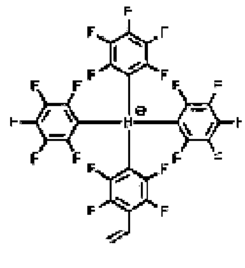

worin in den Strukturen

n1 eine ganze Zahl von 1 bis 3 ist, m1 eine ganze zahl von 1 bis 3 ist und n1+m1=4,
n2 eine ganze zahl von 0 bis 3 ist, m2 eine ganze Zahl von 1 bis 4 ist und n2+m2=4,
M1 Deuterium; eine Halogengruppe; eine Nitrogruppe; eine Cyanogruppe; eine Aminogruppe; -OR221; -SR222; $-SO_3R223$; -COOR224; -OC(O)R225; -C(O)NR226R227; -C(O)R228; eine substituierte oder unsubstituierte Alkylgruppe; eine substituierte oder unsubstituierte Alkenylgrupp; eine substituierte oder unsubstituierte Alkinylgruppe; eine substituierte oder unsubstituierte Amingruppe; eine substituierte oder unsubstituierte Arylgruppe; oder eine substituierte oder unsubstituierte heterocyclische Gruppe sind, und
R221 bis R228 gleich oder voneinander verschieden sind und jeweils unabhängig Wasserstoff; Deuterium; oder eine substituierte oder unsubstituierte Alkylgruppe sind, und
i eine ganze Zahl von 1 bis 4 ist, und wenn i 2 oder größer ist, zwei oder mehr M1 gleich oder voneinander verschieden sind.

**9.** Tintenzusammensetzung gemäß Anspruch 7, worin die ionische Verbindung ferner eine kationische Gruppe umfasst und die kationische Gruppe eine monovalente kationische Gruppe, eine Oniumverbindung oder irgendeine der folgenden Strukturen ist:

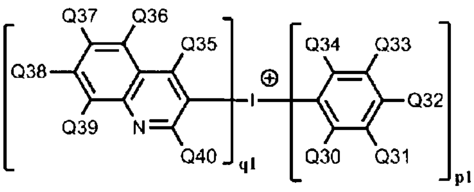

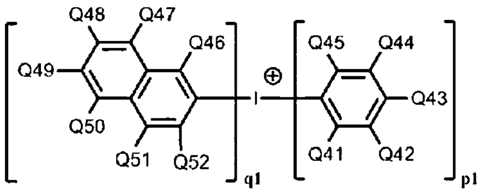

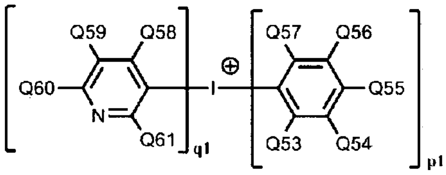

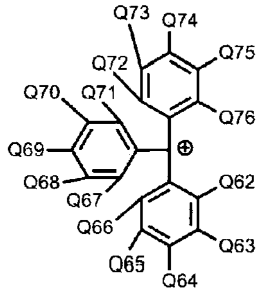

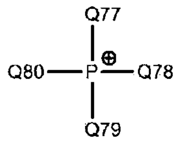

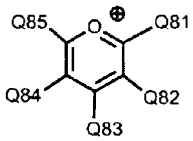

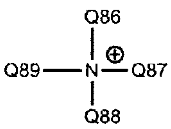

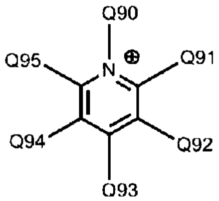

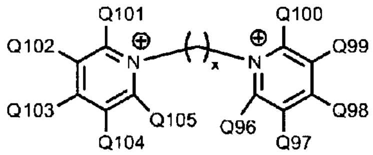

worin in den Strukturen

Q30 bis Q105 gleich oder voneinander verschieden sind und jeweils unabhängig Wasserstoff; Deuterium; eine Cyanogruppe; eine Nitrogruppe; eine Halogengruppe; eine Hydroxylgruppe; -COOR250; eine substituierte oder unsubstituierte Alkylgruppe; eine substituierte oder unsubstituierte Alkoxygrupp; eine substituierte oder unsubstituierte Aryloxygruppe; eine substituierte oder unsubstituierte Cycloalkylgruppe; eine substituierte oder unsubstituierte Arylgruppe; oder eine härtbare Gruppe sind,
R250 Wasserstoff; Deuterium; oder eine substituierte oder unsubstituierte Alkylgruppe ist,
x eine ganze Zahl von 0 bis 10 ist und
p1 1 oder 2 ist, q1 0 oder 1 ist und p1+q1=2.

**10.** Tintenzusammensetzung gemäß Anspruch 7, worin die ionische Verbindung irgendeine der folgenden chemischen Formeln D-1 bis D-37 ist:

[Chemische Formel D-1]

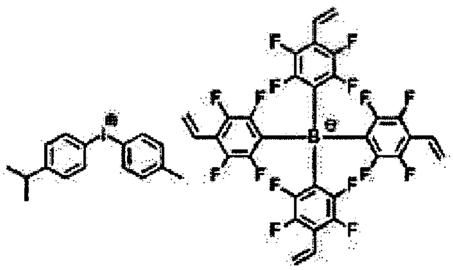

[Chemische Formel D-2]

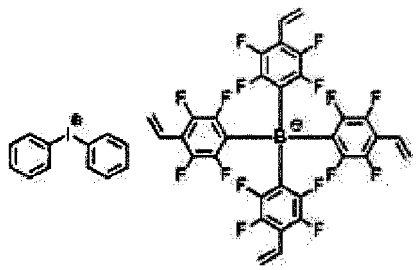

[Chemische Formel D-3]

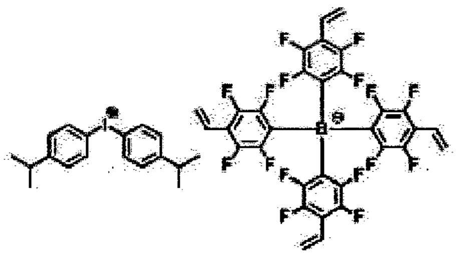

[Chemische Formel D-4]

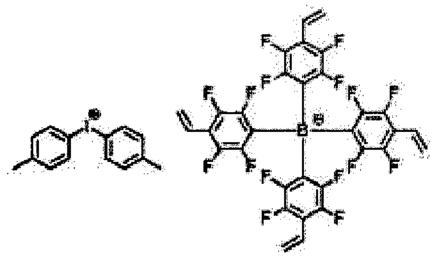

[Chemische Formel D-5]

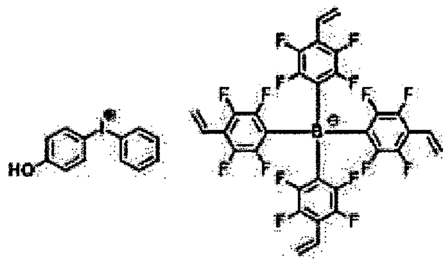

[Chemische Formel D-6]

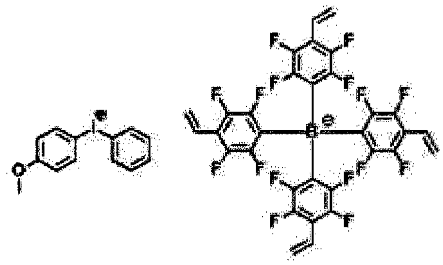

[Chemische Formel D-7]

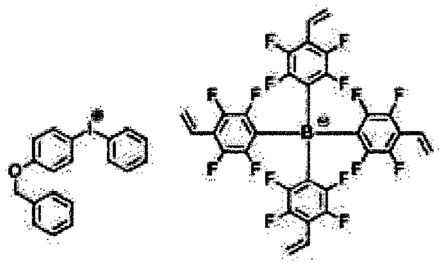

[Chemische Formel D-8]

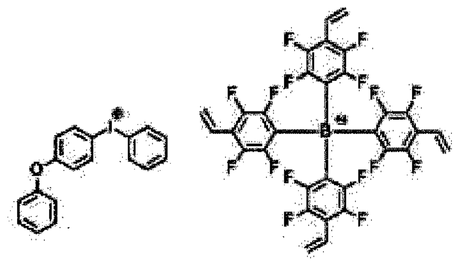

[Chemische Formel D-9]

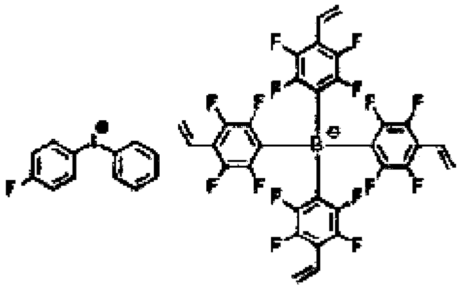

[Chemische Formel D-10]

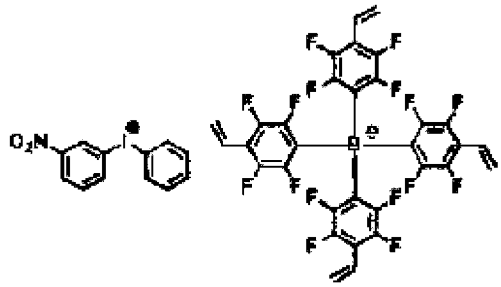

[Chemische Formel D-11]

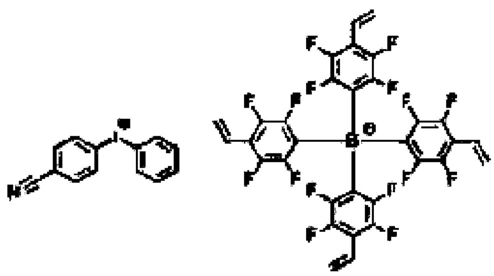

[Chemische Formel D-12]

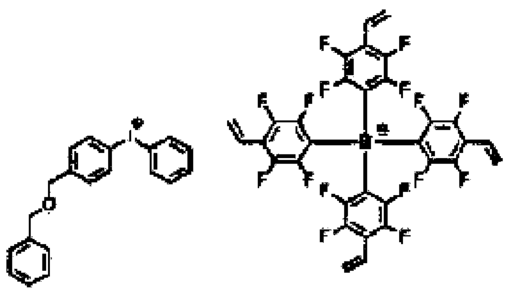

[Chemische Formel D-13]

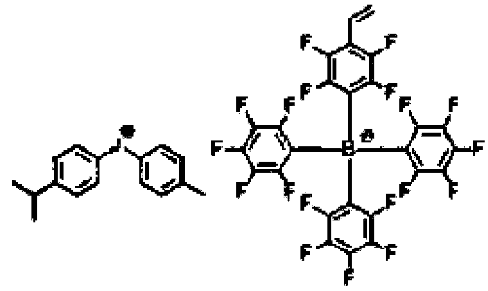

[Chemische Formel D-14]

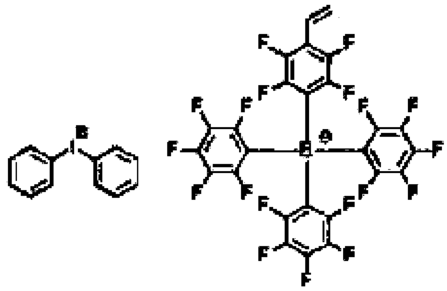

[Chemische Formel D-15]

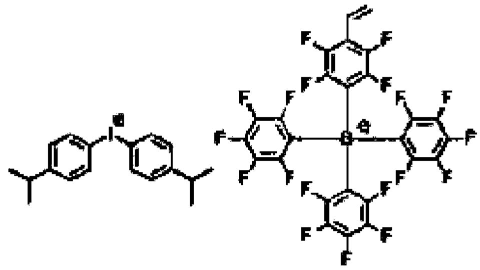

[Chemische Formel D-16]

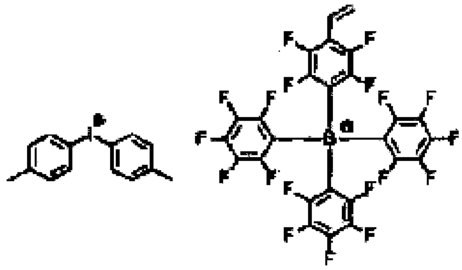

[Chemische Formel D-17]

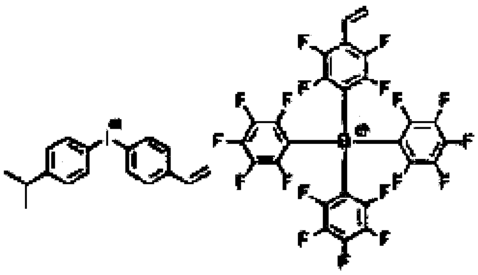

[Chemische Formel D-18]

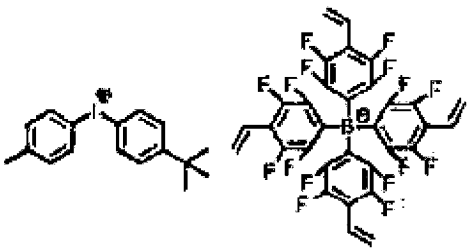

[Chemische Formel D-19]

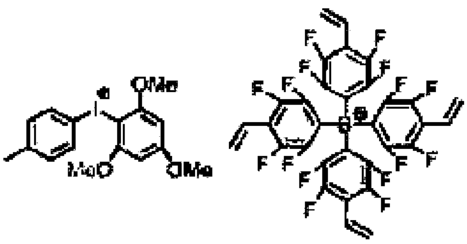

[Chemische Formel D-20]

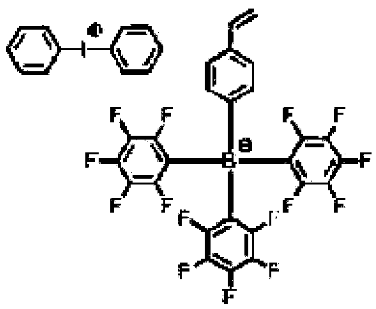

[Chemische Formel D-21]

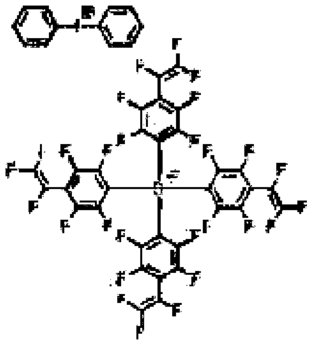

[Chemische Formel D-22]

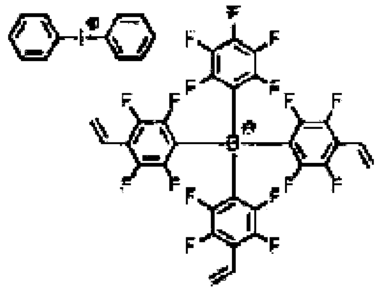

[Chemische Formel D-23]

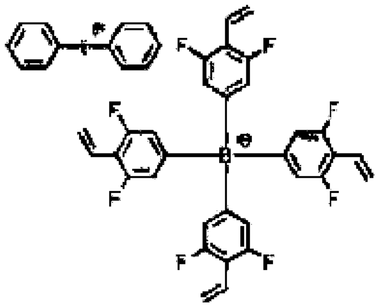

[Chemische Formel D-24]

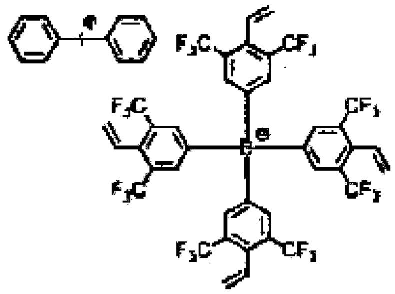

[Chemische Formel D-25]

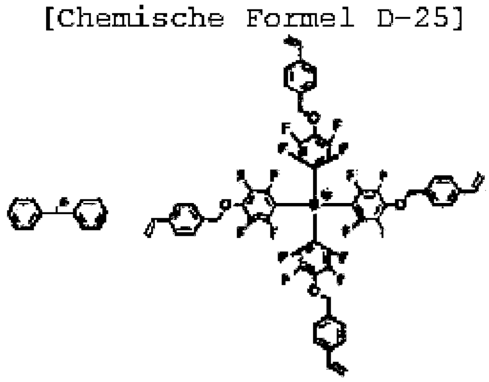

[Chemische Formel D-26]

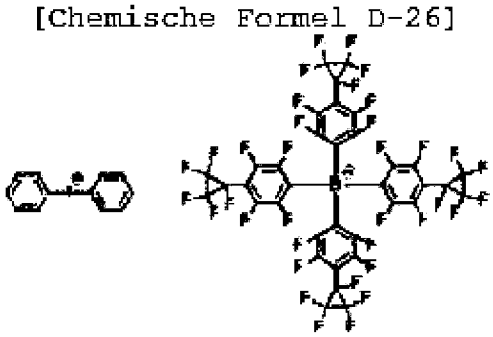

[Chemische Formel D-27]

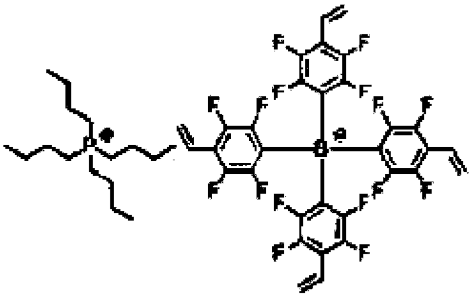

[Chemische Formel D-28]

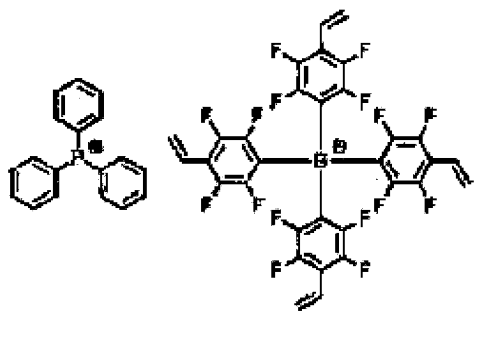

[Chemische Formel D-29]

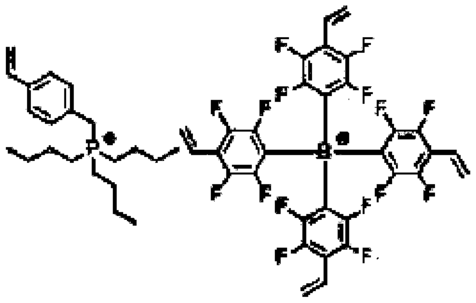

[Chemische Formel D-30]

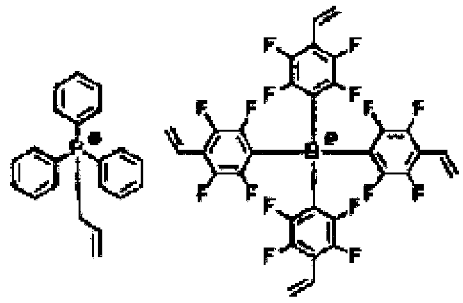

[Chemische Formel D-31]

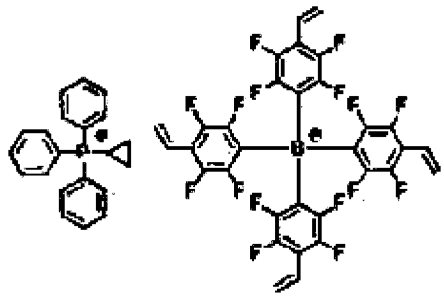

[Chemische Formel D-32]

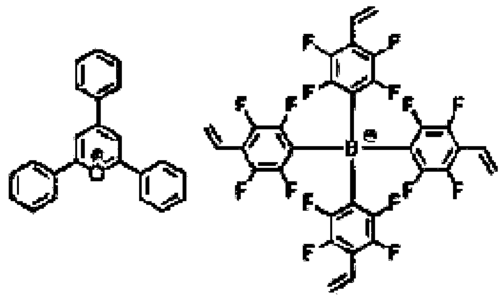

[Chemische Formel D-33]

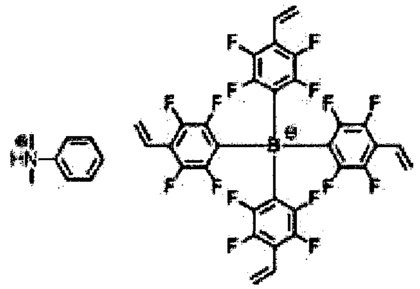

[Chemische Formel D-34]

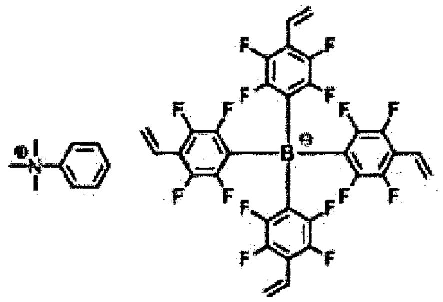

[Chemische Formel D-35]

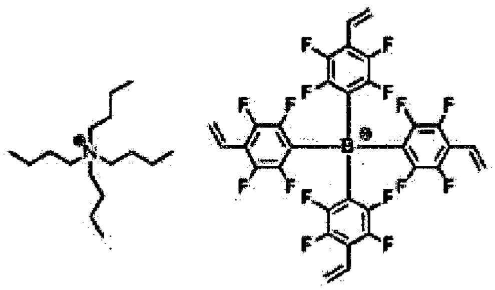

[Chemische Formel D-36]

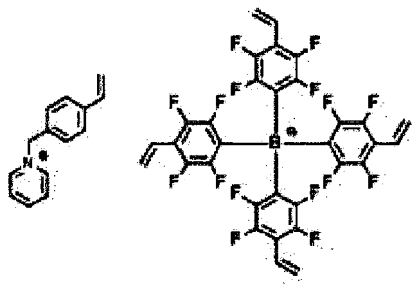

[Chemische Formel D-37]

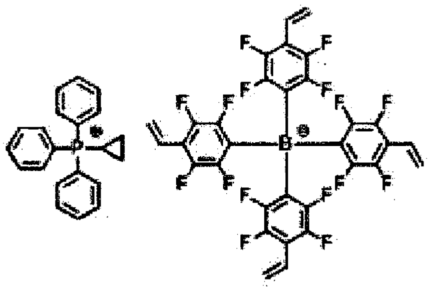

**11.** Pixel, umfassend die Tintenzusammensetzung gemäß irgendeinem der Ansprüche 1 bis 10 oder ein gehärtetes Produkt hieraus.

**12.** Pixel gemäß Anspruch 11, worin der Pixel eine Flachheit von 0,4 oder größer aufweist, wenn der Pixel eine Kurzachsenbreite von 50 μm oder kleiner aufweist.

**13.** Organische Materialschicht, umfassend den Pixel gemäß Anspruch 11.

**14.** Organische lichtemittierende Vorrichtung, umfassend:

eine erste Elektrode;
eine zweite Elektrode, und
eine organische Materialschicht mit ein oder mehr Schichten, vorgesehen zwischen der ersten Elektrode und der zweiten Elektrode,
worin eine oder mehr Schichten der organischen Materialschicht die organische Materialschicht gemäß Anspruch 13 sind.

**15.** Organische lichtemittierende Vorrichtung gemäß Anspruch 14,

worin die organische Materialschicht eine oder mehr Schichten umfasst, ausgewählt aus der Gruppe bestehend aus einer Lochinjektionsschicht, einer Lochtransportschicht, einer Lochinjektions- und -transportschicht und einer Elektronensperrschicht, und
worin die ein oder mehr Schichten, ausgewählt aus der Gruppe bestehend aus der Lochinjektionsschicht, der Lochtransportschicht, der Lochinjektions- und -transportschicht und der Elektronensperrschicht, die Tintenzusammensetzung oder ein gehärtetes Produkt hieraus umfassen.

## Revendications

**1.** Composition d'encre comprenant :

un composé représenté par la formule chimique 1 suivante ;
un premier solvant représenté par la formule chimique A suivante ; et
un deuxième solvant représenté par la formule chimique A suivante et différent du premier solvant :

[Formule chimique 1]

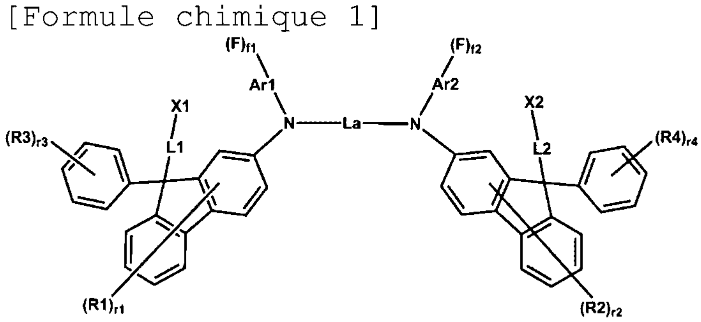

[Formule chimique A]

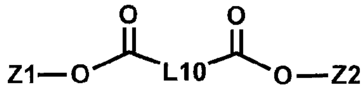

dans lesquelles, dans les formules chimiques 1 et A,

La est un groupe cyclique hydrocarboné divalent substitué ou non substitué ; ou un groupe hétérocyclique divalent substitué ou non substitué,

L1 et L2 sont identiques ou différents l'un de l'autre, et sont chacun indépendamment une liaison directe ; ou un groupe arylène substitué ou non substitué,

R1 à R4 sont identiques ou différents les uns des autres, et sont chacun indépendamment un atome d'hydrogène ; un atome de deutérium ; un groupe halogène ; un groupe alkyle substitué ou non substitué ; un groupe alcoxy substitué ou non substitué ; un groupe aryle substitué ou non substitué ; ou un groupe hétéroaryle substitué ou non substitué,

Ar1 et Ar2 sont identiques ou différents l'un de l'autre, et représentent chacun indépendamment un groupe aryle substitué ou non substitué ; ou un groupe hétéroaryle substitué ou non substitué,

X1 et X2 sont identiques ou différents l'un de l'autre, et représentent chacun indépendamment un groupe durcissable,

L10 est une liaison directe ; ou un groupe alkylène substitué ou non substitué,

Z1 et Z2 sont identiques ou différents l'un de l'autre, et sont chacun indépendamment un groupe alkyle substitué ou non substitué ; ou un groupe aryle substitué ou non substitué,

r1 et r2 sont chacun un nombre entier compris entre 1 et 7, r3 et r4 sont chacun un nombre entier compris entre 1 et 5, et lorsque r1 à r4 sont chacun égaux ou supérieurs à 2, deux ou plusieurs substituants entre parenthèses sont identiques ou différents les uns des autres,

f1 est égal à 1 jusqu'au nombre de positions de liaison dans lesquelles les substituants peuvent être liés à Ar1, et f2 est égal à 1 plus le nombre de positions de liaison dans lesquelles des substituants peuvent être liés à Ar2.

2. La composition d'encre de la revendication 1, dans laquelle la formule chimique 1 est l'une quelconque des structures suivantes :

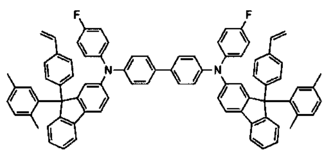 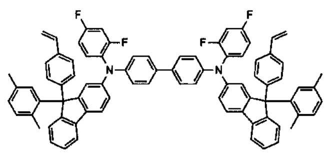 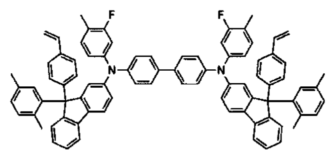

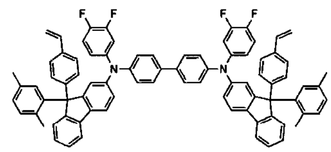 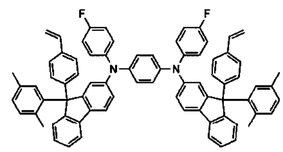 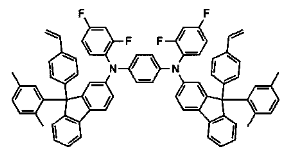

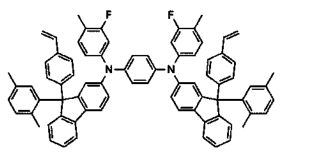 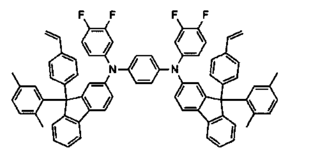 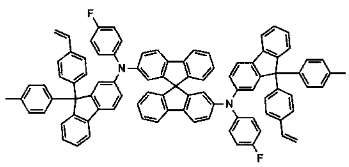

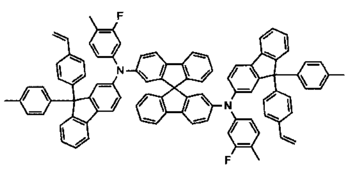 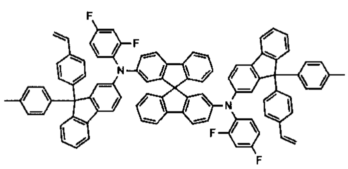 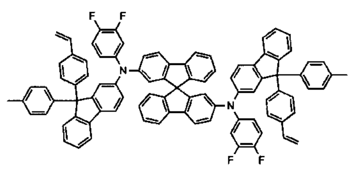

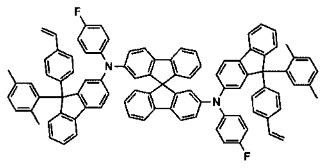
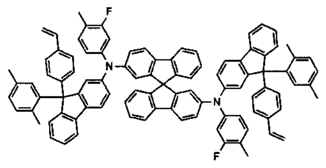
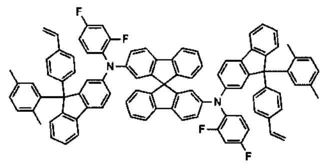
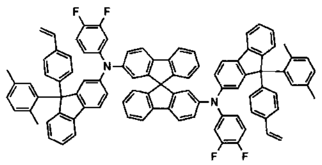
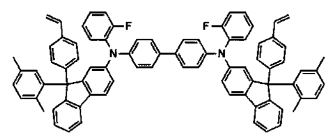
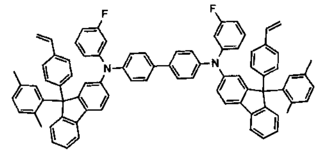
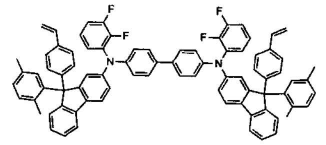
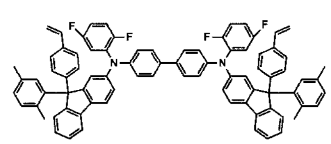
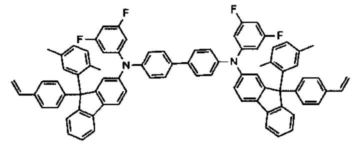
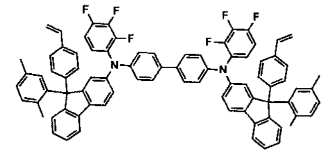
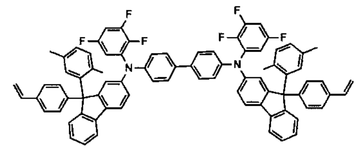
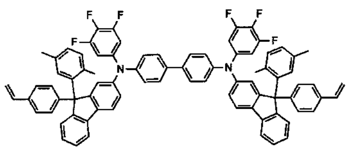
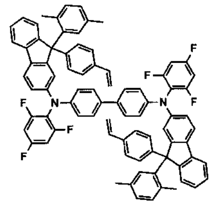
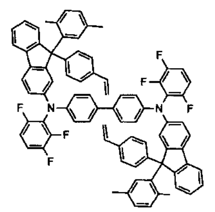
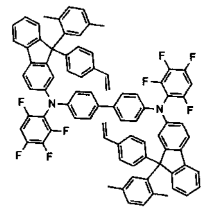
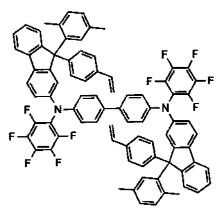
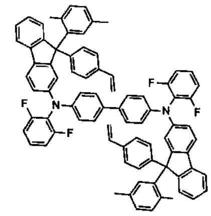
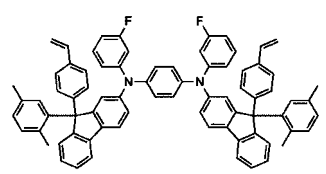
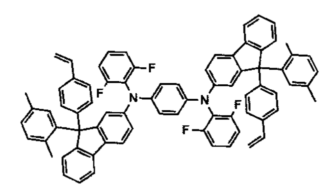
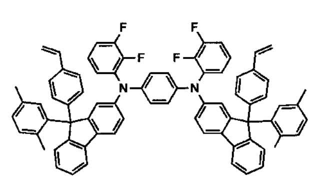
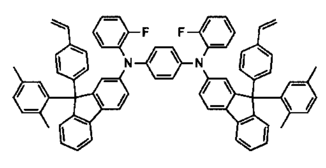
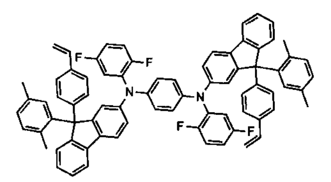
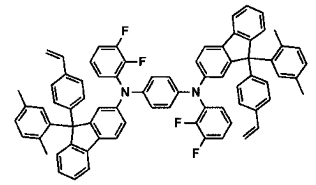

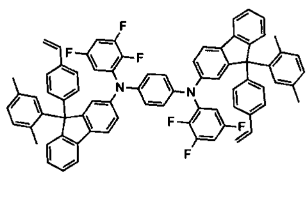 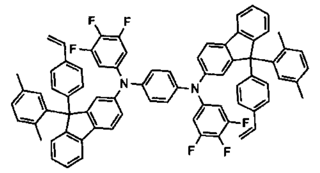 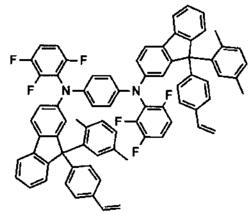

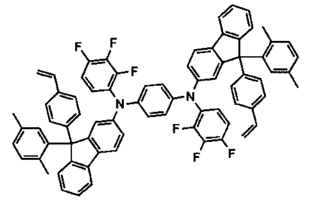 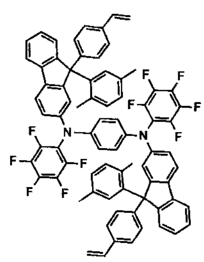 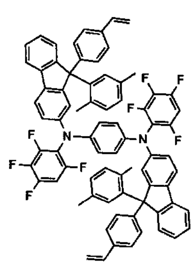 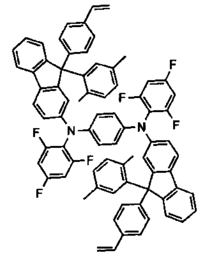

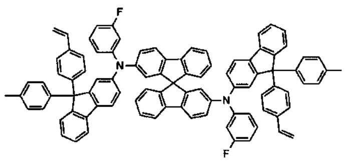 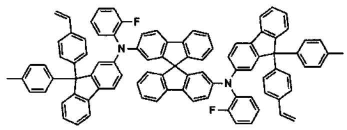 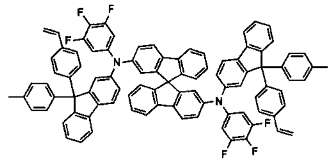

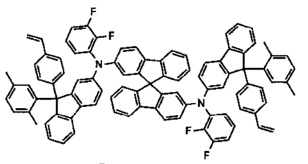 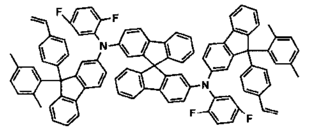 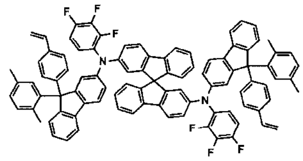

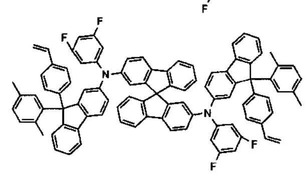 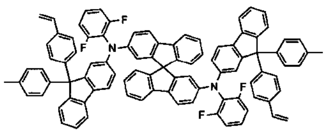 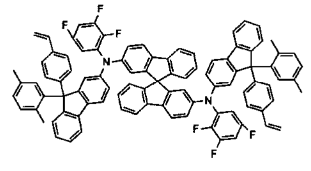

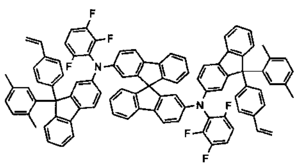 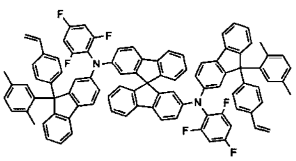 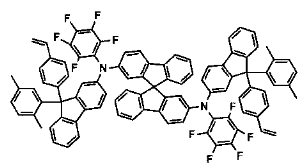

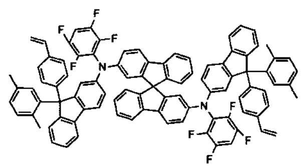 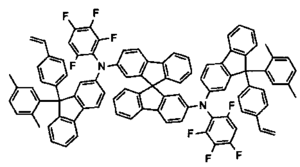 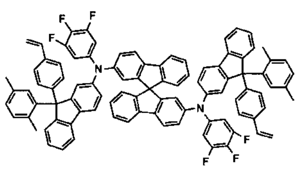

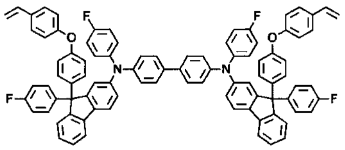 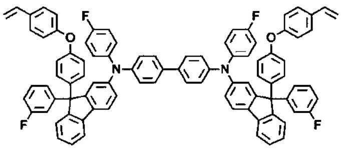 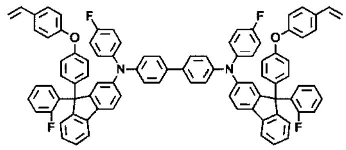

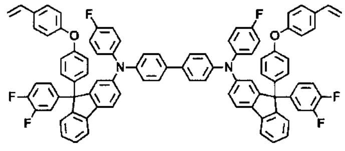
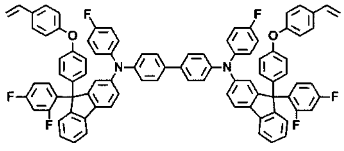
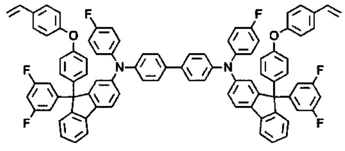

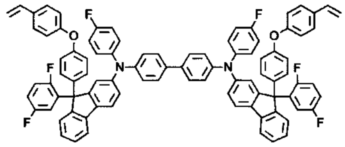
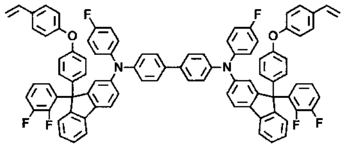
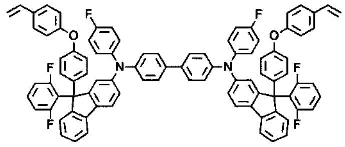

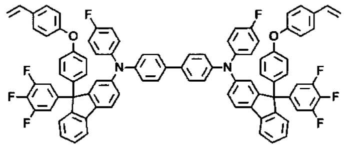
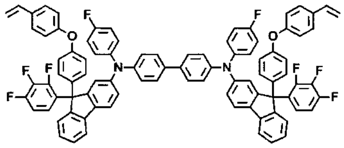
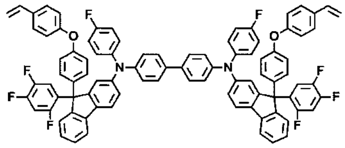

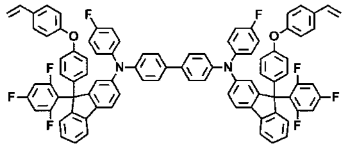
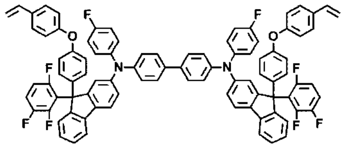
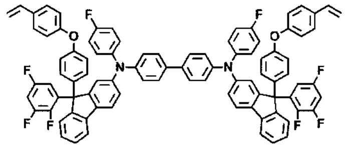

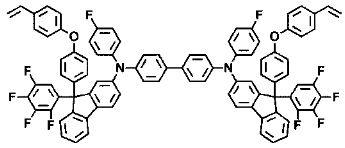
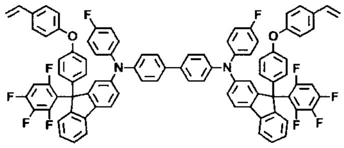
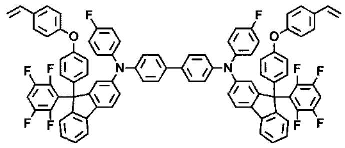

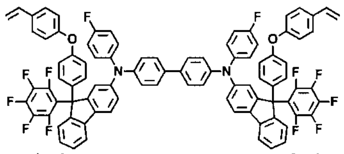

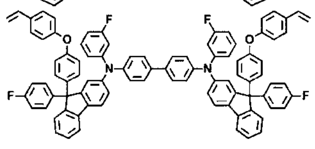
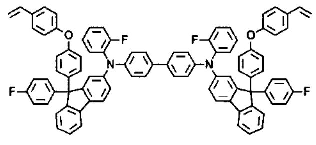
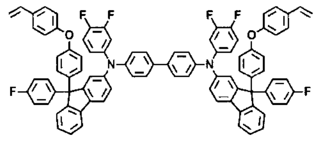

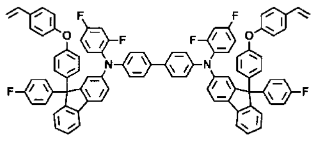
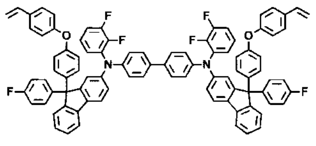
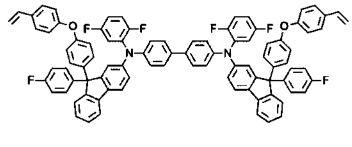

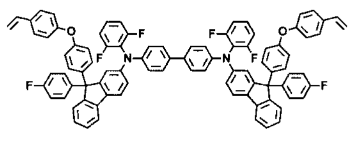
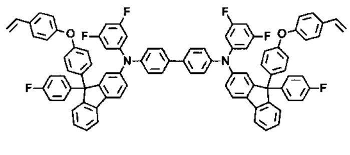
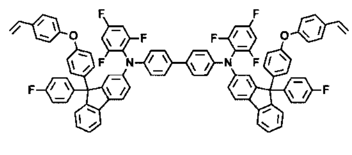

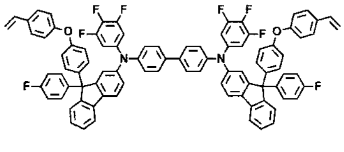
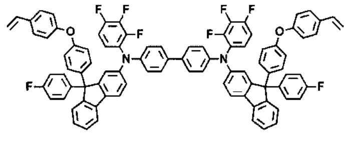
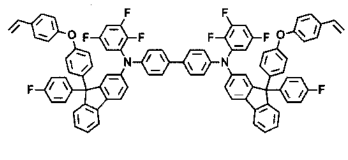

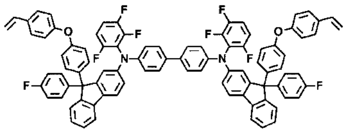
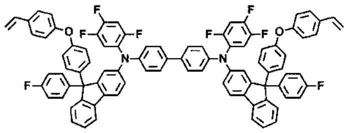
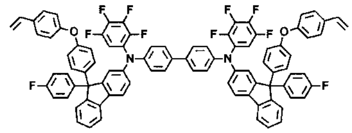

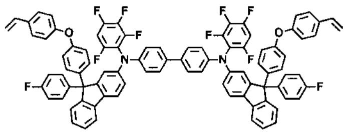
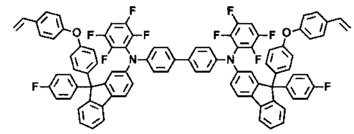
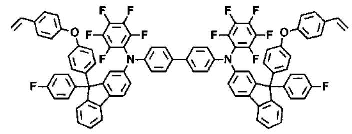

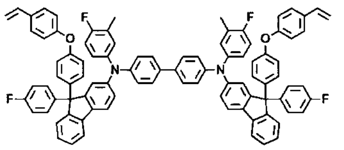
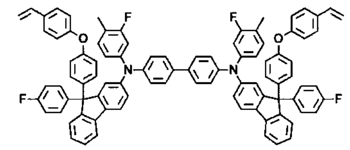
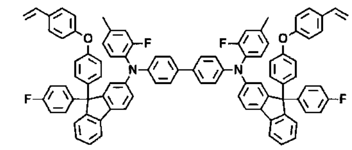

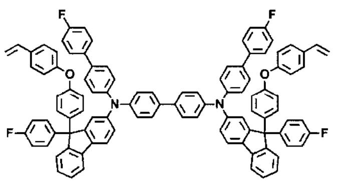
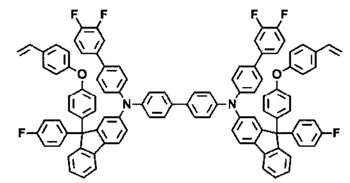
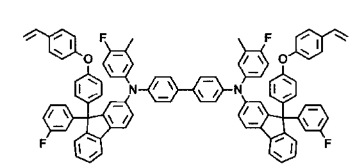

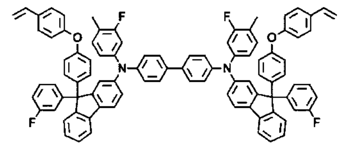
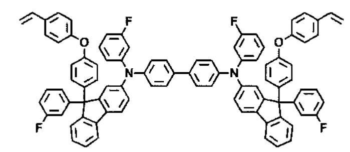
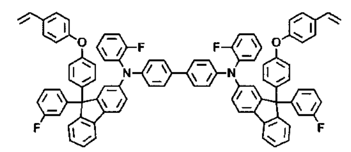

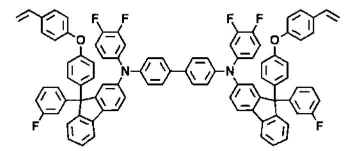
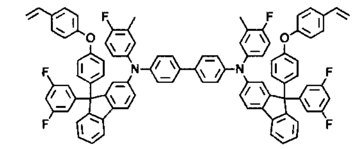
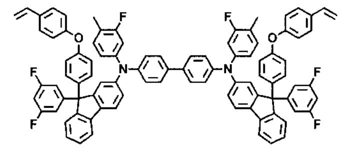

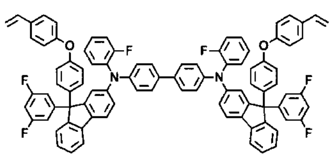
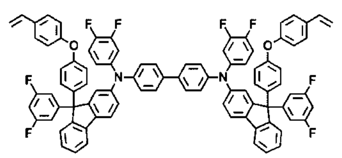
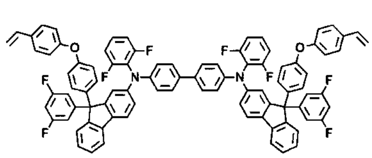

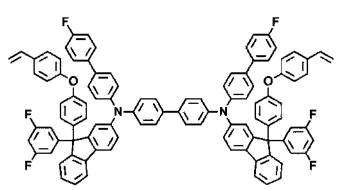
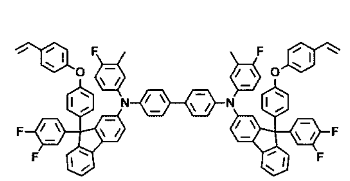
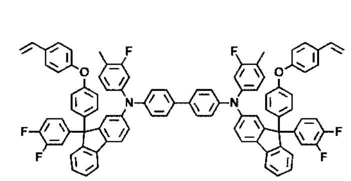

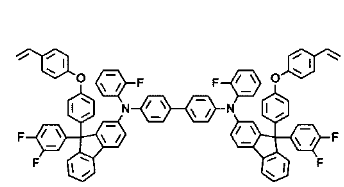
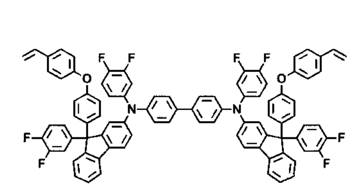
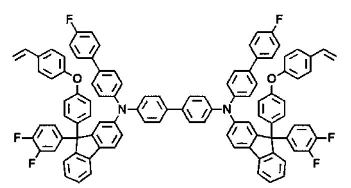

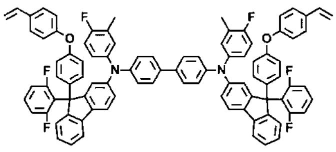 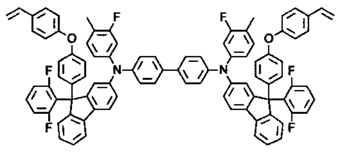 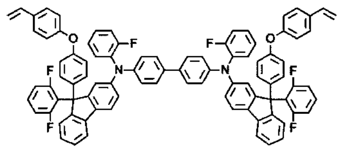

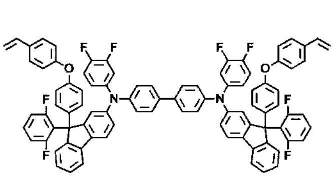 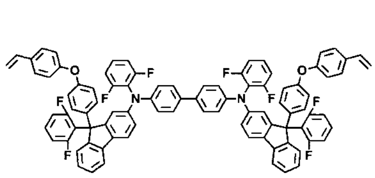 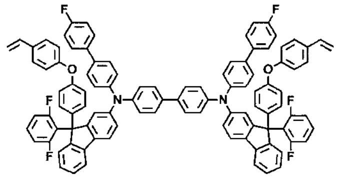

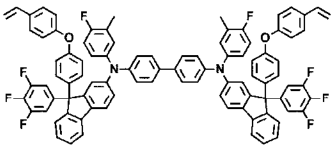 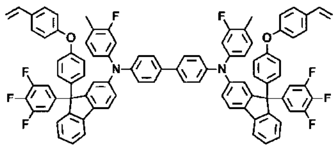 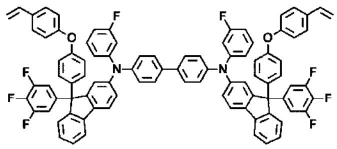

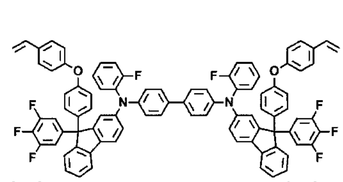 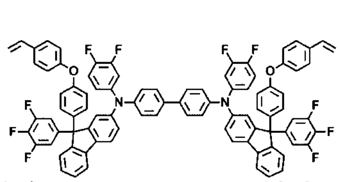 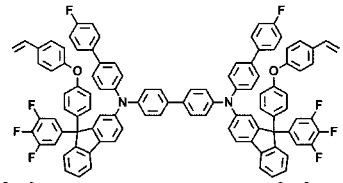

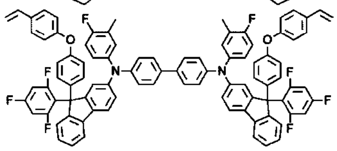 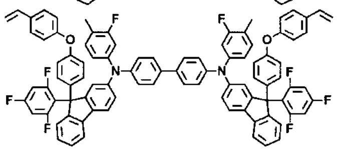 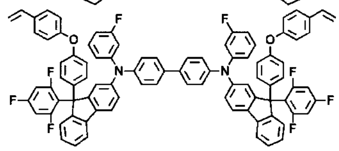

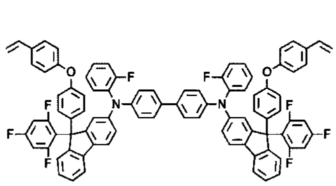 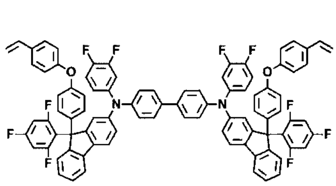 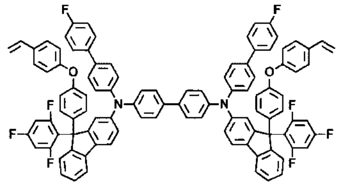

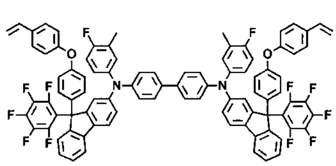 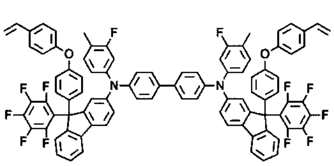 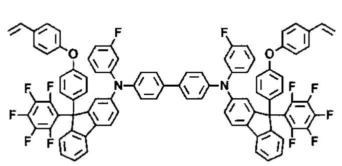

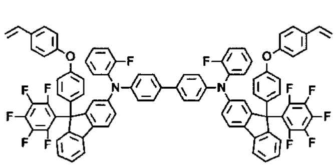 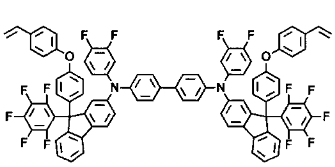 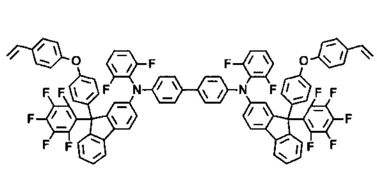

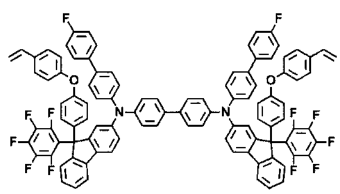

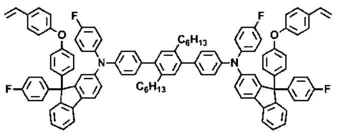
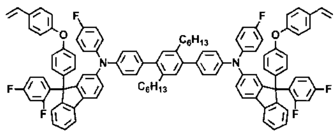
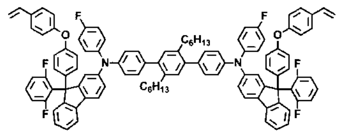

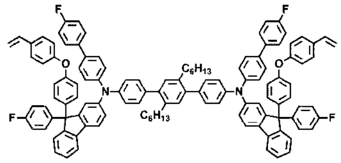
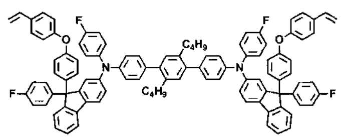
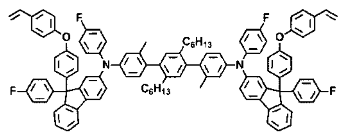

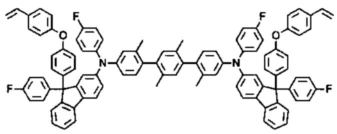
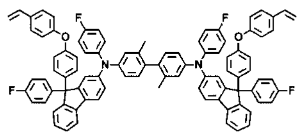
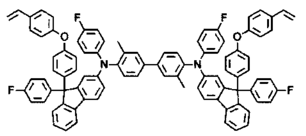

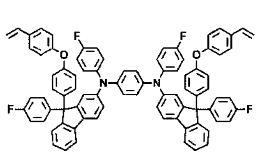
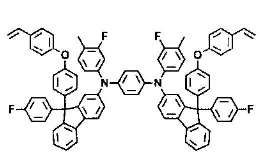
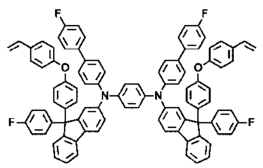

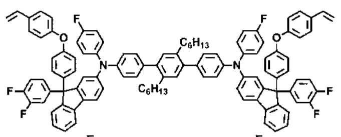
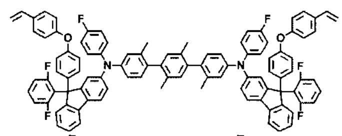

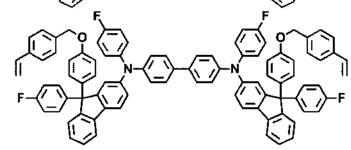
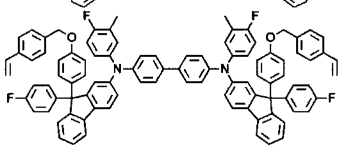
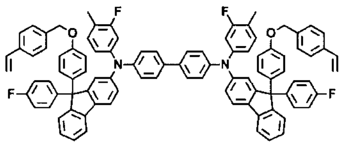

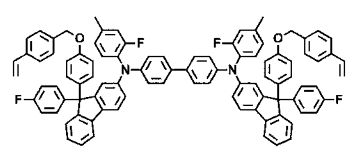
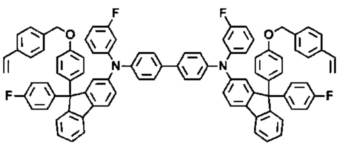
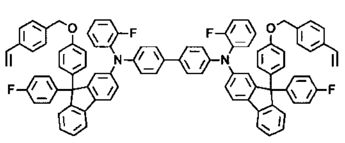

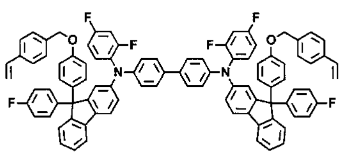
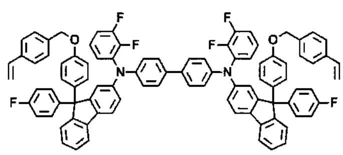
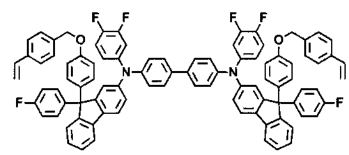

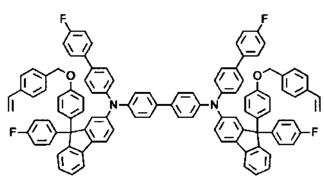
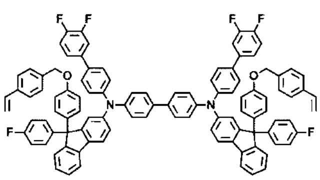
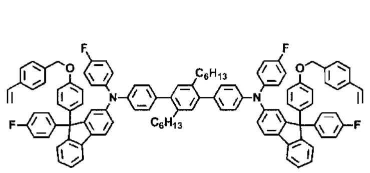

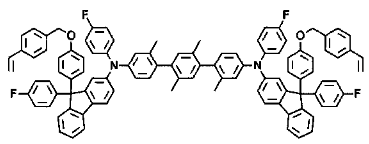
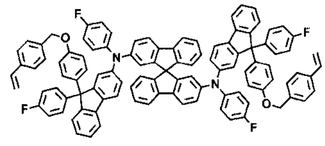
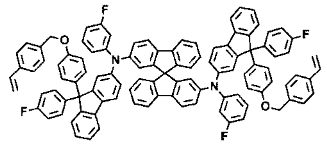

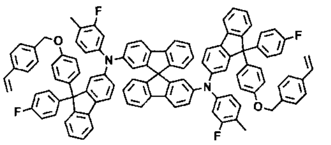
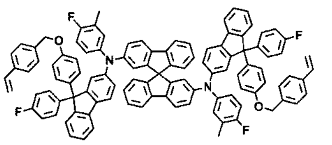
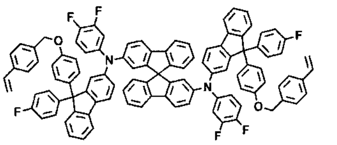

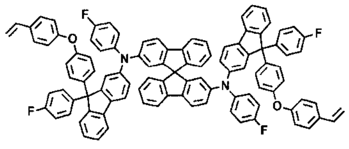
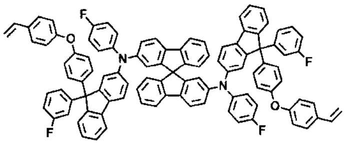
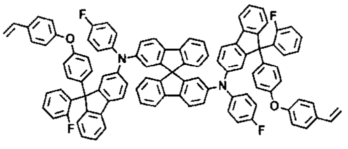

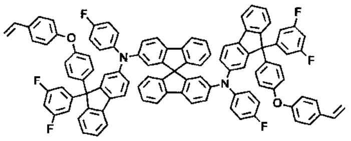
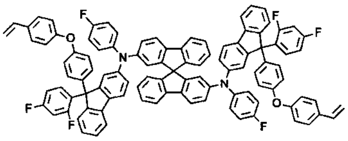
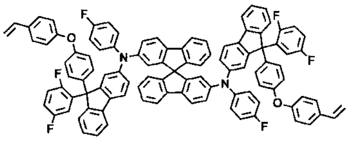

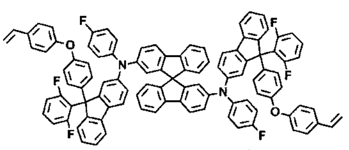
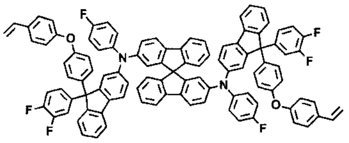
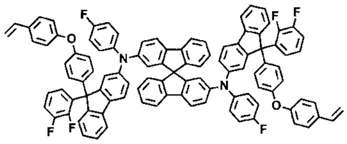

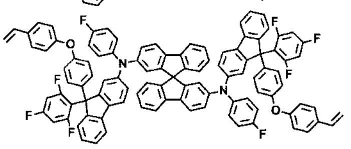
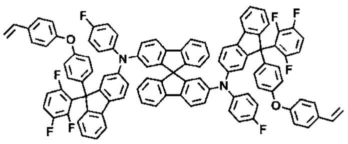
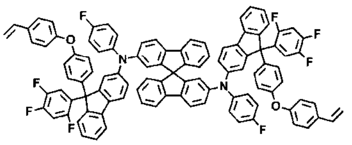

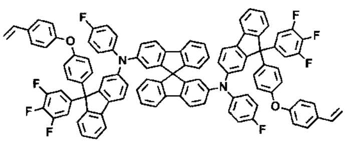
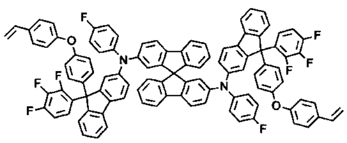
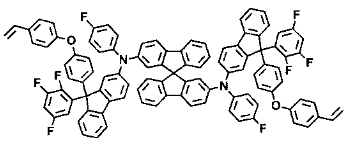

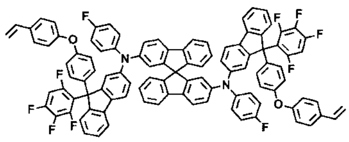
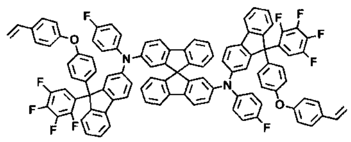
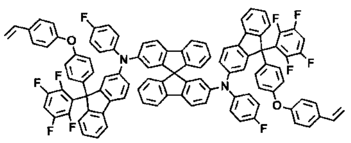

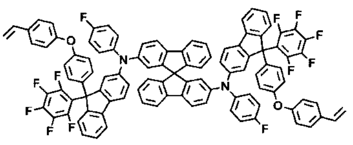

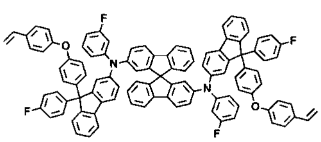
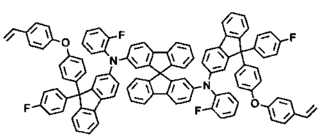
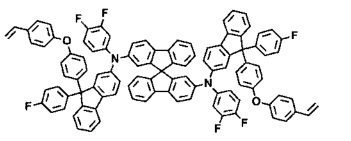

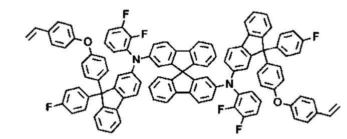 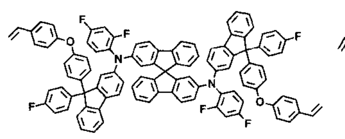 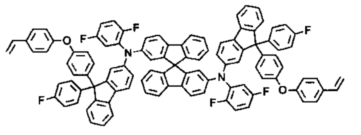

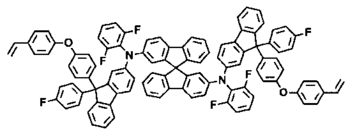 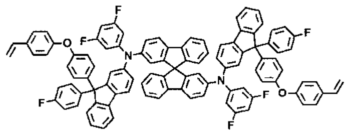 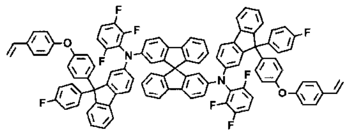

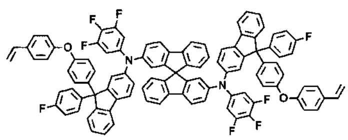 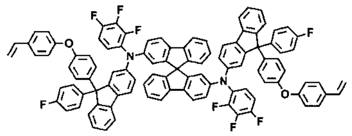 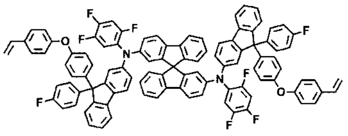

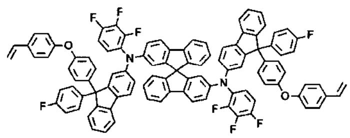 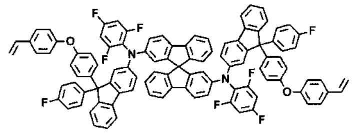 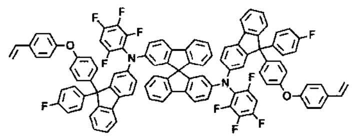

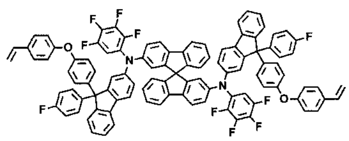 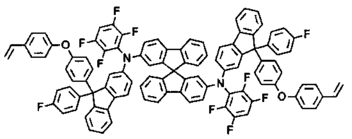 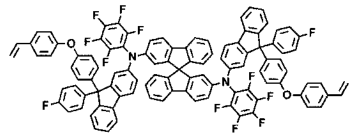

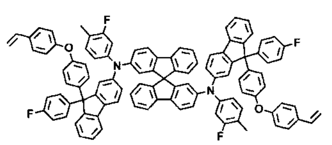 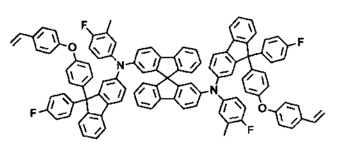 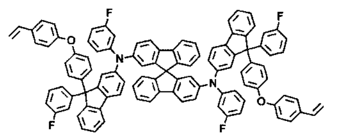

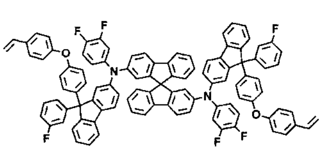 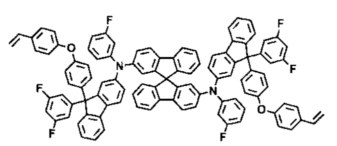 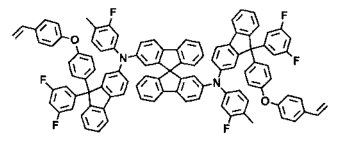

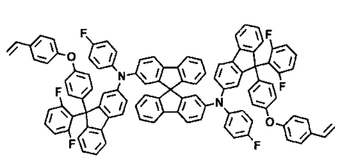 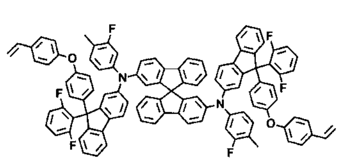 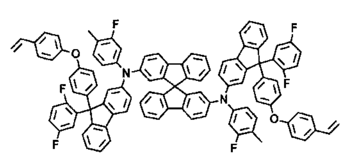

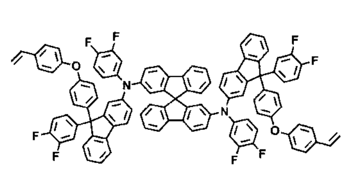 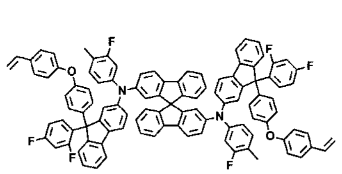 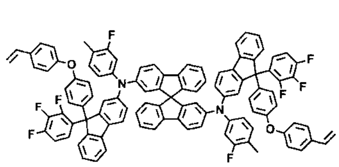

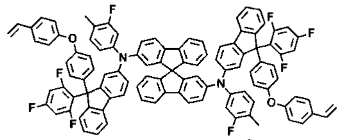
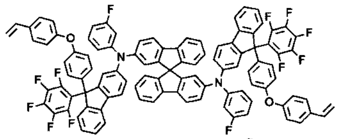
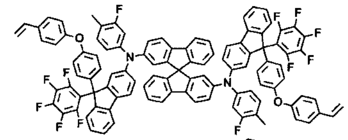
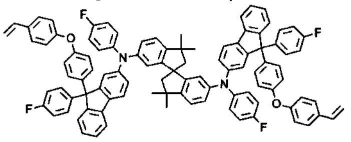
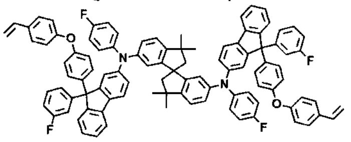
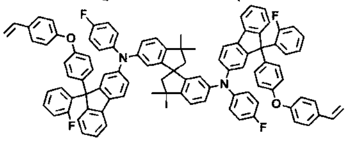
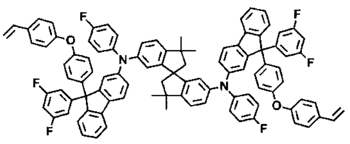
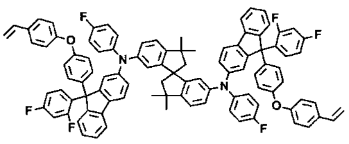
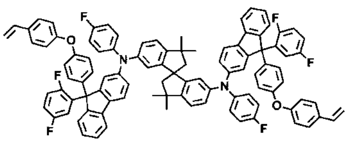
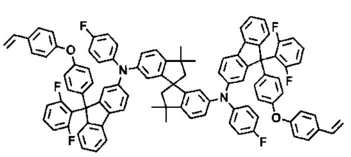
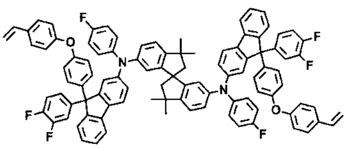
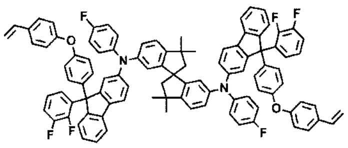
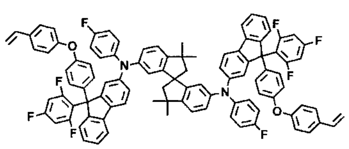
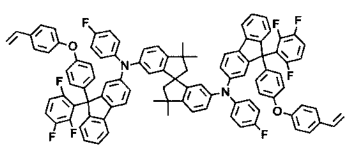
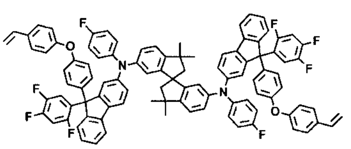
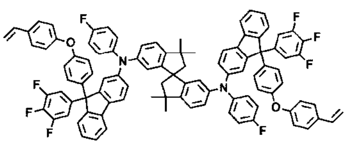
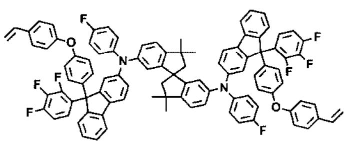
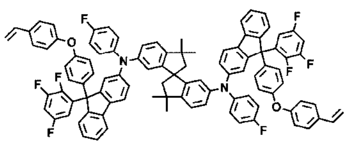
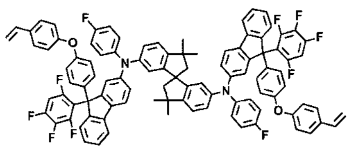
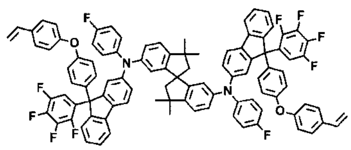
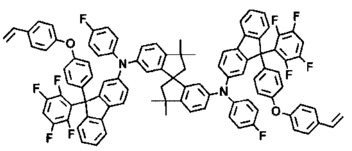
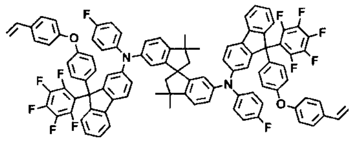
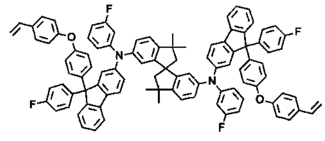
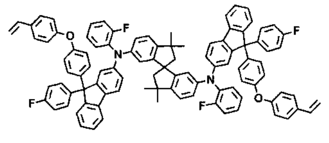
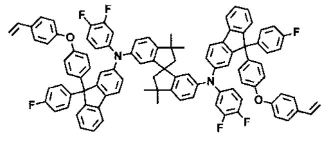
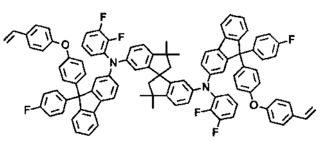
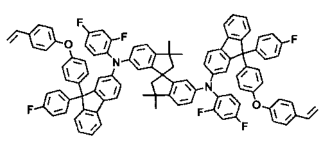
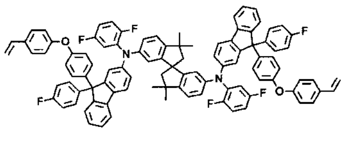

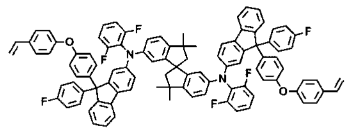 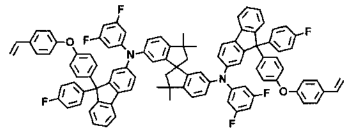 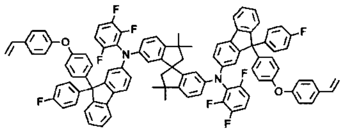

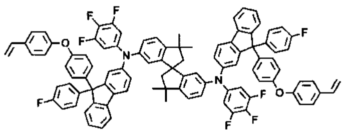 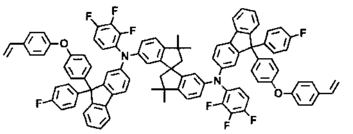 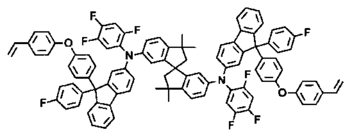

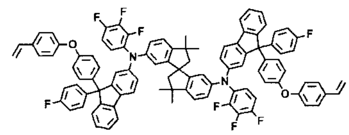 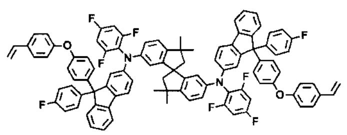 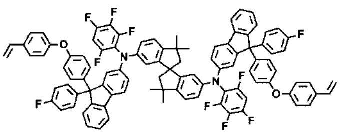

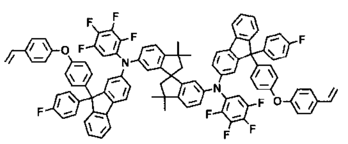 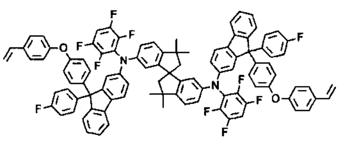 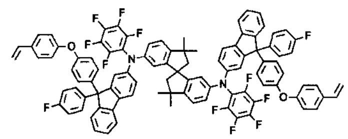

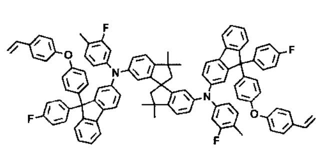 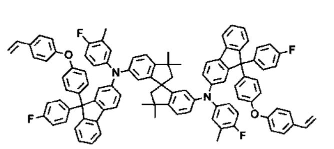 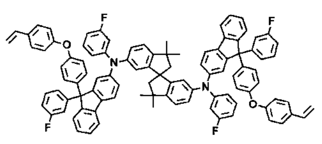

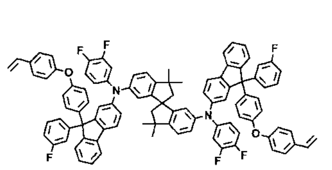 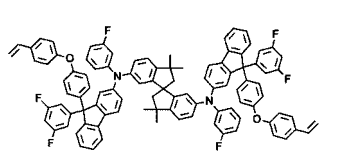 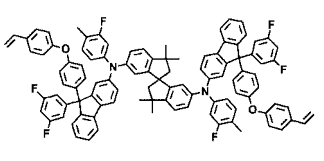

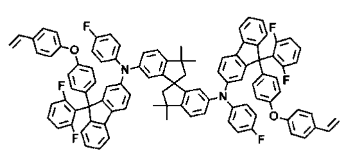 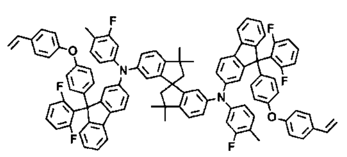 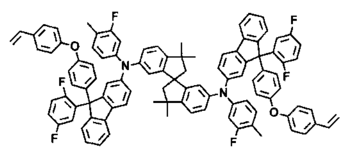

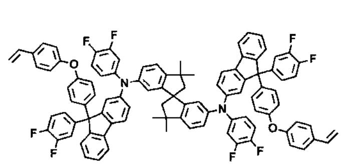 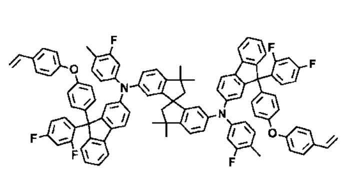 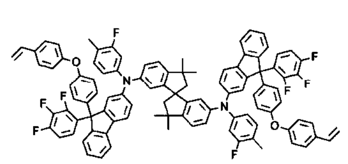

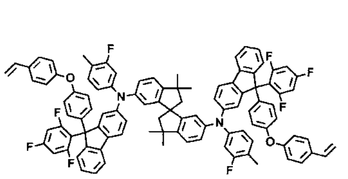 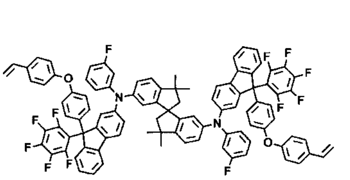 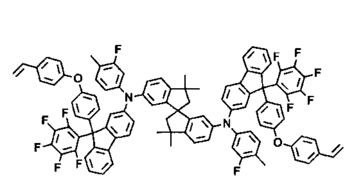

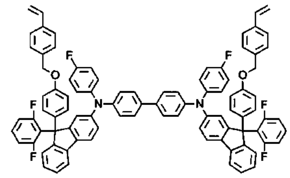

3. La composition d'encre de la revendication 1, dans laquelle la formule chimique A est l'une quelconque des structures suivantes :

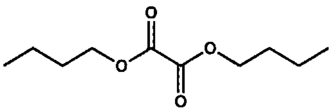

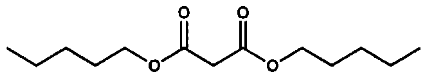

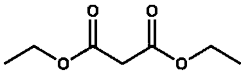

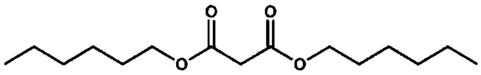

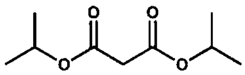

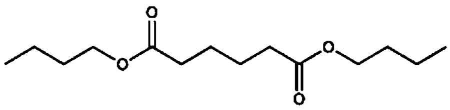

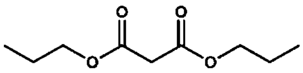

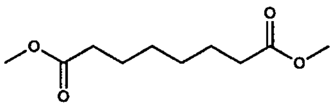

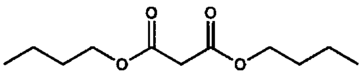

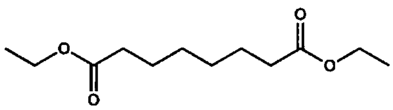

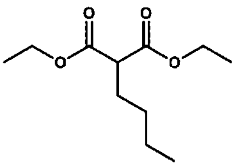

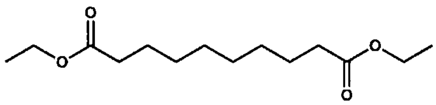

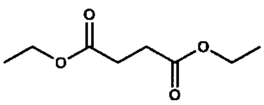

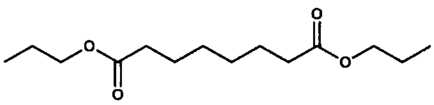

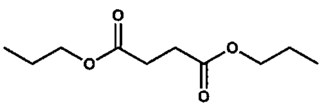

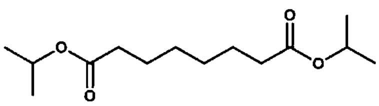

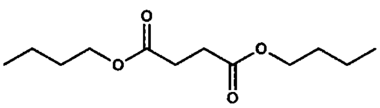

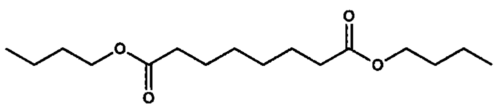

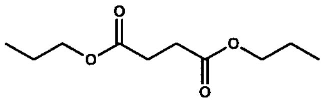

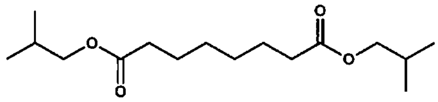

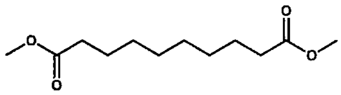

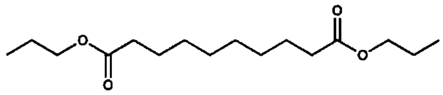

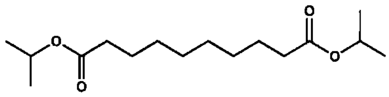

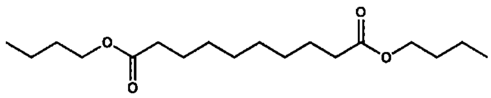

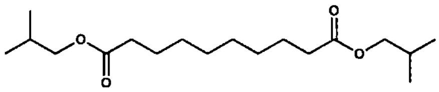

.

**4.** La composition d'encre selon la revendication 1, dans laquelle le premier solvant a un point d'ébullition de 250 °C à 350 °C,

le deuxième solvant a un point d'ébullition de 180 °C à 280 °C, et
le point d'ébullition du premier solvant est supérieur au point d'ébullition du deuxième solvant.

**5.** La composition d'encre selon la revendication 1, comprenant en outre un troisième solvant différent du premier solvant et du deuxième solvant.

**6.** La composition d'encre selon la revendication 5, dans laquelle le troisième solvant est différent du premier solvant et du deuxième solvant, et comprend un ou plusieurs des solvants représentés par la formule chimique A ; un solvant représenté par la formule chimique B suivante ; la tétraline ; le 4-méthoxytoluène ; le tripropylène glycol monobutyl éther ; et le cyclohexylbenzène :

[Formule chimique B]

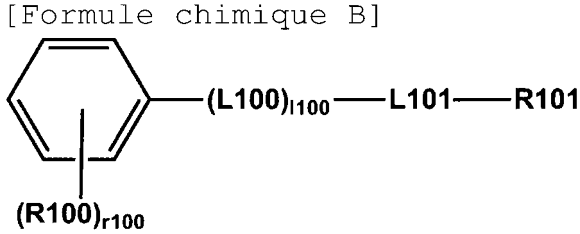

dans la formule chimique B,

L100 est un groupe alkylène,
L101 est -COO-,
R100 est un atome d'hydrogène ; ou un groupe alkyle substitué ou non substitué,
R101 est un groupe alkyle substitué ou non substitué, l100 est 0 ou 1, et
r100 est un nombre entier compris entre 1 et 5, et
lorsque r100 est égal ou supérieur à 2, les substituants entre parenthèses sont identiques ou différents les uns des autres.

**7.** La composition d'encre selon la revendication 1, comprenant en outre un composé ionique comprenant un groupe anionique représenté par la formule chimique 2 suivante :

[Formule chimique 2]

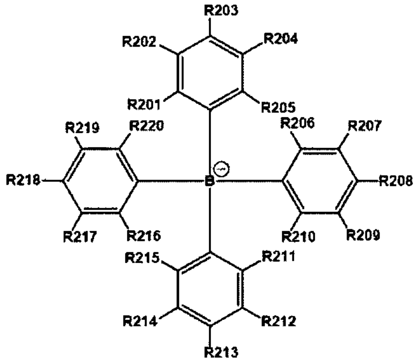

dans la formule chimique 2,

au moins l'un des R201 à R220 est F ; un groupe cyano ; ou un groupe fluoroalkyle substitué ou non substitué, au moins l'un des autres R201 à R220 est un groupe durcissable,

les autres R201 à R220 sont identiques ou différents les uns des autres, et sont chacun indépendamment un atome d'hydrogène ; du deutérium ; un groupe halogène ; un groupe nitro ; un groupe cyano ; un groupe amino ; -OR221 ; -SR222 ; $-SO_3R223$ ; -COOR224 ; -OC(O)R225 ; - C(O)NR226R227 ; -C(O)R228 ; un groupe alkyle substitué ou non substitué ; un groupe alcényle substitué ou non substitué ; un groupe alcynyle substitué ou non substitué ; un groupe amine substitué ou non substitué ;

un groupe aryle substitué ou non substitué ; ou un groupe hétérocyclique substitué ou non substitué, et R221 à R228 sont identiques ou différents les uns des autres, et sont chacun indépendamment un atome d'hydrogène ; un atome de deutérium ; ou un groupe alkyle substitué ou non substitué.

**8.** La composition d'encre selon la revendication 7, dans laquelle la formule chimique 2 est l'une quelconque des structures suivantes :

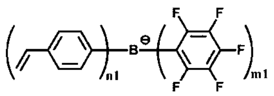
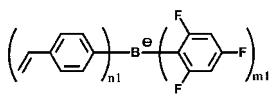
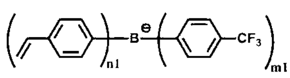

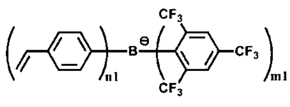
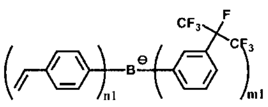
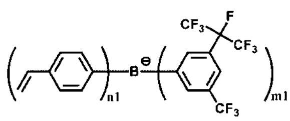

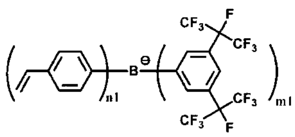
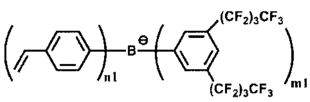
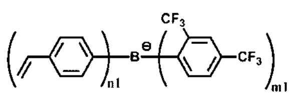

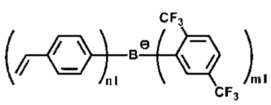
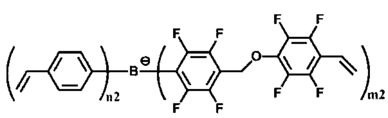

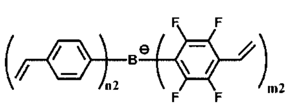
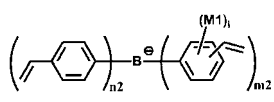
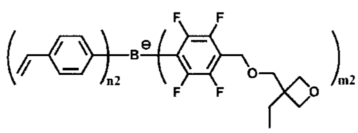

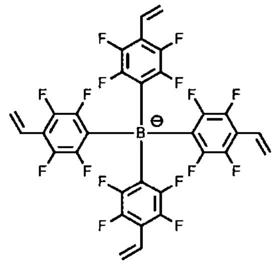

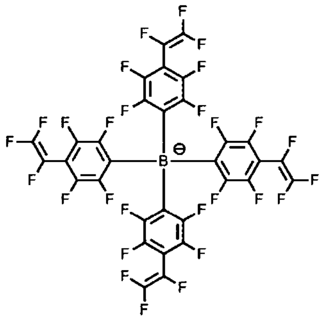

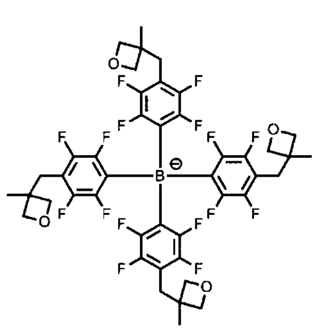

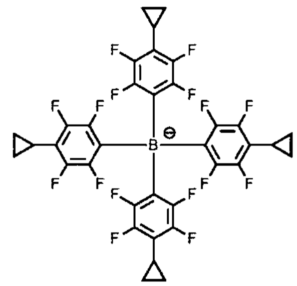

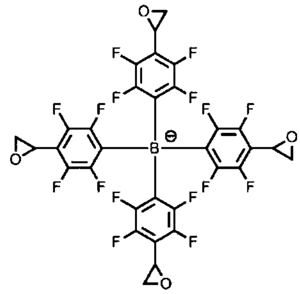

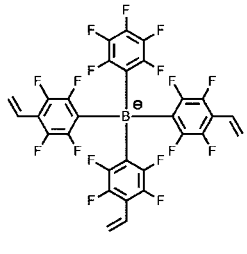

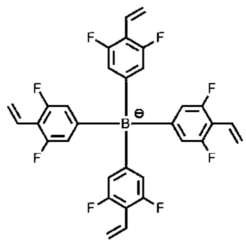

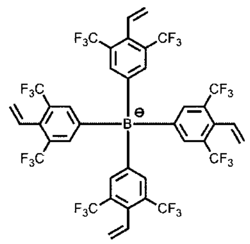

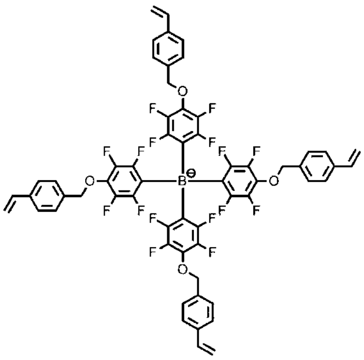

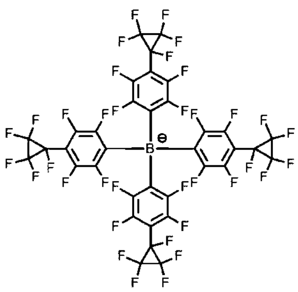

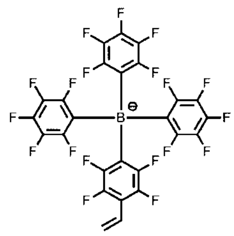

dans les structures,

n1 est un nombre entier compris entre 1 et 3, m1 est un nombre entier compris entre 1 et 3, et n1+m1=4,
n2 est un nombre entier compris entre 0 et 3, m2 est un nombre entier compris entre 1 et 4, et n2+m2=4,
M1 est un deutérium ; un groupe halogène ; un groupe nitro ; un groupe cyano ; un groupe amino ; -OR221 ; -SR222 ; $-SO_3R223$ ; -COOR224 ; -OC(O)R225 ; - C(O)NR226R227 ; -C(O)R228 ; un groupe alkyle substitué ou non substitué ; un groupe alcényle substitué ou non substitué ; un groupe alcynyle substitué ou non substitué ; un groupe amine substitué ou non substitué ;
un groupe aryle substitué ou non substitué ; ou un groupe hétérocyclique substitué ou non substitué, R221 à R228 sont identiques ou différents les uns des autres, et sont chacun indépendamment un atome d'hydrogène ; un atome de deutérium ; ou un groupe alkyle substitué ou non substitué, et
i est un nombre entier de 1 à 4, et lorsque i est égal ou supérieur à 2, deux ou plusieurs M1 sont identiques ou différents les uns des autres.

9. La composition d'encre selon la revendication 7, dans laquelle le composé ionique comprend en outre un groupe cationique, et le groupe cationique est un groupe cationique monovalent, un composé onium ou l'une quelconque des structures suivantes :

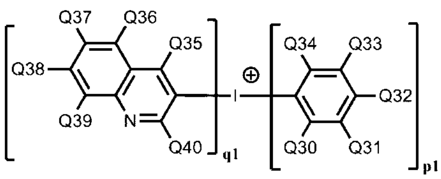

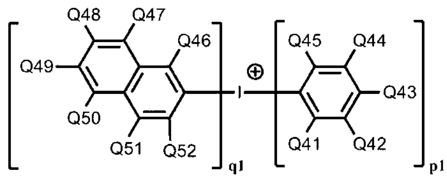

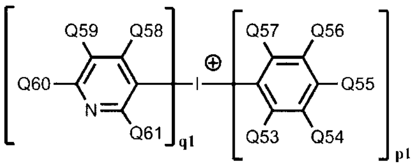

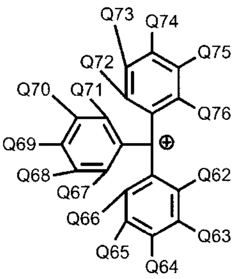

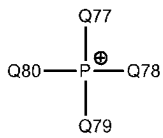

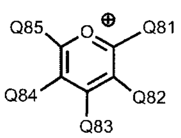

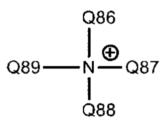

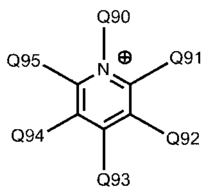

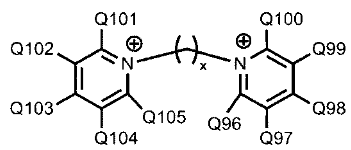

dans les structures,

Q30 à Q105 sont identiques ou différents les uns des autres, et représentent chacun indépendamment un atome d'hydrogène ; un atome de deutérium ; un groupe cyano ;
un groupe nitro ; un groupe halogène ; un groupe hydroxyle ; -COOR250 ; un groupe alkyle substitué ou non substitué ; un groupe alcoxy substitué ou non substitué ; un groupe aryloxy substitué ou non substitué ; un groupe cycloalkyle substitué ou non substitué ; un groupe aryle substitué ou non substitué ; ou un groupe durcissable,
R250 est un atome d'hydrogène, un atome de deutérium ou un groupe alkyle substitué ou non substitué,
x est un nombre entier compris entre 0 et 10, et
p1 est égal à 1 ou 2, q1 est égal à 0 ou 1 et p1+q1=2.

10. La composition d'encre selon la revendication 7, dans laquelle le composé ionique est l'un quelconque des composés chimiques D-1 à D-37 suivants :

[Formule chimique D-1]

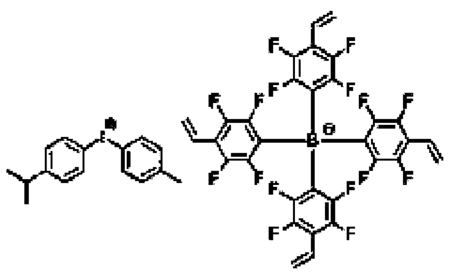

[Formule chimique D-2]

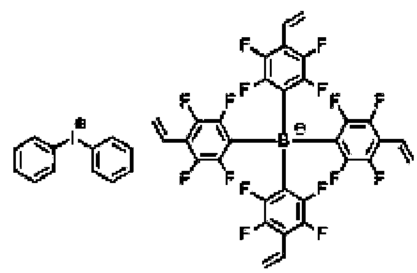

[Formule chimique D-3]

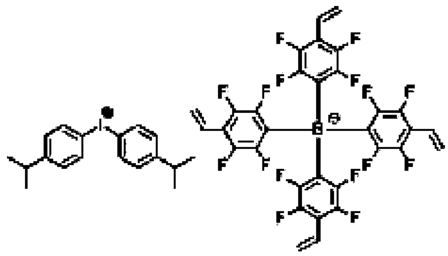

[Formule chimique D-4]

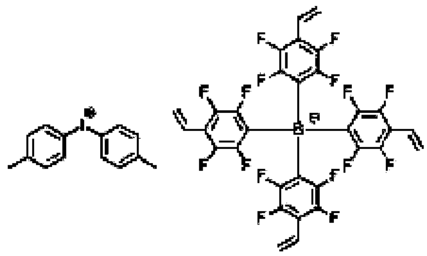

[Formule chimique D-5]

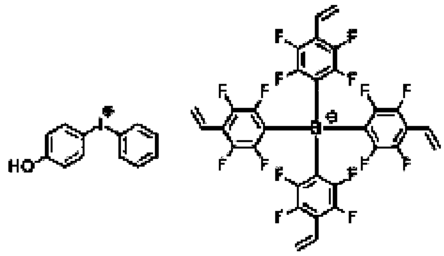

[Formule chimique D-6]

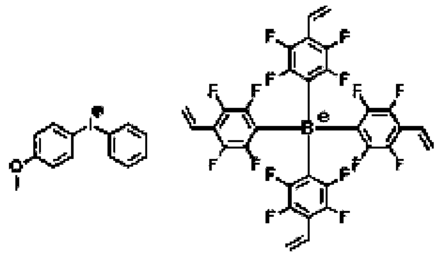

[Formule chimique D-7]

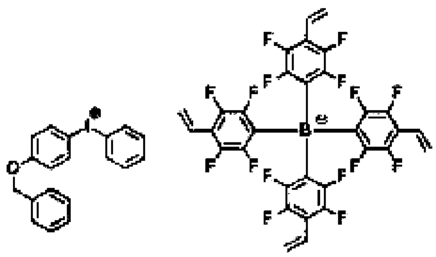

[Formule chimique D-8]

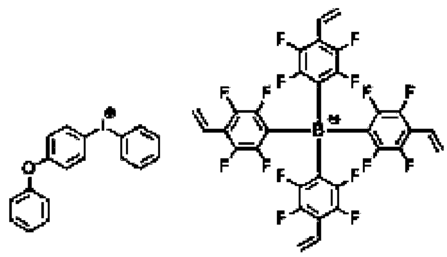

[Formule chimique D-9]

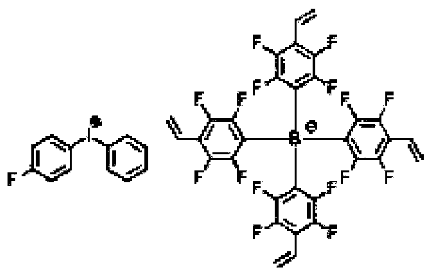

[Formule chimique D-10]

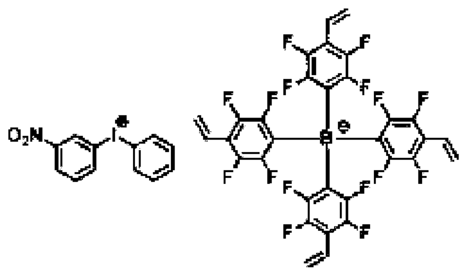

[Formule chimique D-11]

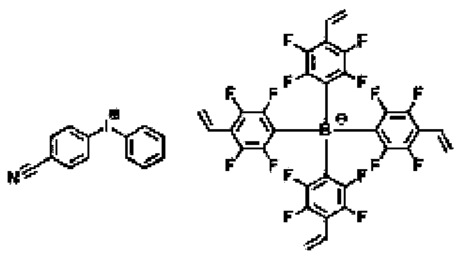

[Formule chimique D-12]

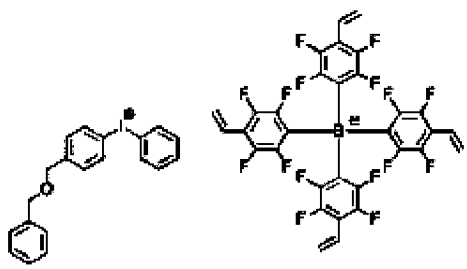

[Formule chimique D-13]

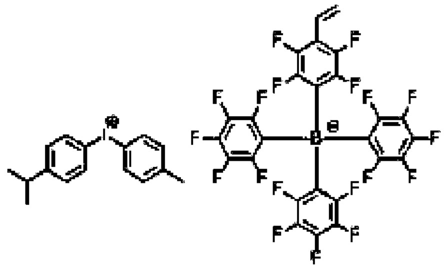

[Formule chimique D-14]

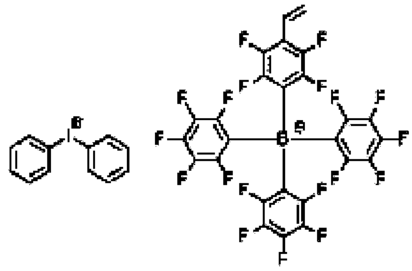

[Formule chimique D-15]

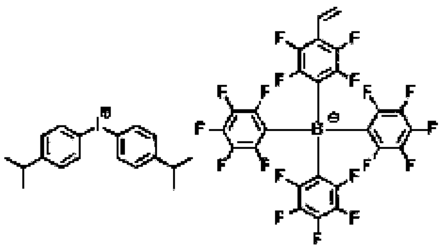

[Formule chimique D-16]

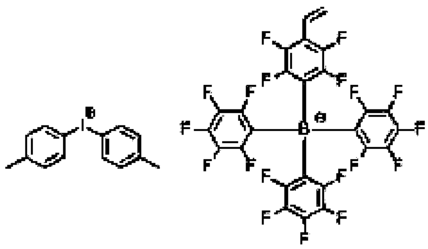

[Formule chimique D-17]

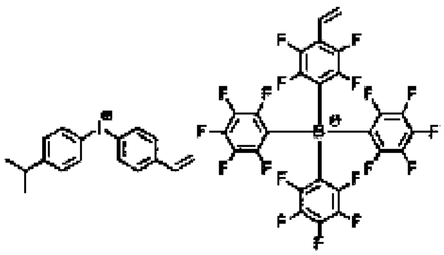

[Formule chimique D-18]

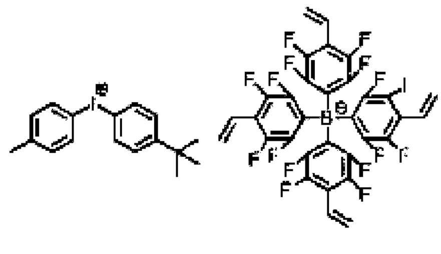

[Formule chimique D-19]

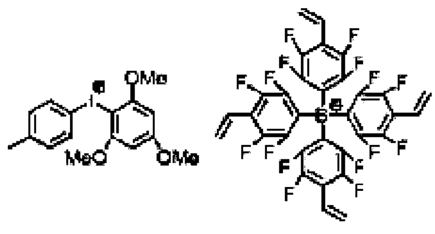

[Formule chimique D-20]

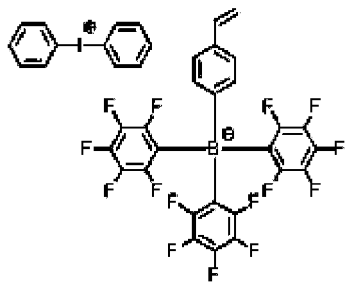

[Formule chimique D-21]

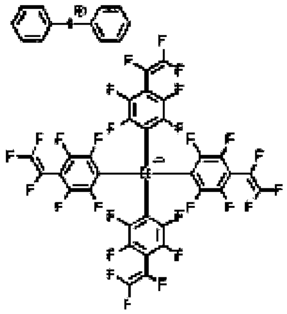

[Formule chimique D-22]

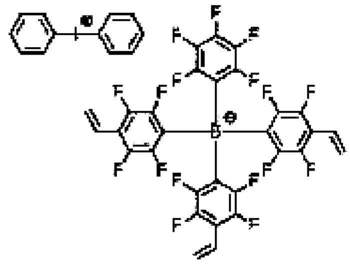

[Formule chimique D-23]

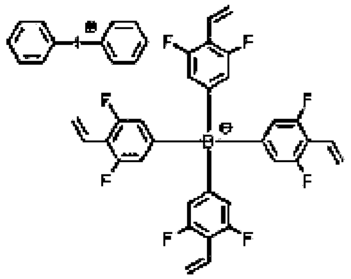

[Formule chimique D-24]

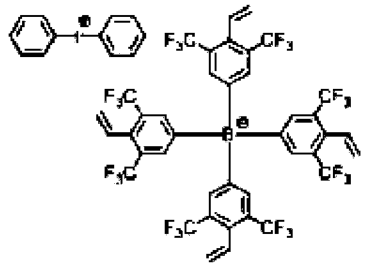

[Formule chimique D-25]

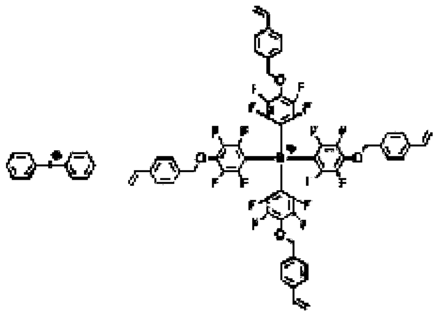

[Formule chimique D-26]

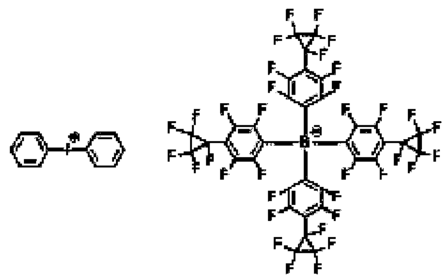

[Formule chimique D-27]

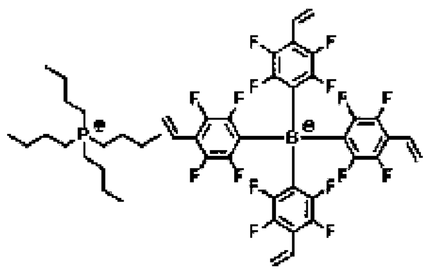

[Formule chimique D-28]

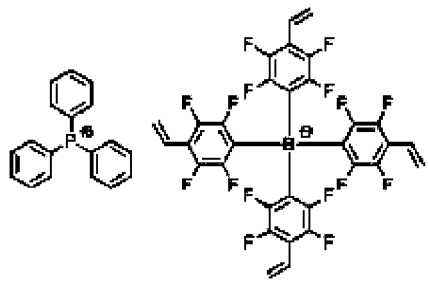

[Formule chimique D-29]

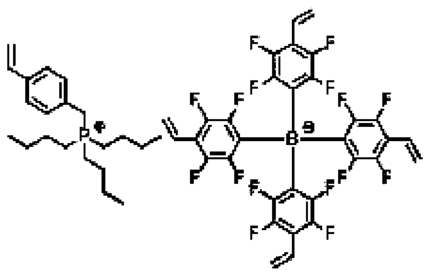

[Formule chimique D-30]

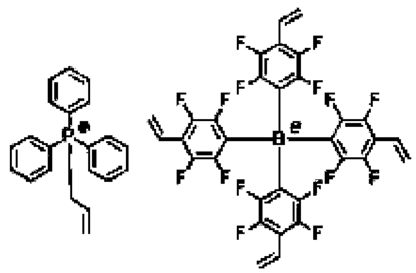

[Formule chimique D-31]

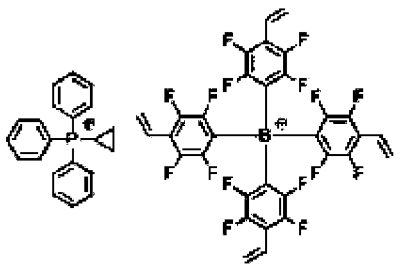

[Formule chimique D-32]

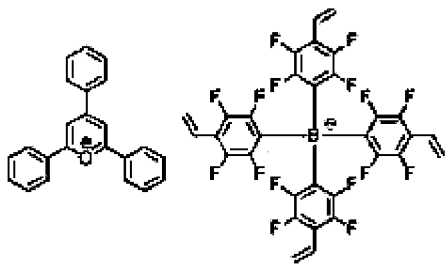

[Formule chimique D-33]

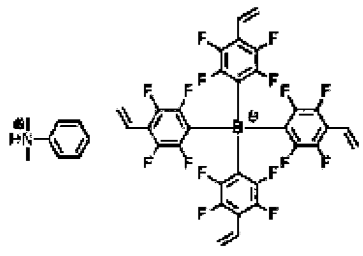

[Formule chimique D-34]

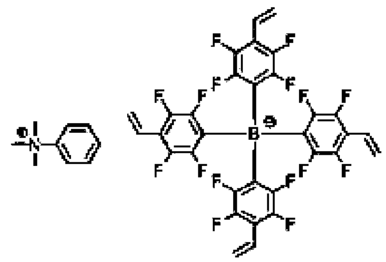

[Formule chimique D-35]

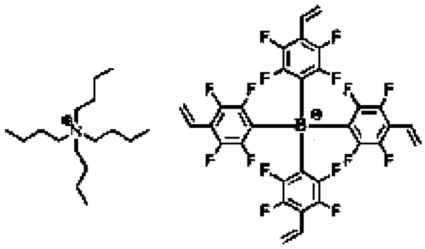

[Formule chimique D-36]

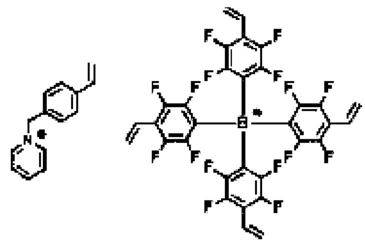

[Formule chimique D-37]

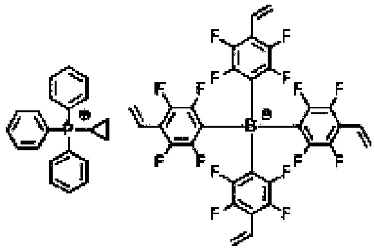

**11.** Pixel comprenant la composition d'encre de l'une quelconque des revendications 1 à 10 ou un produit durci de celle-ci.

**12.** Le pixel selon la revendication 11, dans lequel le pixel a une planéité de 0,4 ou plus lorsque le pixel a une largeur d'axe court de 50 μm ou moins.

**13.** Couche de matériau organique comprenant le pixel de la revendication 11.

**14.** Dispositif électroluminescent organique comprenant :

une première électrode ;
une deuxième électrode ; et
une couche de matériau organique comportant une ou plusieurs couches disposées entre la première électrode et la deuxième électrode,
dans lequel une ou plusieurs couches de la couche de matériau organique sont la couche de matériau organique de la revendication 13.

**15.** Dispositif électroluminescent organique selon la revendication 14, dans lequel la couche de matériau organique comprend une ou plusieurs couches choisies dans le groupe constitué d'une couche d'injection de trous, d'une couche de transport de trous, d'une couche d'injection et de transport de trous, et d'une couche de blocage d'électrons, et
la ou les couches choisies dans le groupe constitué de la couche d'injection de trous, de la couche de transport de trous, de la couche d'injection et de transport de trous, et de la couche de blocage d'électrons comprennent la composition d'encre ou un produit durci de celle-ci.

[Figure 1]

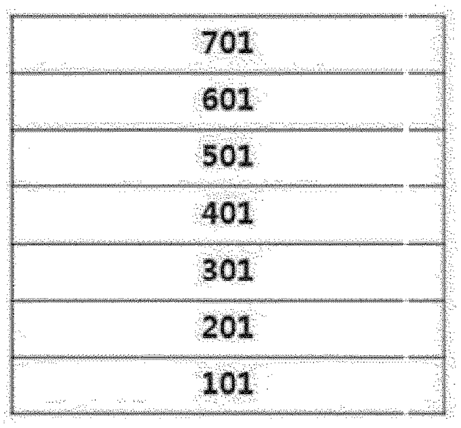


[Figure 2]

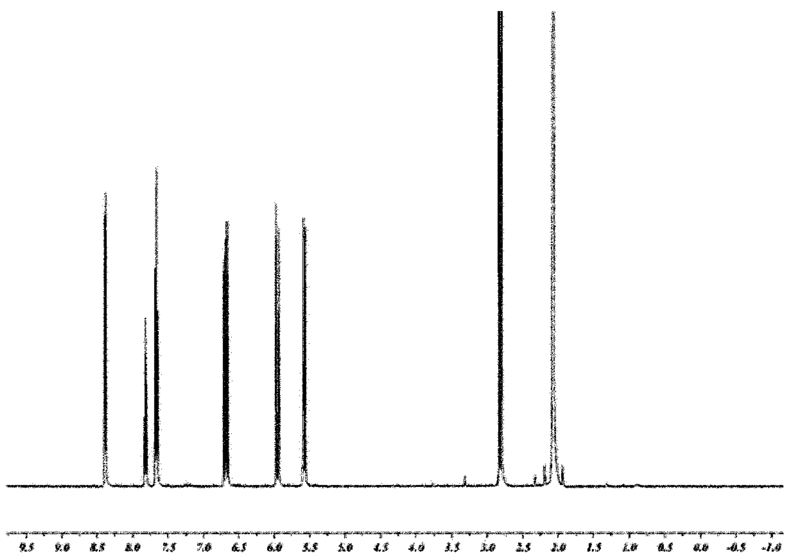

[Figure 3]

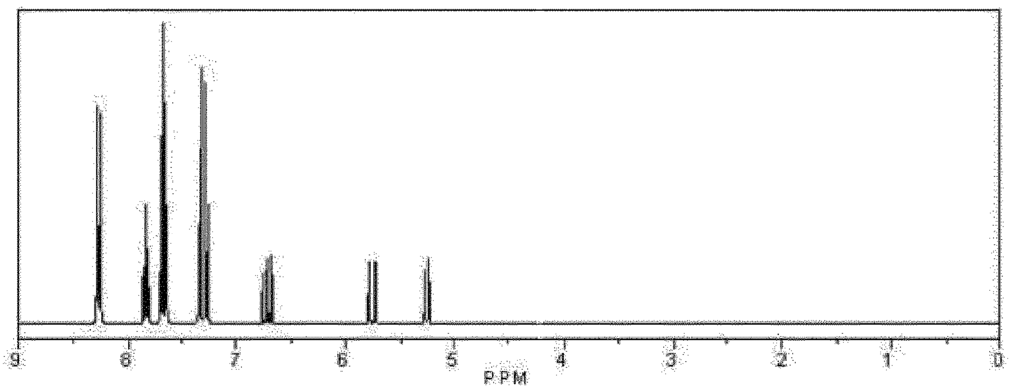


[Figure 4]

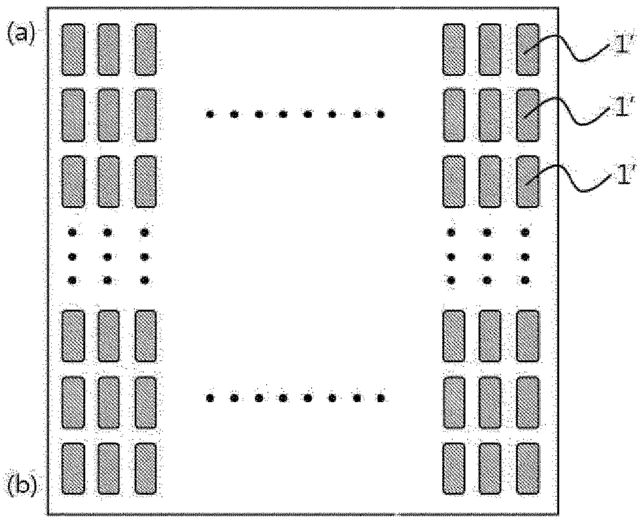

[Figure 5]

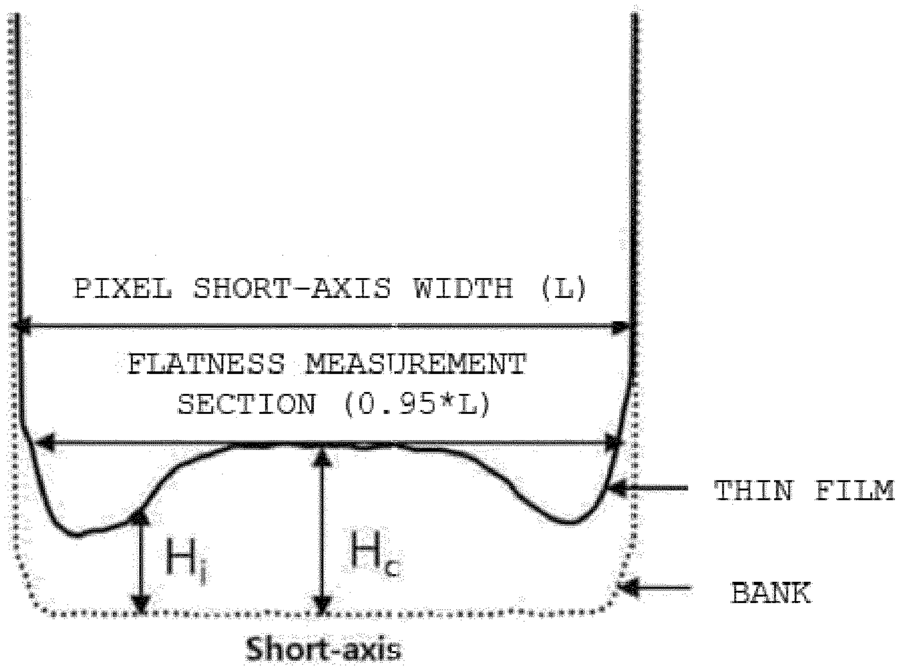


[Figure 6]

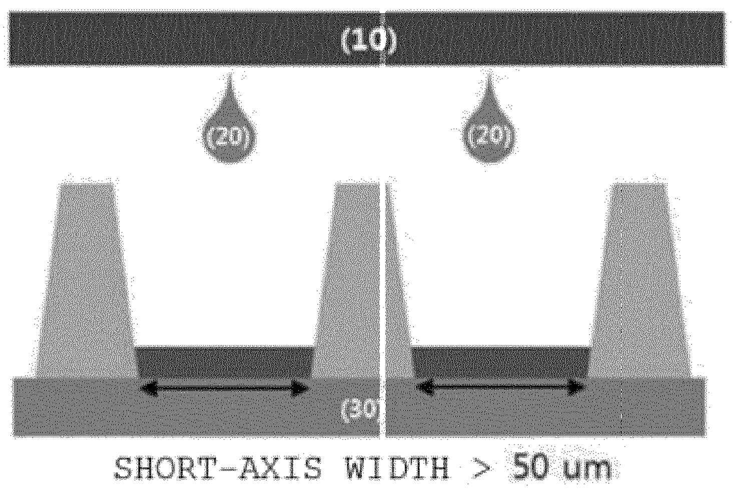

[Figure 7]

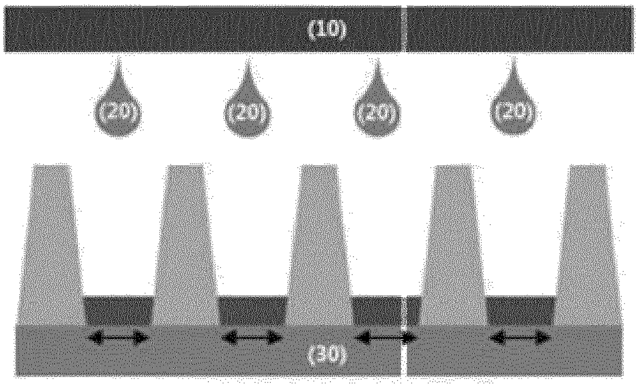


SHORT-AXIS WIDTH ≤ 50 um

[Figure 8]

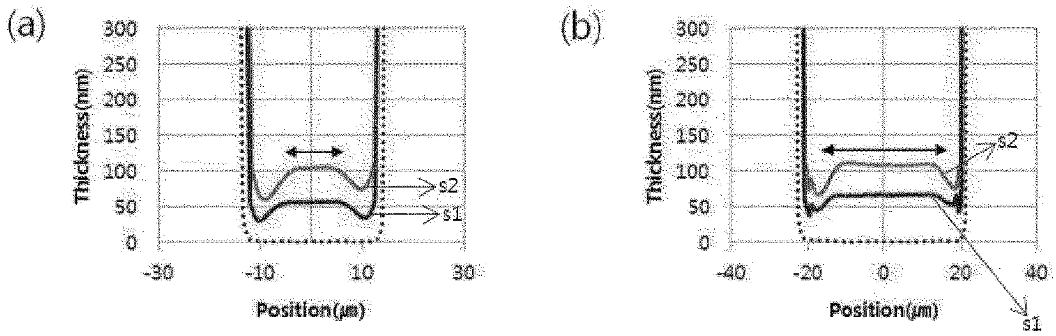

[Figure 9]

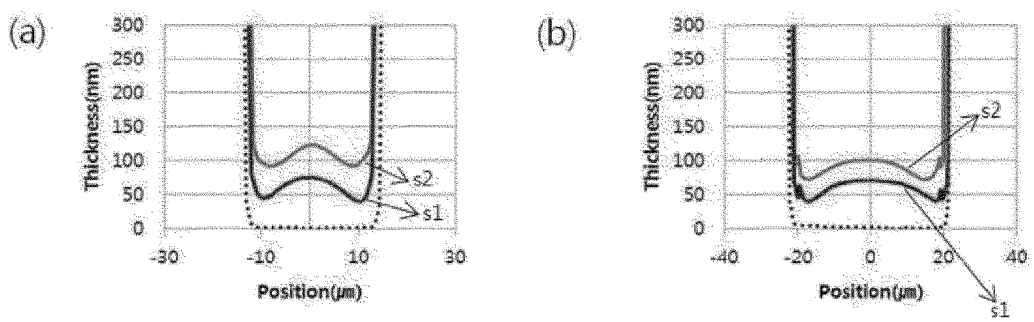
(a)
Thickness(nm)
300
250
200
150
100
50
0
-30
-10
10
30
Position(μm)
s2
s1
(b)
Thickness(nm)
300
250
200
150
100
50
0
-40
-20
0
20
40
Position(μm)
s2
s1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020220146048
- EP 3954677 A1
- KR 20200036610
- KR 20220057778 A